# EUROPÄISCHE PATENTSCHRIFT

(11) **EP 3 515 925 B1**
(45) Veröffentlichungstag und Bekanntmachung des Hinweises auf die Patenterteilung: **21.10.2020**
(21) Anmeldenummer: 17769043.5
(22) Anmeldetag: 18.09.2017
(51) Int. Cl.: C07F 15/00, H01L 51/50, H01L 51/00

(54) **BINUKLEARE METALLKOMPLEXE FÜR DEN EINSATZ ALS EMITTER IN ORGANISCHEN ELEKTROLUMINESZENZVORRICHTUNGEN**
BINUCLEAR METAL COMPLEXES FOR USE AS EMITTERS IN ORGANIC ELECTROLUMINESCENT DEVICES
COMPLEXES MÉTALLIQUES TROUVANT APPLICATION COMME ÉMETTEURS DANS DES DISPOSITIFS ÉLECTROLUMINESCENTS ORGANIQUES

(30) Priorität: 21.09.2016 EP 16189816
(43) Veröffentlichungstag der Anmeldung: 31.07.2019
(73) Patentinhaber: Merck Patent GmbH, 64293 Darmstadt (DE)
(72) Erfinder: STOESSEL, Philipp, 60389 Frankfurt Am Main (DE); EHRENREICH, Christian, 64285 Darmstadt (DE); HARBACH, Philipp, 64367 Muehltal (DE); HAYER, Anna, 64293 Darmstadt (DE); BREUNING, Esther, 64372 Ober-Ramstadt (DE)
(86) Internationale Anmeldenummer: PCT/EP2017/073385
(87) Internationale Veröffentlichungsnummer: WO 2018/054798

(56) Entgegenhaltungen:
- WO-A1-2016/124304
- CN-A- 104 356 170

## Beschreibung

Die vorliegende Erfindung betrifft binukleare Metallkomplexe, welche sich für den Einsatz als Emitter in organischen Elektrolumineszenzvorrichtungen eignen.

Gemäß dem Stand der Technik werden in phosphoreszierenden organischen Elektrolumineszenzvorrichtungen (OLEDs) als Triplettemitter vor allem bis- und tris-ortho-metallierte Iridiumkomplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)-iridium(III) und Derivate davon, wobei als Liganden beispielsweise 1- oder 3-Phenylisochinoline, 2-Phenylchinoline oder Phenylcarbene einsetzt werden. Dabei weisen diese Iridiumkomplexe im Allgemeinen eine recht lange Lumineszenzlebensdauer im Bereich von deutlich über 1 µs auf. Für die Verwendung in OLEDs sind jedoch kurze Lumineszenzlebensdauern gewünscht, um die OLED bei einer hohen Helligkeit mit einem geringen Roll-off-Verhalten betreiben zu können. Auch bei der Effizienz rot phosphoreszierender Emitter gibt es noch Verbesserungsbedarf. Durch das geringe Triplettniveau T₁ liegt bei üblichen rot phosphoreszierenden Emittern die Photolumineszenzquantenausbeute häufig deutlich unter dem theoretisch möglichen Wert, da bei kleinem T₁ auch nicht-radiative Kanäle eine größere Rolle spielen, insbesondere wenn der Komplex eine hohe Lumineszenzlebensdauer aufweist. Hier ist eine Verbesserung durch Erhöhung der radiativen Raten wünschenswert, was wiederum durch eine Reduktion der Photolumineszenzlebensdauer erreicht werden kann.

Eine Verbesserung der Stabilität der Komplexe konnte durch die Verwendung polypodaler Liganden erreicht werden, wie beispielsweise in WO 2004/081017, US 7,332,232 und WO 2016/124304 beschrieben. Auch wenn diese Komplexe Vorteile gegenüber Komplexen zeigen, die ansonsten die gleiche Ligandenstruktur aufweisen, deren einzelne Liganden jedoch nicht polypodal verbrückt sind, gibt es auch noch Verbesserungsbedarf. So sind auch bei Komplexen mit polypodalen Liganden noch Verbesserungen in Bezug auf die Eigenschaften bei Verwendung in einer organischen Elektrolumineszenzvorrichtung, insbesondere in Bezug auf Lumineszenzlebensdauer des angeregten Zustands, Effizienz, Spannung und/oder Lebensdauer, wünschenswert.

Aus US 2003/0152802 sind bimetallische Iridiumkomplexe mit einem überbrückenden Liganden, der an beide Metalle koordiniert, bekannt. Die Synthese dieser Komplexe erfolgt in mehreren Stufen, was einen synthetischen Nachteil darstellt. Außerdem ist bei diesen Komplexen facial-meridional-Isomerisierung sowie Ligandenscrambling möglich, was ebenfalls nachteilhaft ist.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug auf Lumineszenzlebensdauer, Effizienz, Betriebsspannung und/oder Lebensdauer zeigen.

Überraschend wurde gefunden, dass die unten beschriebenen binuklearen Rhodium- und Iridiumkomplexe deutliche Verbesserungen der photophysikalischen Eigenschaften zeigen gegenüber entsprechenden mononuklearen Komplexen und dadurch auch zu verbesserten Eigenschaften bei Verwendung in einer organischen Elektrolumineszenzvorrichtung führen. Insbesondere weisen die erfindungsgemäßen Verbindungen eine verbesserte Photolumineszenzquantenausbeute sowie eine deutlich reduzierte Lumineszenzlebensdauer auf. Eine geringere Lumineszenzlebensdauer führt zu einem verbesserten Roll-off-Verhalten der organischen Elektrolumineszenzvorrichtung. Diese Komplexe und organische Elektrolumineszenzvorrichtungen, welche diese Komplexe enthalten, sind der Gegenstand der vorliegenden Erfindung.

Gegenstand der Erfindung ist somit eine Verbindung gemäß der folgenden Formel (1), 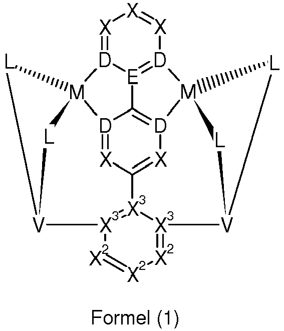 wobei für die verwendeten Symbole gilt:
- M: ist bei jedem Auftreten gleich oder verschieden Iridium oder Rhodium;
- D: ist bei jedem Auftreten gleich oder verschieden C oder N;
- X: ist gleich oder verschieden bei jedem Auftreten und ist CR oder N; oder zwei benachbarte X stehen zusammen für CR oder N und das dritte X ist CR oder N, wenn entweder ein D in diesem Cyclus als anionisches Stickstoffatom an M koordiniert oder wenn E für N steht;
- E: ist C oder N, wobei E nur dann N sein kann, wenn zwei benachbarte X zusammen für CR oder N stehen und das dritte X CR oder N ist;
- V: ist bei jedem Auftreten gleich oder verschieden eine Gruppe der folgenden Formel (2) oder (3), 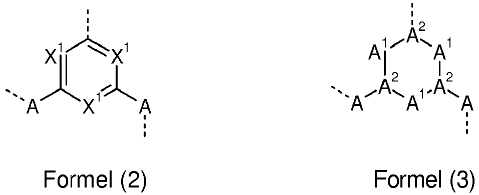 wobei die gestrichelte Bindung, die direkt an den Cyclus gebunden ist, die Bindung an die entsprechende in Formel (1) dargestellte 6-Ring-Aryl- bzw. Heteroarylgruppe darstellt und die beiden gestrichelten Bindungen an A jeweils die Bindungen an die Teilliganden L darstellen;
- L: ist bei jedem Auftreten gleich oder verschieden ein bidentater, monoanionischer Teilligand;
- X¹: ist bei jedem Auftreten gleich oder verschieden CR oder N;
- X²: ist bei jedem Auftreten gleich oder verschieden CR oder N oder zwei benachbarte Gruppen X² stehen zusammen für NR, O oder S, so dass ein Fünfring entsteht, und die verbleibenden X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² für N stehen;
- X³: ist bei jedem Auftreten C oder eine Gruppe X³ steht für N und die anderen Gruppen X³ in demselben Cyclus stehen für C; mit der Maßgabe, dass zwei benachbarte Gruppen X² zusammen für CR oder N stehen, wenn in dem Cyclus eine der Gruppen X³ für N steht;
- A¹: ist bei jedem Auftreten gleich oder verschieden C(R)₂ oder O;
- A²: ist bei jedem Auftreten gleich oder verschieden CR, P(=O), B oder SiR, mit der Maßgabe, dass für A² = P(=O), B oder SiR das Symbol A¹ für O steht und das Symbol A, das an dieses A² gebunden ist, nicht für -C(=O)-NR'- oder -C(=O)-O- steht;
- A: ist bei jedem Auftreten gleich oder verschieden -CR=CR-, -C(=O)-NR'-, -C(=O)-O-, -CR₂-CR₂-, -CR₂-O- oder eine Gruppe der folgenden Formel (4), 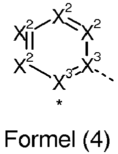 wobei die gestrichelte Bindung die Position der Bindung eines bidentaten Teilliganden L an diese Struktur darstellt und * die Position der Verknüpfung der Einheit der Formel (4) mit der zentralen cyclischen Gruppe darstellt, also der Gruppe, die explizit in Formel (2) bzw. (3) aufgeführt ist, und X² und X³ die oben genannten Bedeutungen aufweisen;
- R: ist bei jedem Auftreten gleich oder verschieden H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(Kation), SO₃(Kation), OSO₃(Kation), OPO₃(Kation)₂, O(Kation), N(R¹)₃(Anion), P(R¹)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
- R': ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder hetero-aromatisches Ringsystem mit 5 bis 40 aromatischen Ringatomen, das jeweils durch einen oder mehrere Reste R¹ substituiert sein kann;
- R¹: ist bei jedem Auftreten gleich oder verschieden H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(Kation), SO₃(Kation), OSO₃(Kation), OPO₃(Kation)₂, O(Kation), N(R²)₃(Anion), P(R²)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder hetero-aromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können;
- Kation: ist bei jedem Auftreten gleich oder verschieden ausgewählt aus der Gruppe bestehend aus Proton, Deuteron, Alkaliionen, Erdalkaliionen, Ammonium, Tetraalkylammonium und Tetraalkylphosphonium;
- Anion: ist bei jedem Auftreten gleich oder verschieden ausgewählt aus der Gruppe bestehend aus Halogeniden, Carboxylaten R²-COO-, Cyanid, Cyanat, Isocyanat, Thiocyanat, Thioisocyanat, Hydroxid, BF₄⁻, PF₆⁻, B(CeF₅)₄⁻, Carbonat und Sulfonaten.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können die Reste, die miteinander ein Ringsystem bilden, benachbart sein, d. h. dass diese Reste an dasselbe Kohlenstoffatom oder an Kohlenstoffatome, die direkt aneinander gebunden sind, gebunden sind, oder sie können weiter voneinander entfernt sein, sind jedoch bevorzugt benachbart.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

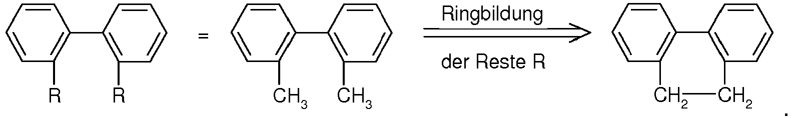

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

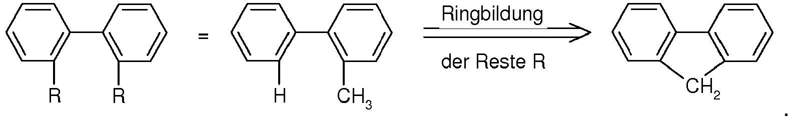

Die Bildung eines aromatischen Ringsystems soll durch das folgende Schema verdeutlicht werden:

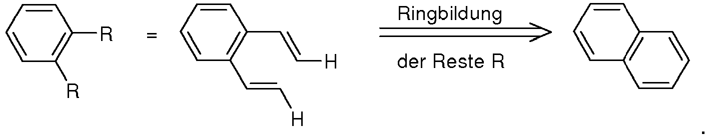

Dabei kann die Ringbildung an Resten erfolgen, die an direkt aneinander gebundene Kohlenstoffatome gebunden sind, oder an Resten, die an weiter entfernt liegende Kohlenstoffatome gebunden sind. Bevorzugt ist eine solche Ringbildung bei Resten, die an direkt aneinander gebundene Kohlenstoffatome oder an dasselbe Kohlenstoffatom gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl-oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden. Bevorzugte aromatische bzw. heteroaromatische Ringsysteme sind Aryl- bzw. Heteroarylgruppen, Systeme, in denen zwei oder mehrere Aryl- oder Heteroarylgruppen direkt aneinander gebunden sind, sowie Fluoren- und Spirobifluorengruppen.

Unter einer cyclischen Alkylgruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe oder einer cyclischen C3-C20-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Hexenyl, Heptenyl oder Octenyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₂₀-Alkoxygruppe, wie sie für OR¹ bzw. OR² vorliegt, werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Zur weiteren Veranschaulichung der Verbindung wird im Folgenden eine einfache Struktur gemäß Formel (1) vollständig dargestellt und erläutert:

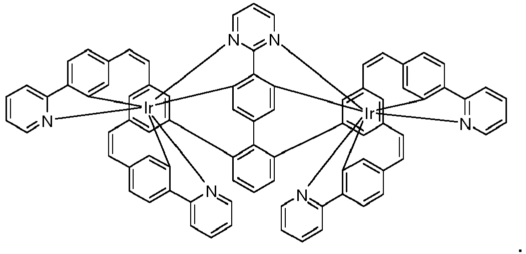

In dieser Struktur steht der Teilligand, der an beide Metalle M koordiniert ist, für eine 2-Phenylpyrimidingruppe. An die koordinierende Phenylgruppe ist eine Phenylgruppe gebunden, an die in den beiden ortho-Positionen jeweils eine Gruppe der Formel (2) gebunden ist, d. h. V steht in dieser Struktur jeweils für eine Gruppe der Formel (2). Darin steht der zentrale Cyclus für eine Phenylgruppe und die beiden Gruppen A stehen jeweils für -HC=CH-, also für cis-Alkenylgruppen. An diese Gruppe der Formel (2) sind jeweils noch zwei Teilliganden L gebunden, welche in der oben abgebildeten Struktur jeweils für Phenylpyridin stehen. Jedes der beiden Metalle M, die hier für Iridium stehen, ist somit in der oben abgebildeten Struktur mit jeweils zwei Phenylpyridinliganden und einem Phenylpyrimidinliganden koordiniert, wobei die Phenylgruppe und die Pyrimidingruppe des Phenylpyrimidins jeweils an beide Iridiumatome koordinieren. Dabei sind die Teilliganden jeweils durch die Gruppe der Formel (2) zu einem polypodalen System verknüpft.

Der Begriff "bidentater Teilligand" für L bedeutet im Sinne dieser Anmeldung, dass es sich bei dieser Einheit um einen bidentaten Liganden handeln würde, wenn die Gruppe der Formel (2) bzw. (3) nicht vorhanden wäre. Durch die formale Abstraktion eines Wasserstoffatoms an diesem bidentaten Liganden und die Verknüpfung innerhalb der Brücke der Formel (2) bzw. (3) ist dieser jedoch kein separater Ligand, sondern ein Teil des so entstehenden dodekadentaten Liganden, also eines Liganden mit insgesamt 12 Koordinationsstellen, so dass hierfür der Begriff "Teilligand" verwendet wird.

Die Bindung des Liganden an das Metall M kann sowohl eine Koordinationsbindung als auch eine kovalente Bindung sein bzw. der kovalente Anteil an der Bindung kann je nach Ligand variieren. Wenn in der vorliegenden Anmeldung die Rede davon ist, dass der Ligand bzw. der Teilligand an M koordiniert oder bindet, so bezeichnet dies im Sinne der vorliegenden Anmeldung jede Art der Bindung des Liganden bzw. Teilliganden an M, unabhängig vom kovalenten Anteil der Bindung.

Die erfindungsgemäßen Verbindungen sind bevorzugt nicht geladen, d. h. sie sind elektrisch neutral. Dies wird dadurch erreicht, dass Rh bzw. Ir jeweils in der Oxidationsstufe +III vorliegen. Jedes der Metalle ist dann von zwei monoanionischen bidentaten Teilliganden, sowie einem dianionischen tetradentaten Teilliganden, der an beide Metalle bindet, koordiniert, so dass die Teilliganden die Ladung des komplexierten Metallatoms kompensieren.

Wie oben beschrieben, können die beiden Metalle M in der erfindungsgemäßen gemäßen Verbindung gleich oder verschieden sein und liegen bevorzugt in der Oxidationsstufe +III vor. Es kommen daher die Kombinationen Ir / Ir, Ir / Rh und Rh / Rh in Frage. In einer bevorzugten Ausführungsform der Erfindung stehen beide Metalle M für Ir(III).

In einer bevorzugten Ausführungsform der Erfindung sind die Verbindungen der Formeln (1) gewählt aus den Verbindungen der folgenden Formeln (1'), (1") oder (1"'), 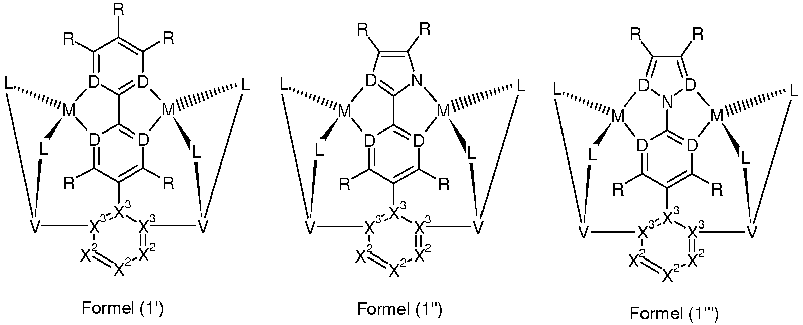 wobei die Reste R in ortho-Position zu D und in ortho-Position zu dem explizit eingezeichneten koordinierenden Stickstoffatom in Formel (1") jeweils gleich oder verschieden bei jedem Auftreten ausgewählt sind aus der Gruppe bestehend aus H, D, F, CH₃ und CD₃ und bevorzugt für H stehen und die weiteren verwendeten Symbole die oben aufgeführten Bedeutungen aufweisen.

In einer bevorzugten Ausführungsform der Formel (1) ist in Strukturen, welche über zwei Sechsring(hetero)arylgruppen des zentralen Teilliganden an M koordinieren, jedes der Metalle M von einem Kohlenstoffatom und einem Stickstoffatom des zentralen Teilliganden koordiniert und ist weiterhin von jeweils zwei Teilliganden L koordiniert. In einer weiteren bevorzugten Ausführungsform der Formel (1) ist in Strukturen, welche über eine Sechsringheteroarylgruppe und eine Fünfringheteroarylgruppe, in der E für C steht, des zentralen Teilliganden an M koordinieren, eines der beiden Metalle M von einem Kohlenstoffatom und einem Stickstoffatom und das andere der beiden Metalle M von zwei Stickstoffatomen des zentralen Teilliganden koordiniert. Weiterhin sind beide Metalle von jeweils zwei Teilliganden L koordiniert. In einer weiteren bevorzugten Ausführungsform der Formel (1) ist in Strukturen, welche über eine Sechsring(hetero)arylgruppe und eine Fünfringheteroarylgruppe, in der E für N steht, des zentralen Teilliganden an M koordinieren, jedes der Metalle M von einem Kohlenstoffatom und einem Stickstoffatom des zentralen Teilliganden koordiniert und ist weiterhin von jeweils zwei Teilliganden L koordiniert.

Die Verbindung der Formel (1) weist also bevorzugt eine Struktur gemäß einer der folgenden Formeln (1a) bis (1 h) auf, 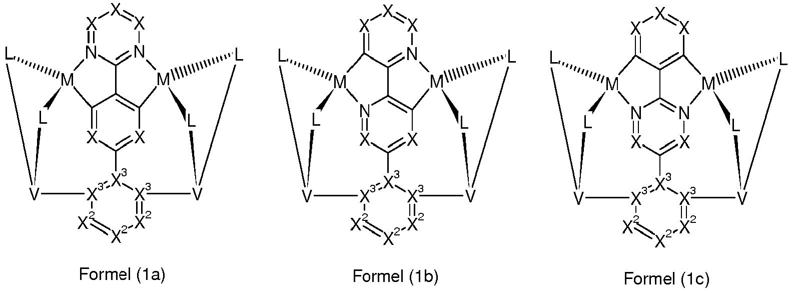 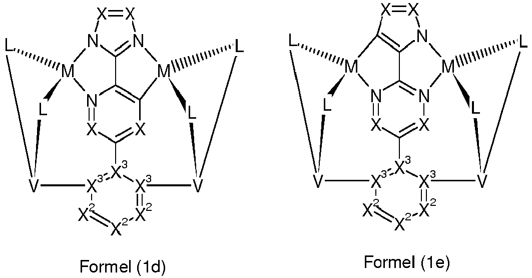 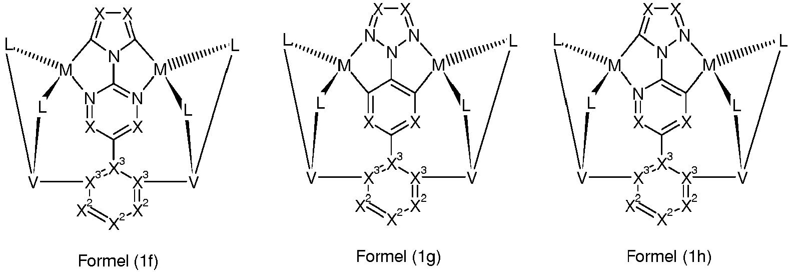 wobei die verwendeten Symbole die oben genannten Bedeutungen aufweisen und X in dem Fünfring der Formel (1d) bis (1h) gleich oder verschieden bei jedem Auftreten für CR oder N steht.

In einer bevorzugten Auführungsform der Erfindung steht X in den Formeln (1a) bis (1h) für CR.

In einer weiteren bevorzugten Ausführungsform der Erfindung stehen die explizit aufgeführten X² in Formel (1), (1'), (1"), (1"') und (1a) bis (1h) gleich oder verschieden bei jedem Auftreten für CR und besonders bevorzugt für CH, und X³ steht für C.

Bevorzugt sind also die Verbindungen gemäß den folgenden Formeln (1a') bis (1h'), 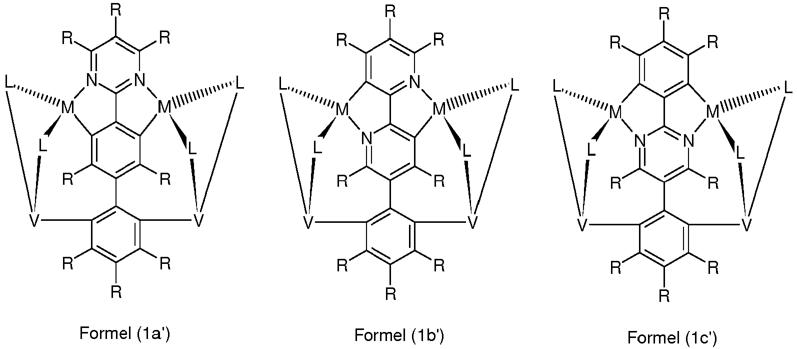 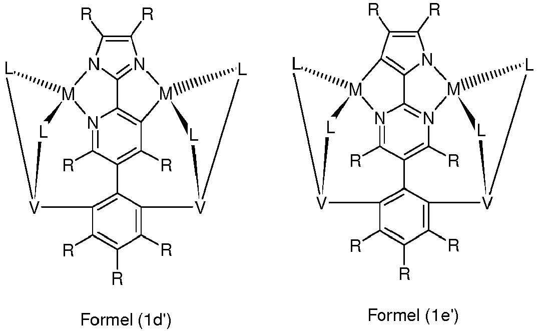 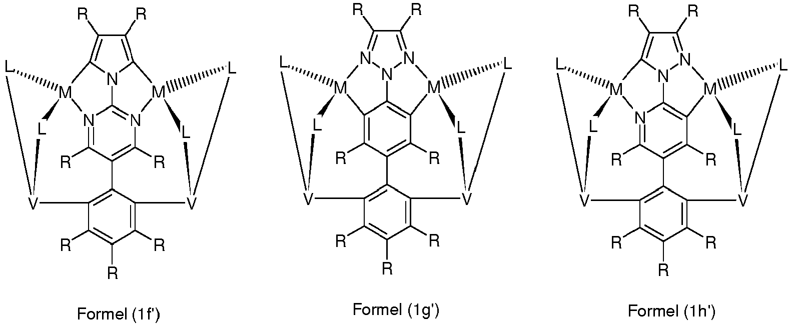 wobei die explizit eingezeichneten Reste R in ortho-Position zu den koordinierenden Kohlenstoff- bzw. Stickstoffatomen jeweils gleich oder verschieden bei jedem Auftreten ausgewählt sind aus der Gruppe bestehend aus H, D, F, CH₃ und CD₃ und die weiteren verwendeten Symbole die oben genannten Bedeutungen aufweisen. Besonders bevorzugt stehen die Reste R in ortho-Position zu den koordinierenden Kohlenstoff- bzw. Stickstoffatomen in Formeln (1a') bis (1h') für H.

Besonders bevorzugt sind die Strukturen der Formel (1a) und (1c) bzw. (1a') und (1c').

Nachfolgend werden bevorzugte Ausführungsformen für V, also die Gruppe der Formel (2) bzw. (3) ausgeführt.

Wenn in Formel (3) A² für CR steht, insbesondere wenn alle A² für CR stehen, ganz besonders wenn zusätzlich 0, 1, 2 oder 3, insbesondere 3, der A¹ für CR₂ stehen, können die Reste R an A² abhängig von der Konfiguration unterschiedliche Positionen einnehmen. Bevorzugt sind dabei kleine Reste R wie H oder D. Bevorzugt ist, dass sie entweder alle weg vom Metall gerichtet sind (apical) oder alle nach innen zum Metall hin gerichtet sind (endohedral). Dies ist nachfolgend an einem Beispiel veranschaulicht, in dem die Gruppen A jeweils für eine ortho-Phenylengruppe stehen.

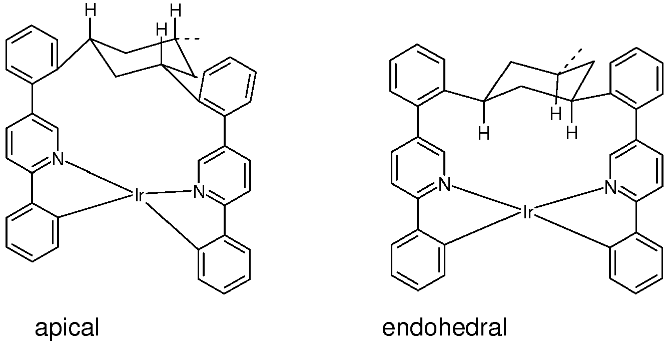

Der dritte Teilligand, der an beide Metalle M koordiniert, ist der Übersichtlichkeit halber nicht dargestellt, sondern nur durch die gestrichelte Bindung angedeutet. Bevorzugt sind daher Komplexe, welche mindestens eine der beiden Konfigurationen einnehmen können. Dies sind Komplexe, bei welchen alle drei Teilliganden äquatorial am zentralen Ring angeordnet sind.

Geeignete Ausführungsformen der Gruppe der Formel (2) sind die Strukturen der folgenden Formeln (5) bis (8), und geeignete Ausführungsformen der Gruppe der Formel (3) sind die Strukturen der folgenden Formeln (9) bis (13), 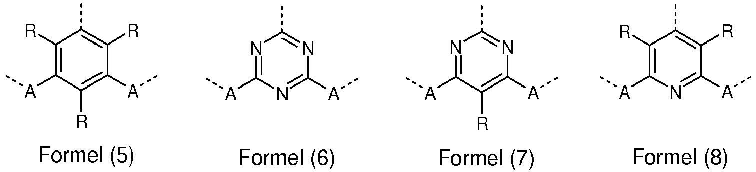 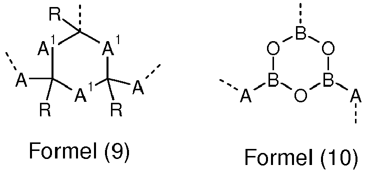 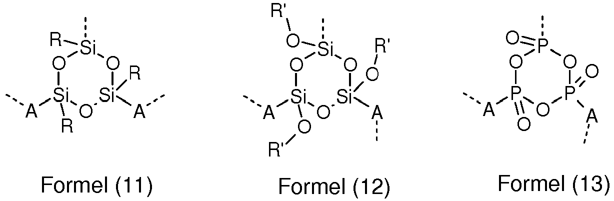 wobei die Symbole die oben genannten Bedeutungen aufweisen.

Für bevorzugte Reste R in Formeln (2), (3) und (5) bis (13) gilt:
- R: ist bei jedem Auftreten gleich oder verschieden H, D, F, CN, OR¹, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R¹ substituiert sein kann, oder ein aromatisches oder heteroaromatisches Ringsystem mit 5 bis 24 aromatischen Ringatomen, das jeweils durch einen oder mehrere Reste R¹ substituiert sein kann;
- R¹: ist bei jedem Auftreten gleich oder verschieden H, D, F, CN, OR², eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch F ersetzt sein können.

Für besonders bevorzugte Reste R in Formeln (2), (3) und (5) bis (13) gilt:
- R: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R¹ substituiert sein kann, oder ein aromatisches oder heteroaromatisches Ringsystem mit 6 bis 12 aromatischen Ringatomen, das jeweils durch einen oder mehrere Reste R¹ substituiert sein kann;
- R¹: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R² substituiert sein kann, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.

In einer bevorzugten Ausführungsform der Erfindung stehen alle Gruppen X¹ in der Gruppe der Formel (2) für CR, so dass der zentrale trivalente Cyclus der Formel (2) ein Benzol darstellt. Besonders bevorzugt stehen alle Gruppen X¹ für CH oder CD, insbesondere für CH. In einer weiteren bevorzugten Ausführungsform der Erfindung stehen alle Gruppen X¹ für ein Stickstoffatom, so dass der zentrale trivalente Cyclus der Formel (2) ein Triazin darstellt. Bevorzugte Ausführungsformen der Formel (2) sind somit die Strukturen der oben abgebildeten Formeln (5) und (6). Besonders bevorzugt ist die Struktur der Formel (5) eine Struktur der folgenden Formel (5'), 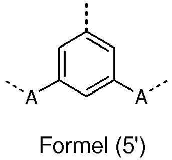 wobei die Symbole die oben genannten Bedeutungen aufweisen.

In einer weiteren bevorzugten Ausführungsform der Erfindung stehen alle Gruppen A² in der Gruppe der Formel (3) für CR. Besonders bevorzugt stehen alle Gruppen A² für CH. Bevorzugte Ausführungsformen der Formel (3) sind somit die Strukturen der oben abgebildeten Formel (9). Besonders bevorzugt ist die Struktur der Formel (9) eine Struktur der folgenden Formel (9') oder (9"), 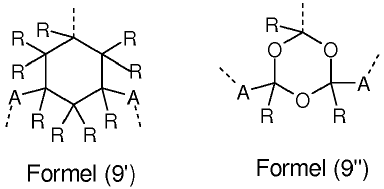 wobei die Symbole die oben genannten Bedeutungen aufweisen und R bevorzugt für H steht.

Im Folgenden werden bevorzugte Gruppen A beschrieben, wie sie in den Strukturen der Formeln (2) und (3) sowie (5) bis (13) vorkommen. Die Gruppe A kann gleich oder verschieden bei jedem Auftreten eine Alkenylgruppe, eine Amidgruppe, eine Estergruppe, eine Alkylengruppe, eine Methylenethergruppe oder eine ortho-verknüpfte Arylen- bzw. Heteroarylengruppe der Formel (4) darstellen. Wenn A für eine Alkenylgruppe steht, dann handelt es sich um eine cis-verknüpfte Alkenylgruppe. Bei unsymmetrischen Gruppen A ist jede Orientierung der Gruppen möglich. Dies ist nachfolgend schematisch am Beispiel von A = -C(=O)-O-erläutert. Hieraus ergeben sich die folgenden möglichen Orientierungen von A, die alle von der vorliegenden Erfindung umfasst sind:

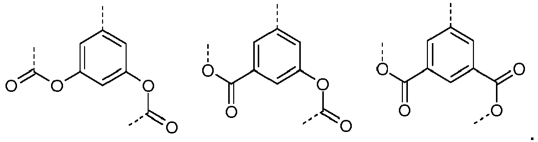

In einer bevorzugten Ausführungsform der Erfindung ist A gleich oder verschieden, bevorzugt gleich, bei jedem Auftreten ausgewählt aus der Gruppe bestehend aus -C(=O)-O-, -C(=O)-NR'- oder einer Gruppe der Formel (4). Weiterhin bevorzugt sind beide Gruppen A gleich und auch gleich substituiert. Bevorzugte Kombinationen für die Gruppen A innerhalb einer Formel (2) und (3) und den bevorzugten Ausführungsformen sind:

| | |
|---|---|
| A | A |
| Formel (4) | Formel (4) |
| -C(=O)-O- | -C(=O)-O- |
| -C(=O)-NR'- | -C(=O)-NR'- |
| -C(=O)-O- | Formel (4) |
| -C(=O)-NR'- | Formel (4) |
| -C(=O)-O- | -C(=O)-NR'- |

Wenn A für -C(=O)-NR'- steht, dann steht R' bevorzugt gleich oder verschieden bei jedem Auftreten für eine geradkettige Alkylgruppe mit 1 bis 10 C-Atomen oder eine verzweigte oder cyclische Alkylgruppe mit 3 bis 10 C-Atomen oder ein aromatisches oder heteroaromatisches Ringsystem mit 6 bis 24 aromatischen Ringatomen, das jeweils durch einen oder mehrere Reste R¹ substituiert sein kann. Besonders bevorzugt steht R' gleich oder verschieden bei jedem Auftreten für eine geradkettige Alkylgruppe mit 1 bis 5 C-Atomen oder eine verzweigte oder cyclische Alkylgruppe mit 3 bis 6 C-Atomen oder ein aromatisches oder heteroaromatisches Ringsystem mit 6 bis 12 aromatischen Ringatomen, das jeweils durch einen oder mehrere Reste R¹ substituiert sein kann, bevorzugt aber unsubstituiert ist.

Im Folgenden werden bevorzugte Ausführungsformen der Gruppe der Formel (4) beschrieben. Die Gruppe der Formel (4) kann einen heteroaromatischen Fünfring oder einen aromatischen oder heteroaromatischen Sechsring darstellen. In einer bevorzugten Ausführungsform der Erfindung enthält die Gruppe der Formel (4) maximal zwei Heteroatome in der aromatischen bzw. heteroaromatischen Einheit, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc..

Wenn beide Gruppen X³ in Formel (4) für Kohlenstoffatome stehen, sind bevorzugte Ausführungsformen der Gruppe der Formel (4) die Strukturen der folgenden Formeln (14) bis (30), und wenn eine Gruppe X³ für ein Kohlenstoffatom und die andere Gruppe X³ in demselben Cyclus für ein Stickstoffatom steht, sind bevorzugte Ausführungsformen der Gruppe der Formel (4) die Strukturen der folgenden Formeln (31) bis (38), 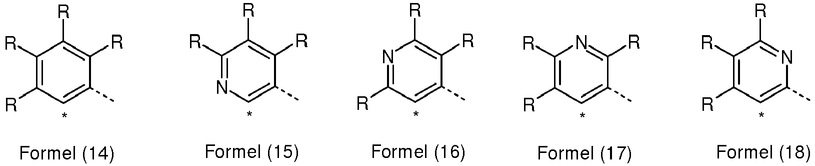 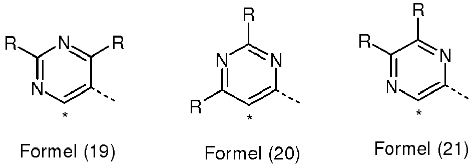 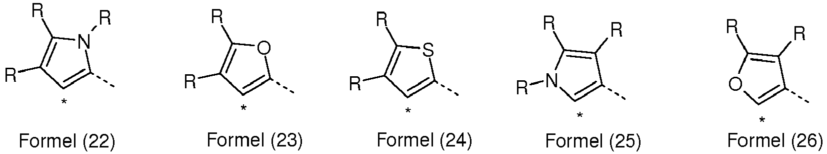 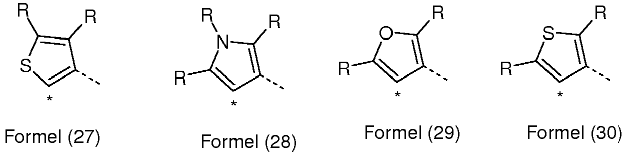 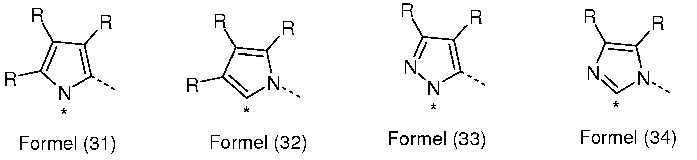 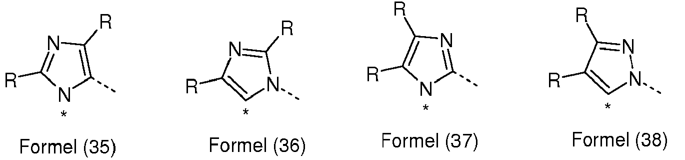 wobei die Symbole die oben genannten Bedeutungen aufweisen.

Besonders bevorzugt sind die Sechsring-Aromaten und -Heteroaromaten der oben abgebildeten Formeln (14) bis (18). Ganz besonders bevorzugt ist ortho-Phenylen, also eine Gruppe der oben genannten Formel (14). Dabei können auch benachbarte Substituenten R miteinander ein Ringsystem bilden, so dass kondensierte Strukturen, auch kondensierte Aryl-und Heteroarylgruppen, wie beispielsweise Naphthalin, Chinolin, Benzimidazol, Carbazol, Dibenzofuran oder Dibenzothiophen, entstehen können. Eine solche Ringbildung ist im Folgenden schematisch an Gruppen der oben genannten Formel (14) aufgeführt, was beispielsweise zu Gruppen der folgenden Formeln (14a) bis (14j) führen kann: 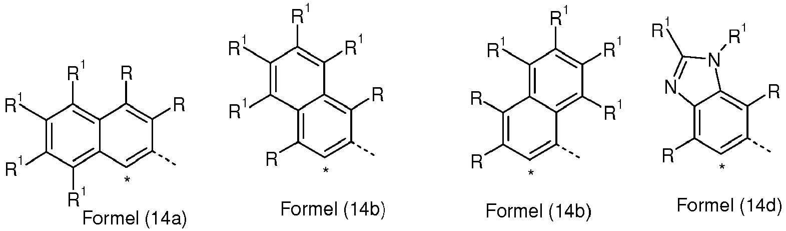 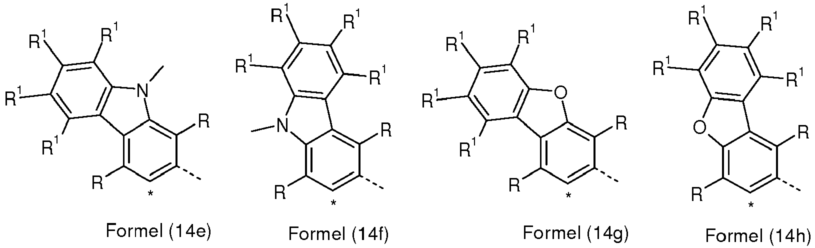 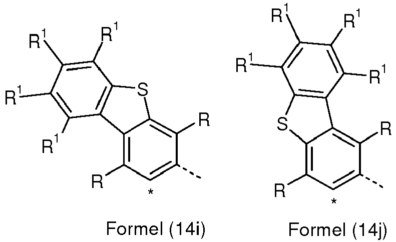 wobei die Symbole die oben genannten Bedeutungen aufweisen.

Generell können die ankondensierten Gruppen an jeder Position der Einheit gemäß Formel (4) ankondensiert sein, wie durch die ankondensierte Benzogruppe in den Formeln (14a) bis (14c) dargestellt. Die Gruppen, wie sie in den Formeln (14d) bis (14j) an die Einheit der Formel (4) ankondensiert sind, können daher auch an anderen Positionen der Einheit der Formel (4) ankondensiert werden.

Die Gruppe der Formel (2) kann besonders bevorzugt durch die folgenden Formeln (2a) bis (2i) dargestellt werden, und die Gruppe der Formel (3) kann besonders bevorzugt durch die folgenden Formeln (3a) bis (3i) dargestellt werden: 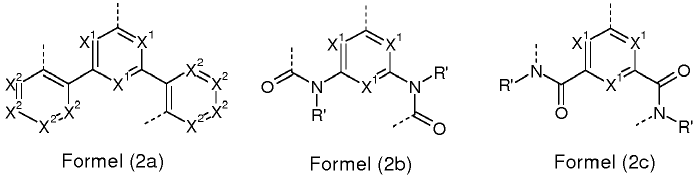 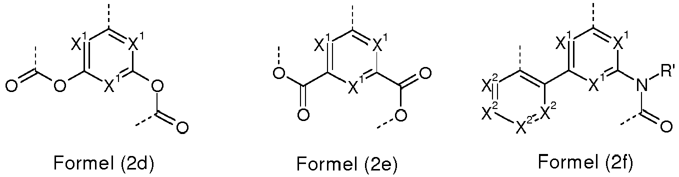 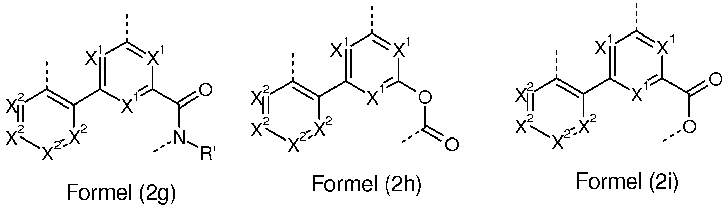 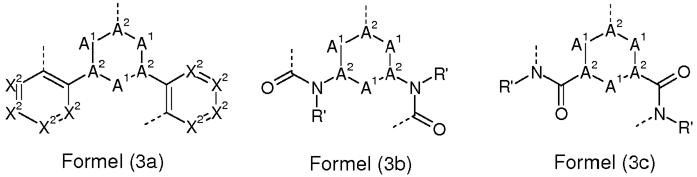 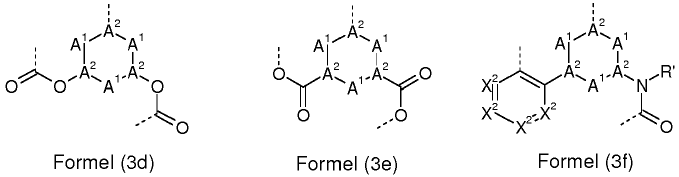 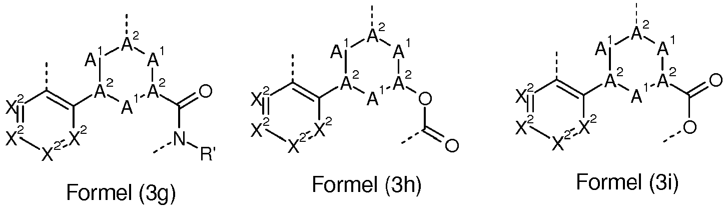 wobei die Symbole die oben genannten Bedeutungen aufweisen. Bevorzugt steht X² gleich oder verschieden bei jedem Auftreten für CR.

In einer bevorzugten Ausführungsform der Erfindung ist die Gruppe der Formeln (2a) bis (2i) ausgewählt aus den Gruppen der Formeln (5a') bis (5m') und die Gruppe der Formel (3a) bis (3i) aus den Gruppen der Formeln (9a') bis (9i'), 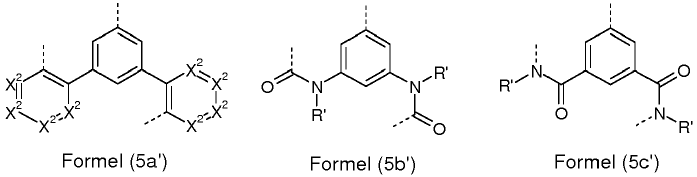 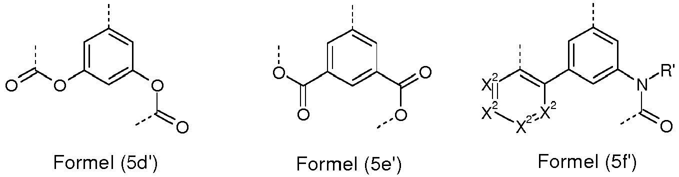 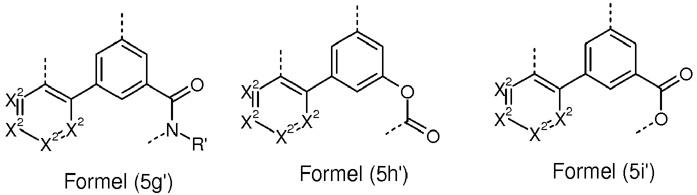 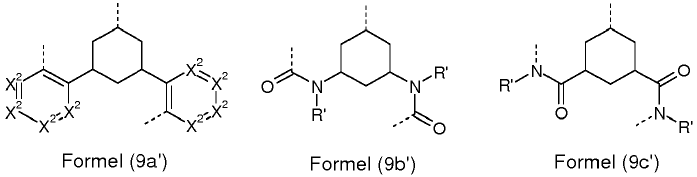 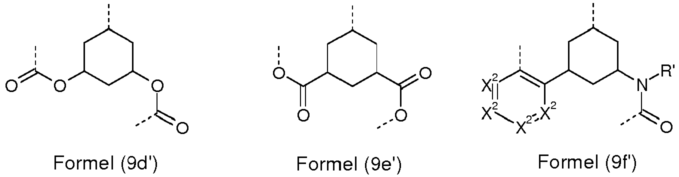 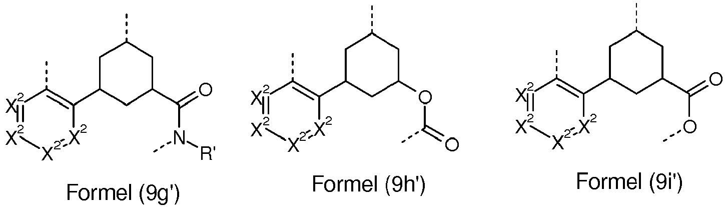 wobei die Symbole die oben genannten Bedeutungen aufweisen. Bevorzugt steht X² gleich oder verschieden bei jedem Auftreten für CR.

Eine besonders bevorzugte Ausführungsform der Gruppe der Formel (2) ist die Gruppe der folgenden Formel (5a"), 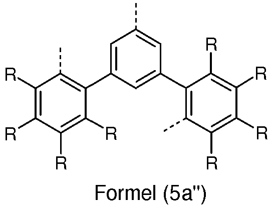 wobei die Symbole die oben genannten Bedeutungen aufweisen.

Besonders bevorzugt sind die Gruppen R in den oben genannten Formeln gleich oder verschieden H, D oder eine Alkylgruppe mit 1 bis 4 C-Atomen. Ganz besonders bevorzugt ist R = H. Ganz besonders bevorzugt ist also die Struktur der folgenden Formeln (5a'"), 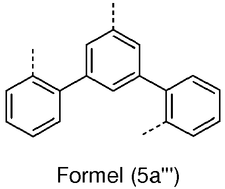 wobei die Symbole die oben genannten Bedeutungen aufweisen.

Im Folgenden werden die bidentaten, monoanionischen Teilliganden L beschrieben. Die Teilliganden L können gleich oder verschieden sein. Dabei ist es bevorzugt, wenn jeweils die beiden Teilliganden L, die an dasselbe Metall M koordinieren, gleich sind und auch gleich substituiert sind. Diese Bevorzugung ist durch die einfachere Synthese der entsprechenden Liganden begründet. In einer besonders bevorzugten Ausführungsform sind alle vier bidentaten Teilliganden L für gleich und sind auch gleich substituiert.

In einer weiteren bevorzugten Ausführungsform der Erfindung sind die koordinierenden Atome der bidentaten Teilliganden L gleich oder verschieden bei jedem Auftreten ausgewählt aus C, N, P, O, S und/oder B, besonders bevorzugt C, N und/oder O und ganz besonders bevorzugt C und/oder N. Dabei weisen die bidentaten Teilliganden L bevorzugt ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome auf. Dabei können die koordinierenden Atome von jedem der Teilliganden L gleich sein, oder sie können unterschiedlich sein. Bevorzugt weist mindestens einer der beiden bidentaten Teilliganden L, die an dasselbe Metall M koordinieren, ein Kohlenstoffatom und ein Stickstoffatom oder zwei Kohlenstoffatome als koordinierende Atome auf, insbesondere ein Kohlenstoffatom und ein Stickstoffatom. Besonders bevorzugt weisen mindestens alle bidentaten Teilliganden ein Kohlenstoffatom und ein Stickstoffatom oder zwei Kohlenstoffatome als koordinierende Atome auf, insbesondere ein Kohlenstoffatom und ein Stickstoffatom. Besonders bevorzugt handelt es sich somit um einen Metallkomplex, in dem alle Teilliganden ortho-metalliert sind, d. h. mit dem Metall M einen Metallacyclus bilden, in dem mindestens eine Metall-Kohlenstoff-Bindung vorliegt.

Es ist weiterhin bevorzugt, wenn es sich bei dem Metallacyclus, der aus dem Metall M und dem bidentaten Teilliganden L aufgespannt wird, um einen Fünfring handelt, der vor allem dann bevorzugt ist, wenn die koordinierenden Atome C und N, N und N oder N und O sind. Wenn es sich bei den koordinierenden Atomen um O handelt, kann auch ein Metallasechsring bevorzugt sein. Dies wird im Folgenden schematisch dargestellt: 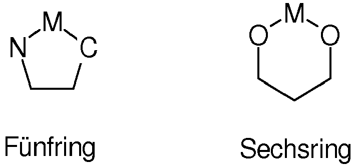 wobei N ein koordinierendes Stickstoffatom, C ein koordinierendes Kohlenstoffatom und O koordinierende Sauerstoffatome darstellen und die eingezeichneten Kohlenstoffatome Atome des bidentaten Teilliganden L darstellen.

In einer bevorzugten Ausführungsform der Erfindung ist mindestens einer der bidentaten Teilliganden L pro Metall M und besonders bevorzugt alle bidentaten Teilliganden gleich oder verschieden bei jedem Auftreten ausgewählt aus den Strukturen der folgenden Formeln (L-1), (L-2) oder (L-3), 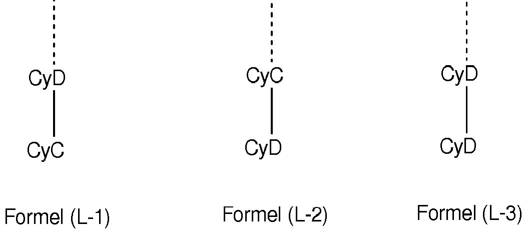 wobei die gestrichelte Bindung die Bindung des Teilliganden L an die Gruppe der Formel (2) bzw. (3) bzw. der bevorzugten Ausführungsformen darstellt und für die weiteren verwendeten Symbole gilt:
- CyC: ist gleich oder verschieden bei jedem Auftreten eine substituierte oder unsubstituierte Aryl- oder Heteroarylgruppe mit 5 bis 14 aromatischen Ringatomen, welche über ein Kohlenstoffatom an M koordiniert und welche über eine kovalente Bindung mit CyD verbunden ist;
- CyD: ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an M koordiniert und welche über eine kovalente Bindung mit CyC verbunden ist;
dabei können mehrere der optionalen Substituenten miteinander ein Ringsystem bilden; weiterhin sind die optionalen Reste bevorzugt ausgewählt aus den oben genannten Resten R.

Dabei koordiniert CyD in den Teilliganden der Formeln (L-1) und (L-2) bevorzugt über ein neutrales Stickstoffatom oder über ein Carben-Kohlenstoffatom, insbesondere über ein neutrales Stickstoffatom. Weiterhin bevorzugt koordiniert eine der beiden Gruppen CyD in dem Liganden der Formel (L-3) über ein neutrales Stickstoffatom und und die andere der beiden Gruppen CyD über ein anionisches Stickstoffatom. Weiterhin bevorzugt koordiniert CyC in den Teilliganden der Formeln (L-1) und (L-2) über anionische Kohlenstoffatome.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD in den Formeln (L-1) und (L-2) bzw. die Substituenten an den beiden Gruppen CyD in Formel (L-3) miteinander einen Ring bilden, wodurch CyC und CyD bzw. die beiden Gruppen CyD auch zusammen eine einzige kondensierte Aryl- bzw. Heteroarylgruppe als bidentaten Liganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, insbesondere eine Phenylgruppe, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-20), 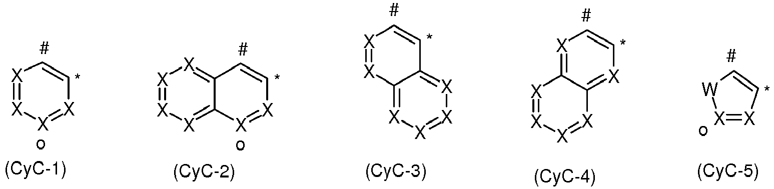 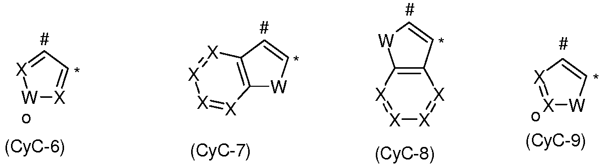 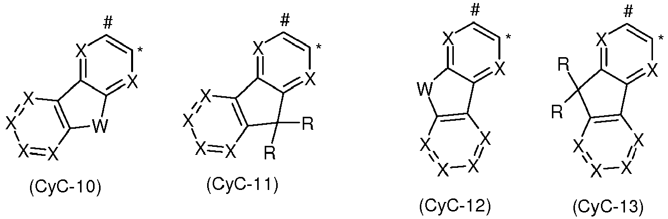 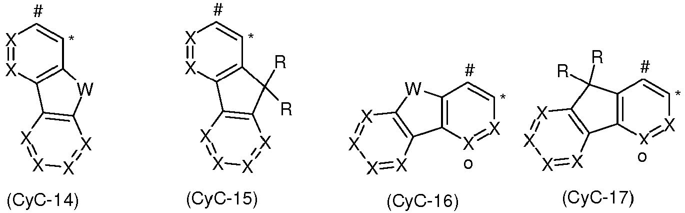 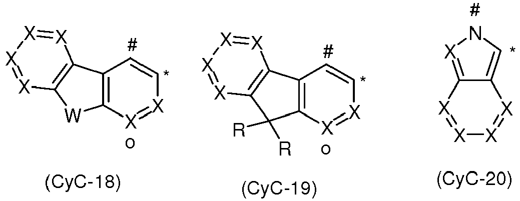 wobei CyC jeweils an der durch # gekennzeichneten Position an CyD bindet und an der durch * gekennzeichneten Position an das Metall koordiniert, R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist NR, O oder S;
mit der Maßgabe, dass, wenn der Teilligand L über CyC innerhalb der Gruppe der Formel (2) bzw. (3) gebunden ist, ein Symbol X für C steht und die Brücke der Formeln (2) bzw. (3) bzw. die bevorzugten Ausführungsformen an dieses Kohlenstoffatom gebunden ist. Wenn der Teilligand L über die Gruppe CyC an die Gruppe der Formel (2) bzw. (3) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht an die Gruppe der Formel (2) bzw. (3) gebunden, da eine solche Bindung an die Brücke aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn CyC direkt innerhalb der Gruppe der Formel (2) bzw. (3) gebunden ist, ein Symbol X für C steht und die Brücke der Formel (2) bzw. (3) bzw. die bevorzugten Ausführungsformen an dieses Kohlenstoffatom gebunden ist.

Besonders bevorzugte Gruppen CyC sind die Gruppen der folgenden Formeln (CyC-1a) bis (CyC-20a), 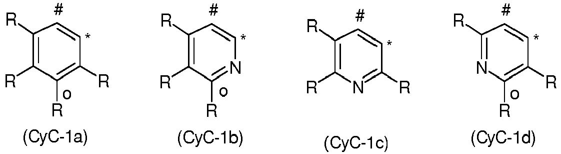 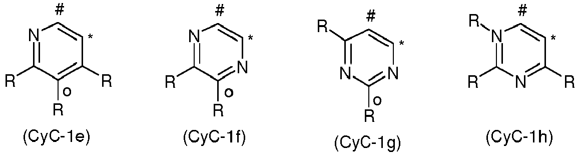 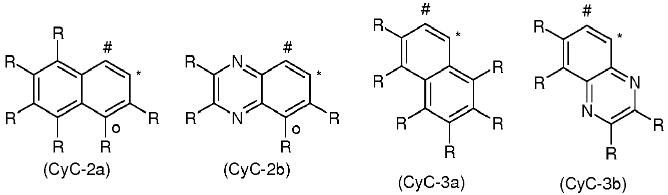 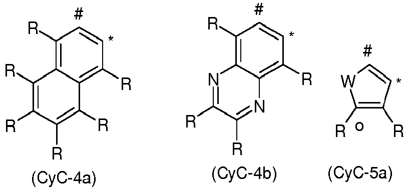 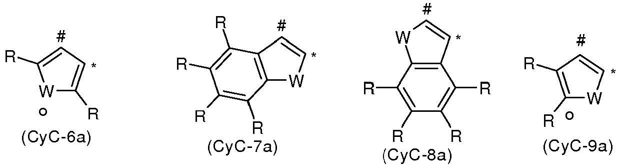 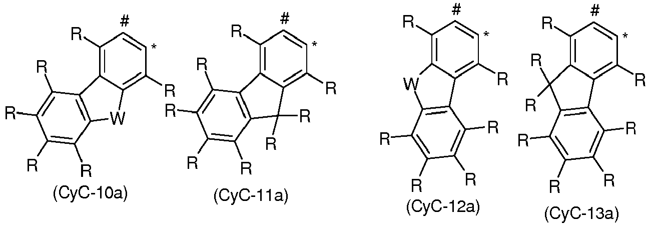 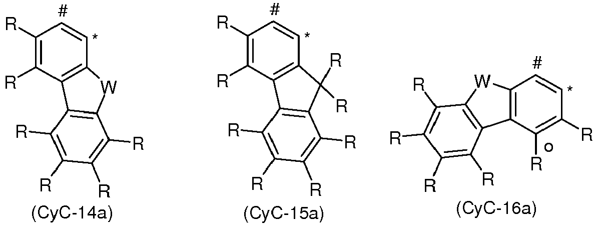 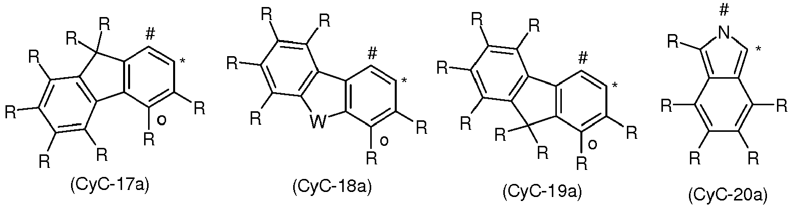 wobei die Symbole die oben genannten Bedeutungen aufweisen und, wenn CyC direkt innerhalb der Gruppe der Formel (2) bzw. (3) gebunden ist, ein Rest R nicht vorhanden ist und die Gruppe der Formel (2) bzw. (3) bzw. die bevorzugten Ausführungsformen an das entsprechende Kohlenstoffatom gebunden ist. Wenn die Gruppe CyC direkt an die Gruppe der Formel (2) bzw. (3) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Gruppe der Formel (2) bzw. (3) gebunden.

Bevorzugte Gruppen unter den Gruppen (CyC-1) bis (CyC-20) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-14), 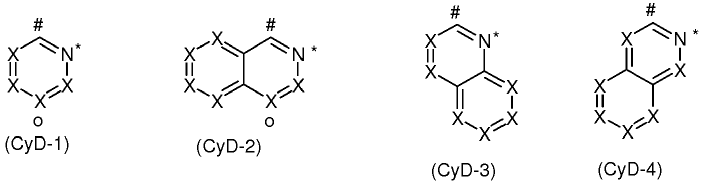 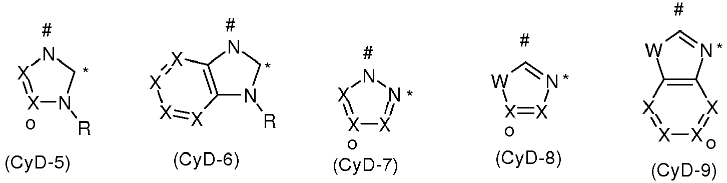 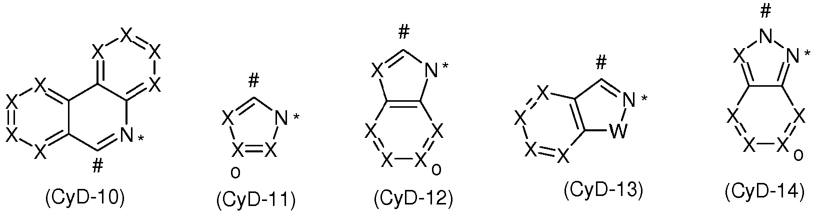 wobei die Gruppe CyD jeweils an der durch # gekennzeichneten Position an CyC bindet und an der durch * gekennzeichneten Position an das Metall koordiniert und wobei X, W und R die oben genannten Bedeutungen aufweisen, mit der Maßgabe, dass, wenn CyD direkt innerhalb der Gruppe der Formel (2) bzw. (3) gebunden ist, ein Symbol X für C steht und die Brücke der Formeln (2) bzw. (3) bzw. die bevorzugten Ausführungsformen an dieses Kohlenstoffatom gebunden ist. Wenn die Gruppe CyD direkt an die Gruppe der Formel (2) bzw. (3) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Gruppe der Formel (2) bzw. (3) gebunden, da eine solche Bindung an die Brücke aus sterischen Gründen nicht vorteilhaft ist.

Dabei koordinieren die Gruppen (CyD-1) bis (CyD-4), (CyD-7) bis (CyD-10), (CyD-13) und (CyD-14) über ein neutrales Stickstoffatom, (CyD-5) und (CyD-6) über ein Carben-Kohlenstoffatom und (CyD-11) und (CyD-12) über ein anionisches Stickstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn CyD direkt innerhalb der Gruppe der Formel (2) bzw. (3) gebunden ist, ein Symbol X für C steht und die Brücke der Formeln (2) bzw. (3) bzw. die bevorzugten Ausführungsformen an dieses Kohlenstoffatom gebunden ist.

Besonders bevorzugte Gruppen CyD sind die Gruppen der folgenden Formeln (CyD-1a) bis (CyD-14b), 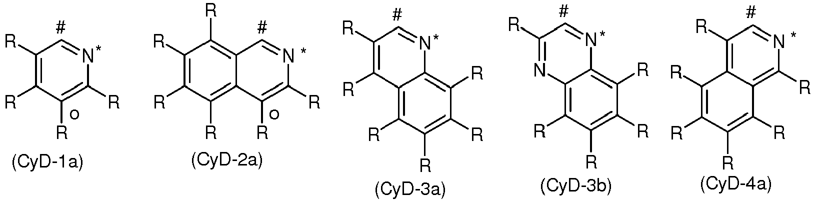 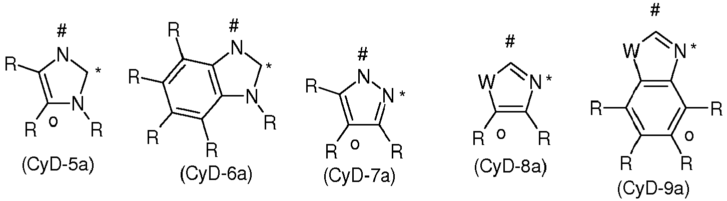 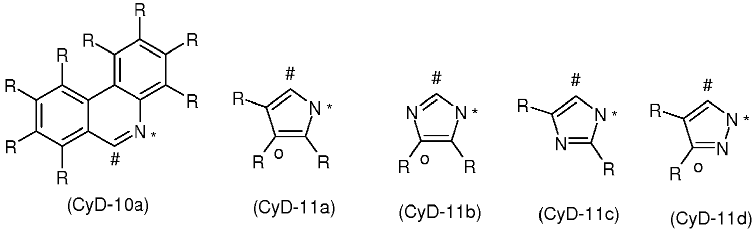 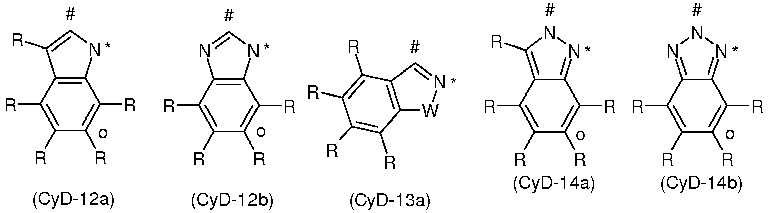 wobei die verwendeten Symbole die oben genannten Bedeutungen aufweisen und, wenn CyD direkt innerhalb der Gruppe der Formel (2) bzw. (3) gebunden ist, ein Rest R nicht vorhanden ist und die Brücke der Formel (2) bzw. (3) bzw. die bevorzugten Ausführungsformen an das entsprechende Kohlenstoffatom gebunden ist. Wenn CyD direkt an die Gruppe der Formel (2) bzw. (3) gebunden ist, so erfolgt die Bindung bevorzugt über die mit "o" markierte Position der oben abgebildeten Formeln, so dass dann bevorzugt in dieser Position der Rest R nicht vorhanden ist.

Die oben abgebildeten Strukturen, die kein mit "o" markiertes Kohlenstoffatom enthalten, sind bevorzugt nicht direkt an die Gruppe der Formel (2) bzw. (3) gebunden.

Bevorzugte Gruppen unter den Gruppen (CyD-1) bis (CyD-14) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen, insbesondere Phenyl, und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-14) können in den Teilliganden der Formeln (L-1) und (L-2) beliebig miteinander kombiniert werden, sofern mindestens eine der Gruppen CyC bzw. CyD eine geeignete Anknüpfungsstelle an die Gruppe der Formel (2) bzw. (3) aufweist, wobei geeignete Anknüpfungsstellen in den oben genannten Formeln mit "o" gekennzeichnet sind. Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden, sofern mindestens eine der bevorzugten Gruppen CyC bzw. CyD eine geeignete Anknüpfungsstelle an die Gruppe der Formel (2) bzw. (3) aufweist, wobei geeignete Anknüpfungsstellen in den oben genannten Formeln mit "o" gekennzeichnet sind. Kombinationen, in denen weder CyC noch CyD eine solche geeignete Anknüpfungsstelle an die Brücke der Formel (2) bzw. (3) aufweist, sind daher nicht bevorzugt. Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L-1) sind die Strukturen der folgenden Formeln (L-1-1) und (L-1-2), und bevorzugte Teilliganden (L-2) sind die Strukturen der folgenden Formeln (L-2-1) bis (L-2-3), 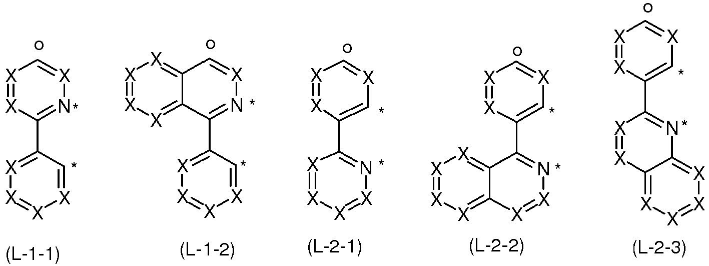 wobei die verwendeten Symbole die oben genannten Bedeutungen aufweisen, * die Position der Koordination an das Iridium andeutet und "o" die Position der Bindung an die Gruppe der Formel (2) bzw. (3) darstellt.

Besonders bevorzugte Teilliganden (L-1) sind die Strukturen der folgenden Formeln (L-1-1a) und (L-1-2b), und besonders bevorzugte Teilliganden (L-2) sind die Strukturen der folgenden Formeln (L-2-1a) bis (L-2-3a), 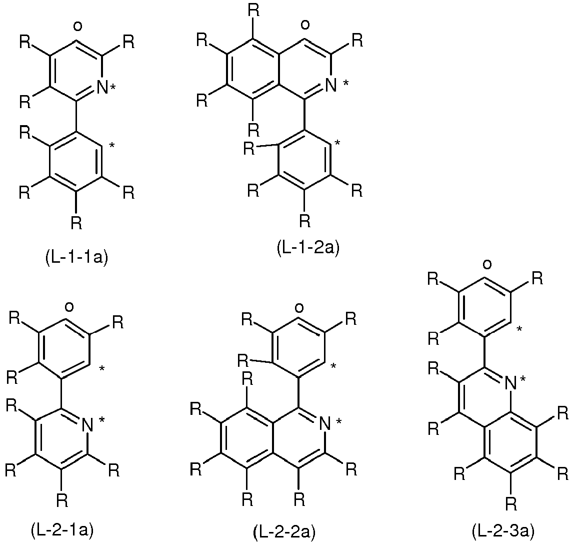 wobei die verwendeten Symbole die oben genannten Bedeutungen aufweisen und "o" die Position der Bindung an die Gruppe der Formel (2) bzw. (3) darstellt.

Ebenso können die oben genannten bevorzugten Gruppen CyD in den Teilliganden der Formel (L-3) beliebig miteinander kombiniert werden, wobei eine neutrale Gruppe CyD, also eine Gruppe (CyD-1) bis (CyD-10), (CyD-13) oder (CyD-14), mit einer anionischen Gruppe CyD, also einer Gruppe (CyD-11) oder CyD-12) kombiniert wird, sofern mindestens eine der bevorzugten Gruppen CyD eine geeignete Anknüpfungsstelle an die Gruppe der Formel (2) bzw. (3) aufweist, wobei geeignete Anknüpfungsstellen in den oben genannten Formeln mit "o" gekennzeichnet sind.

Wenn zwei Reste R, von denen einer an CyC und der andere an CyD in den Formeln (L-1) und (L-2) gebunden sind bzw. von denen einer an die eine Gruppe CyD und der andere an die andere Gruppe CyD in Formel (L-3) gebunden sind, miteinander ein aromatisches Ringsystem bilden, können sich überbrückte Teilliganden und auch Teilliganden ergeben, die insgesamt eine einzige größere Heteroarylgruppe darstellen, wie beispielsweise Benzo[h]chinolin, etc.. Die Ringbildung zwischen den Substituenten an CyC und CyD in den Formeln (L-1) und (L-2) bzw. zwischen den Substituenten an den beiden Gruppen CyD in Formel (L-3) erfolgt dabei bevorzugt durch eine Gruppe gemäß einer der folgenden Formeln (39) bis (48), 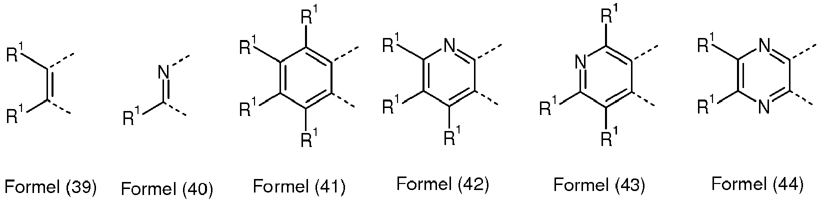 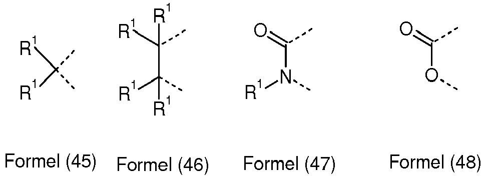 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Orientierungen eingebaut werden, beispielsweise kann bei der Gruppe der Formel (48) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (45) besonders dann bevorzugt, wenn sich dadurch die Ringbildung zu einem Sechsring ergibt, wie beispielsweise unten durch die Formeln (L-22) und (L-23) dargestellt.

Bevorzugte Liganden, die durch Ringbildung zweier Reste R an den unterschiedlichen Cyclen entstehen, sind die im Folgenden aufgeführten Strukturen der Formeln (L-4) bis (L-31), 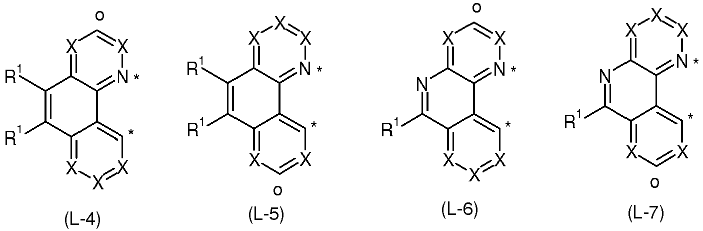 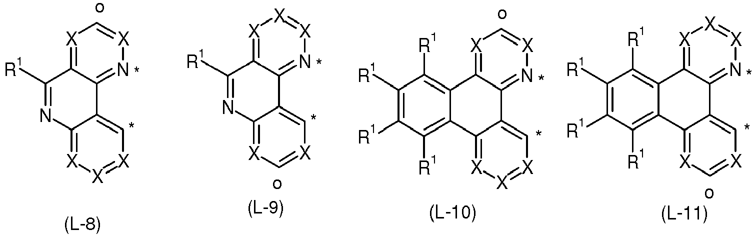 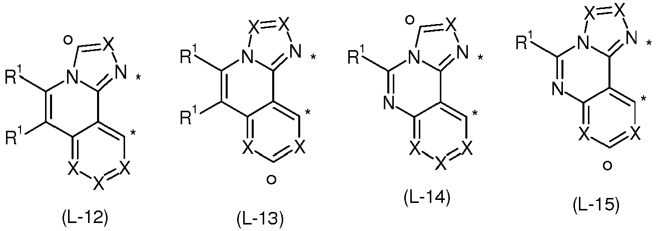 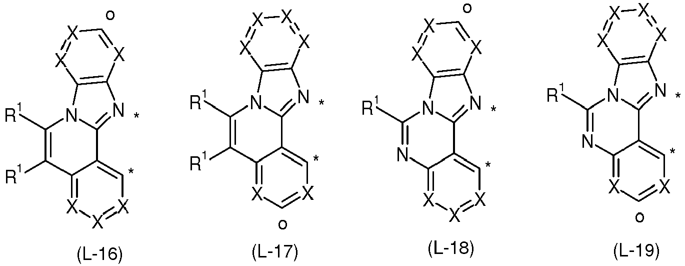 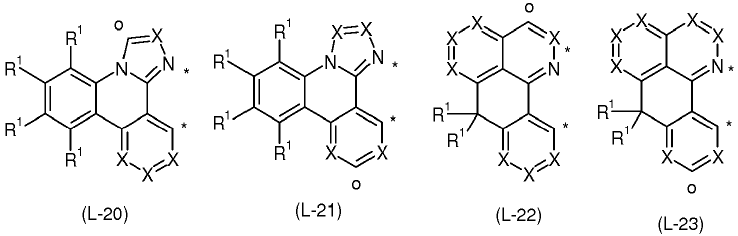 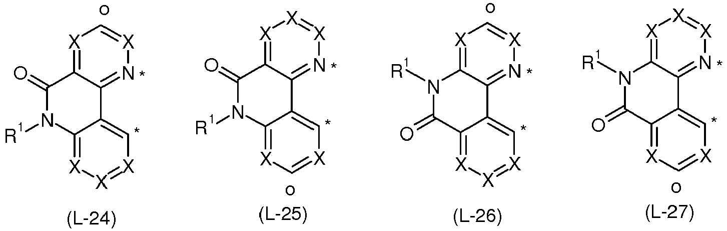 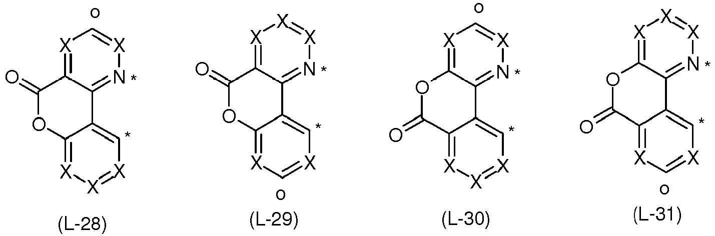 wobei die verwendeten Symbole die oben genannten Bedeutungen aufweisen und "o" die Position angibt, an denen dieser Teilligand mit der Gruppe der Formel (2) bzw. (3) verknüpft ist.

In einer bevorzugten Ausführungsform der Teilliganden der Formeln (L-4) bis (L-31) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L-1-1) bis (L-2-3), (L-4) bis (L-31) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OR¹ wobei R¹ für eine Alkylgruppe mit 1 bis 10 C-Atomen steht, Alkylgruppen mit 1 bis 10 C-Atomen, insbesondere verzweigten oder cyclischen Alkylgruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Teilligand ist der Teilligand der folgenden Formel (L-32) oder (L-33), 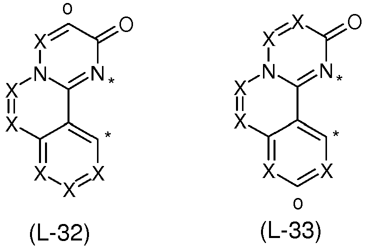 wobei R die oben genannten Bedeutungen aufweist, * die Position der Koordination an das Metall darstellt, "o" die Position der Verknüpfung des Teilliganden mit der Gruppe der Formel (2) bzw. (3) darstellt und für die weiteren verwendeten Symbole gilt:
- X: ist bei jedem Auftreten gleich oder verschieden CR oder N mit der Maßgabe, dass maximal ein Symbol X pro Cyclus für N steht und weiterhin mit der Maßgabe, dass ein Symbol X für C steht und der Teilligand über dieses Kohlenstoffatom innerhalb der Gruppe der Formel (2) bzw. (3) gebunden sind.

Wenn zwei Reste R, die in den Teilliganden (L-32) bzw. (L-33) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der folgenden Formel (49), 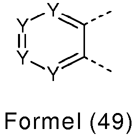 wobei die gestrichelten Bindungen die Verknüpfung dieser Gruppe im Teilliganden symbolisieren und Y gleich oder verschieden bei jedem Auftreten für CR¹ oder N steht und bevorzugt maximal ein Symbol Y für N steht. In einer bevorzugten Ausführungsform des Teilliganden (L-32) bzw. (L-33) ist maximal eine Gruppe der Formel (50) vorhanden. In einer bevorzugten Ausführungsform der Erfindung stehen im Teilliganden der Formel (L-32) und (L-33) insgesamt 0, 1 oder 2 der Symbole X und, falls vorhanden, Y für N. Besonders bevorzugt stehen insgesamt 0 oder 1 der Symbole X und, falls vorhanden, Y für N.

Weitere geeignete bidentate Teilliganden sind die Strukturen der folgenden Formeln (L-34) bis (L-38), wobei bevorzugt maximal eine der beiden bidentaten Teilliganden L pro Metall für eine dieser Strukturen steht, 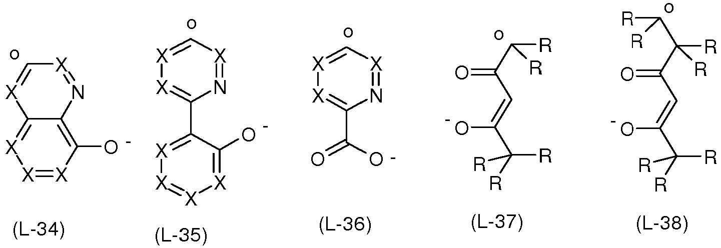 wobei die Teilliganden (L-34) bis (L-36) jeweils über das explizit eingezeichnete Stickstoffatom und das negativ geladene Sauerstoffatom und die Teilliganden (L-37) und (L-38) über die beiden Sauerstoffatome an das Metall koordinieren, X die oben genannten Bedeutungen aufweist und "o" die Position angibt, über die der Teilligand L mit der Gruppe der Formel (2) bzw. (3) verknüpft ist.

Die oben ausgeführten bevorzugten Ausführungsformen für X sind auch bevorzugt für die Teilliganden der Formeln (L-34) bis (L-36).

Bevorzugte Teilliganden der Formeln (L-34) bis (L-36) sind daher die Teilliganden der folgenden Formeln (L-34a) bis (L-36a), 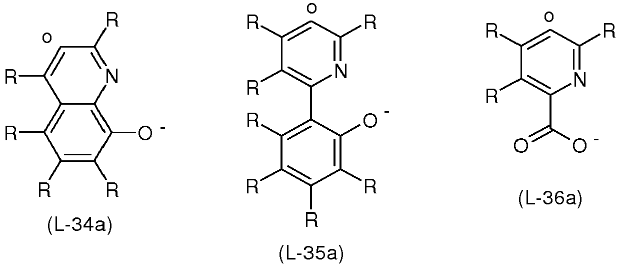 wobei die verwendeten Symbole die oben genannten Bedeutungen aufweisen und "o" die Position angibt, über die der Teilligand L mit der Gruppe der Formel (2) bzw. (3) verknüpft ist.

Besonders bevorzugt steht in diesen Formeln R für Wasserstoff, wobei "o" die Position angibt, über die der Teilligand L innerhalb der Gruppe der Formel (2) bzw. (3) bzw. den bevorzugten Ausführungsformen verknüpft ist, so dass es sich um die Strukturen der folgenden Formeln (L-34b) bis (L-36b) handelt, 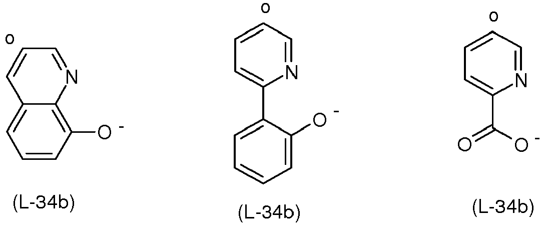 wobei die verwendeten Symbole die oben genannten Bedeutungen aufweisen.

Im Folgenden werden bevorzugte Substituenten beschrieben, wie sie an den oben beschriebenen Teilliganden, aber auch an A, wenn A für eine Gruppe der Formel (4) steht, vorliegen können.

In einer bevorzugten Ausführungsform der Erfindung enthält die erfindungsgemäße Verbindung zwei Substituenten R, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke der Formeln (2) bzw. (3) bzw. den bevorzugten Ausführungsformen vorliegen und/oder an einem oder mehreren der bidentaten Teilliganden L vorliegen. Der aliphatische Ring, der durch die Ringbildung von zwei Substituenten R miteinander gebildet wird, wird bevorzugt durch eine der folgenden Formeln (50) bis (56) beschrieben, 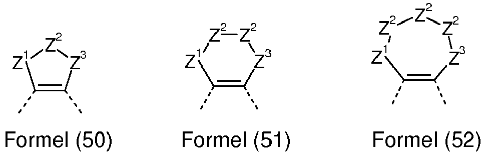 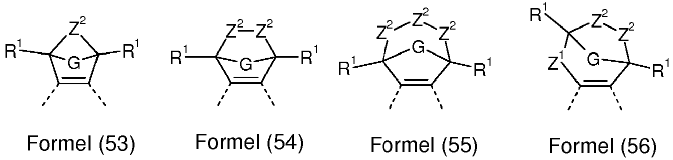 wobei R¹ und R² die oben genannten Bedeutungen aufweisen, die gestrichelten Bindungen die Verknüpfung der beiden Kohlenstoffatome im Liganden andeuten und weiterhin gilt:
- Z¹, Z³: ist gleich oder verschieden bei jedem Auftreten C(R³)₂, O, S, NR³ oder C(=O);
- Z²: ist C(R¹)₂, O, S, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine gerad-kettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryl-oxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In einer bevorzugten Ausführungsform der Erfindung ist R³ ungleich H.

In den oben abgebildeten Strukturen der Formeln (50) bis (56) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (50) bis (52) dadurch erreicht, dass Z¹ und Z³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (53) bis (56) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (53) bis (56) für H steht, handelt es sich dabei daher um ein nicht-azides Proton im Sinne der vorliegenden Anmeldung.

In einer bevorzugten Ausführungsform der Struktur gemäß Formel (50) bis (56) steht maximal eine der Gruppen Z¹, Z² und Z³ für ein Heteroatom, insbesondere für O oder NR³, und die anderen Gruppen stehen für C(R³)₂ bzw. C(R¹)₂ oder Z¹ und Z³ stehen gleich oder verschieden bei jedem Auftreten für O oder NR³ und Z² steht für C(R¹)₂. In einer besonders bevorzugten Ausführungsform der Erfindung stehen Z¹ und Z³ gleich oder verschieden bei jedem Auftreten für C(R³)₂ und Z² steht für C(R¹)₂ und besonders bevorzugt für C(R³)₂ oder CH₂.

Bevorzugte Ausführungsformen der Formel (50) sind somit die Strukturen der Formel (50-A), (50-B), (50-C) und (50-D), und eine besonders bevorzugte Ausführungsform der Formel (50-A) sind die Strukturen der Formel (50-E) und (50-F), 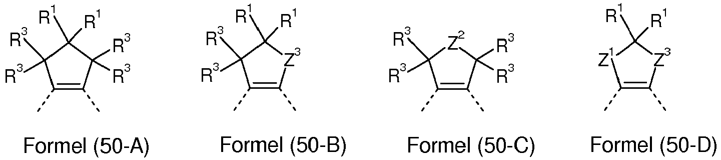 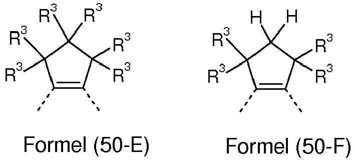 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (51) sind die Strukturen der folgenden Formeln (51-A) bis (51-F), 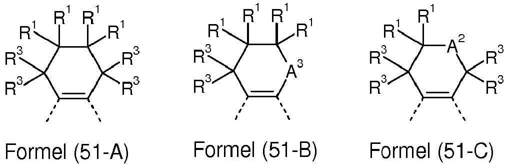 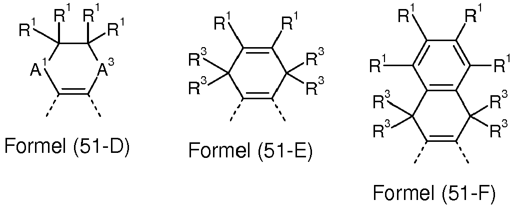 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (52) sind die Strukturen der folgenden Formeln (52-A) bis (52-E), 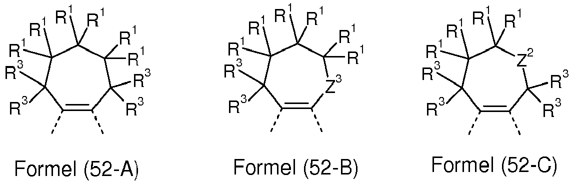 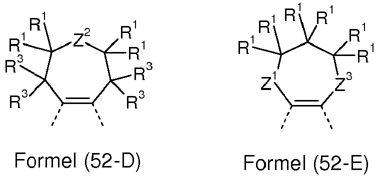 wobei R¹ und R³ die oben genannten Bedeutungen aufweisen und Z¹, Z² und Z³ gleich oder verschieden bei jedem Auftreten für O oder NR³ steht.

In einer bevorzugten Ausführungsform der Struktur gemäß Formel (53) stehen die Reste R¹, die an den Brückenkopf gebunden sind, für H, D, F oder CH₃. Weiterhin bevorzugt steht Z² für C(R¹)₂ oder O, und besonders bevorzugt für C(R³)₂. Bevorzugte Ausführungsformen der Formel (53) sind somit eine Strukturen der Formel (53-A) und (53-B), und eine besonders bevorzugte Ausführungsform der Formel (53-A) ist eine Struktur der Formel (53-C), 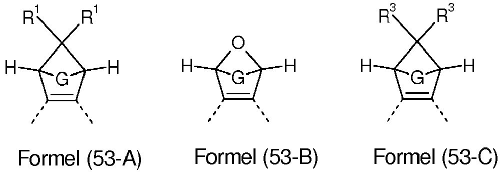 wobei die verwendeten Symbole die oben genannten Bedeutungen aufweisen.

In einer bevorzugten Ausführungsform der Struktur gemäß Formel (54), (55) und (56) stehen die Reste R¹, die an den Brückenkopf gebunden sind, für H, D, F oder CH₃. Weiterhin bevorzugt steht Z² für C(R¹)₂. Bevorzugte Ausführungsformen der Formel (54), (55) und (56) sind somit die Strukturen der Formeln (54-A), (55-A) und (56-A), 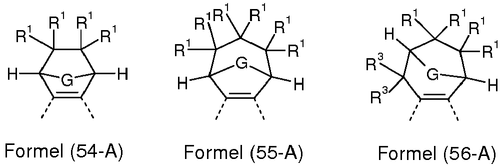 wobei die verwendeten Symbole die oben genannten Bedeutungen aufweisen.

Weiterhin bevorzugt steht die Gruppe G in den Formeln (53), (53-A), (53-B), (53-C), (54), (54-A), (55), (55-A), (56) und (56-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (50) bis (56) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (50) bis (56) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (50) sind die im Folgenden abgebildeten Gruppen:

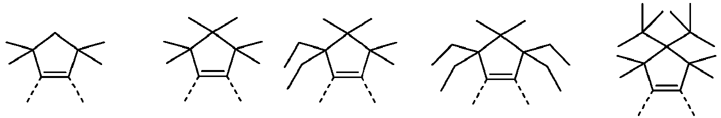

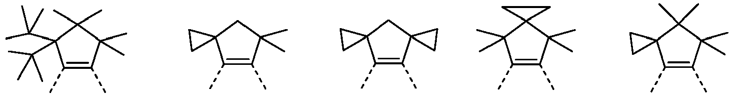

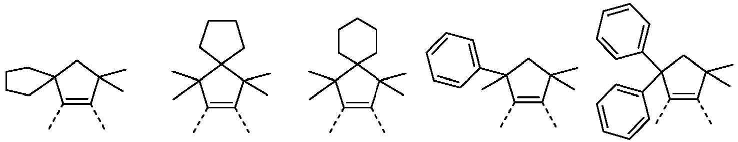

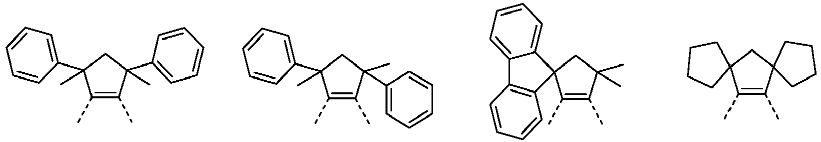

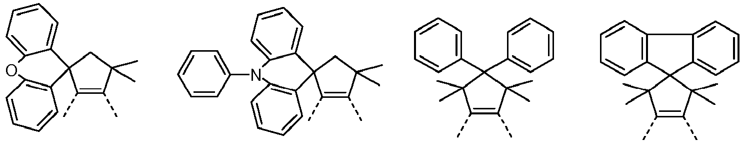

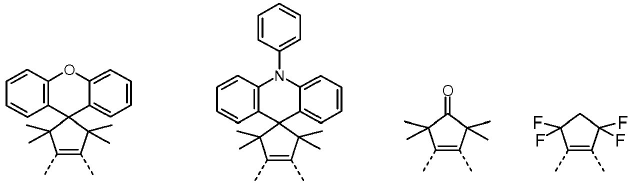

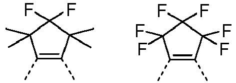

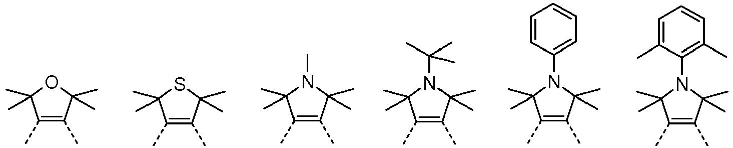

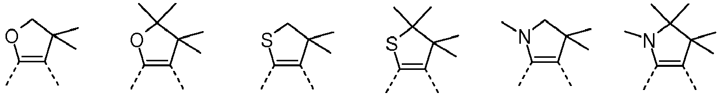

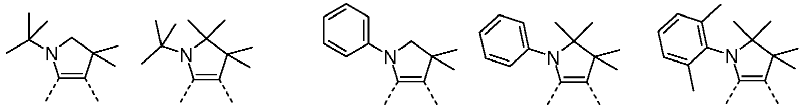

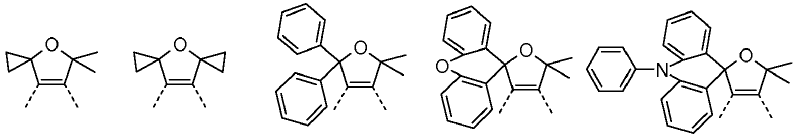

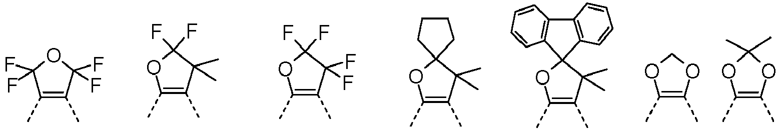

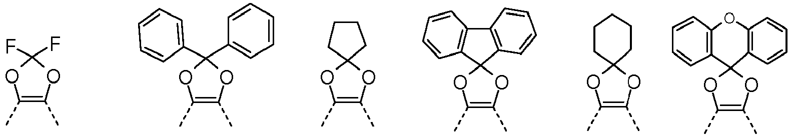

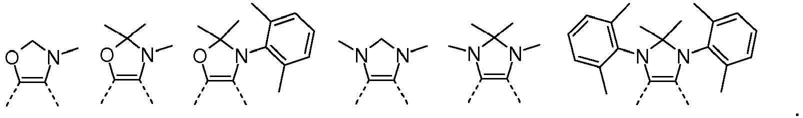

Beispiele für besonders geeignete Gruppen der Formel (51) sind die im Folgenden abgebildeten Gruppen:

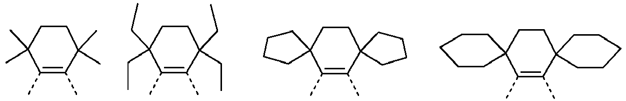

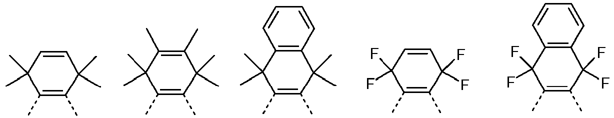

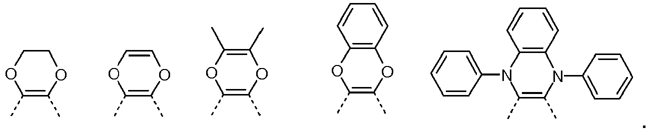

Beispiele für besonders geeignete Gruppen der Formel (52), (55) und (56) sind die im Folgenden abgebildeten Gruppen:

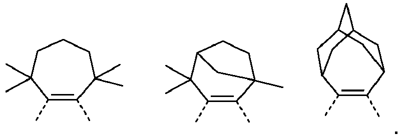

Beispiele für besonders geeignete Gruppen der Formel (53) sind die im Folgenden abgebildeten Gruppen:

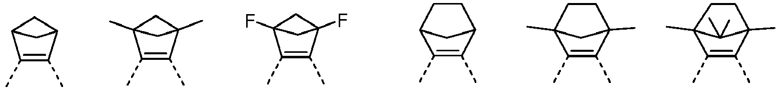

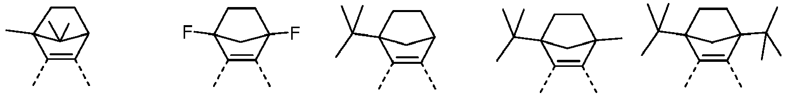

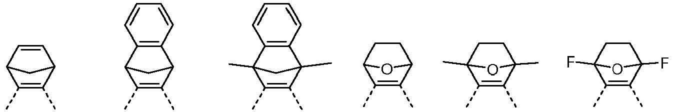

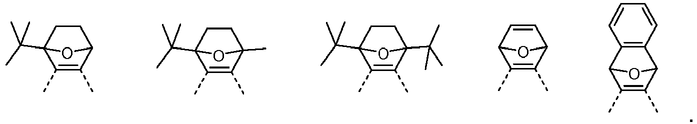

Beispiele für besonders geeignete Gruppen der Formel (54) sind die im Folgenden abgebildeten Gruppen:

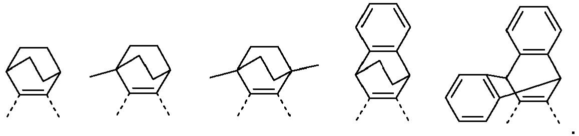

Wenn in den bidentaten Teilliganden bzw. Liganden bzw. in den bivalenten Arylen- bzw. Heteroarylengruppen der Formel (4), welche in den Formeln (2) bzw. (3) bzw. den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, OR¹, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, bevorzugt mit 6 bis 13 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, OR², CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, bevorzugt mit 6 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Beispiele für erfindungsgemäße bimetallische Komplexe sind die nachfolgend aufgeführten Strukturen.

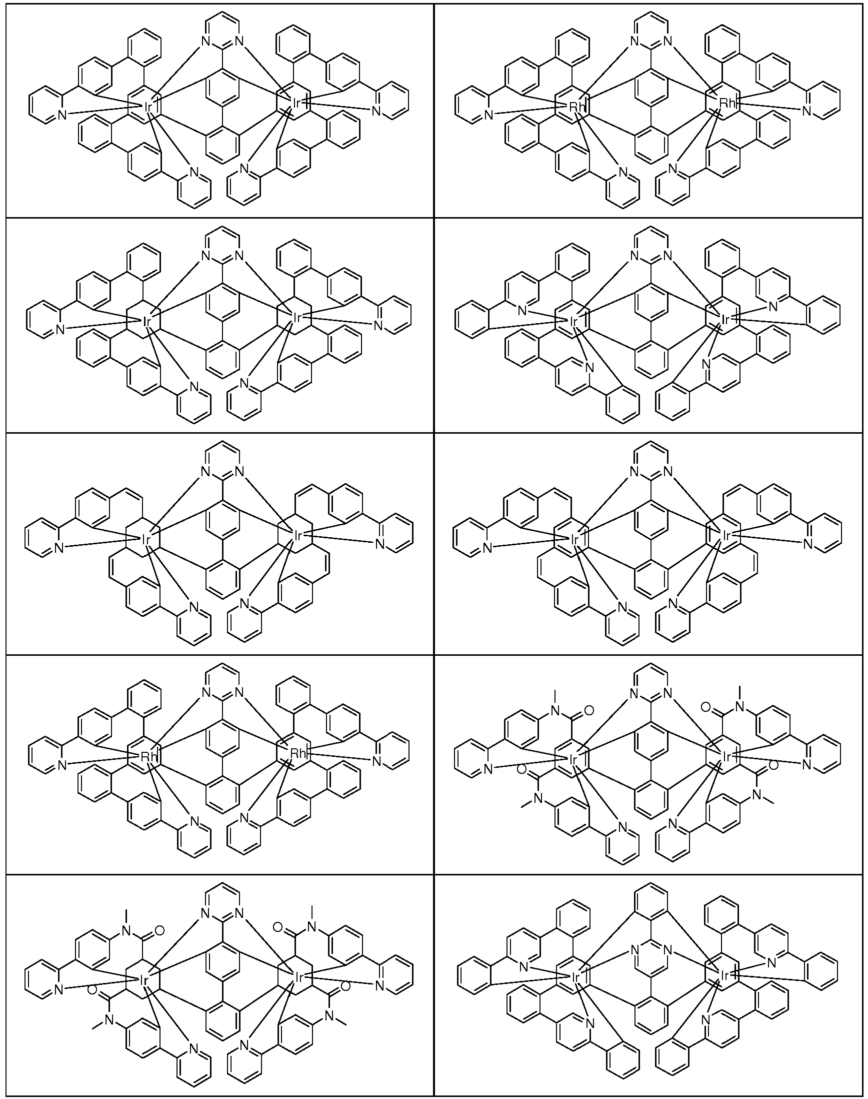

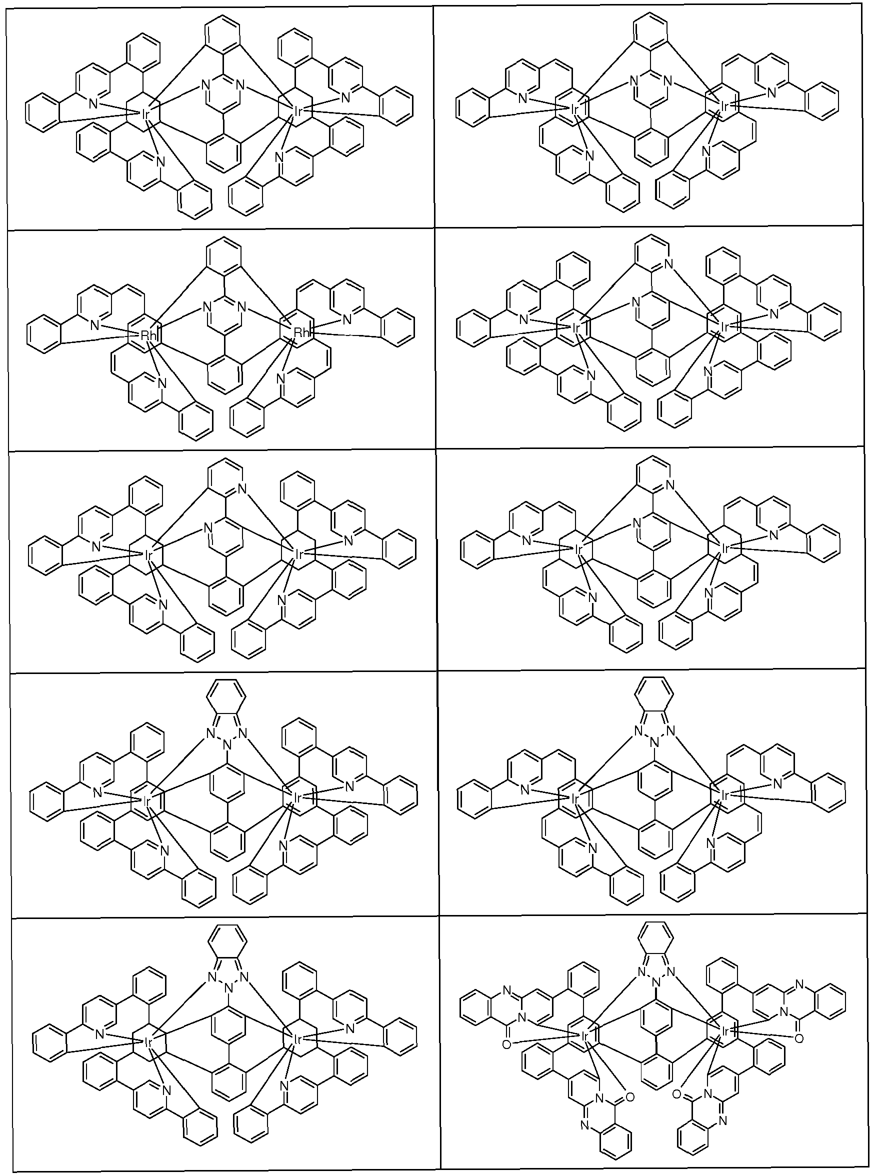

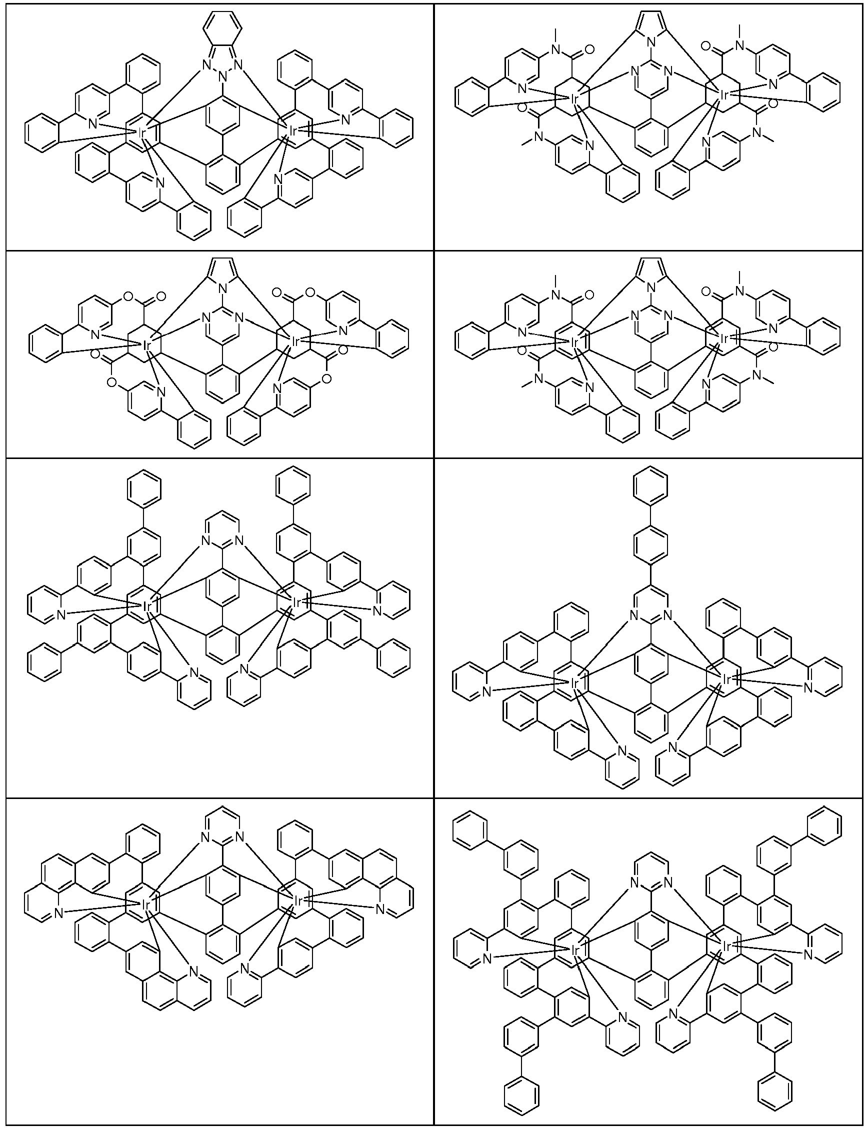

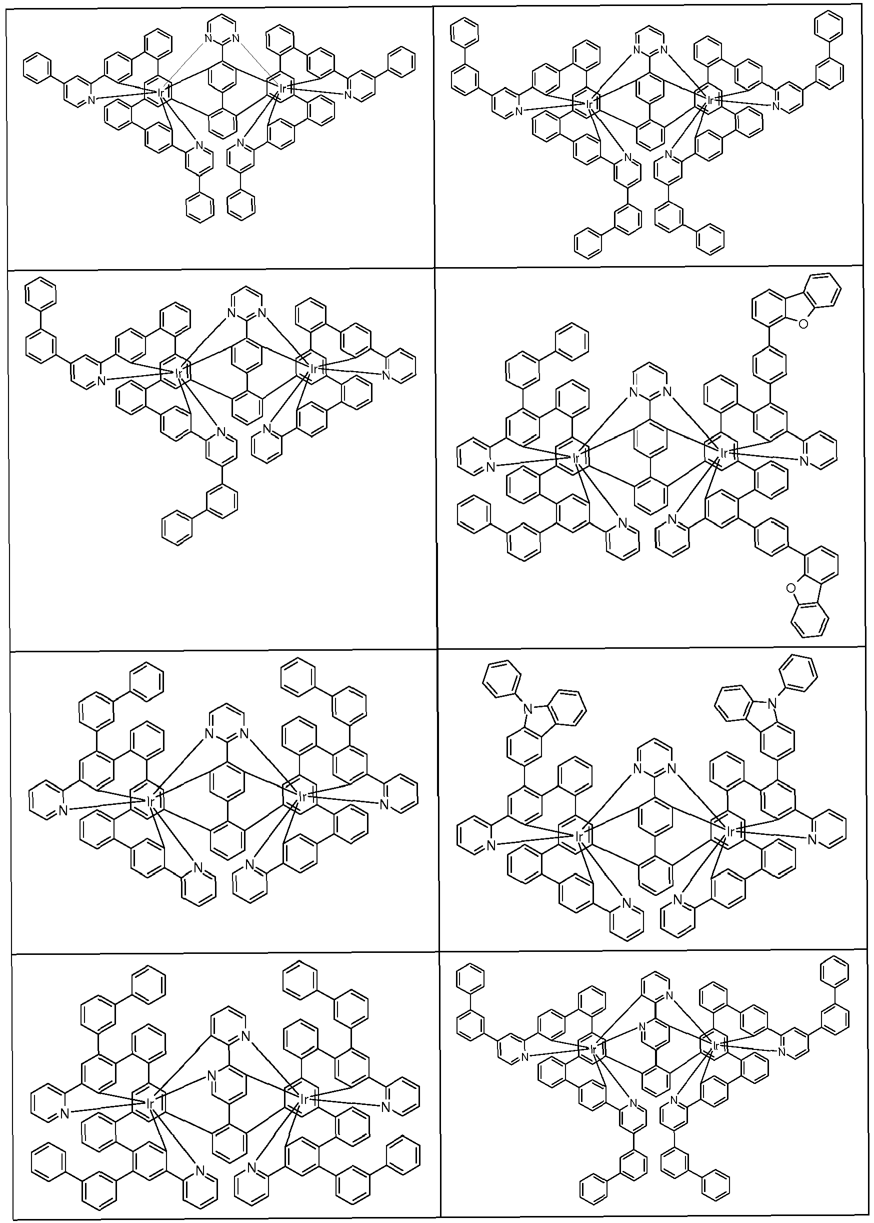

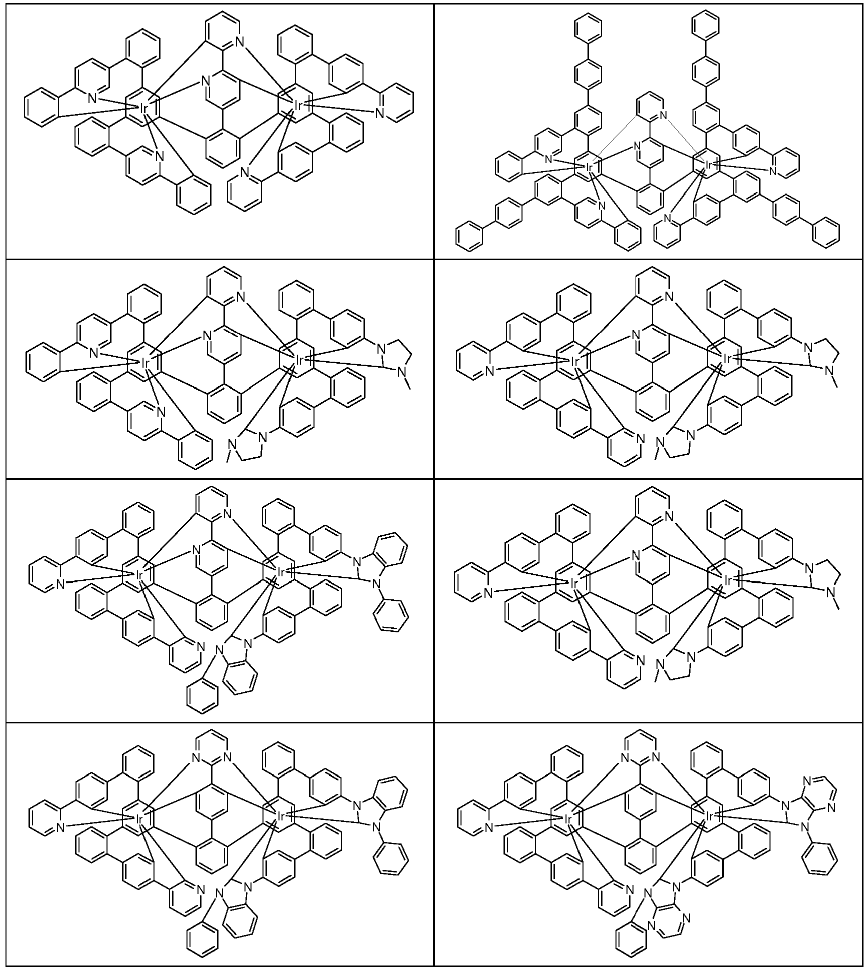

Bei den erfindungsgemäßen Verbindungen handelt es sich um chirale Strukturen. Je nach genauer Struktur der Komplexe und Liganden ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Bei der ortho-Metallierungsreaktion der Liganden fallen die zugehörigen bimetallischen Komplexe typischerweise als Gemisch aus ΛΛ- und ΔΔ-Isomeren sowie ΔΛ- und ΛΔ-Isomeren an. ΛΛ- und ΔΔ-Isomer bilden ein Enantiomerenpaar ebenso wie das ΔΛ- und ΛΔ-Isomer. Die Diastereomerenpaare können mit herkömmlichen Methoden, z. B. chromatographisch oder durch fraktionierte Kristallisation, getrennt werden. Je nach Symmetrie der Liganden können Stereozentren zusammenfallen, so dass auch Mesoformen möglich sind. So fallen z. B. bei der ortho-Metallierung von C₂ᵥ oder Cₛ symmetrischen Liganden typischerweise ΛΛ- und ΔΔ-Isomere (Racemat, C₂-symmetrisch) und ein ΛΔ-Isomer (Mesoverbindung, Cₛ-symmetrisch) an.

Üblicherweise fallen die Komplexe bei der ortho-Metallierung als Gemisch aus Diastereomerenpaaren an. Es gibt jedoch auch die Möglichkeit, nur eines der Diastereomerenpaare gezielt zu synthetisieren, da sich das andere, je nach Ligandenstruktur, aus sterischen Gründen nicht oder nur in geringen Mengen bildet. Dies soll anhand des folgenden Beispiels aufgezeigt werden.

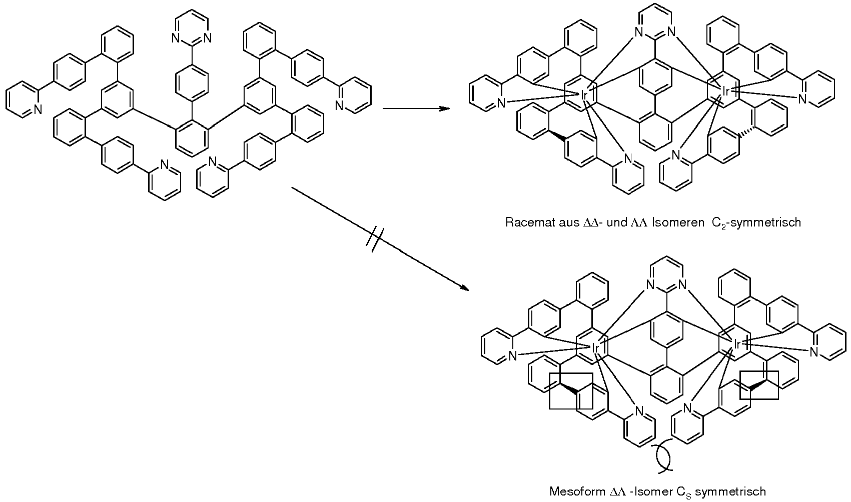

Aufgrund der ungünstigen sterischen Wechselwirkung zweier Phenylpyridinliganden im Falle des ΔΛ-Isomers (beide Liganden stehen aufeinander zu, aus der Zeichenebene heraus) bildet sich das ΔΛ-Isomer (Mesoform) nicht. Es ensteht bei der ortho-Metallierung des Liganden nur das Racemat aus ΔΔ- und ΛΛ-Isomeren.

Die Racemattrennung der ΔΔ- und ΛΛ-Isomere kann via fraktionierter Kristallisation von diastereomeren Salzpaaren oder an chiralen Säulen nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(III)/Ir(IV)- oder die zweifach kationischen Ir(IV)/Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu dem enantiomerenreinen neutralen Komplex zu reduzieren, wie im Folgenden schematisch dargestellt. 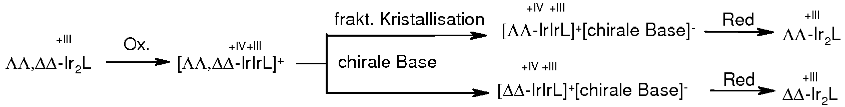 oder

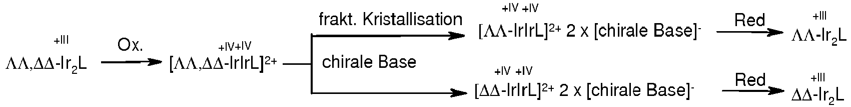

Enantiomerenreine Komplexe können auch gezielt synthetisiert werden, wie im folgenden Schema dargestellt. Dazu wird, wie oben beschrieben, das bei der ortho-Metallierung entstehende Isomerenpaar bromiert und dann mit einer Boronsäure R*A-B(OH)₂ enthaltend einen chiralen Rest R* (bevorzugt >99% Enantiomerenüberschuss) via Kreuzkupplungsreaktion umgesetzt, wie allgemein in der noch nicht offen gelegten Anmeldung EP 16177095.3 beschrieben. Die enstehenden Diastereomerenpaare können chromatographisch an Kieselgel oder durch fraktionierte Kristallisation nach üblichen Methoden getrennt werden. So werden enantiomeren-angereicherte bzw. enantiomerenreine Komplexe erhalten.

Anschließend kann die chirale Gruppe optional abgespalten werden oder auch im Molkül verbleiben.

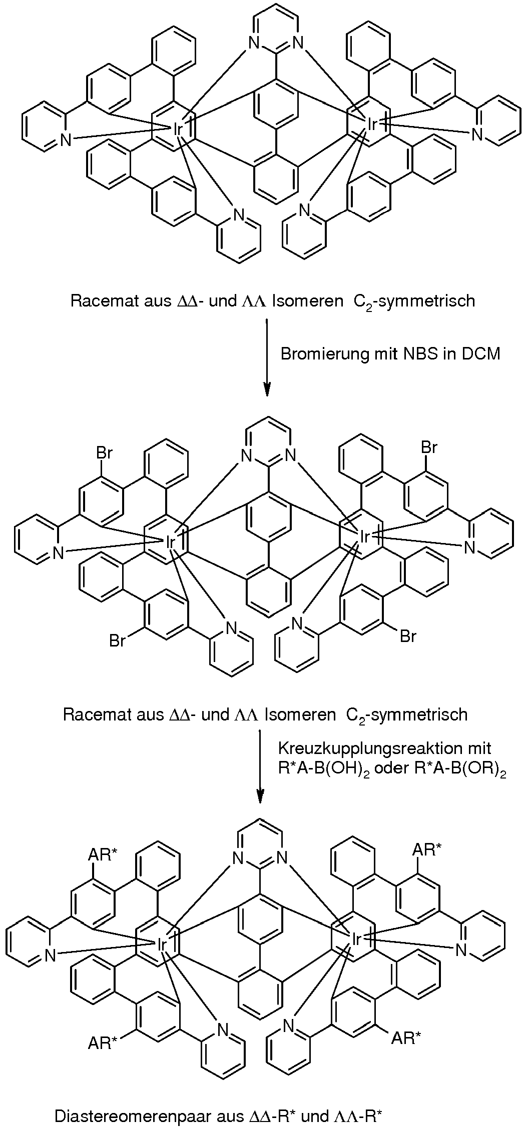

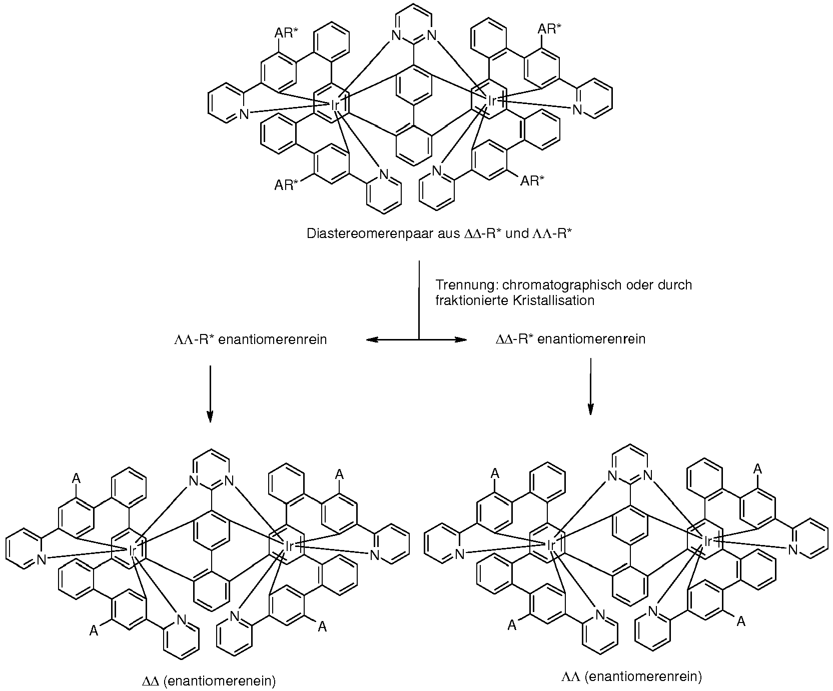

Die erfindungsgemäßen Komplexe können insbesondere durch den nachfolgend beschriebenen Weg dargestellt werden. Dazu wird der 12-zähnige Ligand dargestellt und dann an die Metalle M durch eine ortho-Metallierungsreaktion koordiniert. Generell wird hierzu ein Iridium- bzw. Rhodiumsalz mit dem entsprechenden freien Liganden umgesetzt.

Daher ist ein weiterer Gegenstand der vorliegenden Erfindung ein Verfahren zur Herstellung der erfindungsgemäßen Verbindung durch Umsetzung der entsprechenden freien Liganden mit Metallalkoholaten der Formel (57), mit Metallketoketonaten der Formel (58), mit Metallhalogeniden der Formel (59) oder mit Metallcarboxylaten der Formel (60), 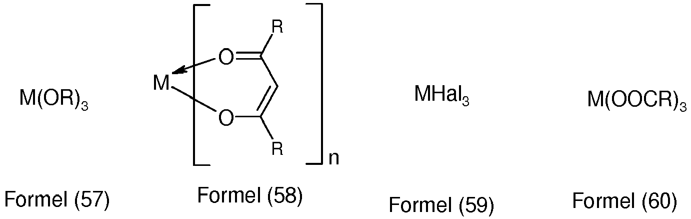 wobei M und R die oben angegebenen Bedeutungen aufweisen, Hal = F, Cl, Br oder I ist und die Iridium- bzw. Rhodiumedukte auch als die entsprechenden Hydrate vorliegen können. Dabei steht R bevorzugt für eine Alkylgruppe mit 1 bis 4 C-Atomen.

Es können ebenfalls Iridium- bzw. Rhodiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris-(2,2,6,6-Tetramethylheptan-3,5-dionato)iridium, und IrCl₃·xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, Hydrochinon, etc.. Dabei ist die Verwendung von Hydrochinon besonders bevorzugt.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (50) bis (56) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die erfindungsgemäße Verbindung kann in der elektronischen Vorrichtung als aktive Komponente oder als Sauerstoff-Sensibilisatoren verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen Infrarot-Elektrolumineszenzsensoren, organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen (Grätzel-Zellen) verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen bzw. Systeme, welche mehr als drei emittierende Schichten aufweisen. Weiterhin bevorzugt sind Tandem-OLEDs Es kann sich auch um ein Hybrid-System handeln, wobei eine oder mehrere Schichten fluoreszieren und eine oder mehrere andere Schichten phosphoreszieren. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Metallkomplex und dem Matrixmaterial enthält zwischen 0.1 und 99 Gew.-%, vorzugsweise zwischen 1 und 90 Gew.-%, besonders bevorzugt zwischen 3 und 40 Gew.-%, insbesondere zwischen 5 und 25 Gew.-% des erfindungsgemäßen Metallkomplexes bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 95 und 75 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Biscarbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat, insbesondere einem Biscarbazol-Derivat, als gemischte Matrix für die erfindungsgemäße Verbindung. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Nachfolgend sind Beispiele für Verbindungen abgebildet, die sich als Matrixmaterialien für die erfindungsgemäßen Verbindungen eignen.

Beispiele für Triazine und Pyrimidine, welche als elektronentransportierende Matrixmaterialien eingesetzt werden können, sind die folgenden Verbindungen:

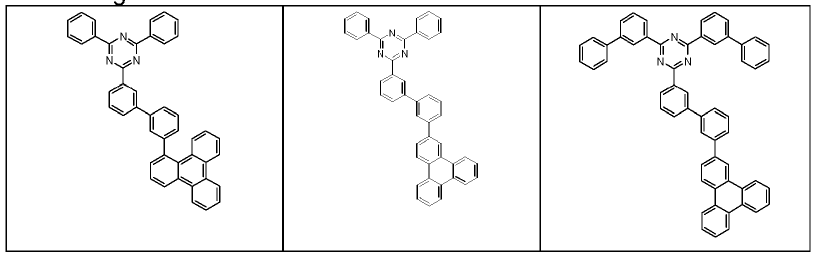

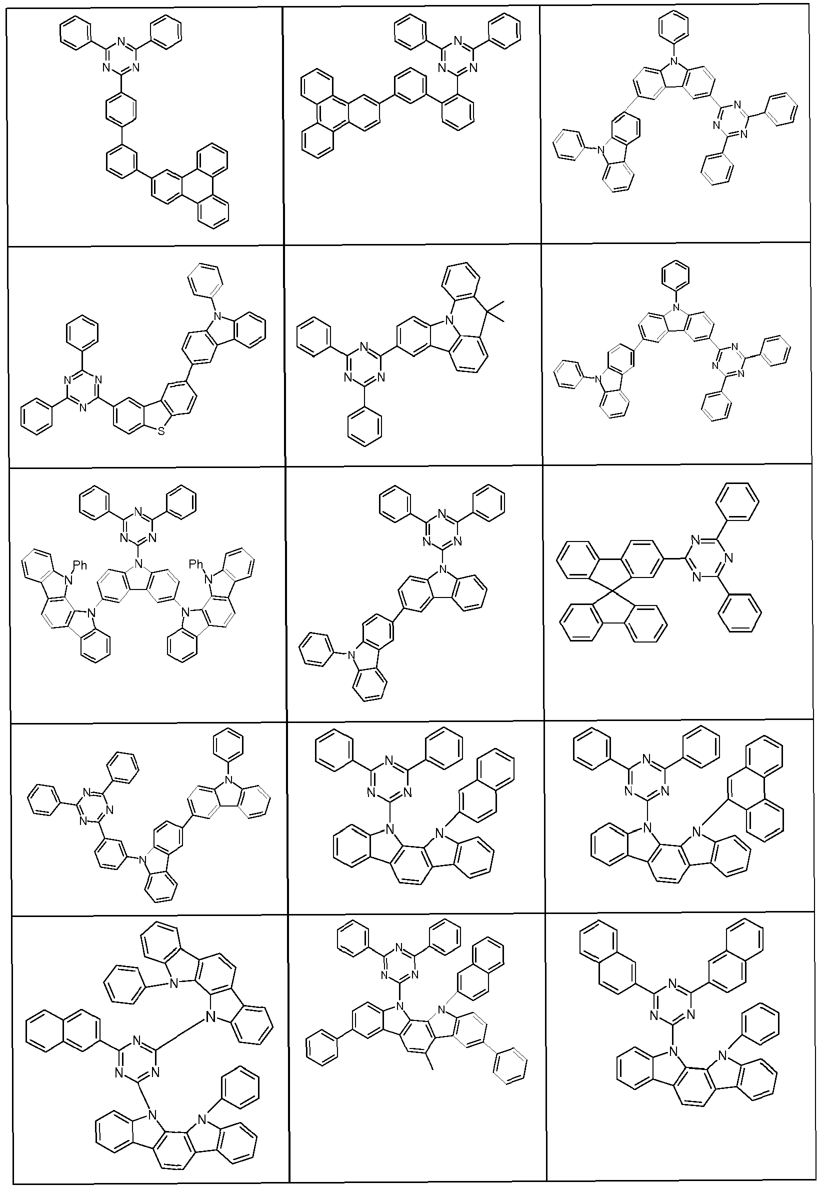

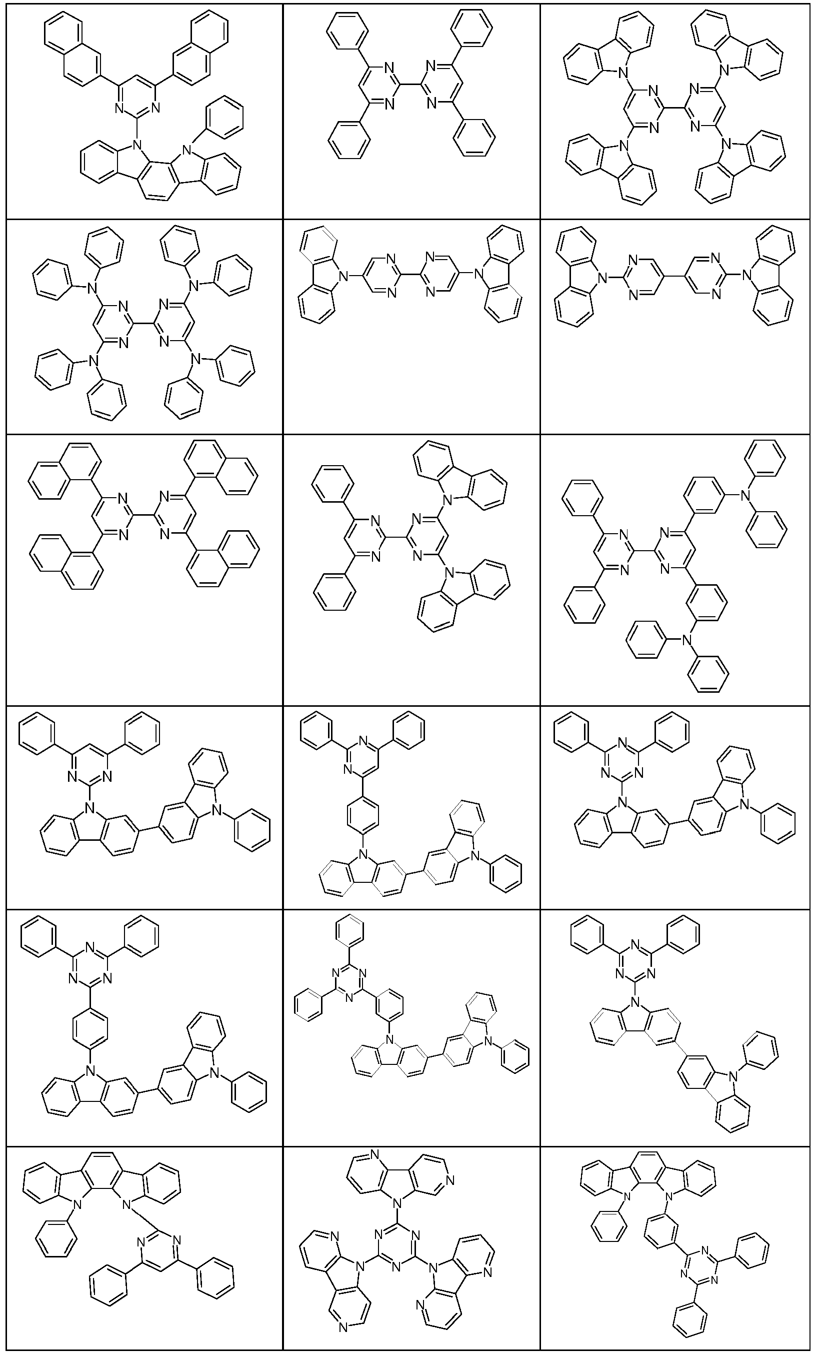

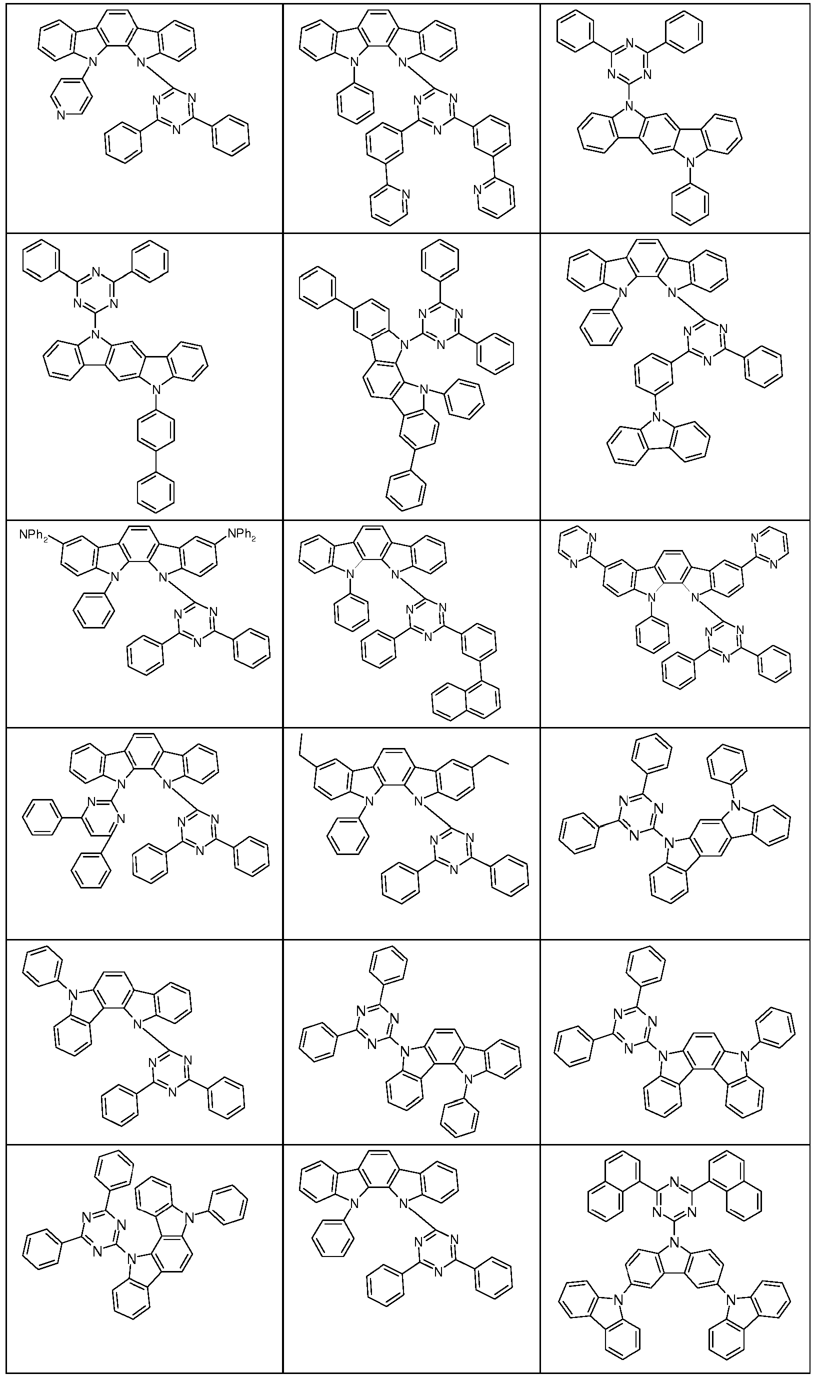

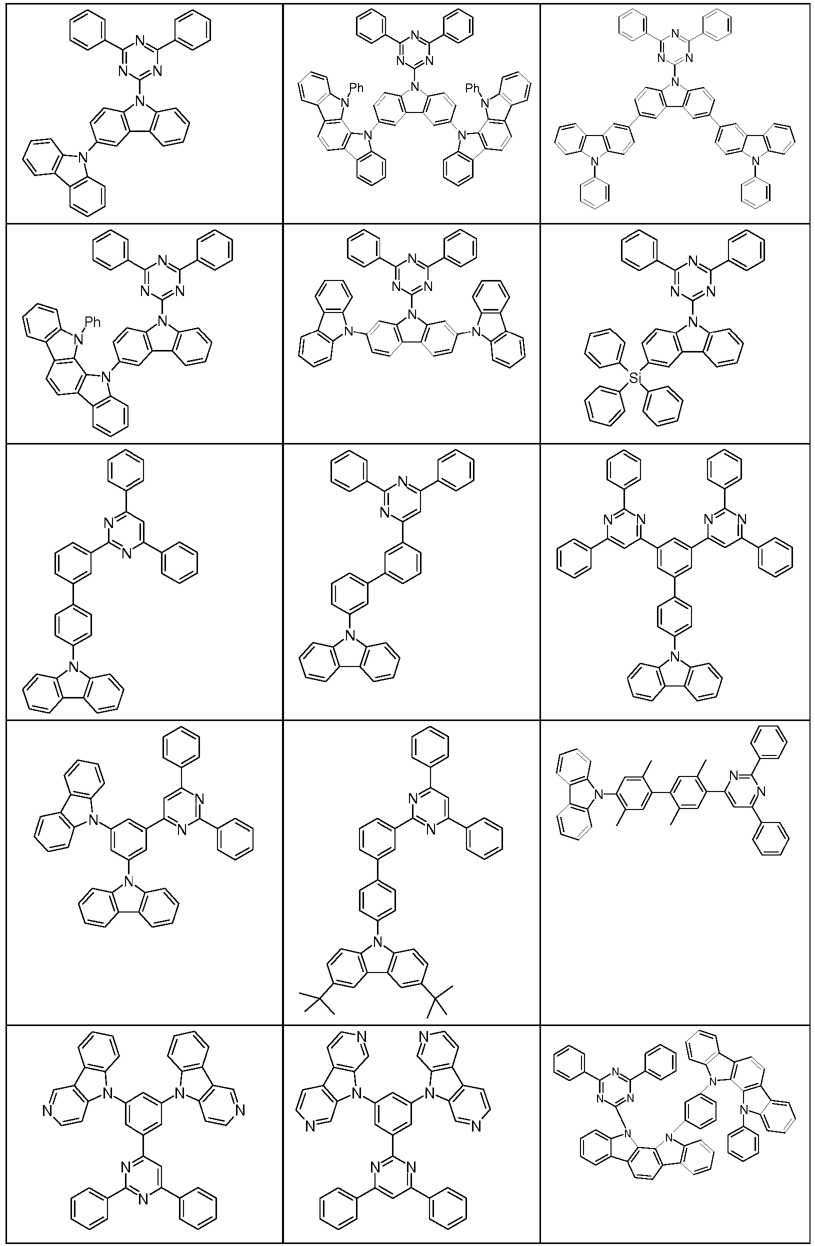

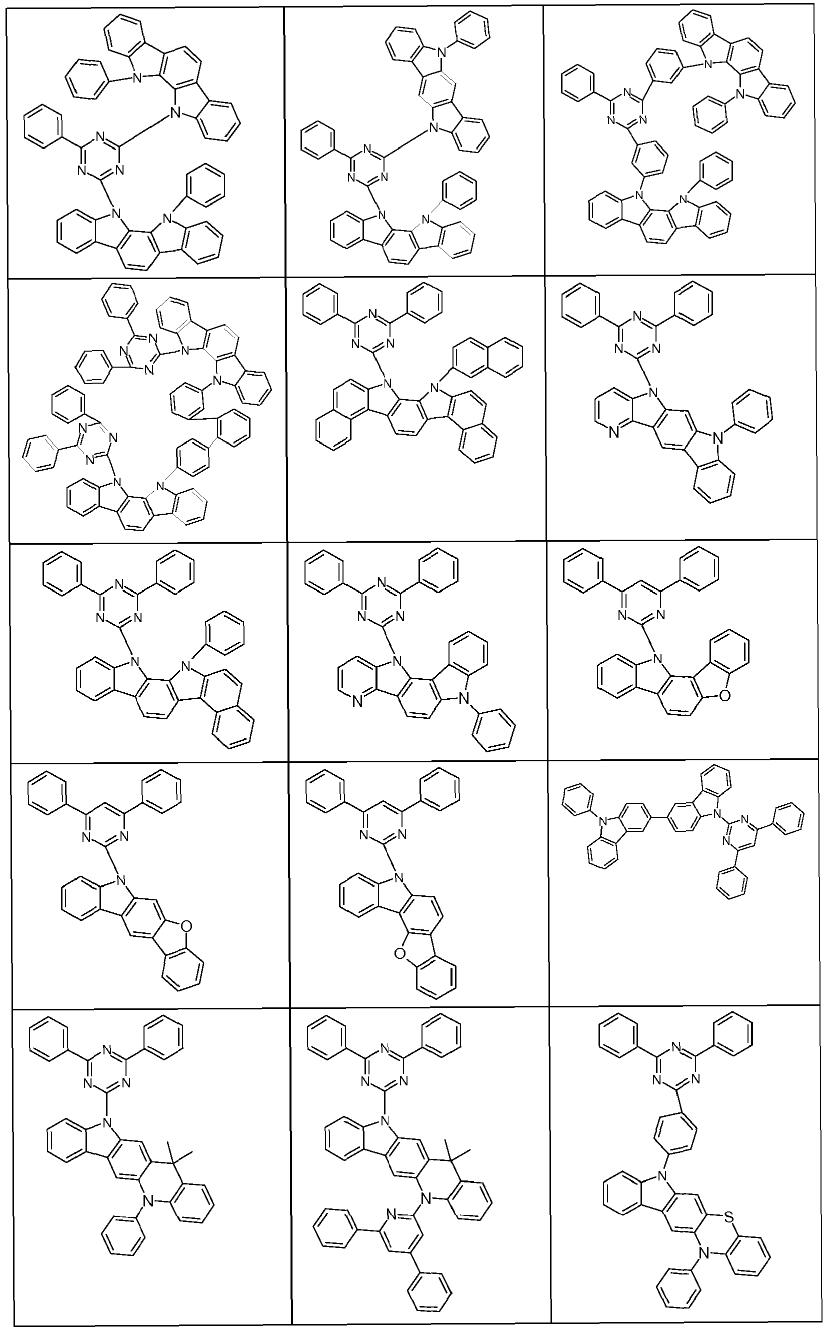

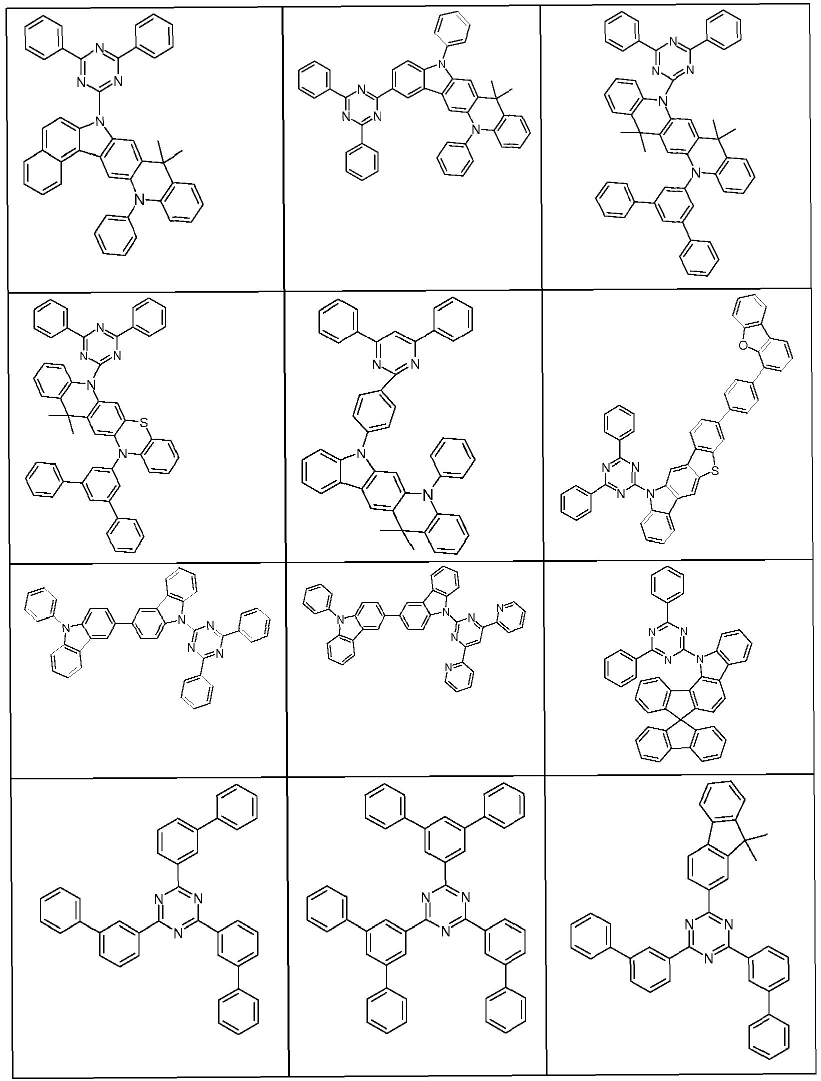

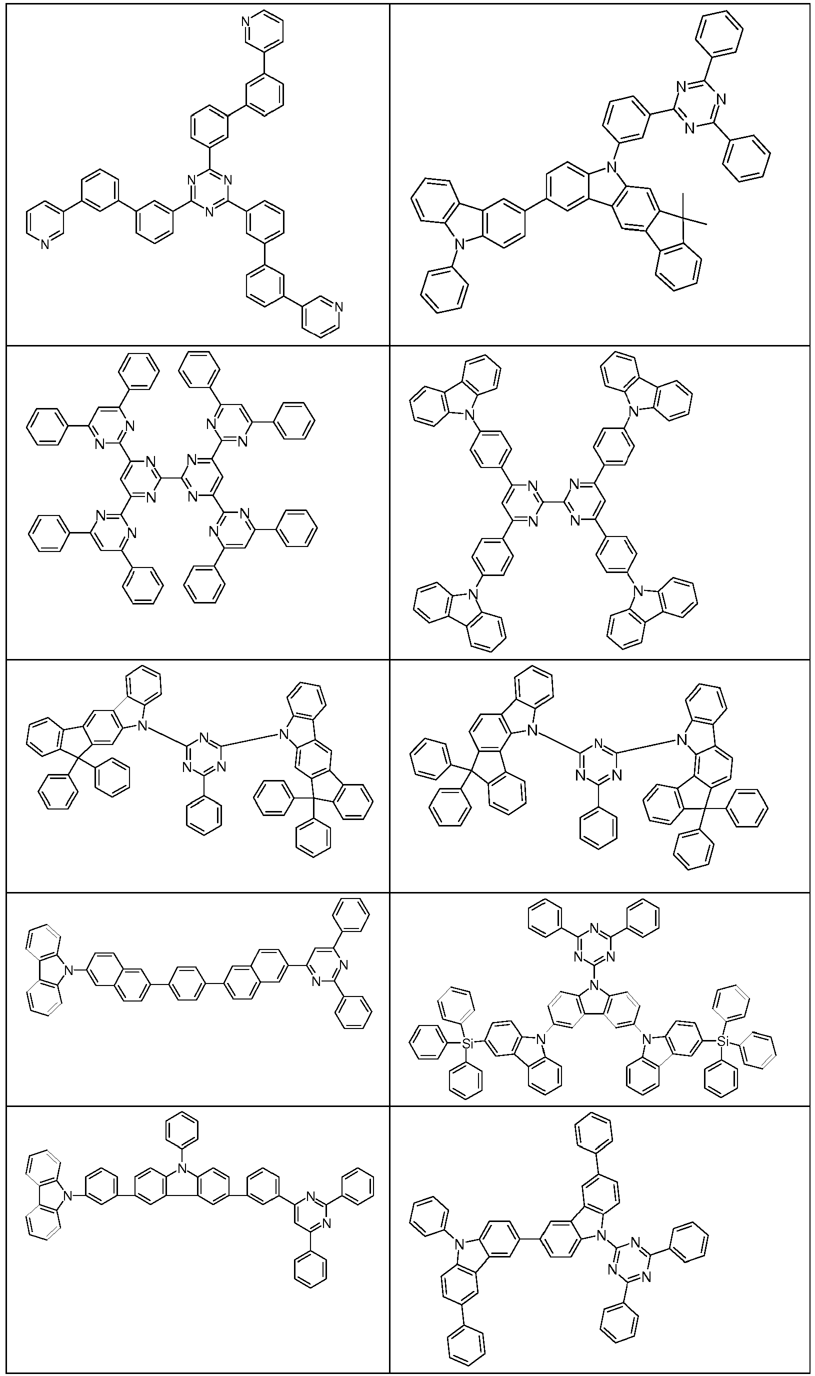

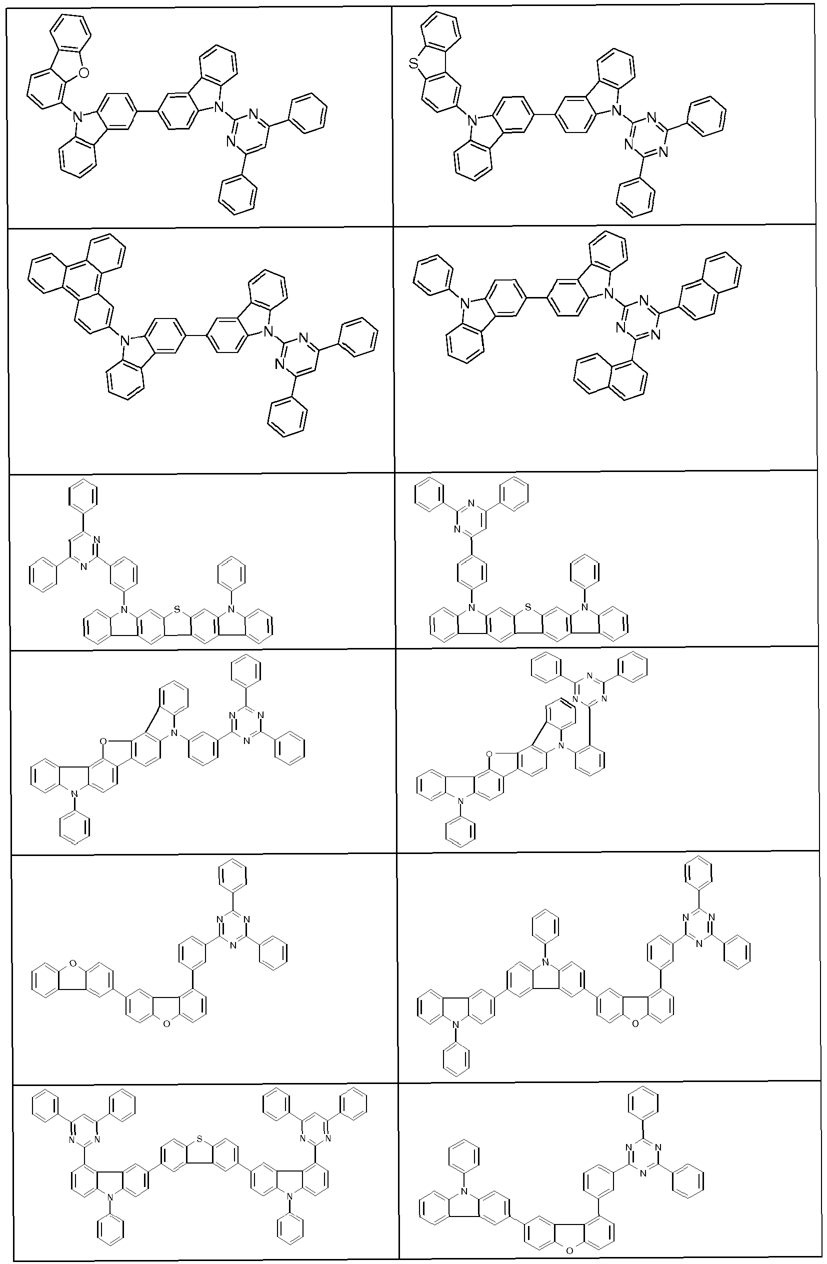

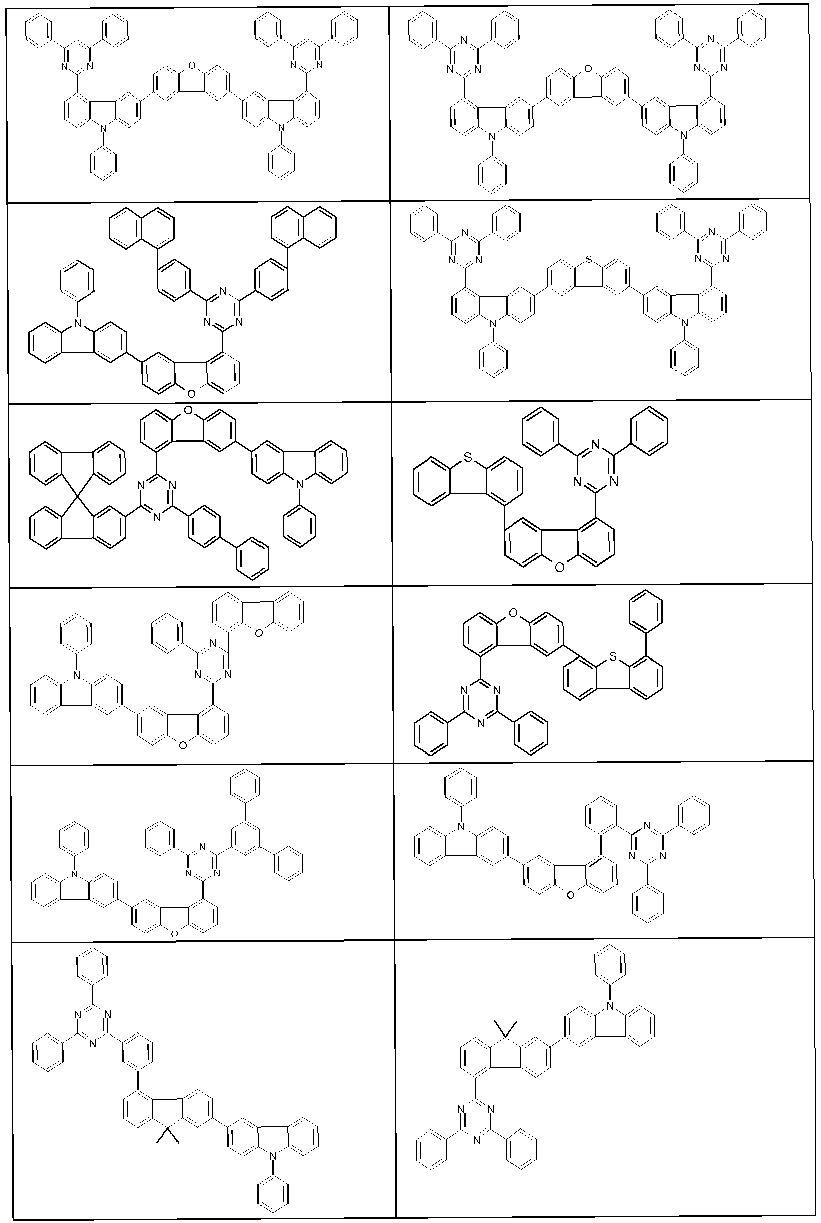

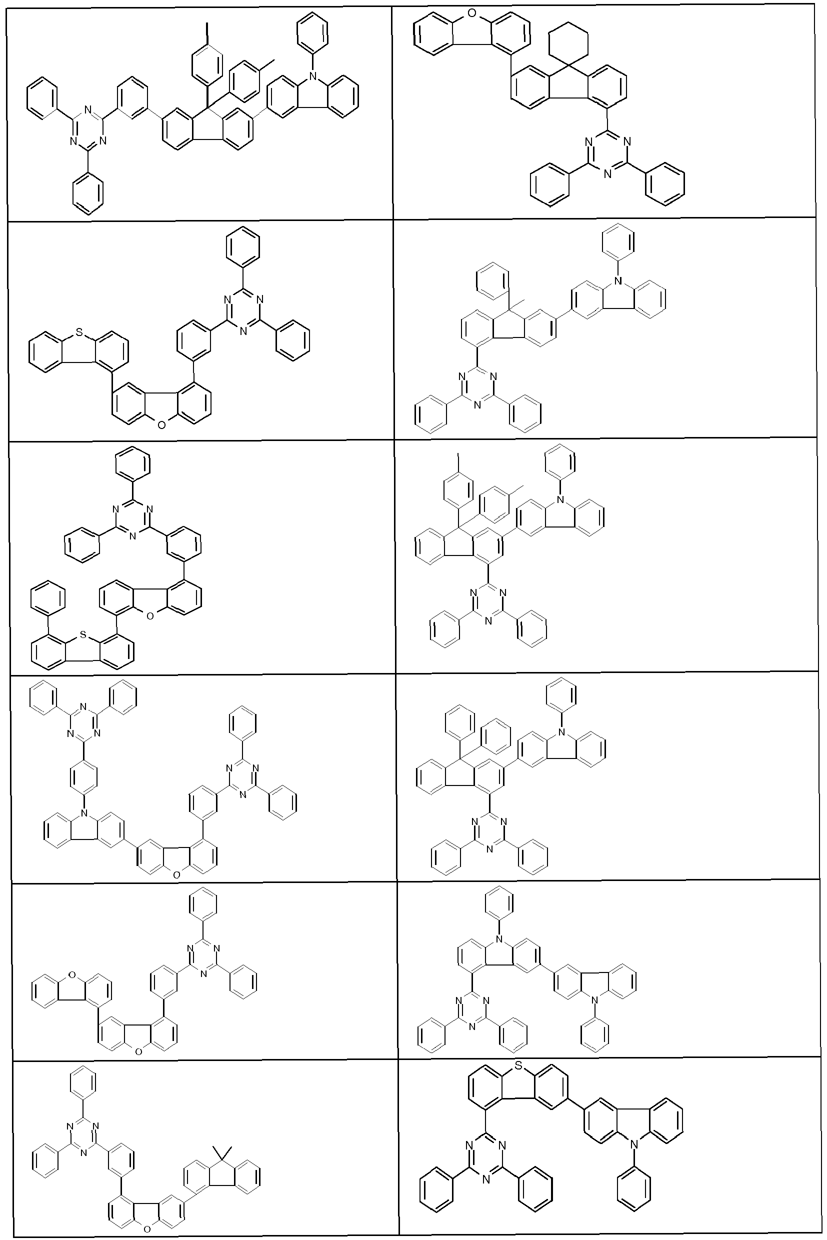

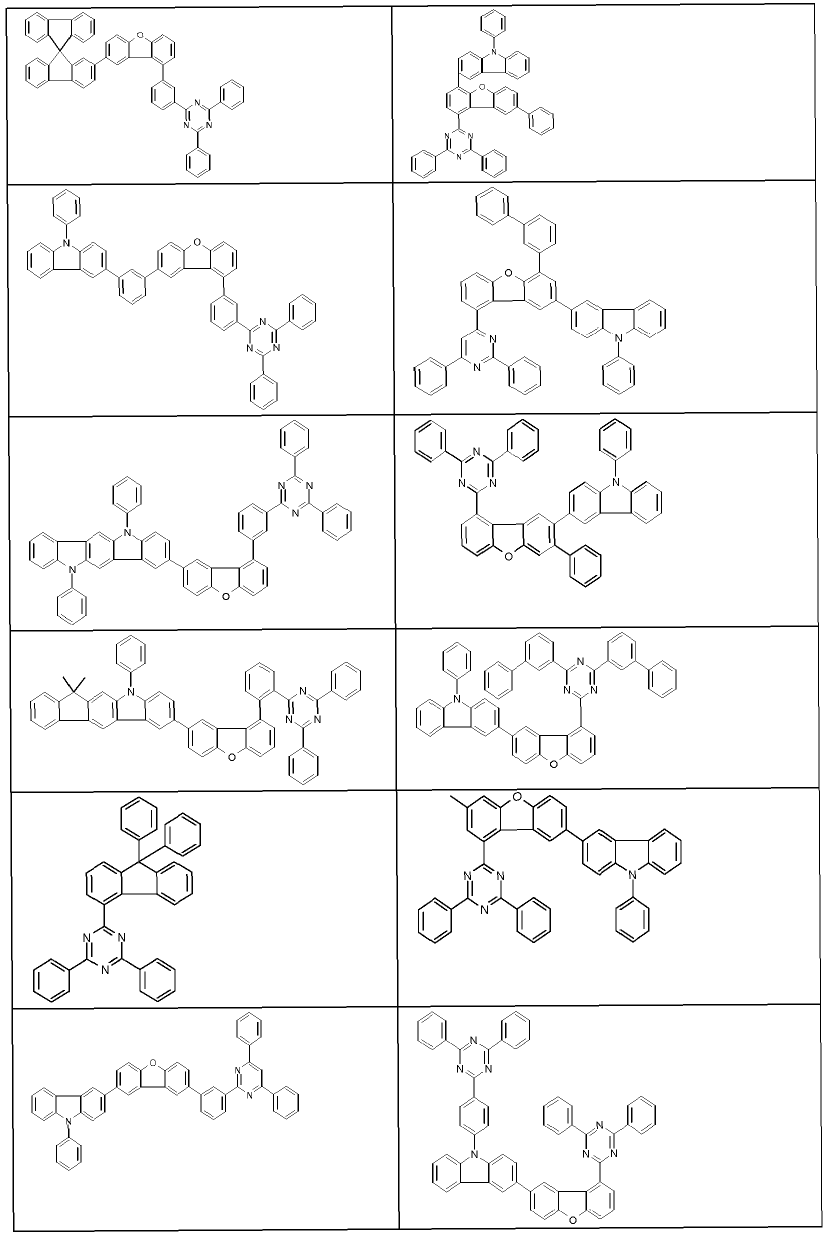

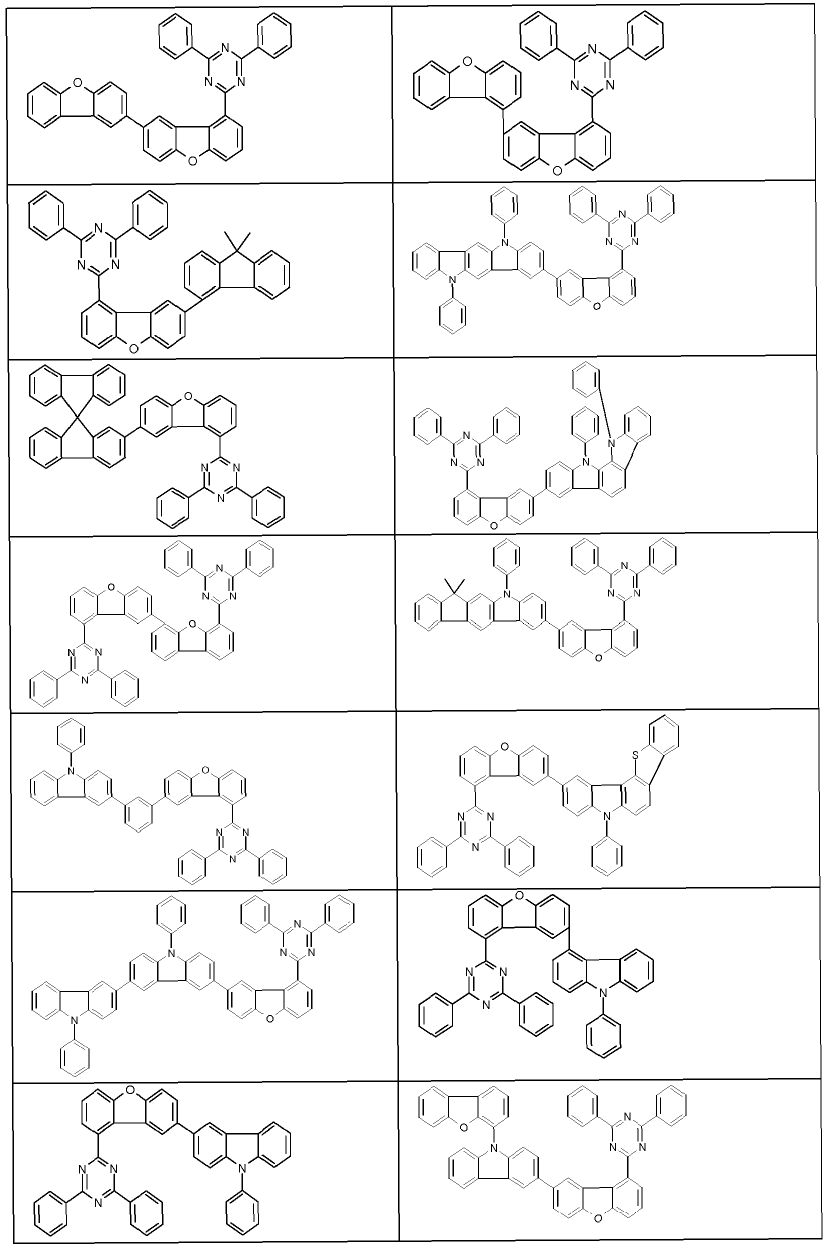

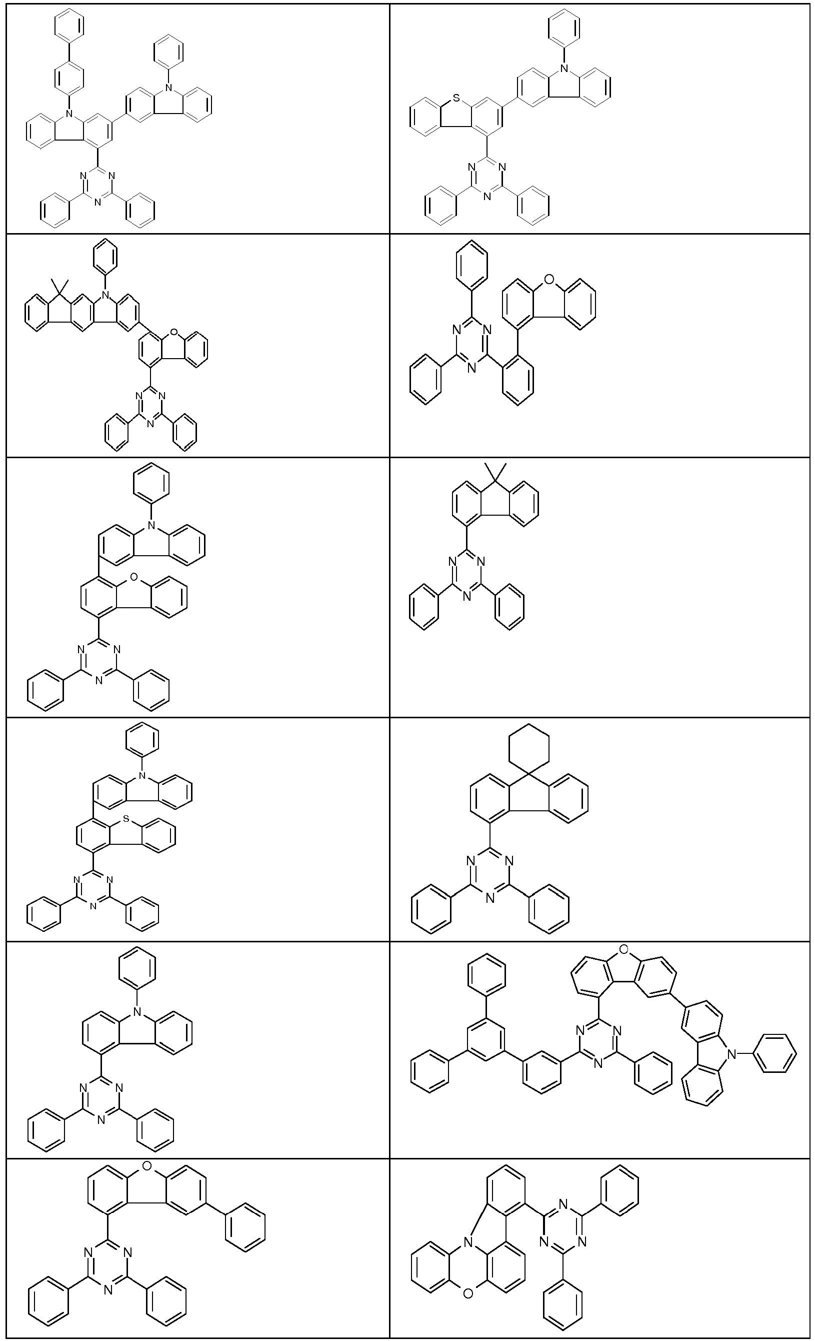

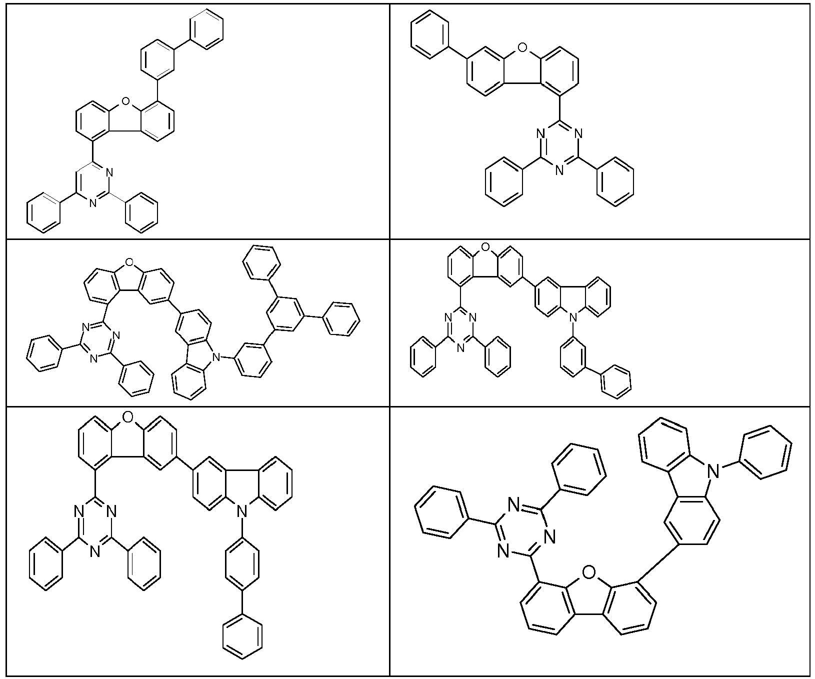

Beispiele für Lactame, welche als elektronentransportierende Matrixmaterialien eingesetzt werden können, sind die folgenden Verbindungen:

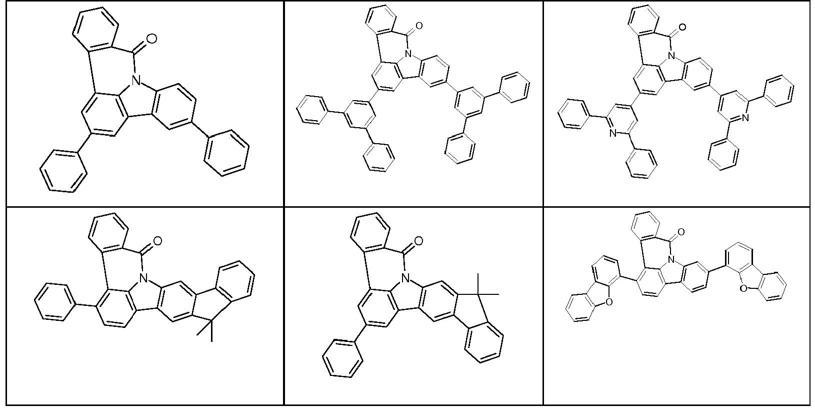

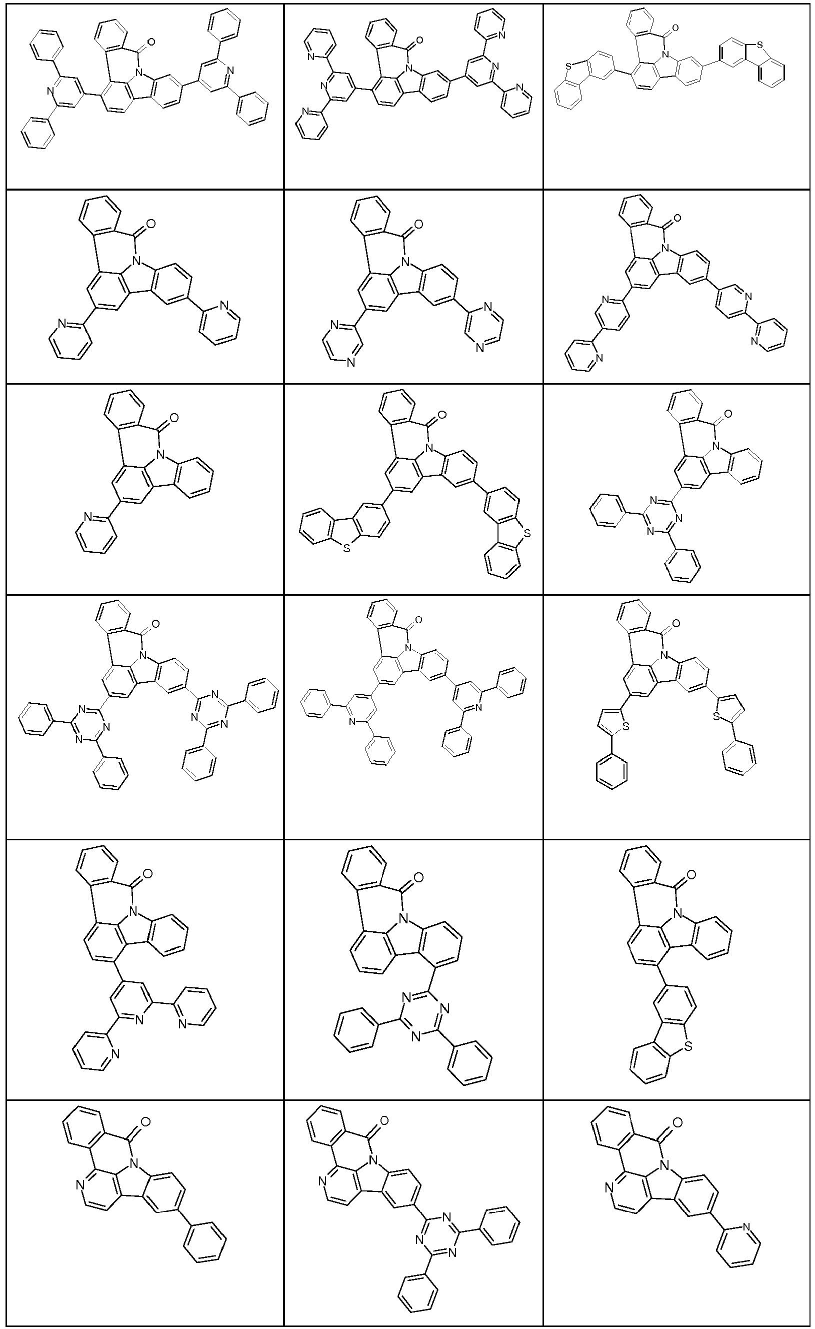

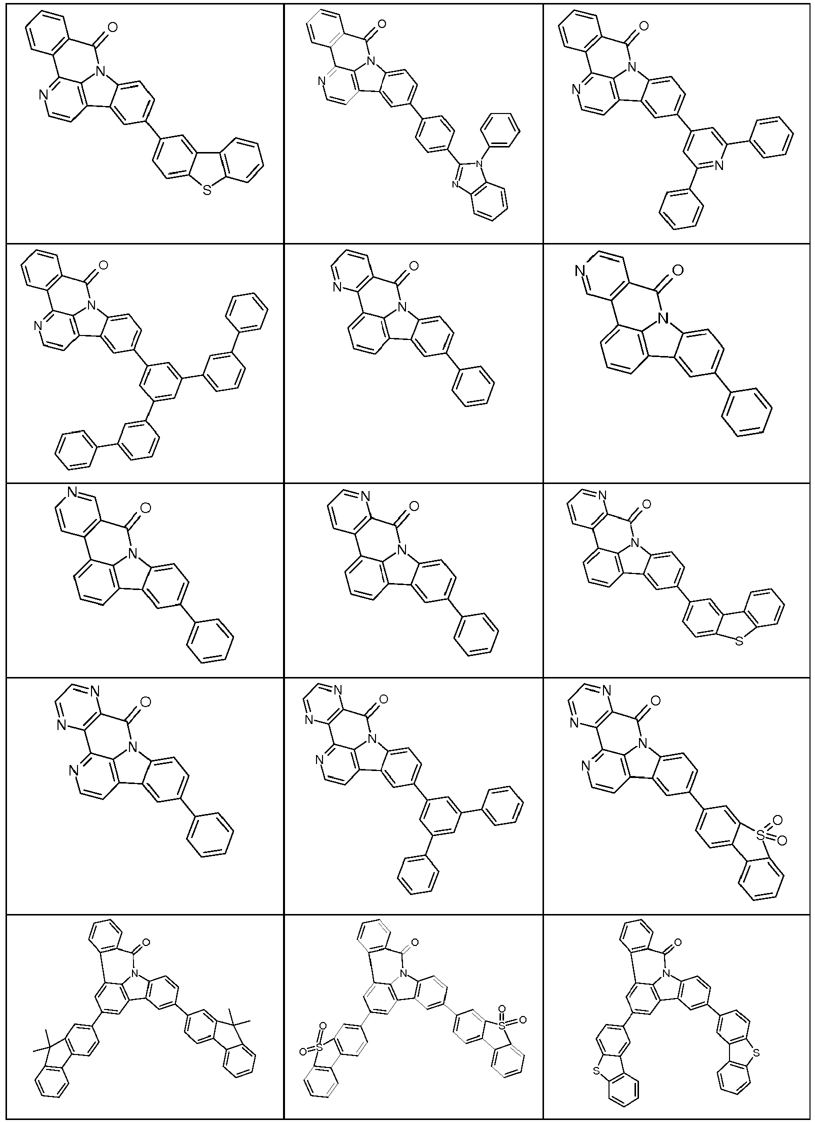

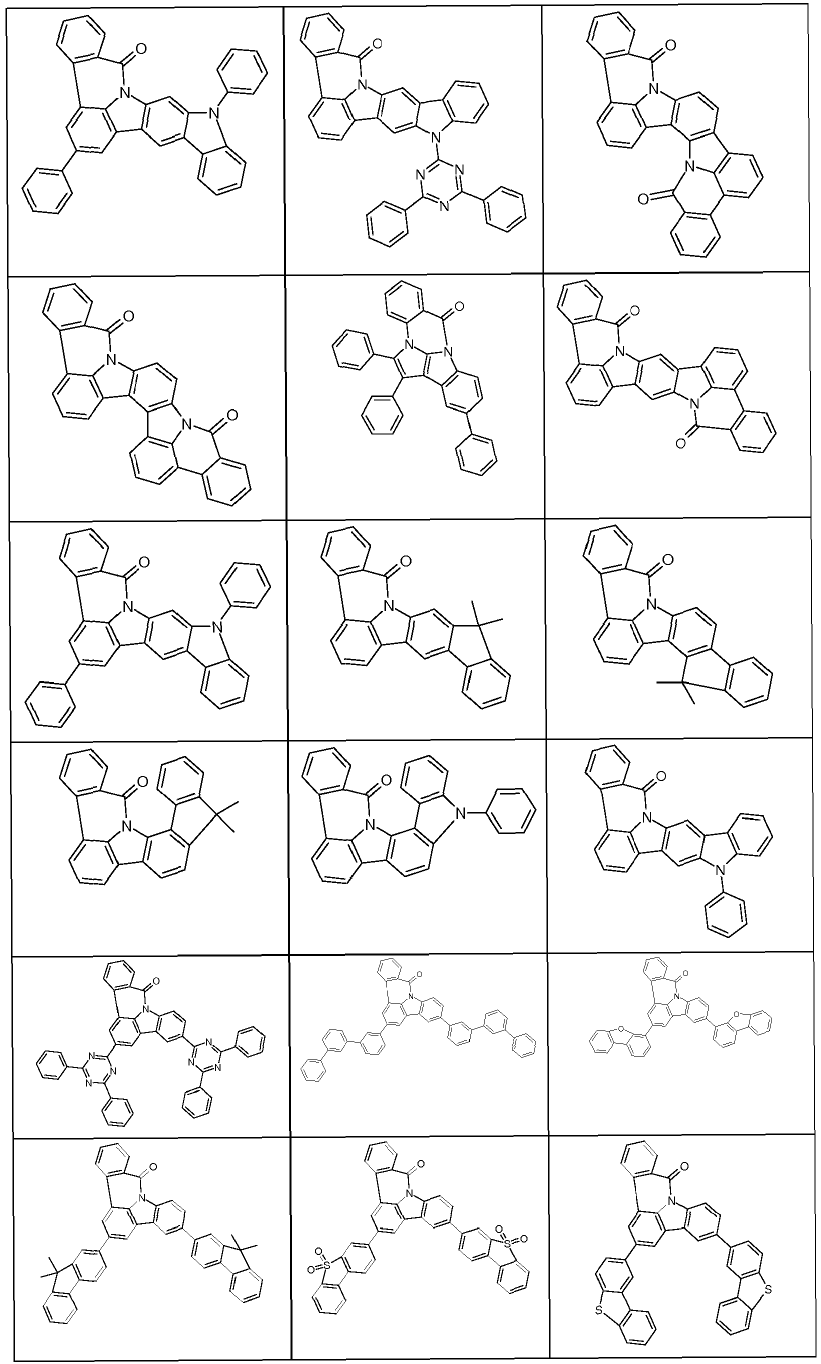

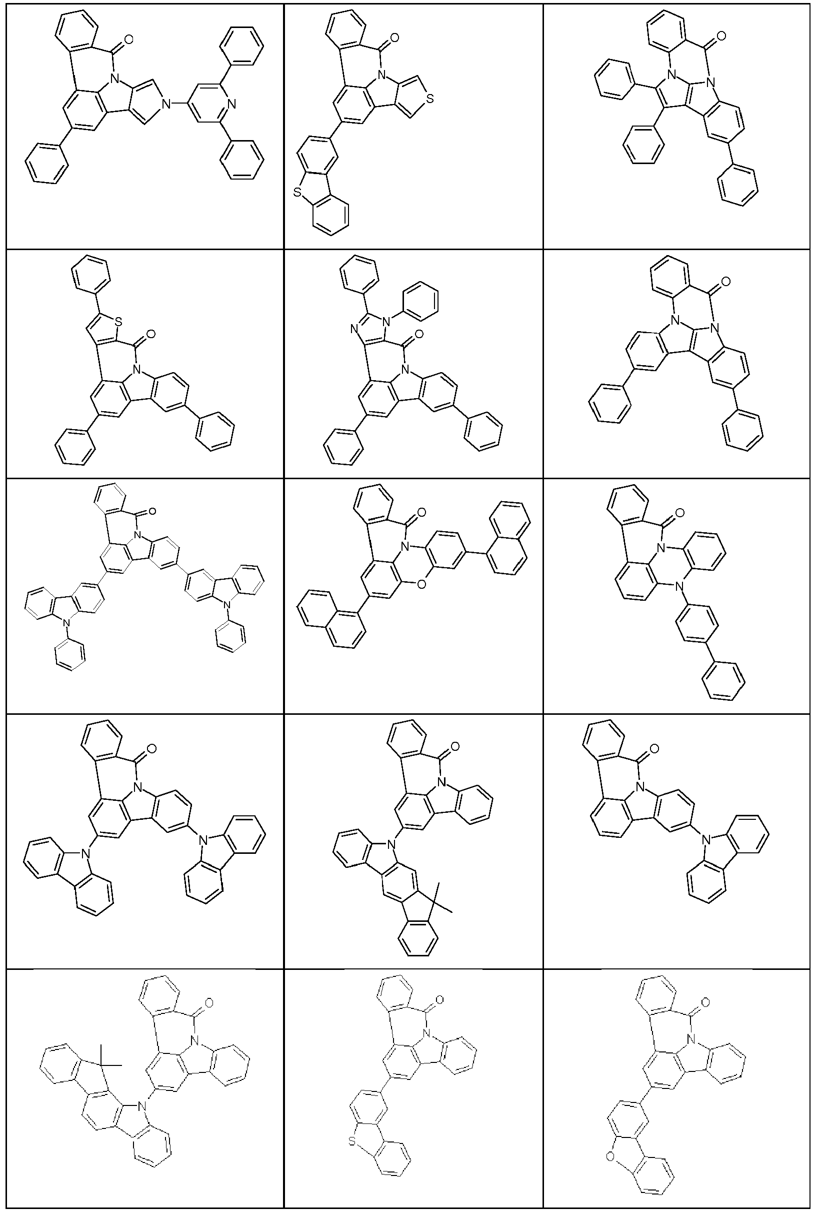

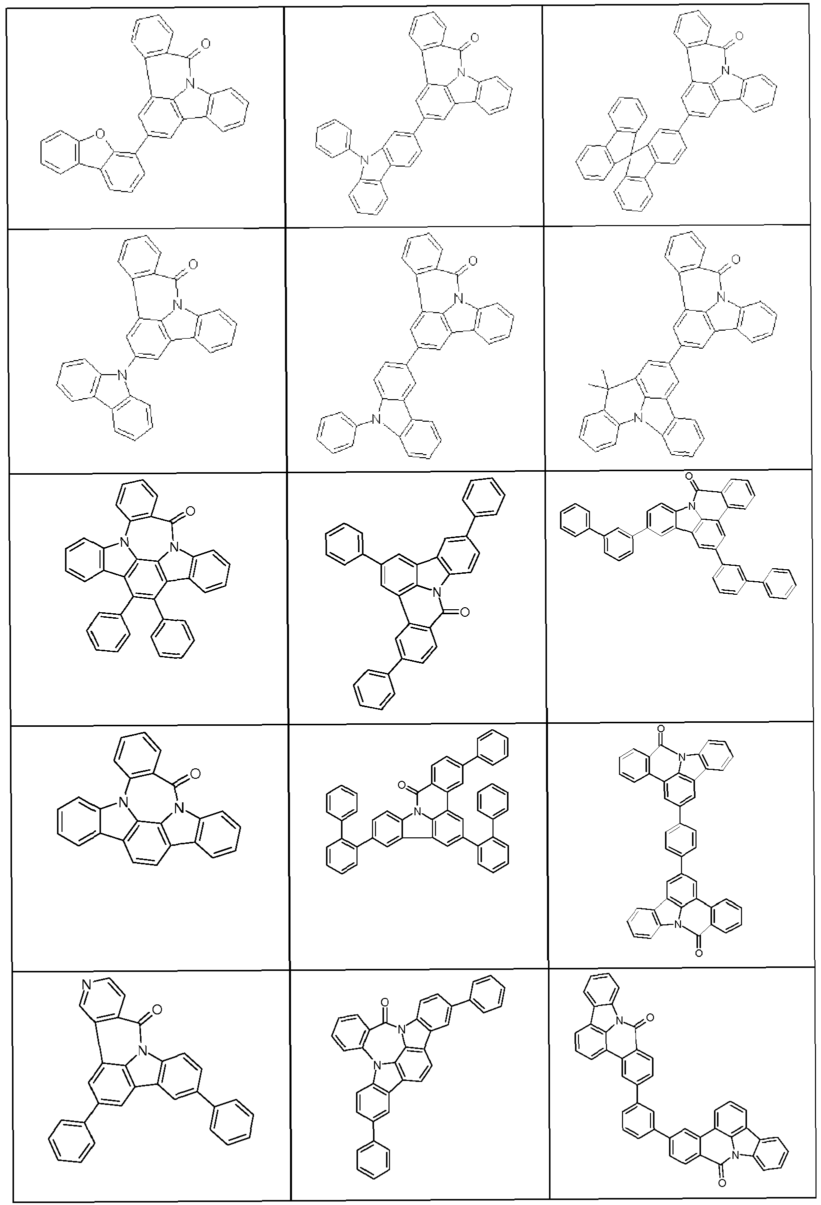

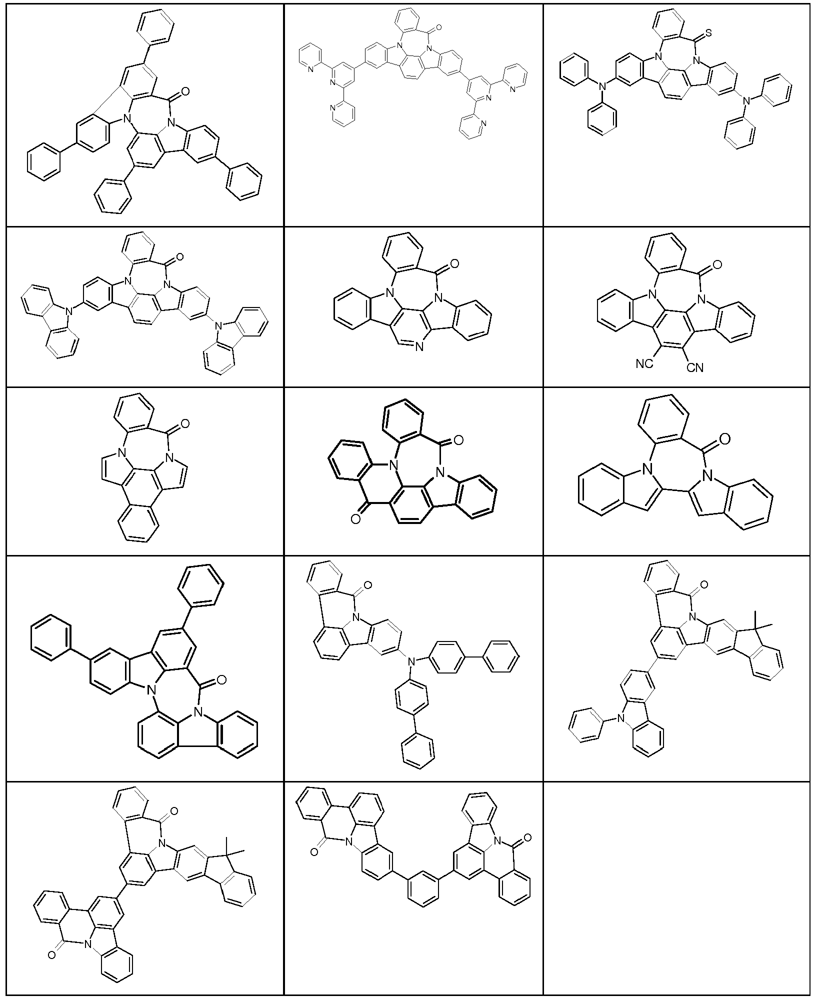

Beispiele für Ketone, welche als elektronentransportierende Matrixmaterialien eingesetzt werden können, sind die folgenden Verbindungen:

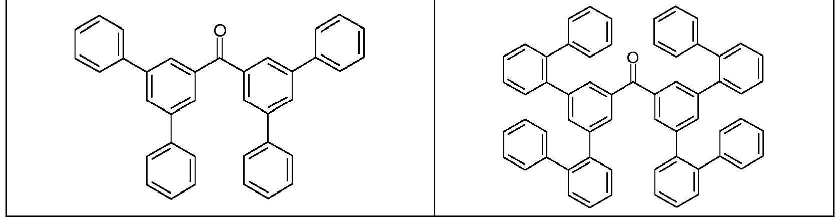

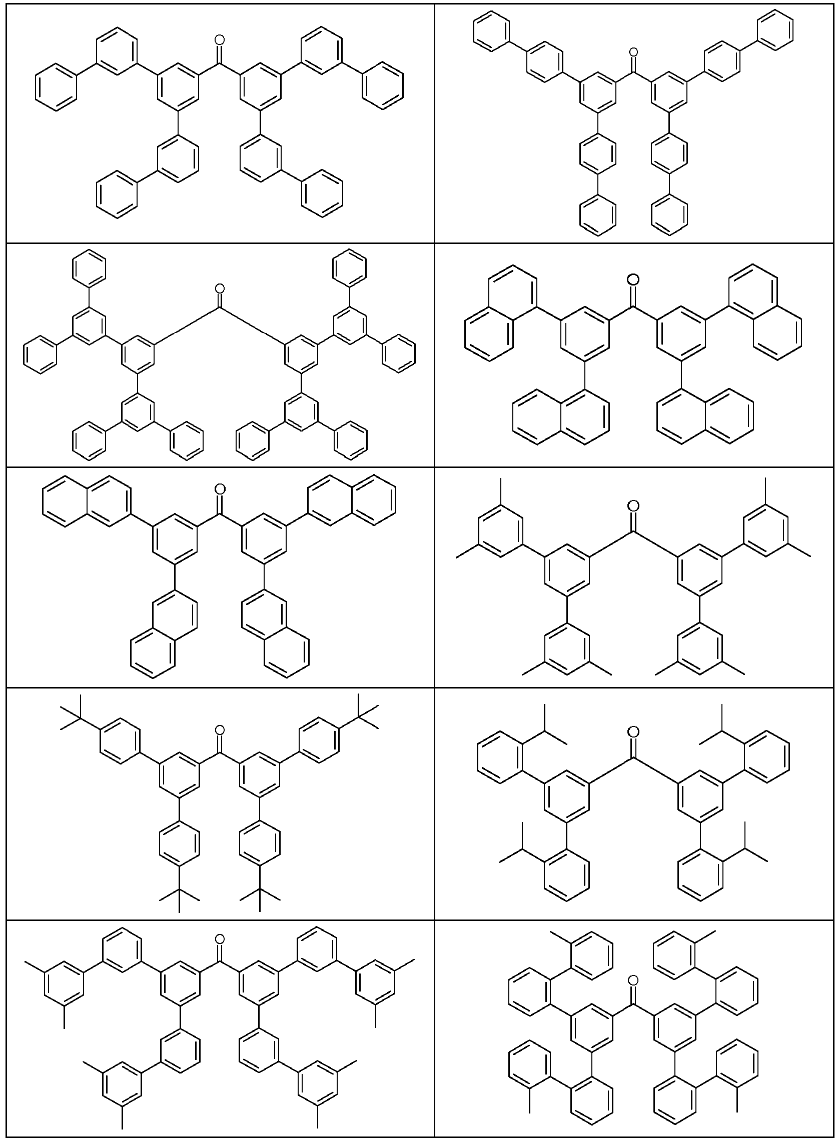

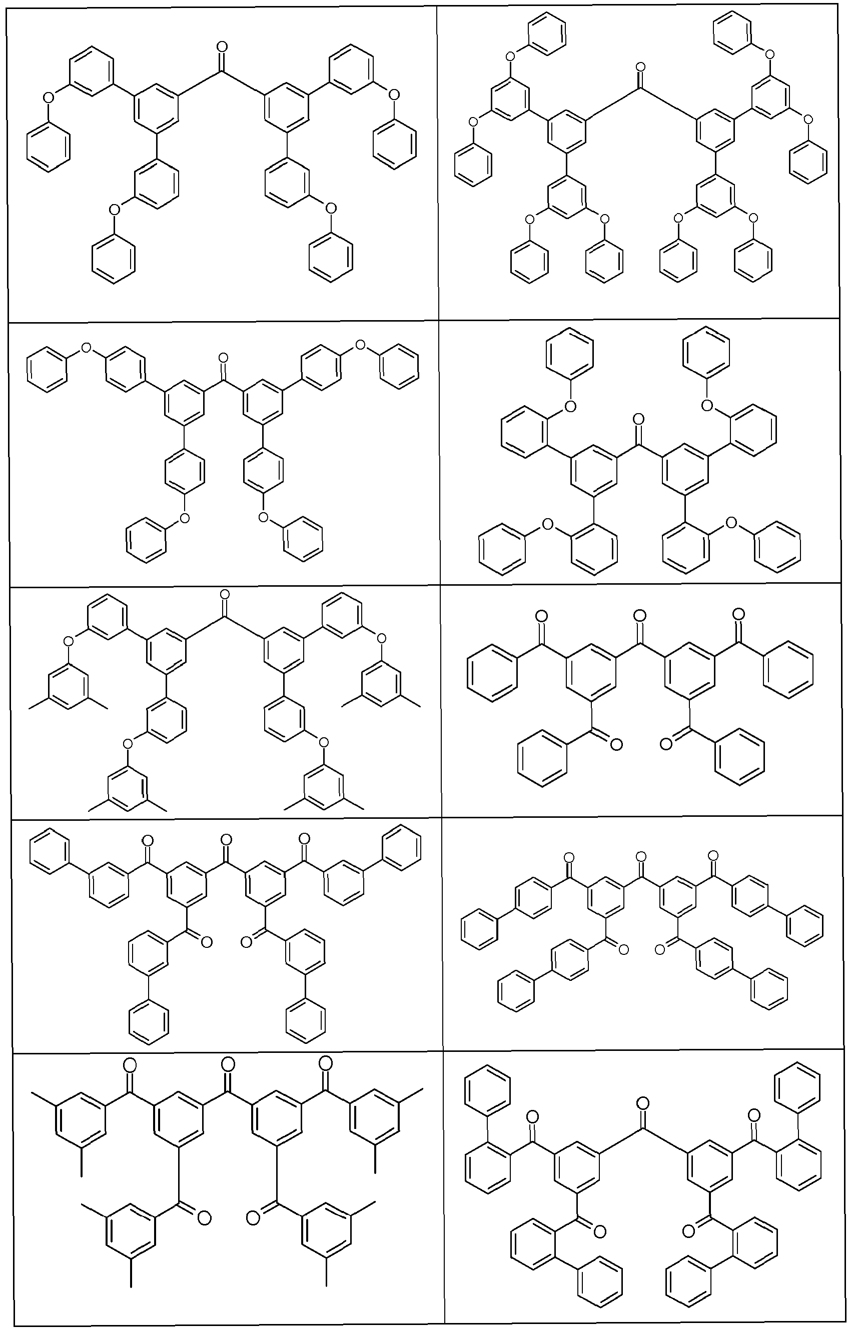

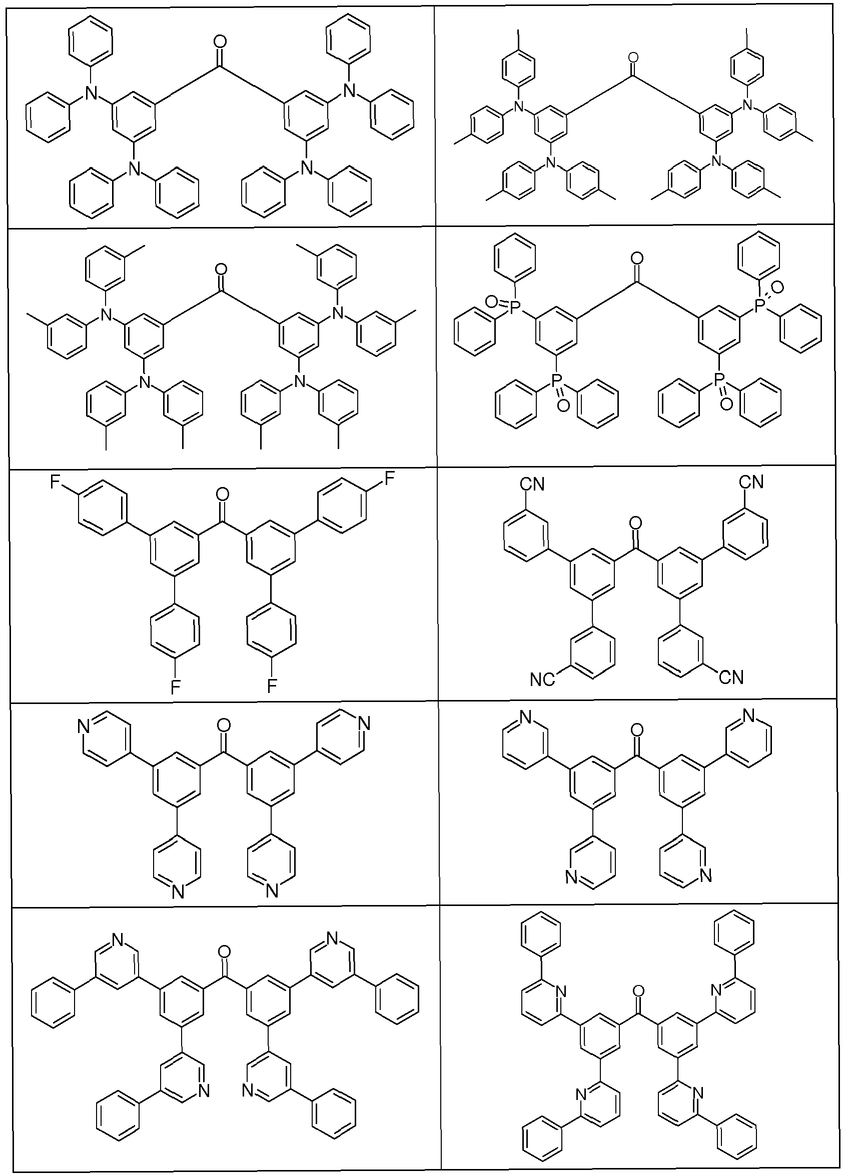

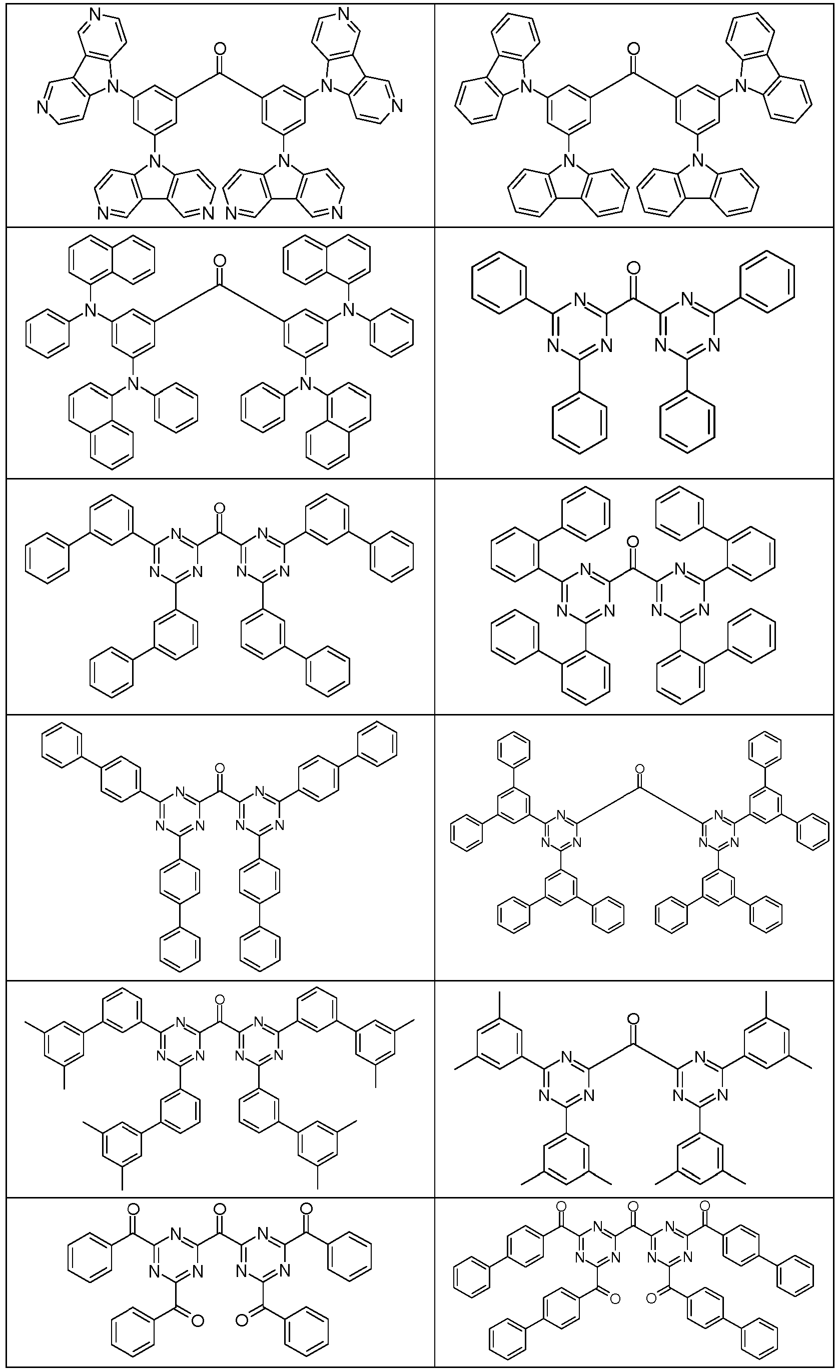

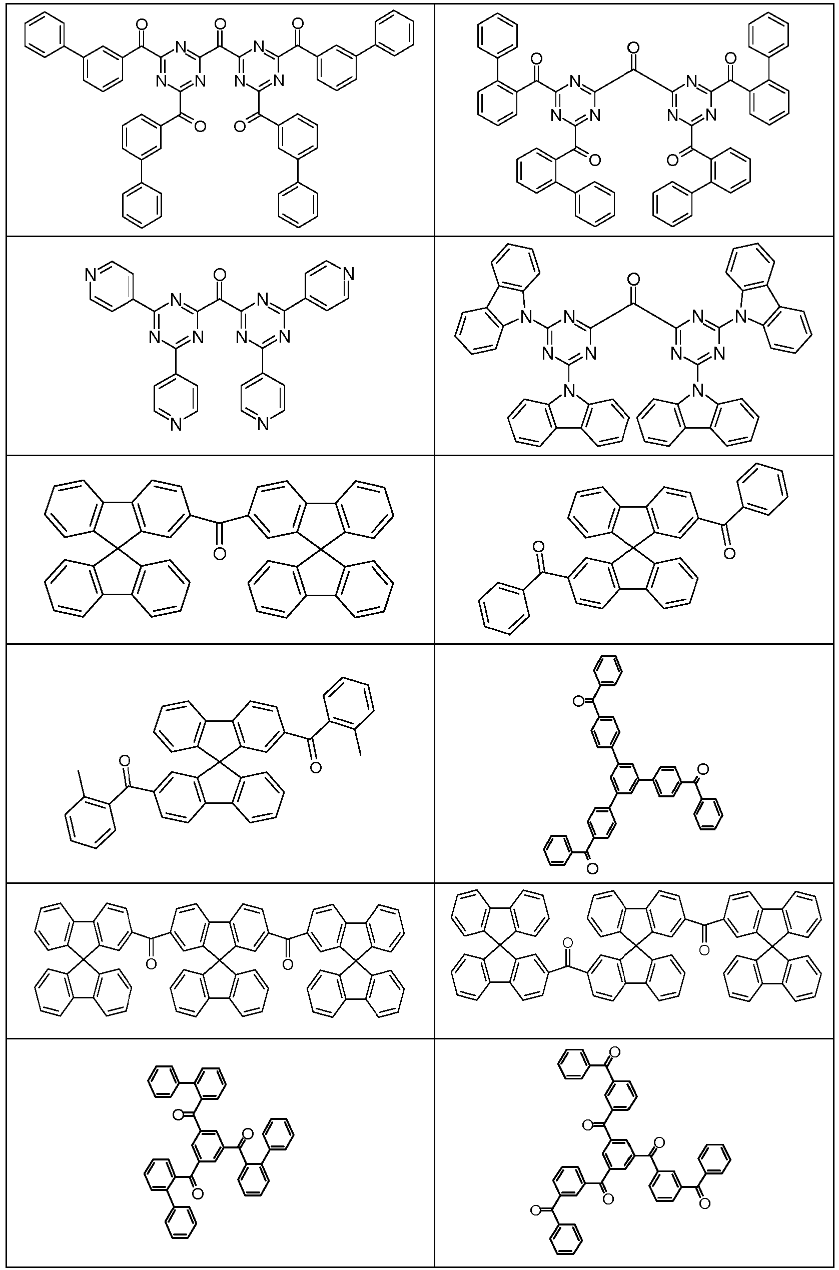

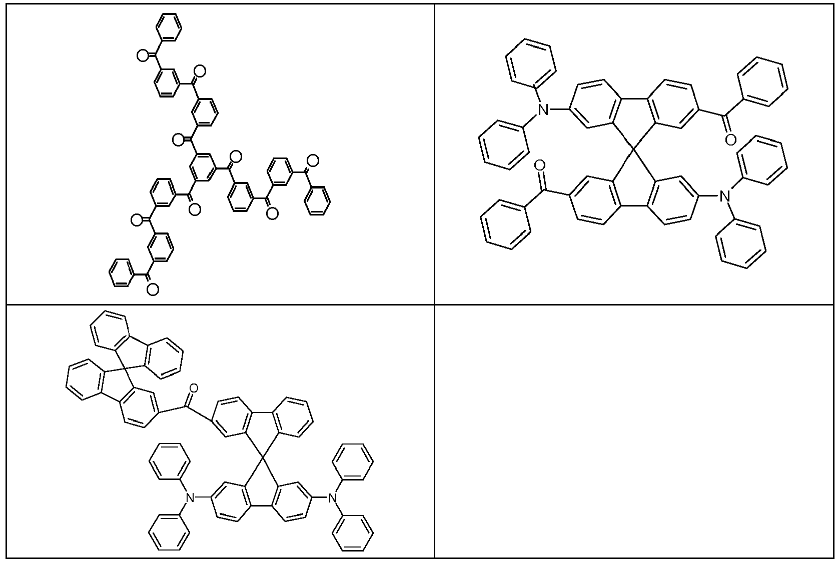

Beispiele für Metallkomplexe, welche als elektronentransportierende Matrixmaterialien eingesetzt werden können, sind die folgenden Verbindungen:

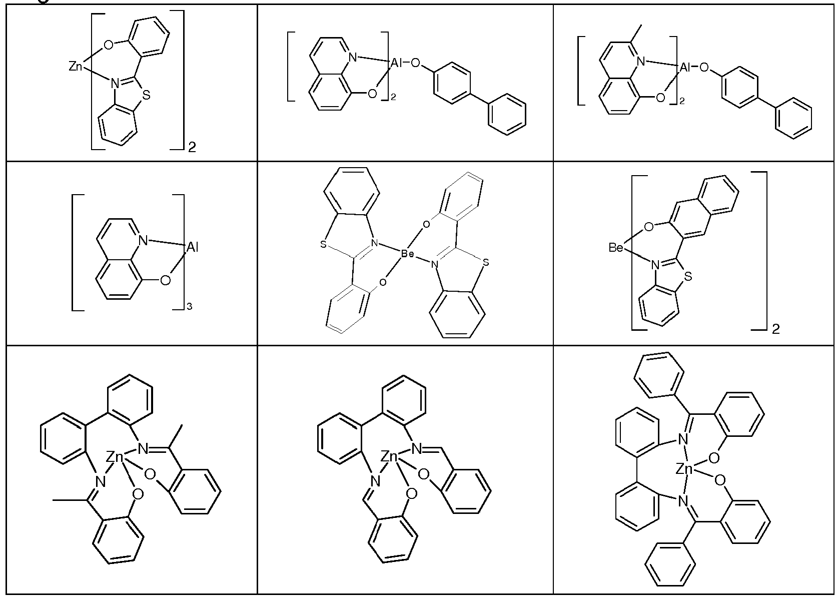

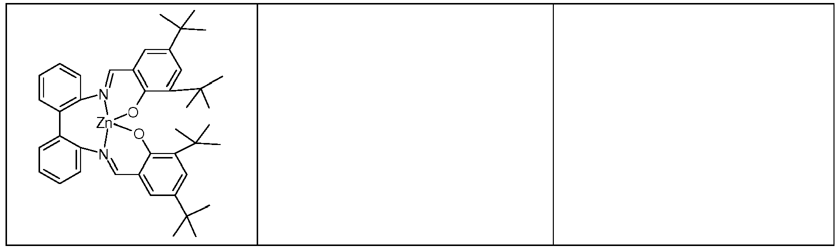

Beispiele für Phosphinoxide, welche als elektronentransportierende Matrixmaterialien eingesetzt werden können, sind die folgenden Verbindungen:

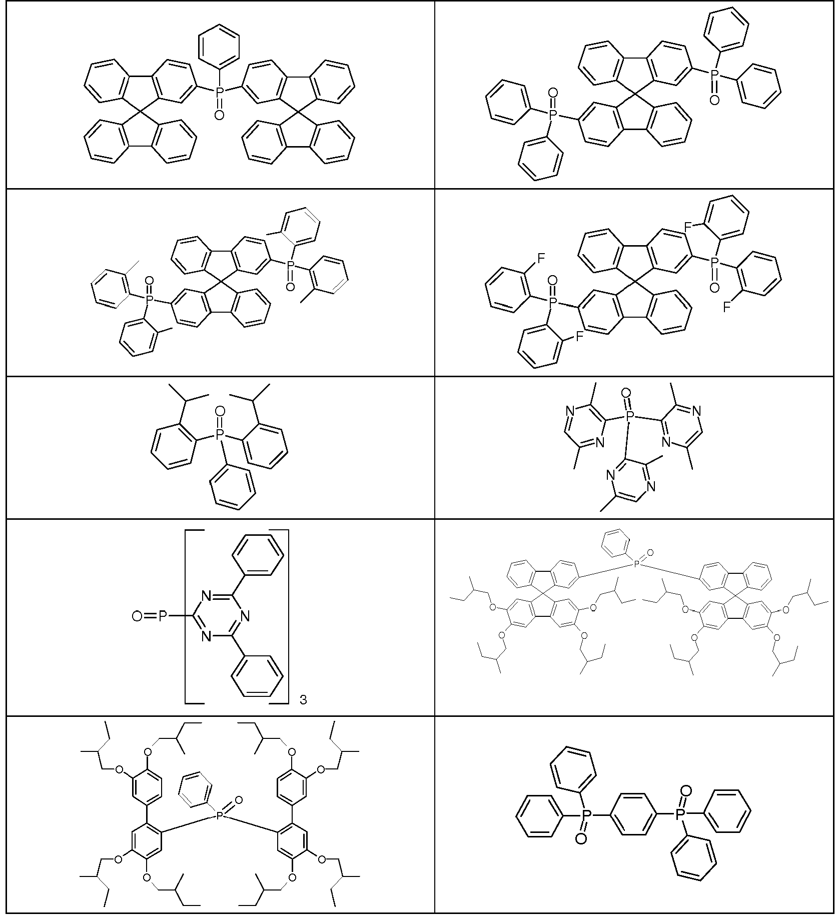

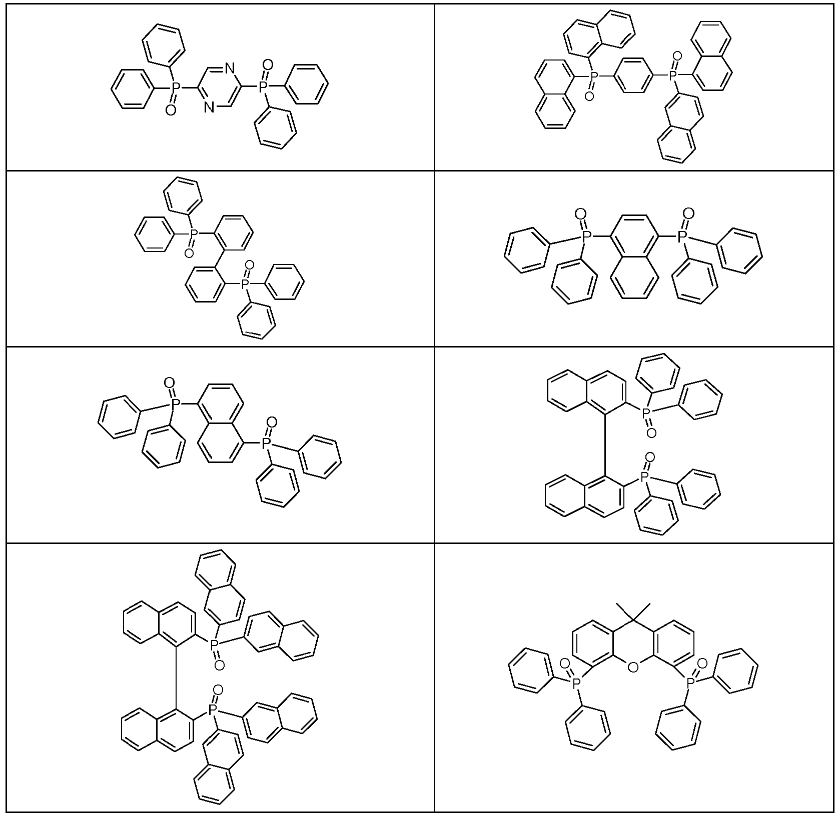

Beispiele für Indolo- und Indenocarbazolderivate im weitesten Sinn, welche je nach Substitutionsmuster als loch- oder elektronentransportierende Matrixmaterialien eingesetzt werden können, sind die folgenden Verbindungen:

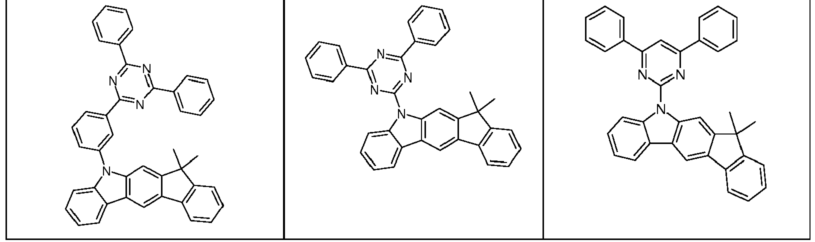

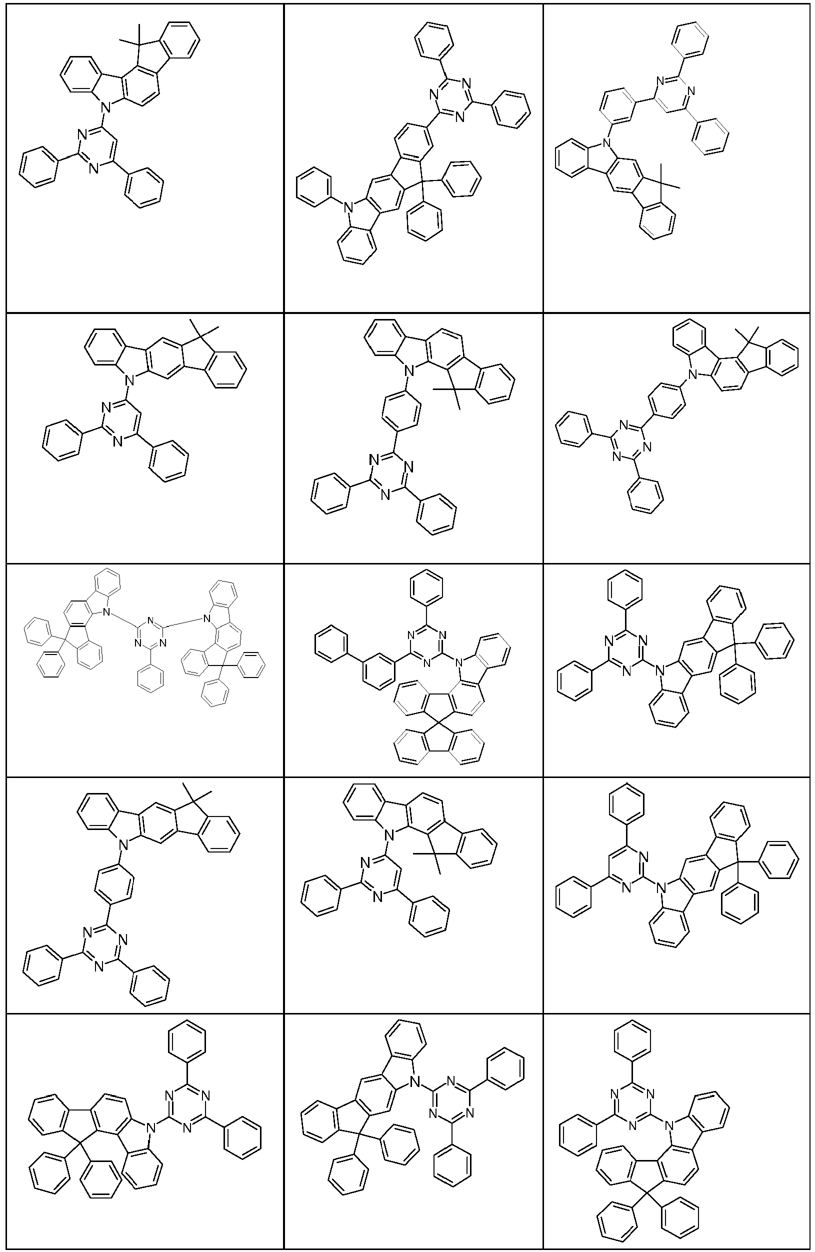

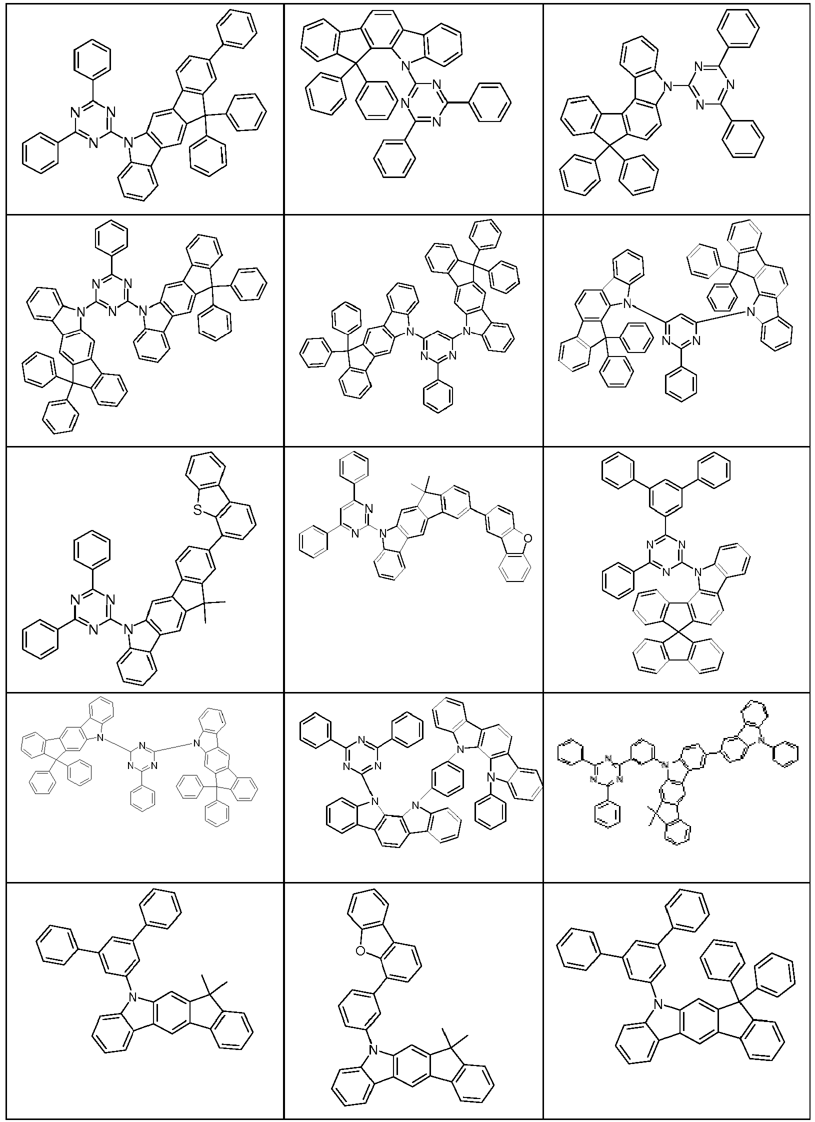

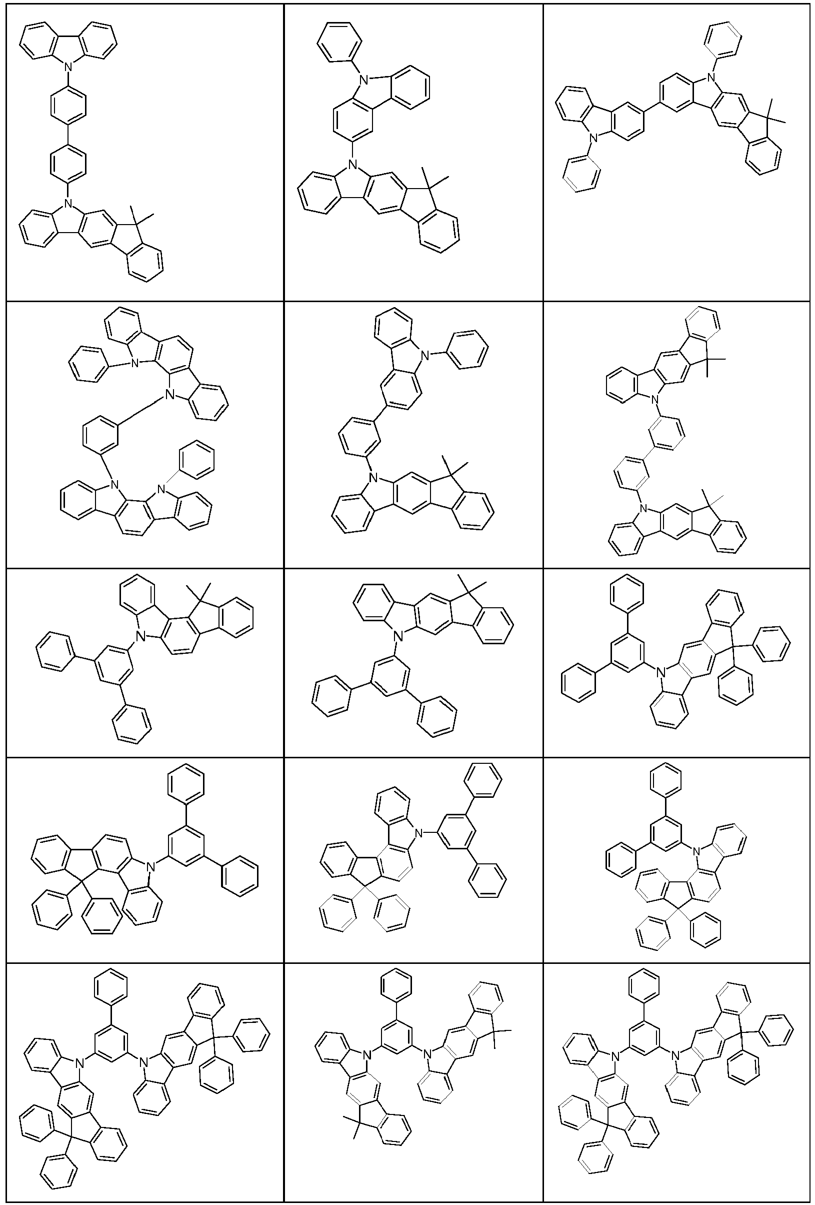

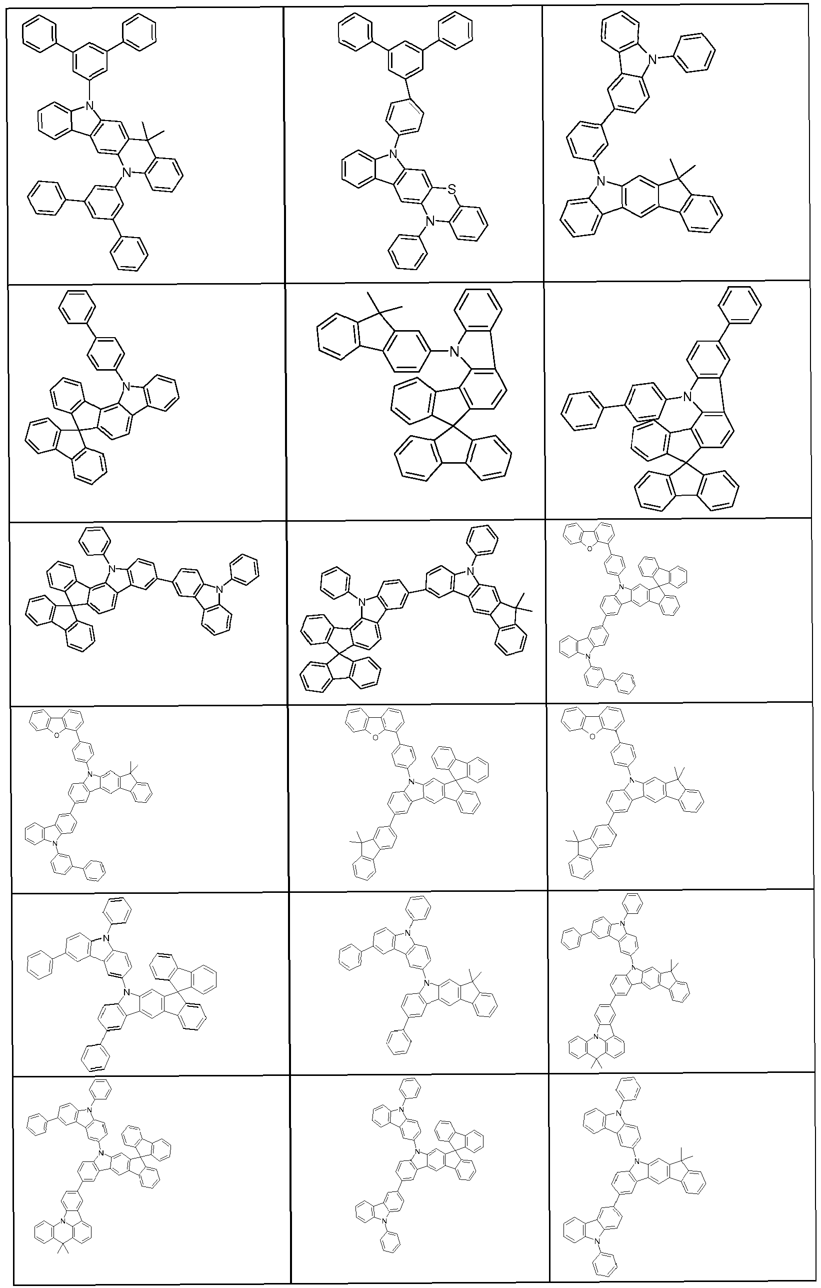

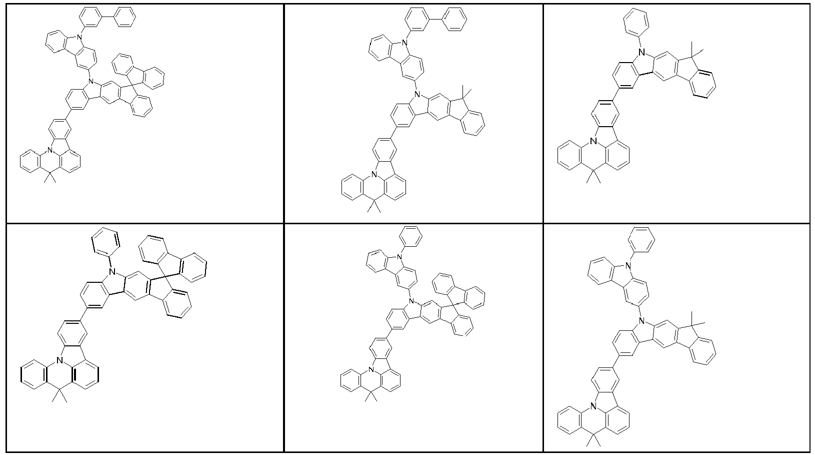

Beispiele für Carbazolderivate, welche je nach Substitutionsmuster als loch- oder elektronentransportierende Matrixmaterialien eingesetzt werden können, sind die folgenden Verbindungen:

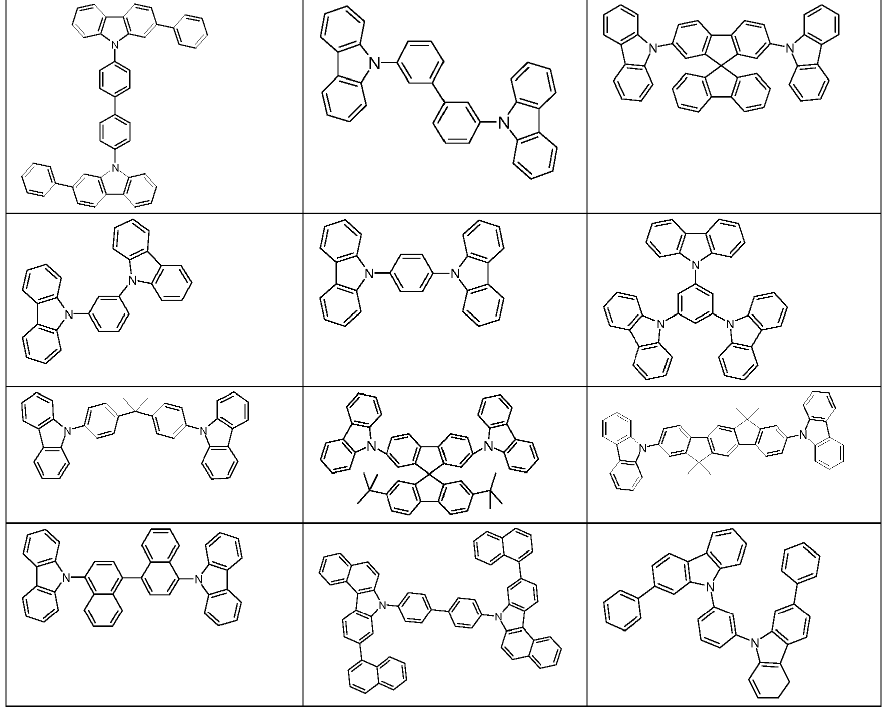

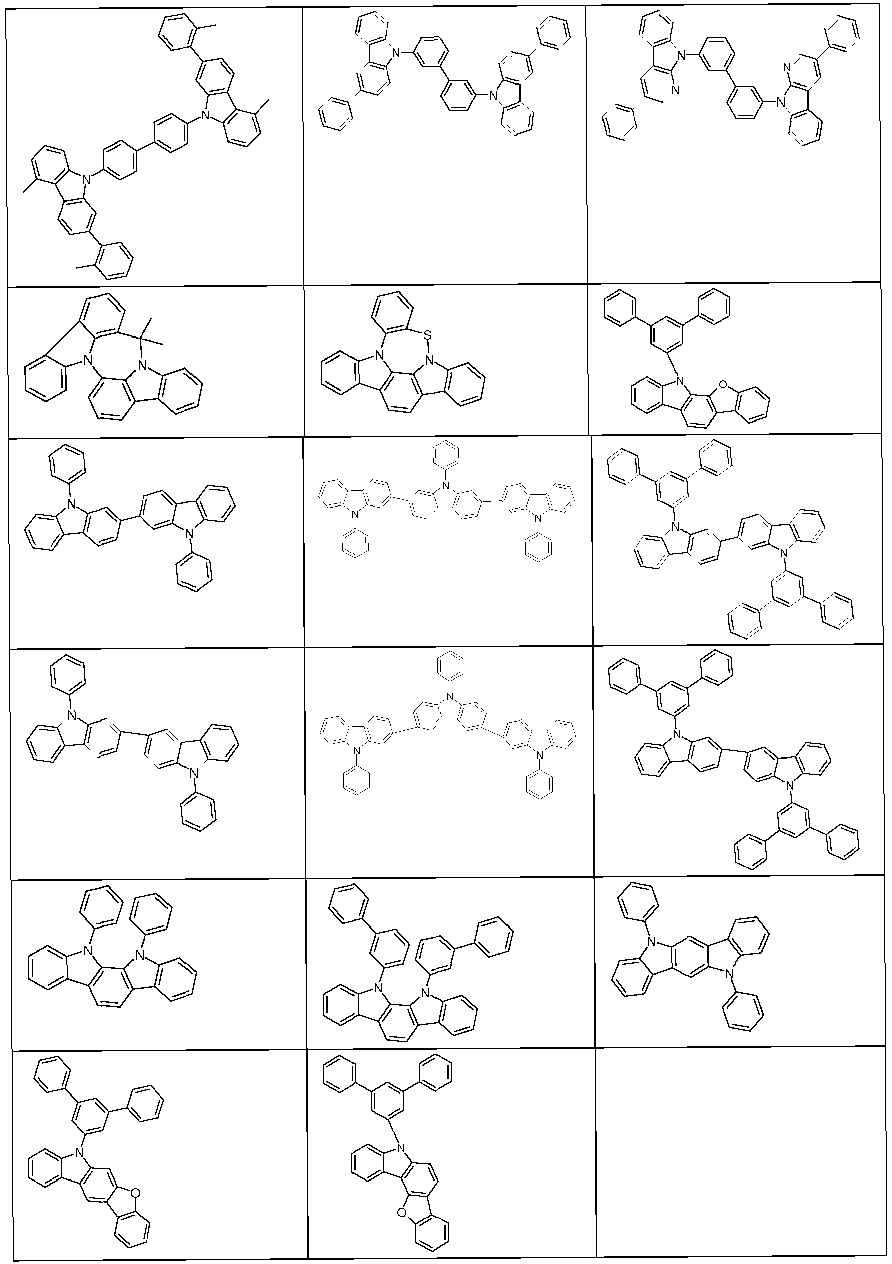

Beispiele für verbrückte Carbazolderivate, welche als lochtransportierende Matrixmaterialien eingesetzt werden können, sind die folgenden Verbindungen:

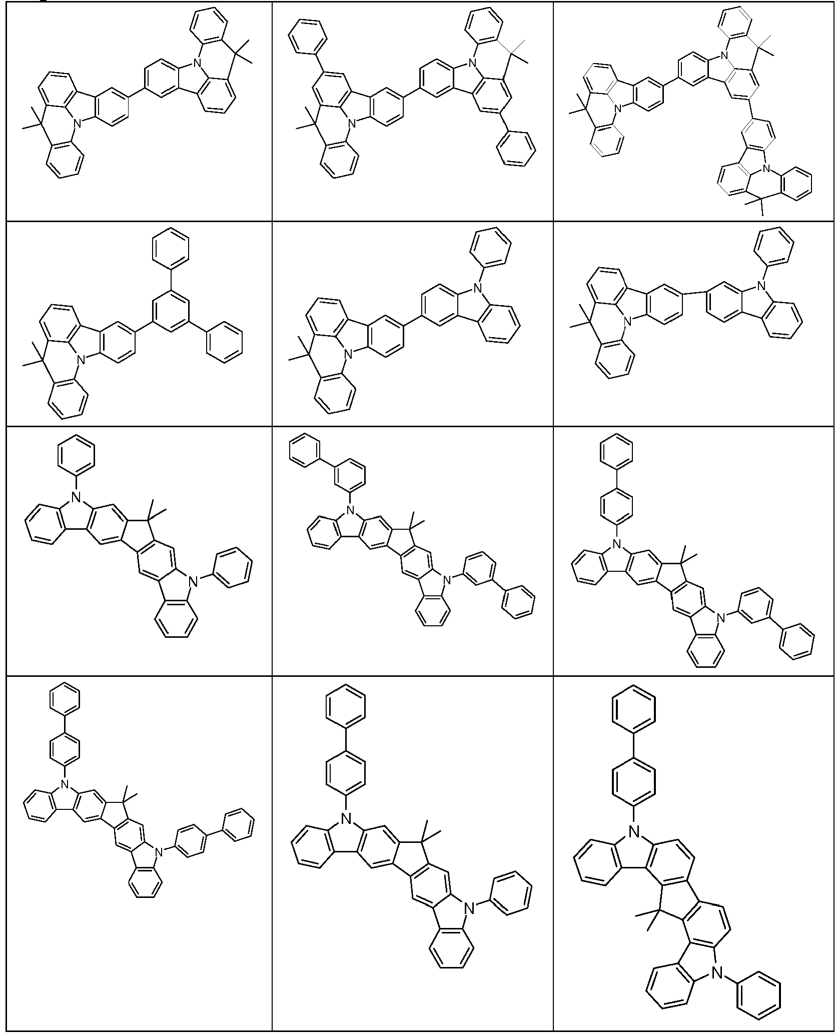

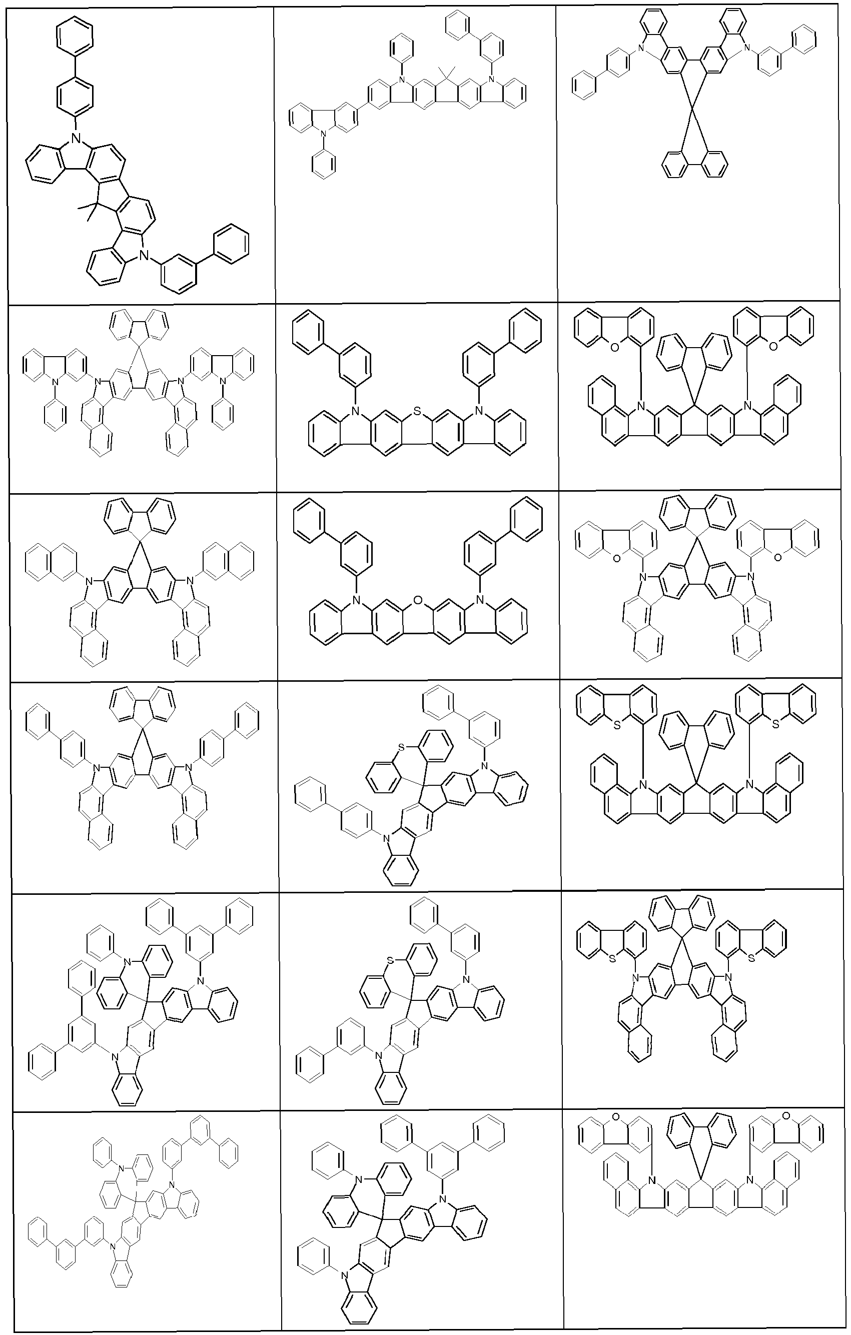

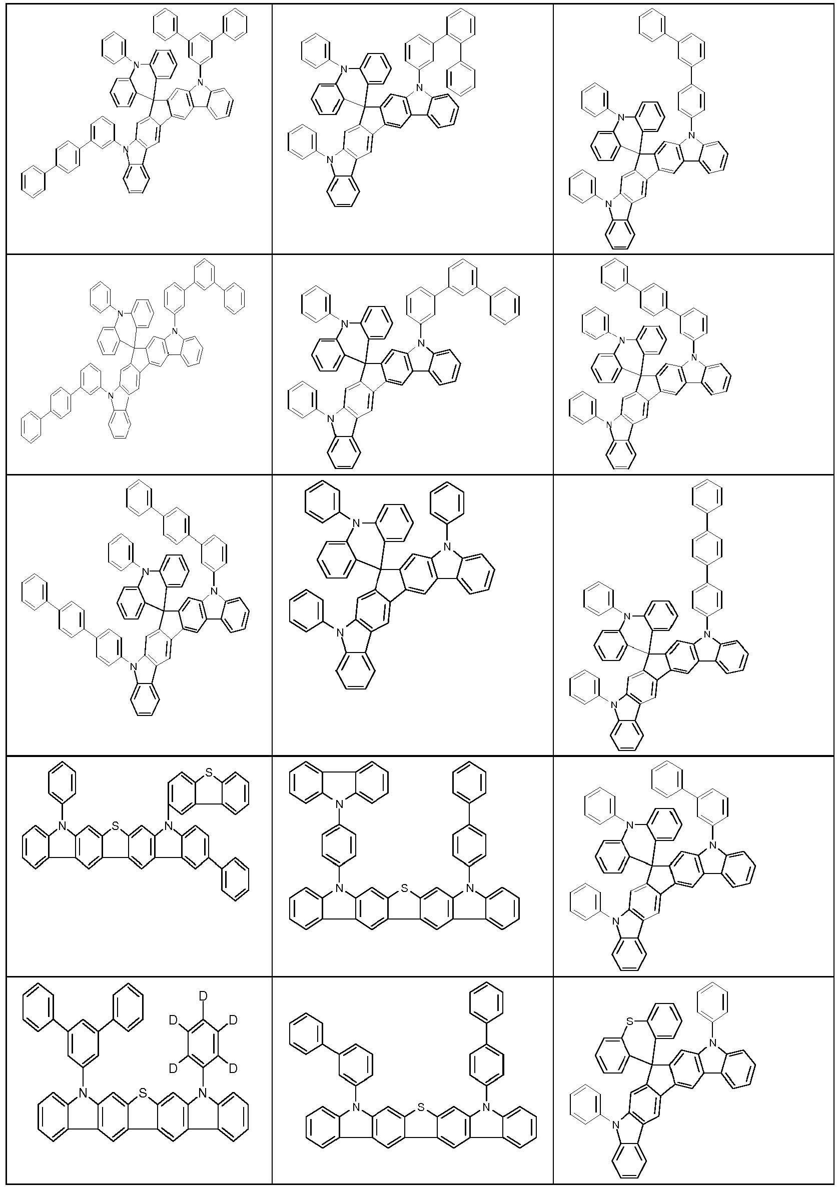

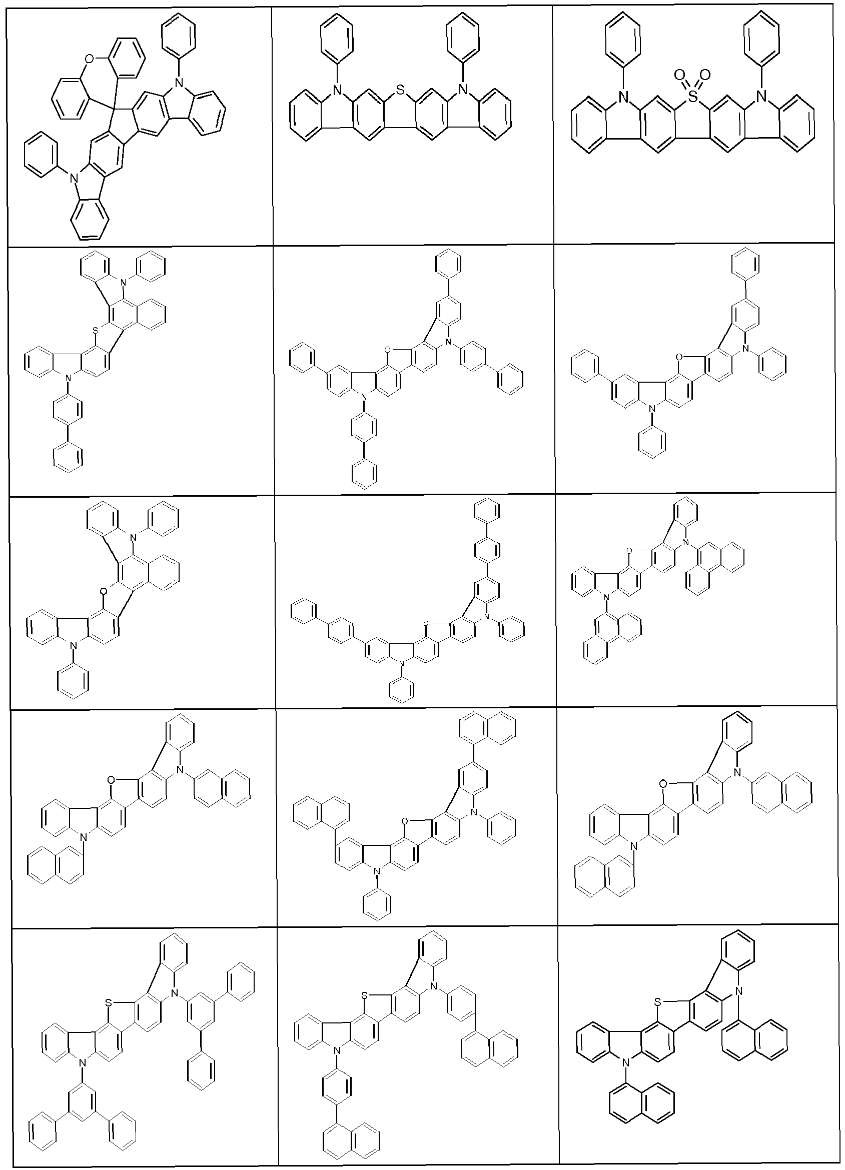

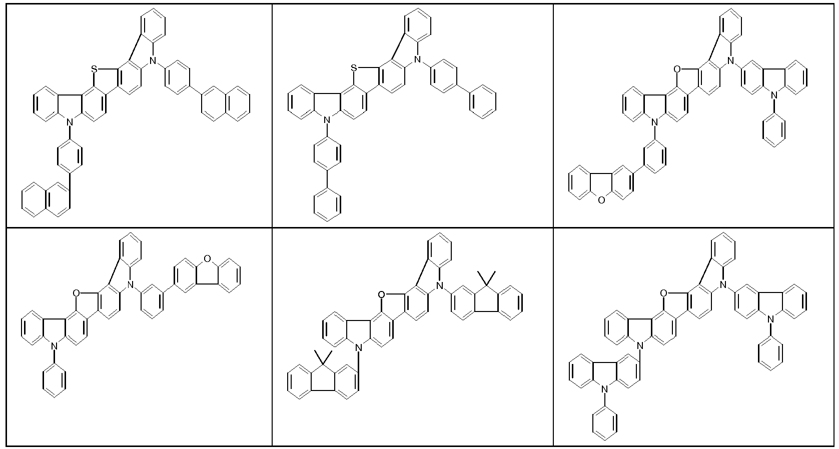

Beispiele für Biscarbazole, welche als lochtransportierende Matrixmaterialien eingesetzt werden können, sind die folgenden Verbindungen:

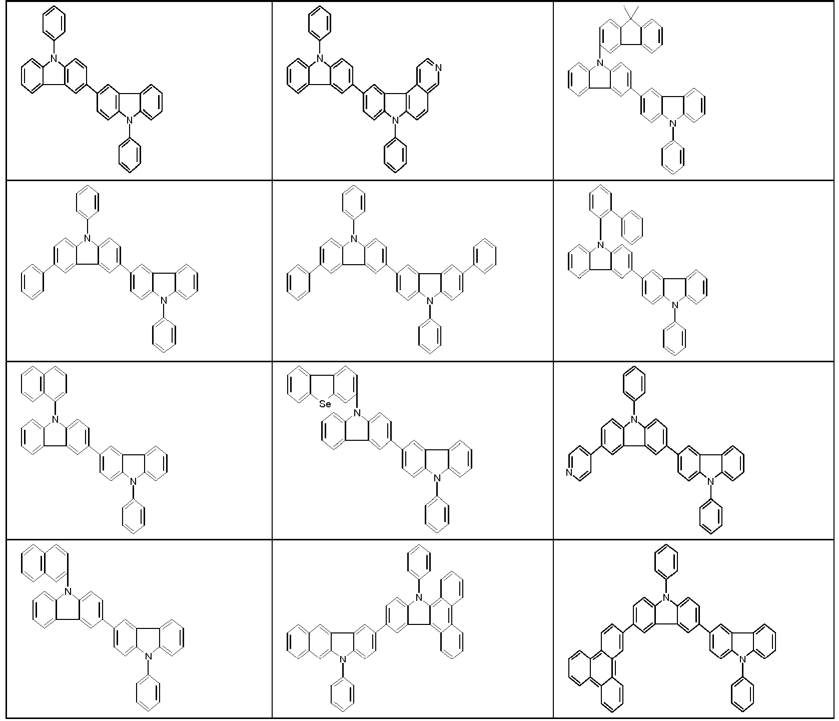

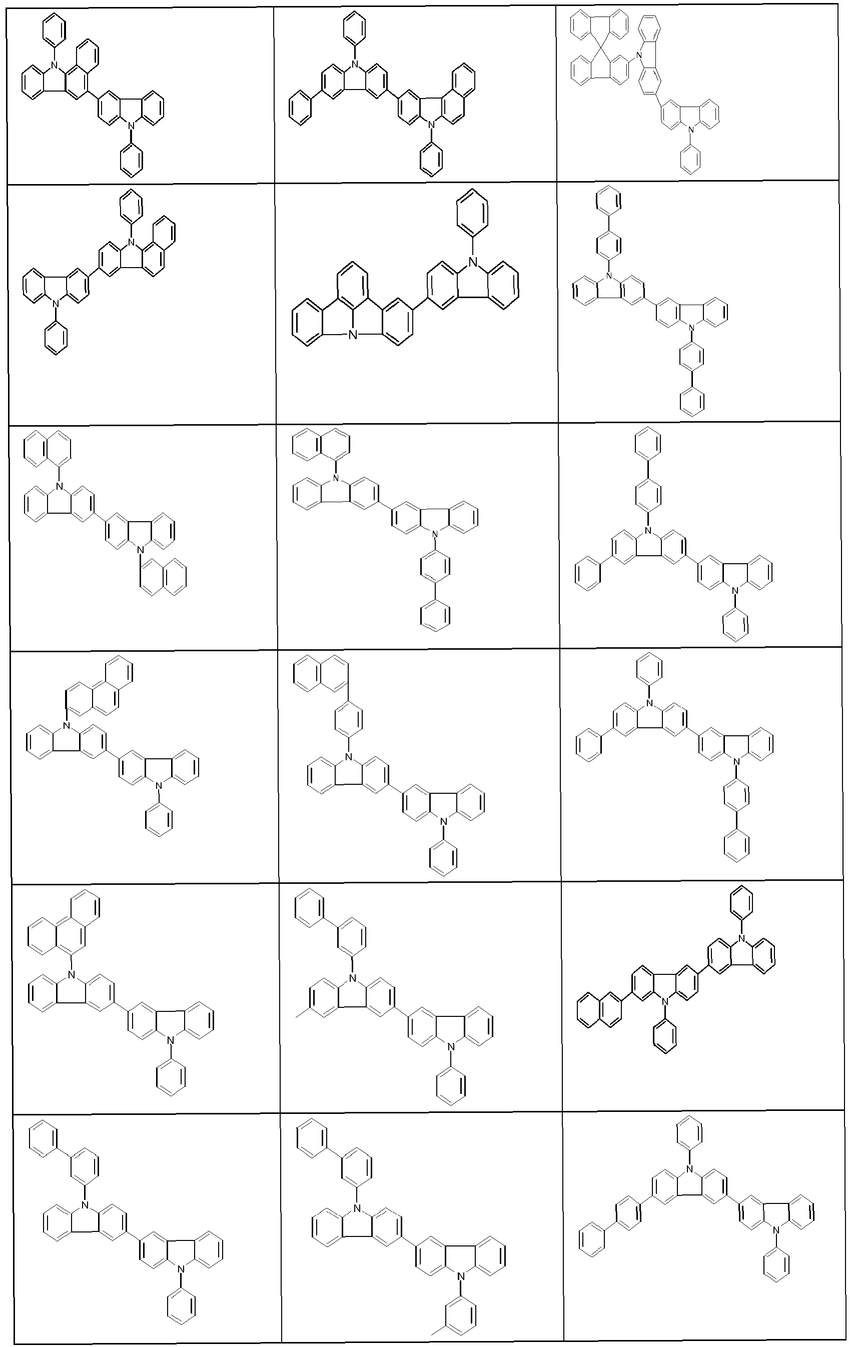

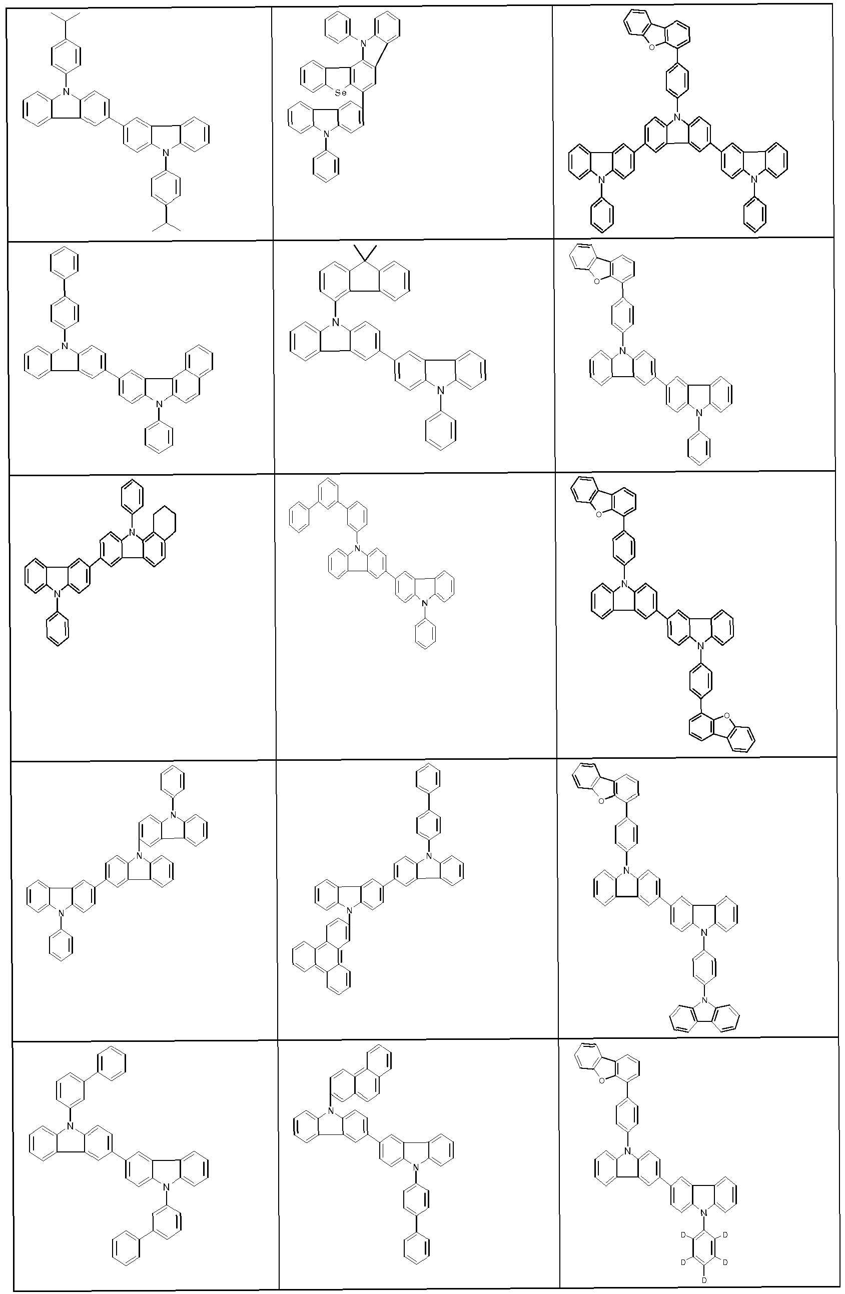

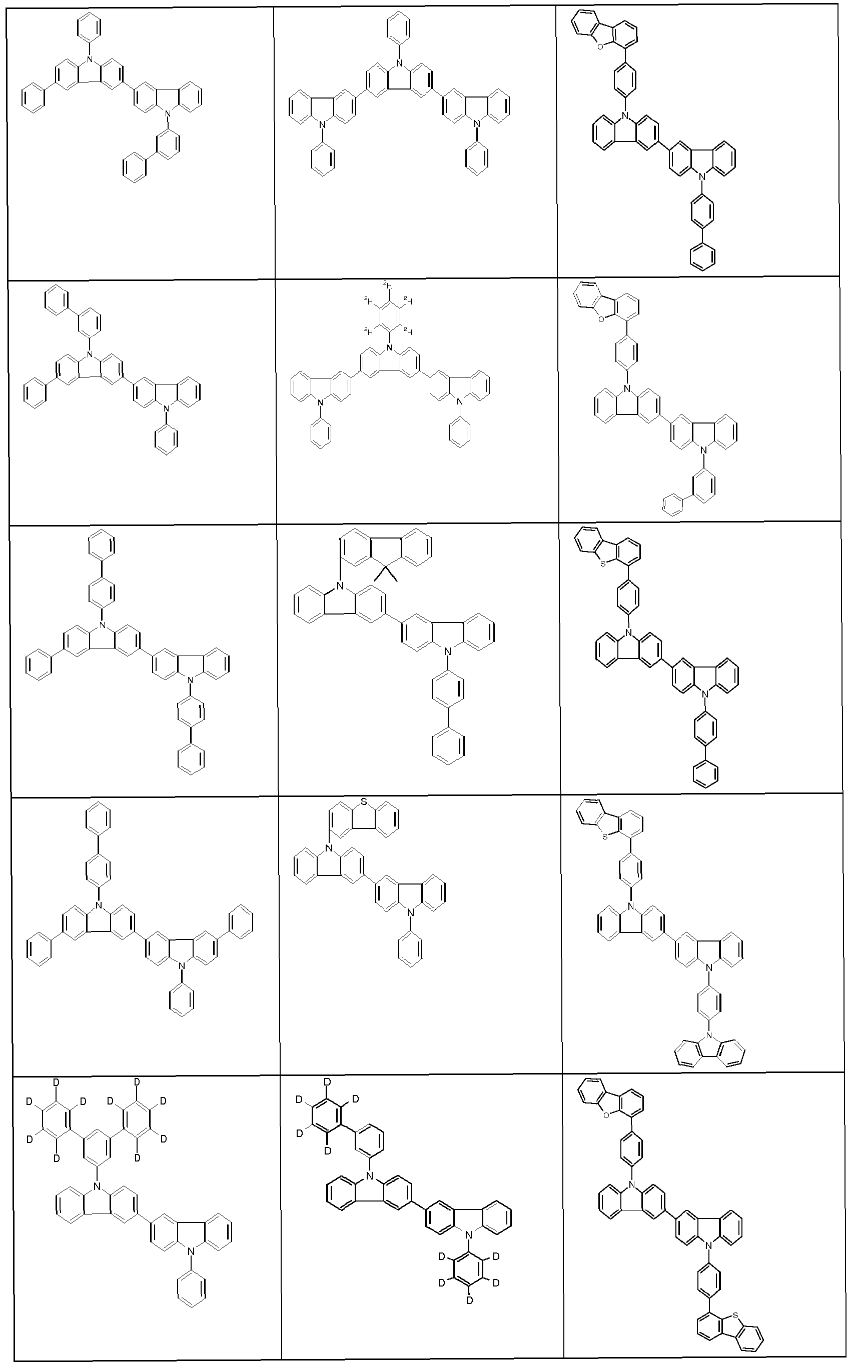

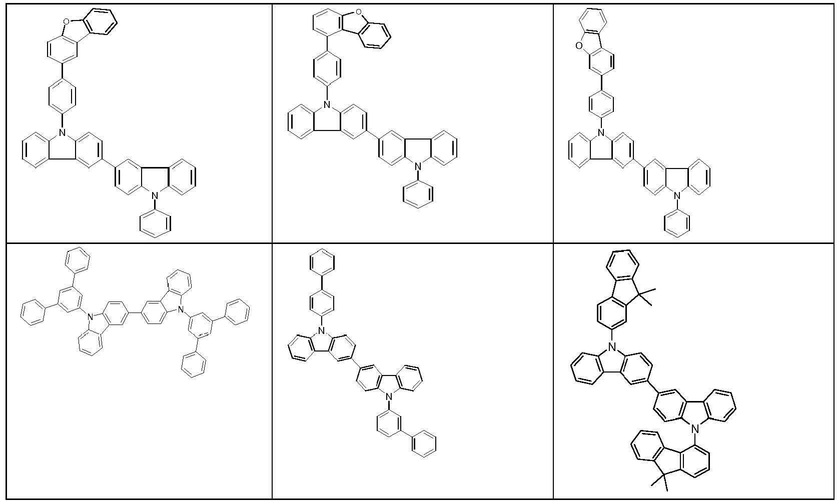

Beispiele für Amine, welche als lochtransportierende Matrixmaterialien eingesetzt werden können, sind die folgenden Verbindungen:

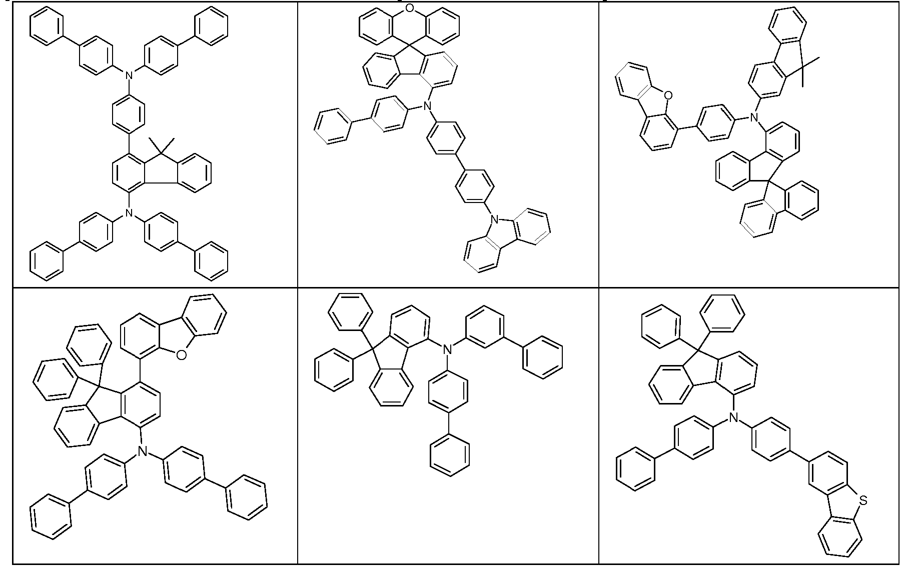

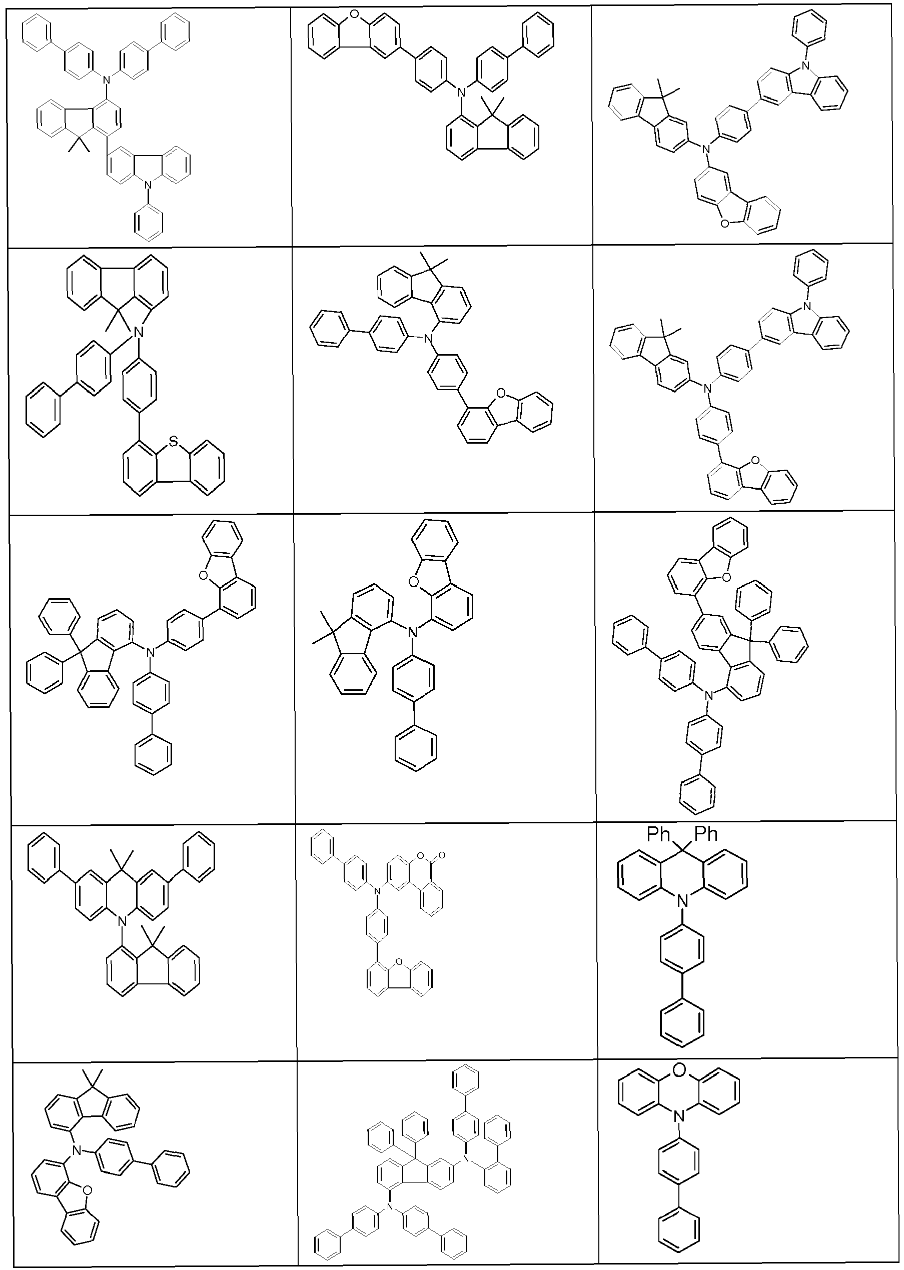

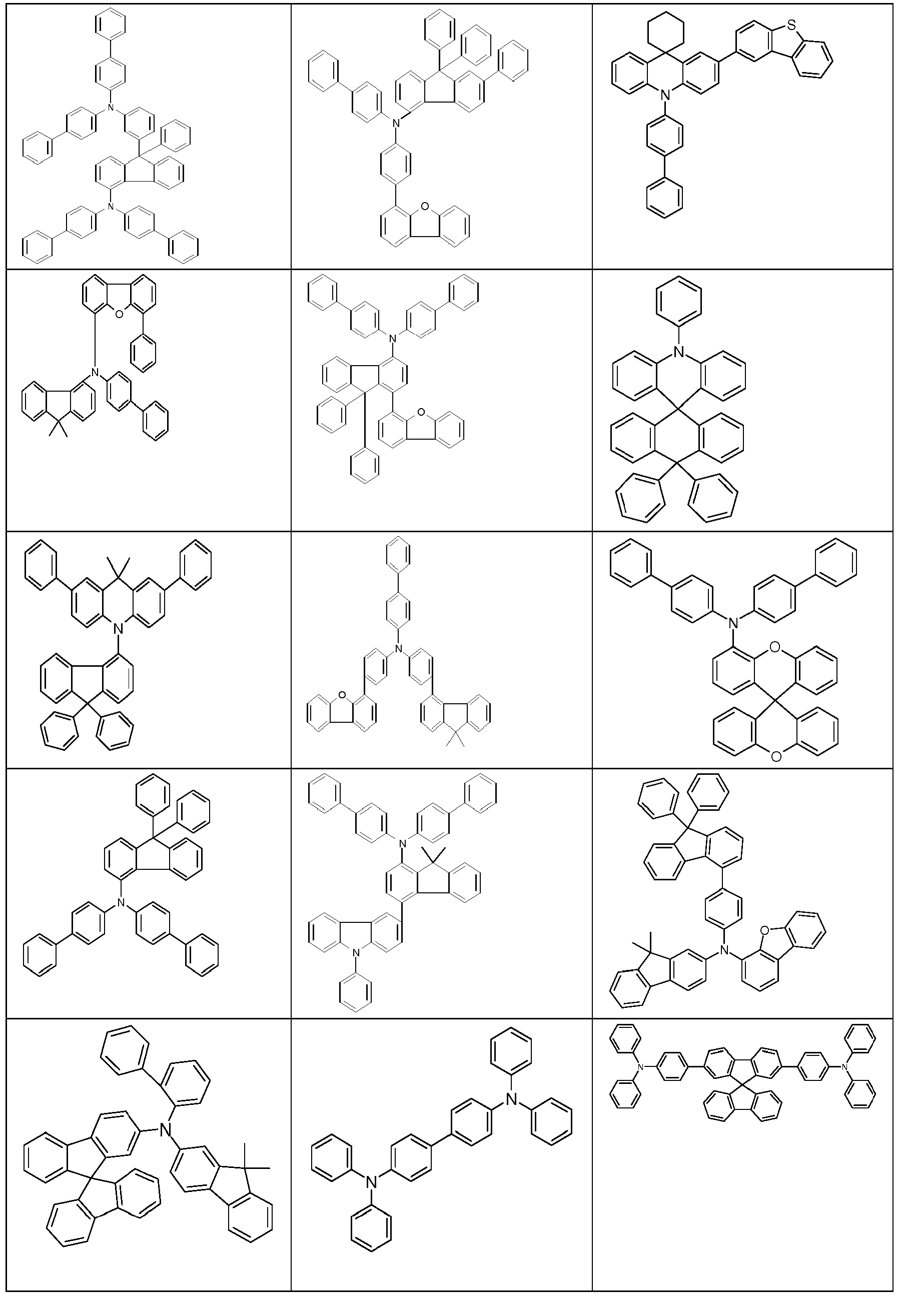

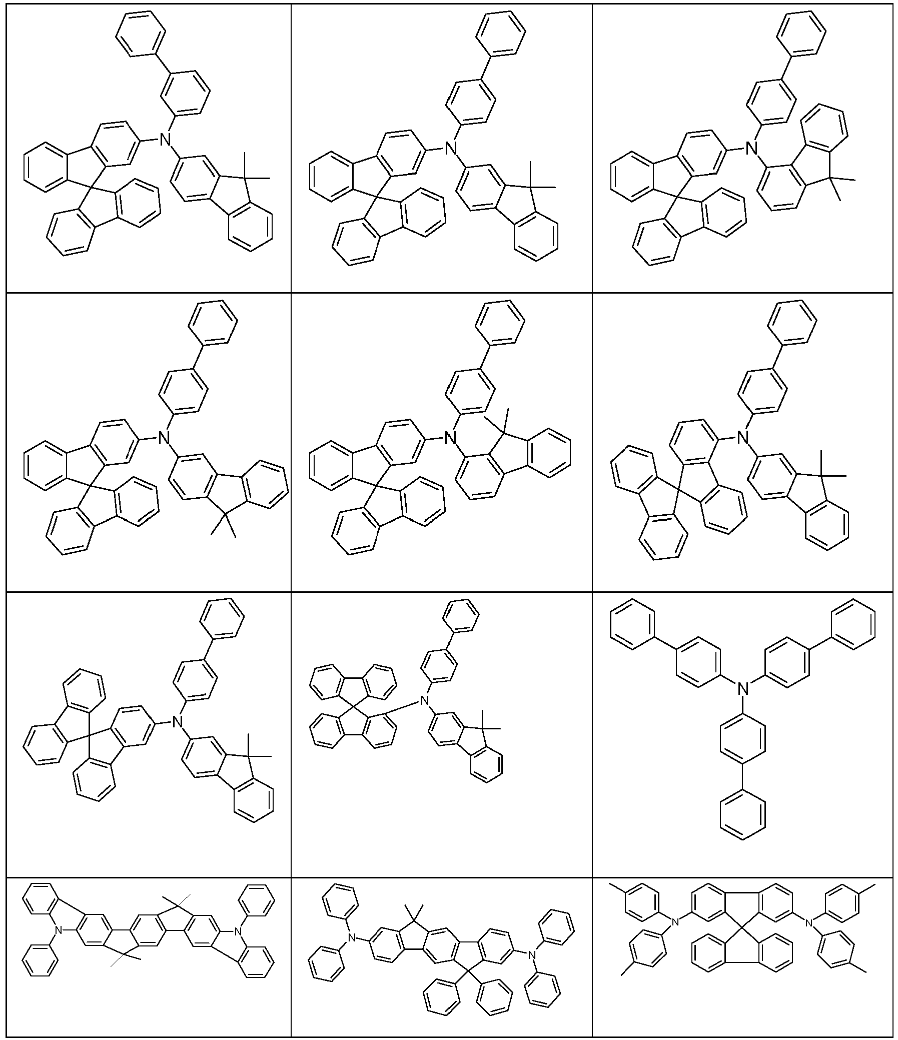

Beispiele für Materialien, welche als Wide Bandgap Matrixmaterialien eingesetzt werden können, sind die folgenden Verbindungen:

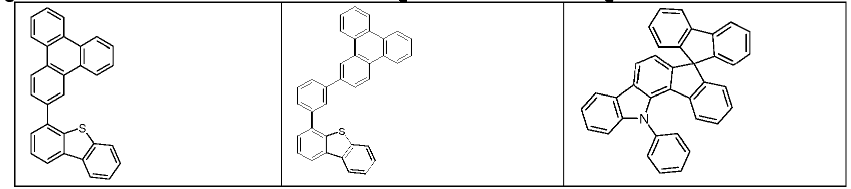

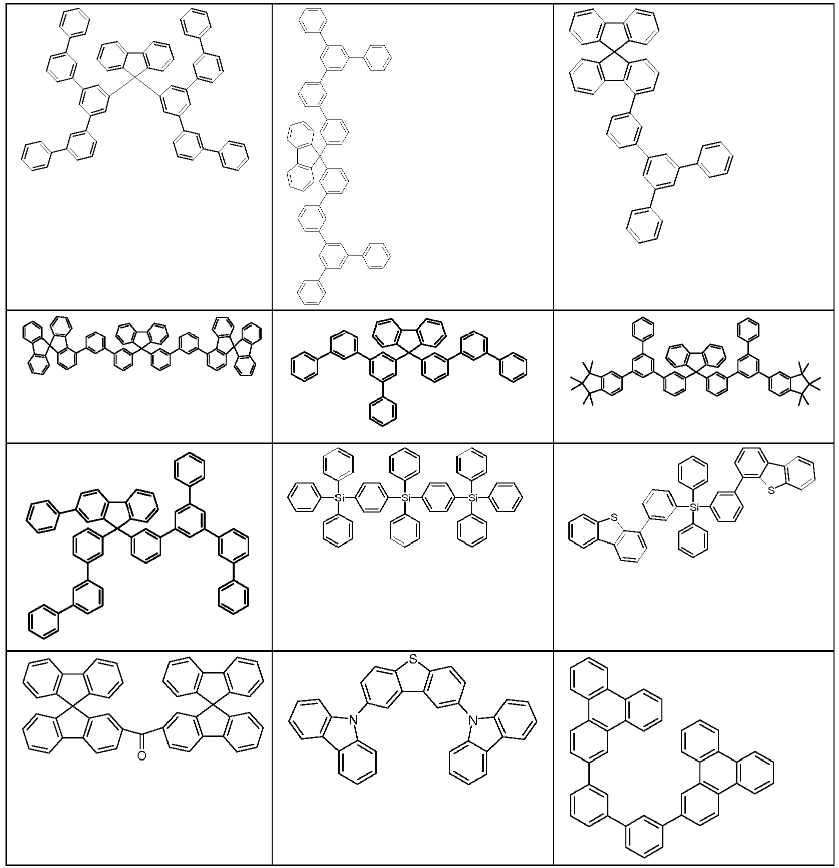

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe als Co-Matrix für längerwellig emittierende Triplettemitter, beispielsweise für grün oder rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist. Hierfür eignen sich insbesondere auch die Verbindungen, die in WO 2016/124304 und WO 2017/032439 offenbart sind.

Beispiele für geeignete Triplettemitter, welche als Co-Dotanden für die erfindungsgemäßen Verbindungen eingesetzt werden können, sind in der folgenden Tabelle abgebildet.

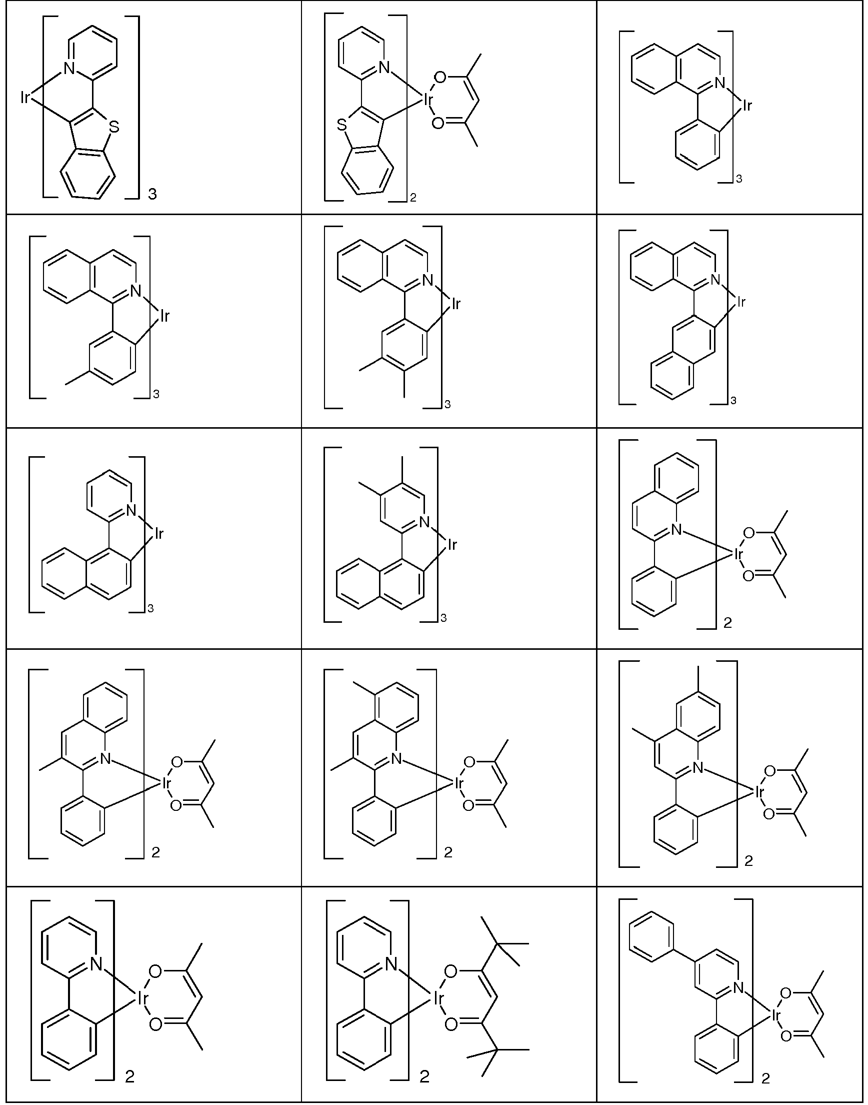

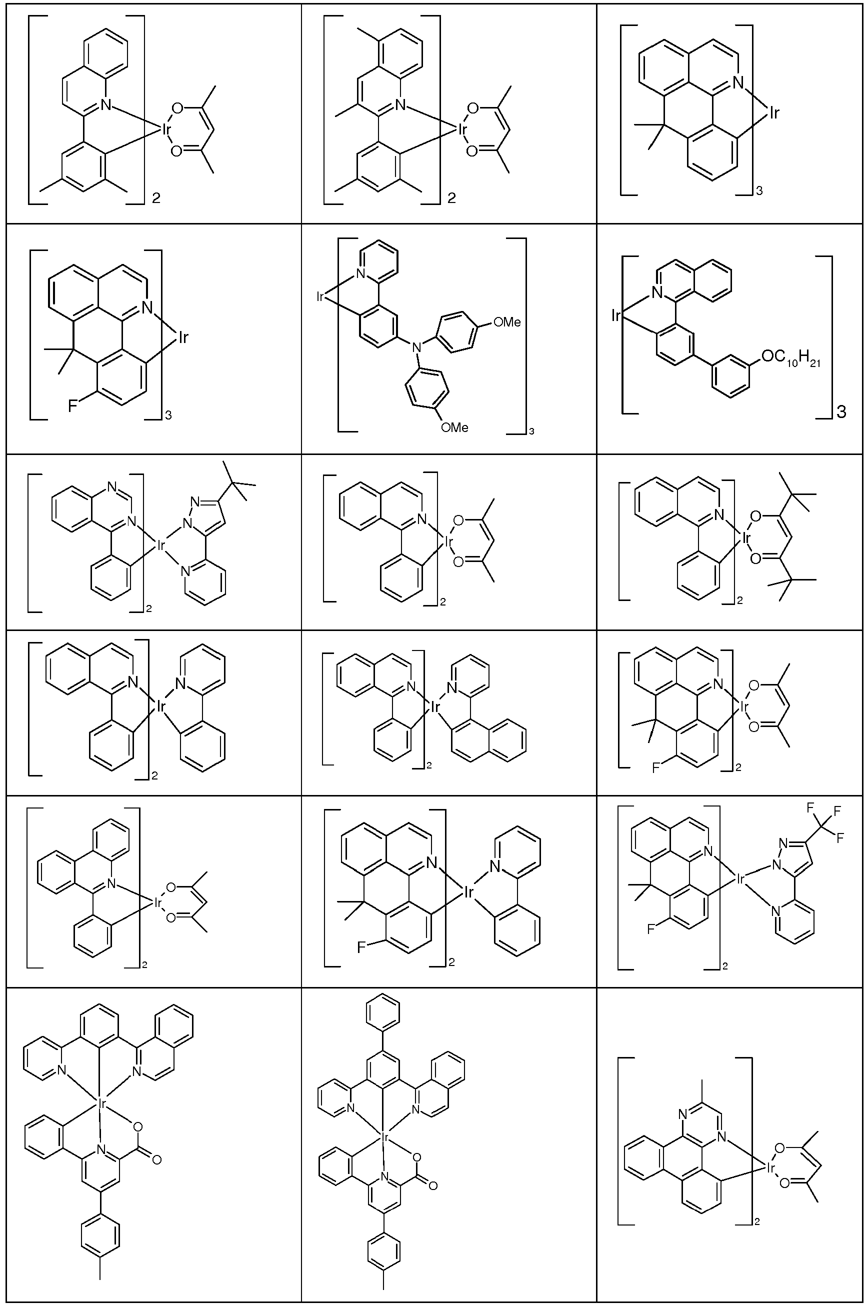

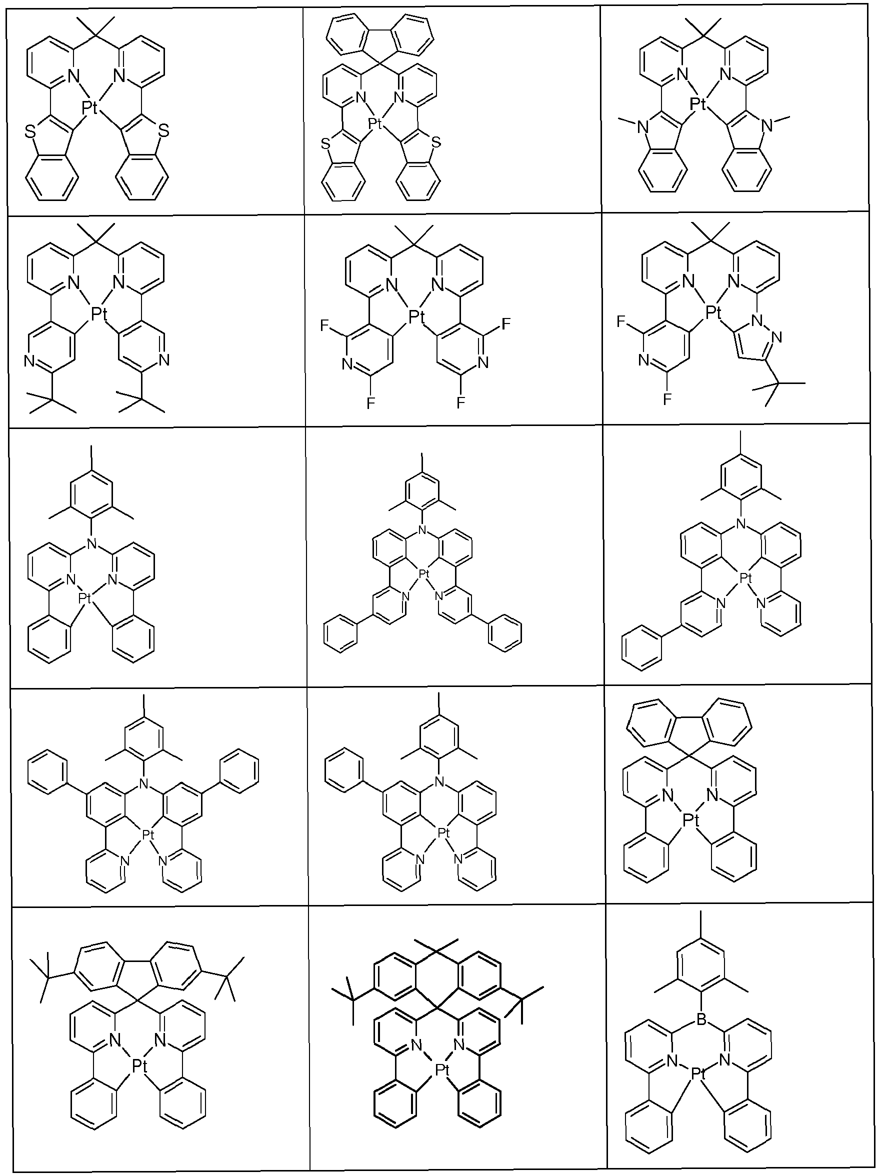

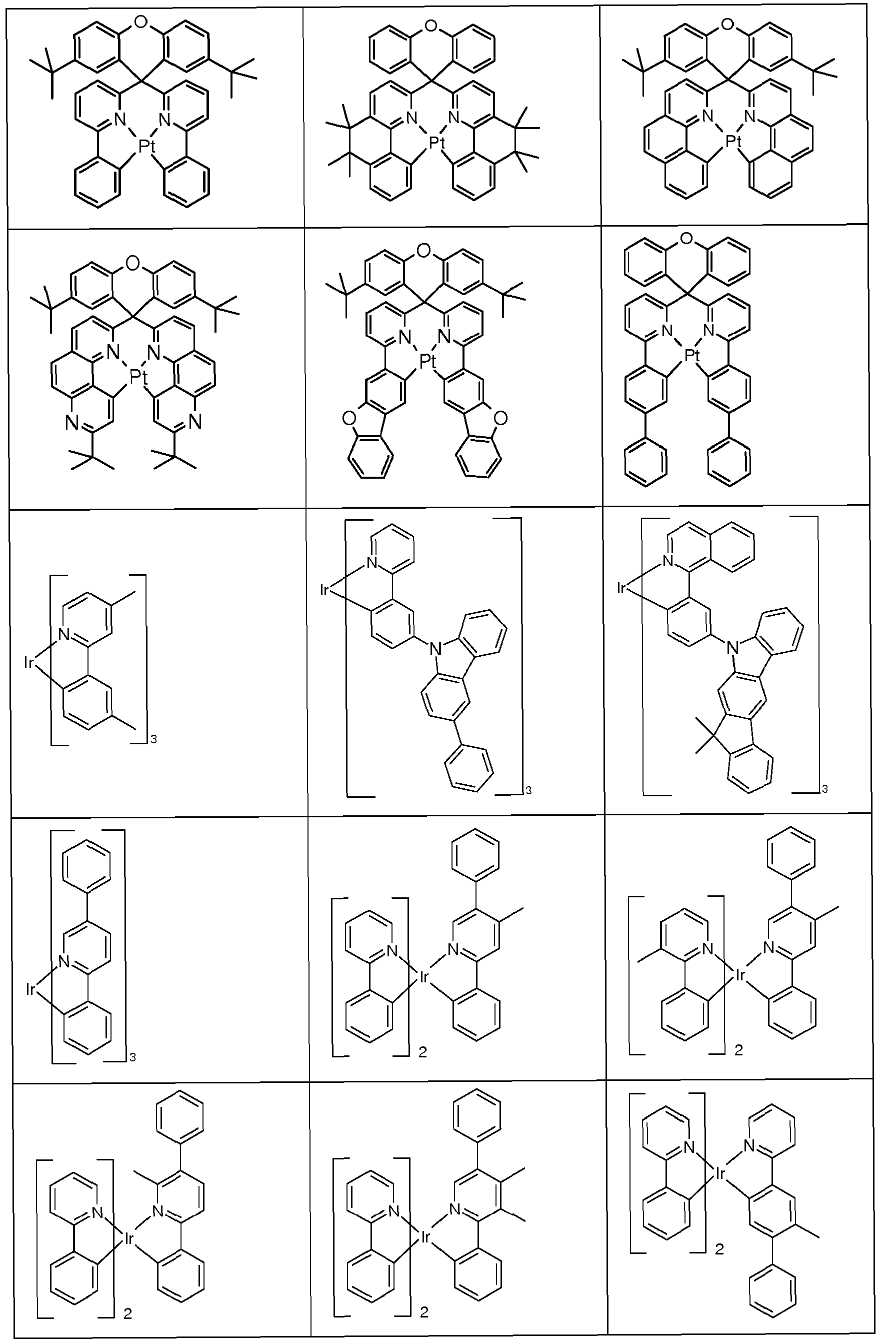

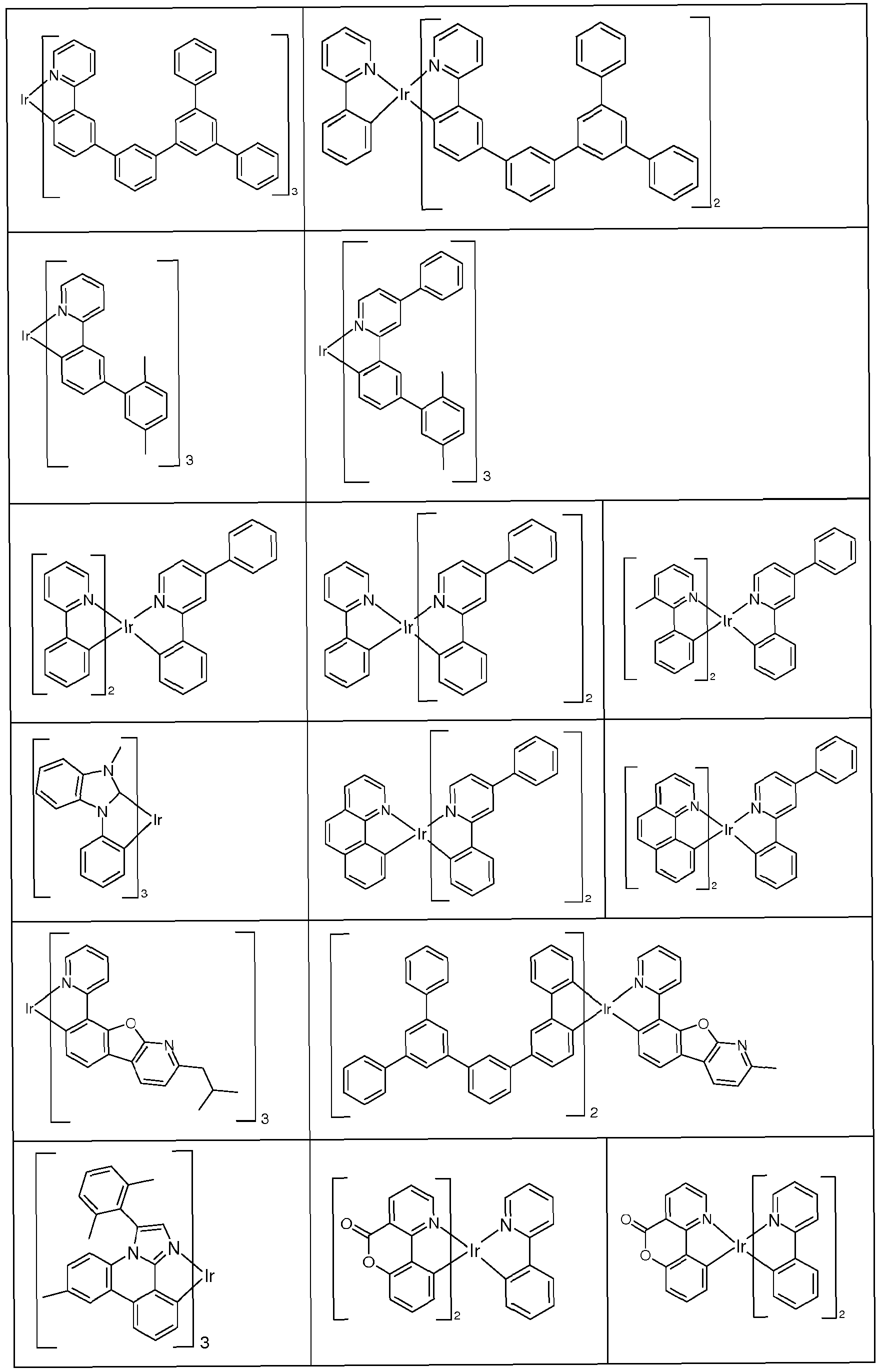

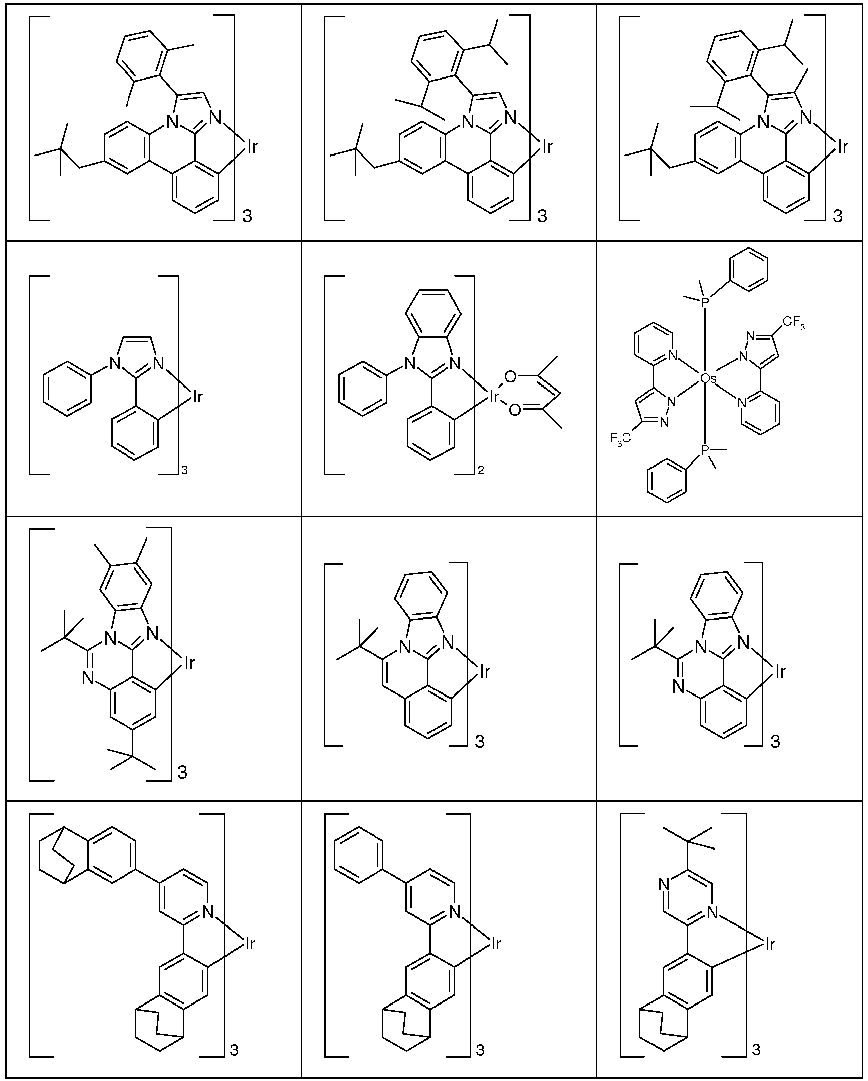

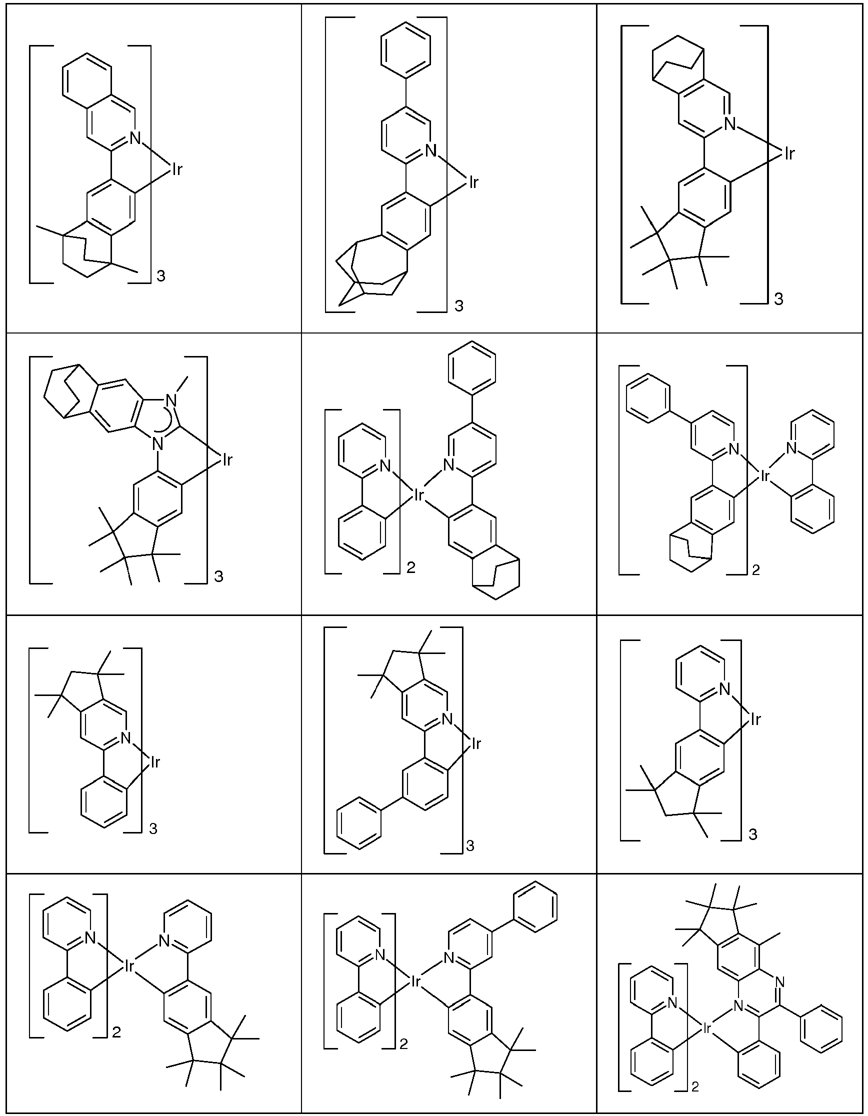

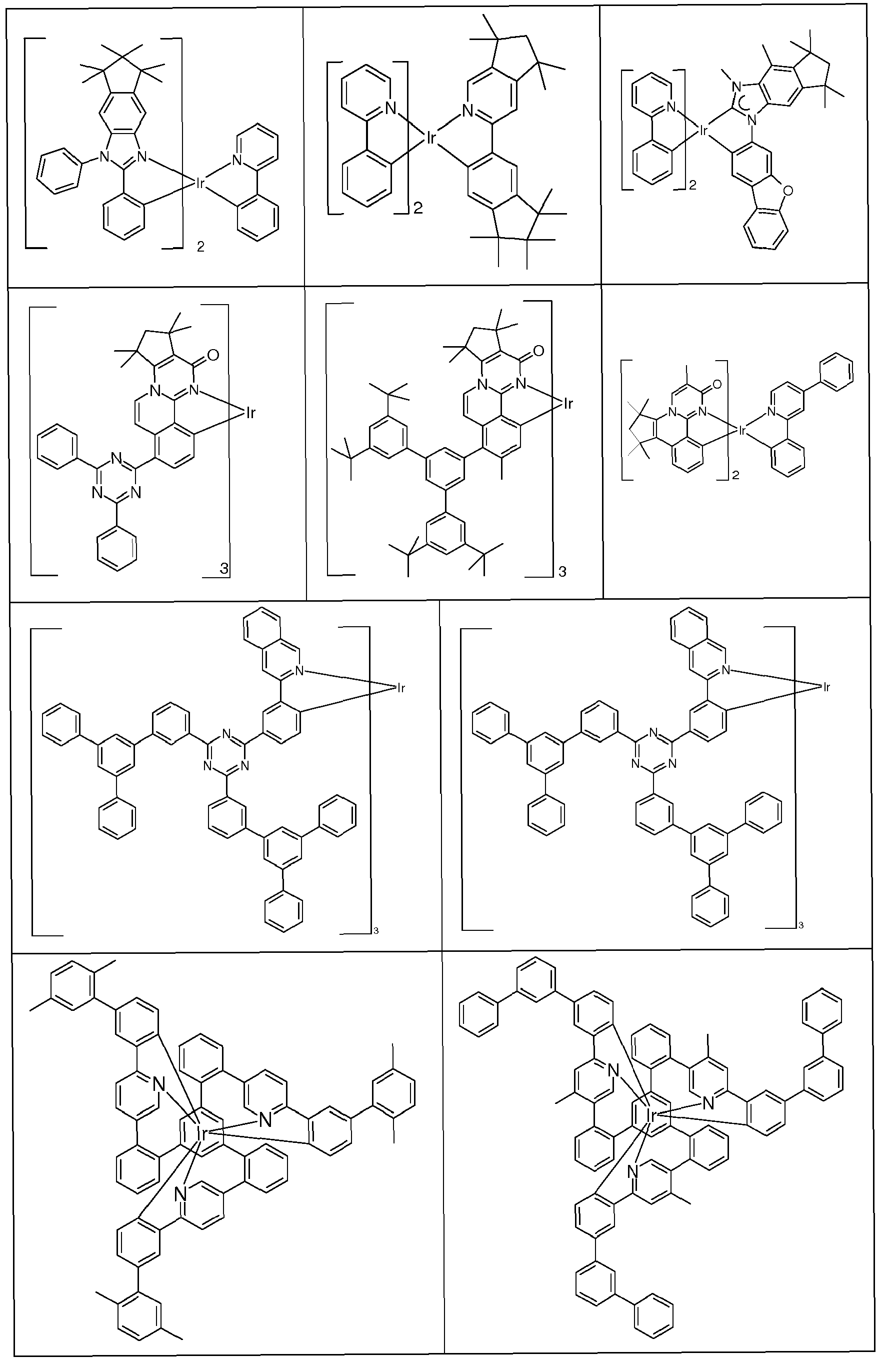

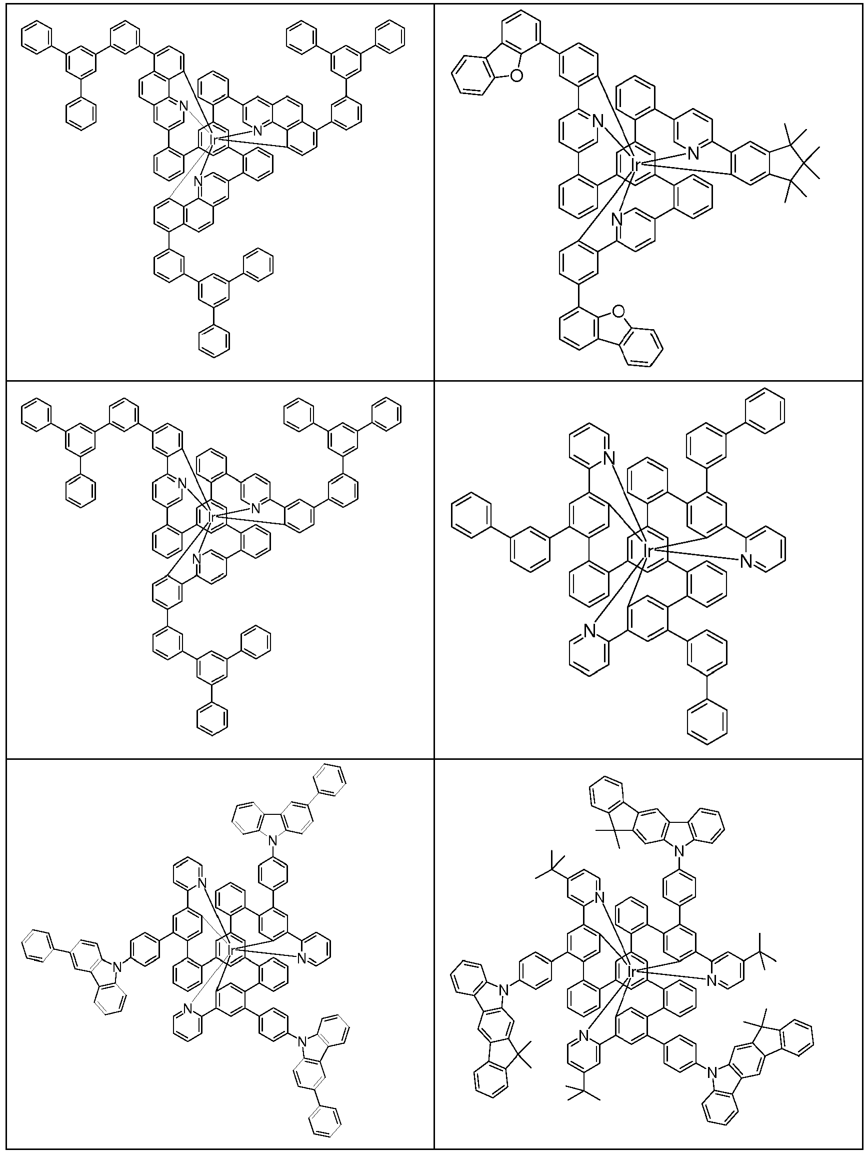

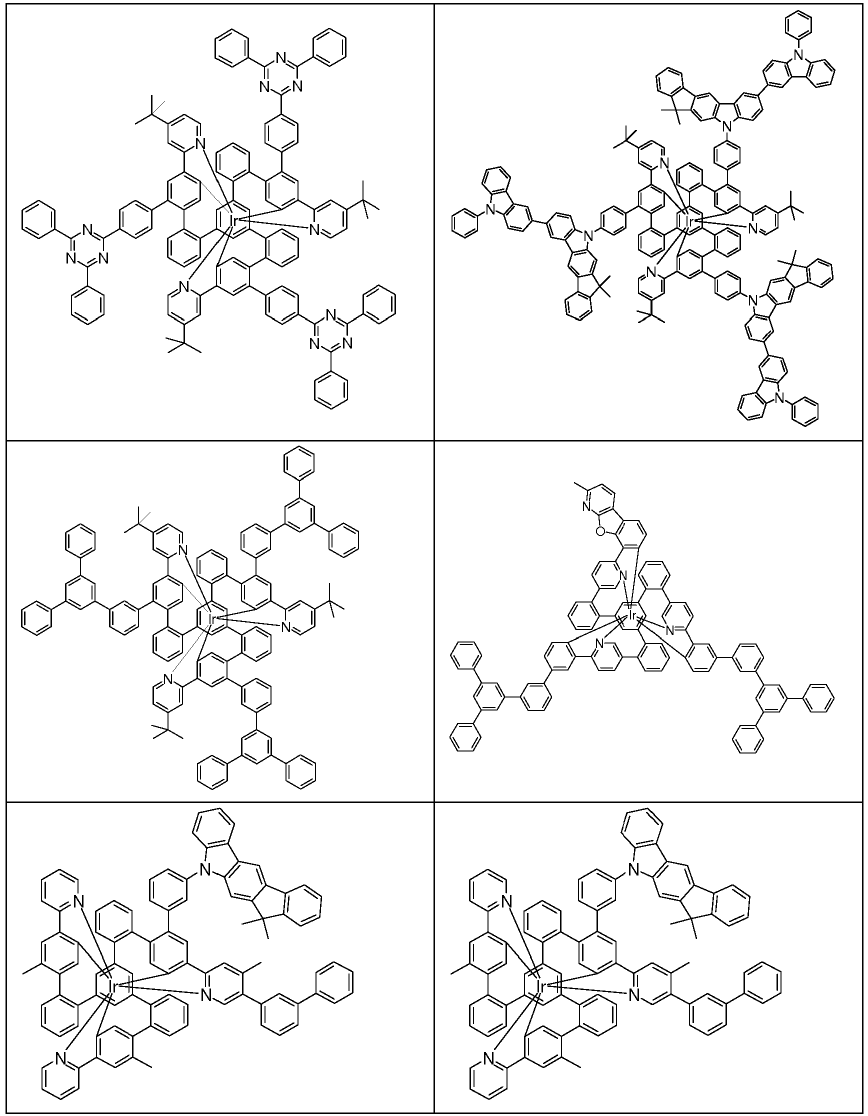

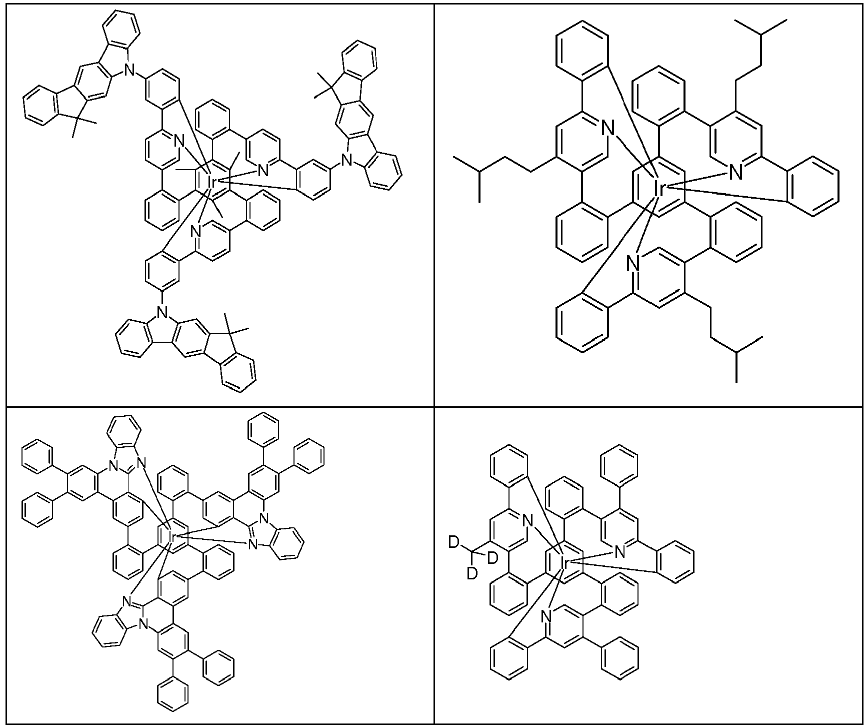

Die erfindungsgemäßen Metallkomplexe lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht, je nach genauer Struktur des Liganden. Ebenso lassen sich die erfindungsgemäßen Metallkomplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. In einer bevorzugten Ausführungsform der Erfindung wird die Schicht, die die erfindungsgemäße Verbindung enthält, aus Lösung aufgebracht.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Die erfindungsgemäßen Verbindungen weisen eine sehr hohe Photolumineszenz-Quantenausbeute auf. Dies führt bei Verwendung in einer organischen Elektrolumineszenzvorrichtung zu hervorragenden Effizienzen.
2. Die erfindungsgemäßen Verbindungen weisen eine sehr geringe Lumineszenzlebensdauer auf. Dies führt bei Verwendung in einer organischen Elektrolumineszenzvorrichtung zu einem verbesserten Roll-off-Verhalten sowie durch Vermeidung nicht-radiativer Relaxationskanäle zu einer höheren Lumineszenz-Quantenausbeute.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese der Synthone

### Beispiel B1:

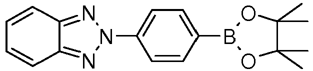

Ein Gemisch aus 23.0 g (100 mmol) 2-(4-Chlorphenyl)-2*H*-benzo-[d]-[1,2,3]-triazol [3933-77-5], 27.4 g (107 mmol) Bis(pinacolato)diboran [73183-34-3], 29.5 g (300 mmol) Kaliumacetat, 1.1 g (4 mmol) SPhos [657408-07-6], 650 mg (3 mmol) Palladium(II)acetat und 450 ml 1,4-Dioxan werden 16 h unter Rückfluss erhitzt. Das Dioxan wird am Rotationsverdampfer abrotiert, der schwarze Rückstand wird mit 1000 ml Ethylacetat und 500 mL Wasser extraktiv im Scheidetrichter aufgearbeitet, die organische Phase wird einmal mit 300 mL Wasser und einmal mit 150 mL gesättigter Natriumchloridlösung gewaschen und über ein Kieselgelbett filtriert. Das Kieselgel wird mit 2 x 250 mL Ethylacetat nachgewaschen. Das Filtrat wird über Natriumsulfat getrocknet und dann eingeengt. Der Rückstand wird in 200 mL n-Heptan digeriert und die Suspension 1 h auf Rückfluss erhitzt. Nach dem Abkühlen wird der Feststoff abgesaugt und mit wenig n-Heptan gewaschen. Ausbeute: 26.0 g (81 mmol), 81 %. Reinheit: ca. 96%ig nach ¹H-NMR.

**Beispiel B2:**

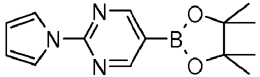

Durchführung analog zu Beispiel B1, wobei statt 2-(4-Chlorphenyl)-2*H-*benzo-[d]-[1,2,3]-triazol 5-Chlor-2-(1H-pyrrol-1-yl)pyrimidin [860785-43-9] verwendet wird.

### Beispiel B3:

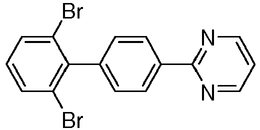

Ein Gemisch aus 10 g (50 mmol) [4-(2-Pyrimidinyl)phenyl]boronsäure [1615248-01-5], 18.1 g (50 mmol) 1,3-Dibrom-2-iodbenzol [19821-80-8], 15.9 g (150 mmol) Natriumcarbonat, 390 mg (1.5 mmol) Triphenylphosphin, 110 mg (0.5 mmol) Palladium(II)acetat, 120 ml Toluol, 40 mL Ethanol und 120 mL Wasser wird 60 h unter Rückfluss erhitzt. Nach dem Abkühlen wird die Reaktionsmischung extraktiv im Scheidetrichter aufgearbeitet. Hierzu wird die organische Phase abgetrennt und die wässrige Phase zweimal mit je 50 mL Ethylacetat extrahiert. Anschließend werden die vereinigten organischen Phasen zweimal mit je 100 mL Wasser und einmal mit 50 mL gesättigter Natriumchloridlösung gewaschen, über Natriumsulfat getrocknet und zur Trockene eingeengt. Der Rückstand wird durch Säulenchromatographie an Kieselgel mit Dichlormethan als Eluent aufgereinigt. Ausbeute 8.1 g (21 mmol), 42%, 95%ig nach ¹H-NMR.

### Beispiel B160:

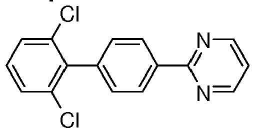

Ein Gemisch aus 10 g (50 mmol) [4-(2-Pyrimidinyl)phenyl]boronsäure [1615248-01-5], 11.3 g (50 mmol) 1,3-Dichlor-2-brombenzol [19393-92-1], 15.9 g (150 mmol) Natriumcarbonat, 1.2 g (1 mmol) Tetrakis(triphenylphosphin)palladium(0), 200 mL 1,2-Dimethoxyethan und 200 mL Wasser wird 20 h unter Rückfluss erhitzt. Nach dem Abkühlen wird die Reaktionsmischung extraktiv im Scheidetrichter mit 150 mL Toluol und 150 mL Wasser aufgearbeitet. Die organische Phase wird abgetrennt und die wässrige Phase zweimal mit je 50 mL Toluol extrahiert. Anschließend werden die vereinigten organischen Phasen zweimal mit je 100 mL Wasser und einmal mit 50 mL gesättigter Natriumchloridlösung gewaschen, über Natriumsulfat getrocknet und zur Trockene eingeengt. Der Rückstand wird durch Säulenchromatographie an Kieselgel mit Ethylacetat/Heptan gereinigt. Es wird ein farbloses Öl erhalten. Ausbeute: 10.5 g (35 mmol), 70%, 97%ig nach ¹H-NMR.

Analog können folgende Verbindungen hergestellt werden:

| Bsp. | Edukt | Produkt | Ausbeute |
|---|---|---|---|
| B4 | 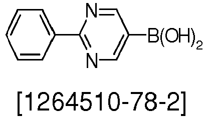 | 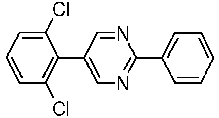 | 65% |
| B5 | 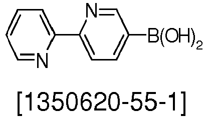 | 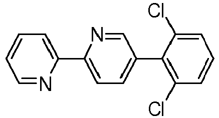 | 71% |
| B6 | B1 | 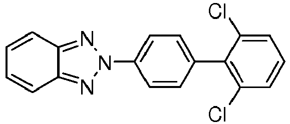 | 69% |
| B7 | B2 | 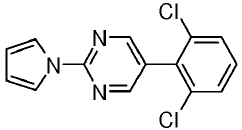 | 72% |

### Beispiel B8:

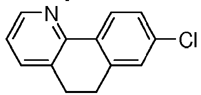

Ein Gemisch aus 18.1 g (100 mmol) 6-Chlor-tetralon [26673-31-4], 16.5 g (300 mmol) Propargylamin [2450-71-7], 796 mg [2 mmol] Natrium-tetra-chloroaurat(III) Dihydrat und 200 ml Ethanol wird 24 h im Autoklaven bei 120 °C gerührt. Nach Erkalten entfernt man das Ethanol im Vakuum, nimmt den Rückstand in 200 ml Ethylacetat auf, wäscht die Lösung dreimal mit 200 ml Wasser und einmal mit 100 ml gesättigter Kochsalzlösung, trocknet über Magnesiumsulfat und filtriert dann von diesem über ein vorgeschlämmtes Kieselgelbett ab. Nach Entfernen des Ethylacetats im Vakuum wird der Rückstand an Kieselgel mit n-Heptan/Ethylaceat (1:2 vv) chromatographiert. Ausbeute: 9.7 g (45 mmol), 45%. Reinheit: ca. 98 %ig n. ¹H-NMR.

### Beispiel B9:

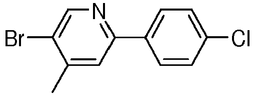

Ein Gemisch aus 25.1 g (100 mmol) 2,5-Dibrom-4-methylpyridin [3430-26-0], 15.6 g (100 mmol) 4-Chlorphenylboronsäure [1679-18-1], 27.6 g (200 mmol) Kaliumcarbonat, 1.57 g (6 mmol) Triphenylphosphin [603-35-0], 676 mg (3 mmol) Palladium(II)acetat [3375-31-3], 200 g Glaskugeln (3 mm Durchmesser), 200 ml Acetonitril und 100 ml Ethanol wird 48 h unter Rückfluss erhitzt. Nach Erkalten entfernt man die Lösemittel im Vakuum, gibt 500 ml Toluol zu, wäscht zweimal mit je 300 ml Wasser und einmal mit 200 ml gesättigter Kochsalzlösung, trocknet über Magnesiumsulfat, filtriert über ein vorgeschlämmtes Kieselgelbett ab und wäscht dieses mit 300 ml Toluol nach. Nach Entfernen des Toluols im Vakuum kristallisiert man einmal aus Methanol/Ethanol (1:1 vv) und einmal aus n-Heptan um. Ausbeute: 17.3 g (61 mmol), 61 %. Reinheit: ca. 95 %ig. ¹H-NMR.

### Beispiel B10:

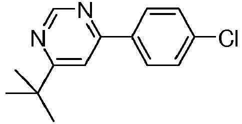

Analog zur Durchführung in Beispiel B9 kann B10 dargestellt werden. Hierzu wird statt 2,5-Dibrom-4-methyl-pyridin 4-Brom-6-tert-butylpyrimidin [19136-36-8] verwendet. Ausbeute: 70%.

### Beispiel B11:

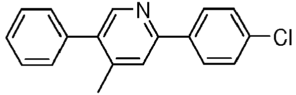

Ein Gemisch aus 28.3 g (100 mmol) B9, 12.8 g (105 mmol) Phenylboronsäure, 31.8 g (300 mmol) Natriumcarbonat, 787 mg (3 mmol) Triphenylphosphin, 225 mg (1 mmol) Palladium(II)acetat, 300 ml Toluol, 150 ml Ethanol und 300 ml Wasser wird 48 h unter Rückfluss erhitzt. Nach Erkalten wird mit 300 ml Toluol erweitert, die organische Phase wird abgetrennt, einmal mit 300 ml Wasser und einmal mit 200 ml gesättigter Kochsalzlösung gewaschen und über Magnesiumsulfat getrocknet. Nach Entfernen das Lösungsmittels wird der Rückstand an Kieselgel (Toluol/Ethylacetat, 9:1 vv) chromatographiert. Ausbeute: 17.1 g (61 mmol), 61 %. Reinheit: ca. 97 %ig n. ¹H-NMR.

Analog können die folgenden Verbindungen synthetisiert werden:

| Bsp. | Boronester | Produkt | Ausbeute |
|---|---|---|---|
| B12 | 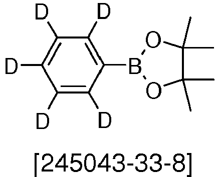 | 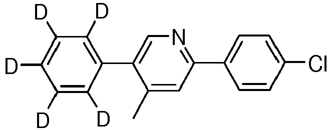 | 56 % |
| B13 | 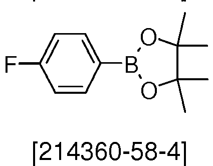 | 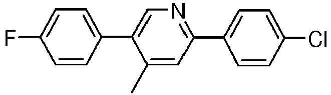 | 61 % |
| B14 | 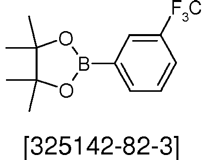 | 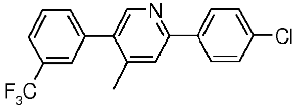 | 55 % |

### Beispiel B15:

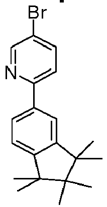

Ein Gemisch aus 164.2 g (500 mmol) 2-(1,1,2,2,3,3-Hexamethylindan-5-yl)-4,4,5,5-tetramethyl-[1,3,2]-dioxaborolan [152418-16-9] (analog können Boronsäuren eingesetzt werden), 142.0 g (500 mmol) 5-Brom-2-iod-pyridin [223463-13-6], 159.0 g (1.5 mol) Natriumcarbonat, 5.8 g (5 mmol) Tetrakis(triphenylphosphino)-palladium(0), 700 ml Toluol, 300 ml Ethanol und 700 ml Wasser wird unter gutem Rühren 16 h unter Rückfluss erhitzt. Nach dem Abkühlen werden 1000 ml Toluol zugegeben, die organische Phase wird abgetrennt, und die wässrige Phase wird mit 300 ml Toluol nachextrahiert. Die vereinigten organischen Phasen werden einmal mit 500 ml gesättigter Kochsalzlösung gewaschen. Nach Trocknen der organischen Phase über Natriumsulfat und Entfernen des Lösemittels im Vakuum kristallisiert man das Rohprodukt zweimal aus ca. 300 ml EtOH um. Ausbeute: 130.8 g (365 mmol), 73 %. Reinheit: ca. 95 %ig n. ¹H-NMR.

Analog können die nachfolgenden Verbindungen dargestellt werden, wobei als Pyridinderivat im Allgemeinen 5-Brom-2-iod-pyridin ([223463-13-6]) eingesetzt wird, welches in der folgenden Tabelle nicht separat aufgeführt ist. Lediglich davon abweichende Pyridinderivate sind in der Tabelle explizit aufgeführt. Zur Umkristallisation können Lösungsmittel wie Ethylacetat, Cyclohexan, Toluol, Acetonitril, n-Heptan, Ethanol oder Methanol verwendet werden. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Boronsäure/-ester Pyridin | Produkt | Ausbeute |
|---|---|---|---|
| B16 | 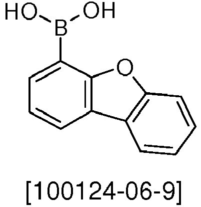 | 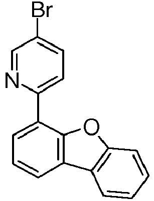 | 69 % |
| B17 | 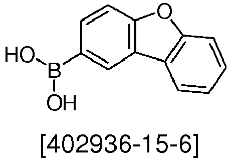 | 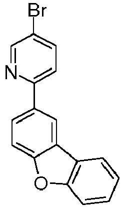 | 71 % |
| B18 | 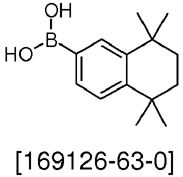 | 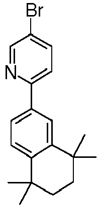 | 78 % |
| B19 | 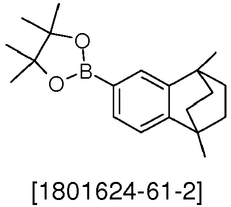 | 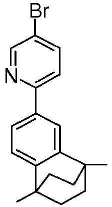 | 78 % |
| B20 | 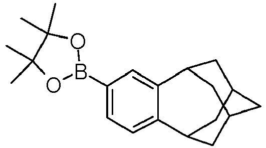 | 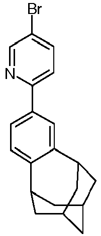 | 81 % |
| | Siehe WO 2016/124304 | | |
| B21 | 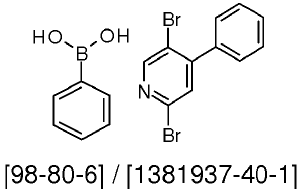 | 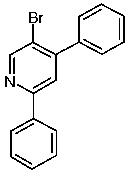 | 73 % |
| B22 | 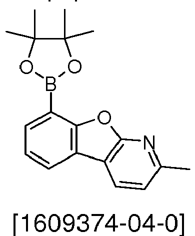 | 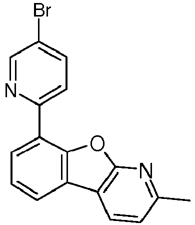 | 68 % |
| B23 | 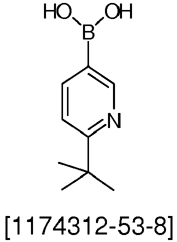 | 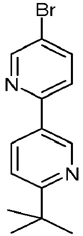 | 63 % |

### Beispiel B24:

### Variante A:

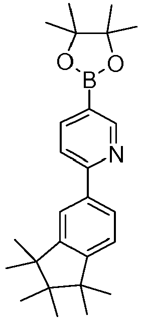

Ein Gemisch aus 35.8 g (100 mmol) B15, 25.4 g (100 mmol) Bis(pinacolato)diboran [73183-34-3], 49.1 g (500 mmol) Kaliumacetat, 1.5 g (2 mmol) 1,1-Bis(diphenylphosphino)ferrocendichlorpalladium(II)-Komplex mit DCM [95464-05-4], 200 g Glaskugeln (3 mm Durchmesser), 700 ml 1,4-Dioxan und 700 ml Toluol werden 16 h unter Rückfluss erhitzt. Nach Abkühlen wird die Suspension über ein Celite-Bett filtriert und das Lösemittel im Vakuum entfernt. Der schwarze Rückstand wird mit 1000 ml heißem n-Heptan, Cyclohexan oder Toluol digeriert, es wird noch heiß über ein Celite-Bett abfiltriert und dann auf ca. 200 ml eingeengt, wobei das Produkt zu kristallisieren beginnt. Alternativ kann mit Ethylacetat heißextrahiert werden. Die Kristallisation wird über Nacht im Kühlschrank vervollständigt, die Kristalle werden abfiltriert und mit wenig n-Heptan gewaschen. Aus der Mutterlauge kann eine zweite Produktfraktion gewonnen werden. Ausbeute: 31.6 g (78 mmol), 78 %. Reinheit: ca. 95 %ig n. ¹H-NMR.

### Variante B: Umsetzung von Arylchloriden

Wie Variante A, jedoch wird an Stelle von 1,1-Bis(diphenylphosphino)-ferrocendichlorpalladium(II)-Komplex mit DCM 2 mmol SPhos [657408-07-6] und 1 mmol Palladium(II)acetat eingesetzt.

Analog können folgende Verbindungen dargestellt werden, wobei zur Reinigung anstelle von n-Heptan auch Cyclohexan, Toluol, Acetonitril bzw. Gemische der genannten Lösungsmittel verwendet werden können:

| Bsp. | Bromid - Variante A Chlorid - Variante B | Produkt | Ausbeute |
|---|---|---|---|
| B25 | 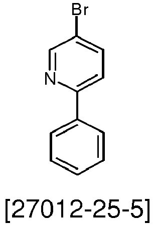 | 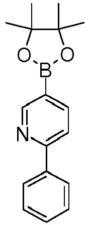 | 85 % |
| B26 | 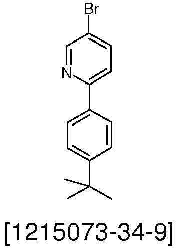 | 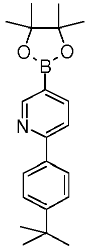 | 80% |
| B27 | 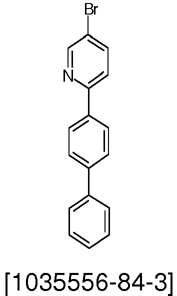 | 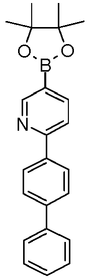 | 83 % |
| B28 | 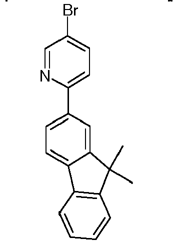 | 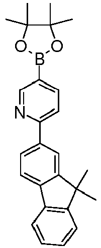 | 77% |
| | 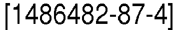 | | |
| B29 | 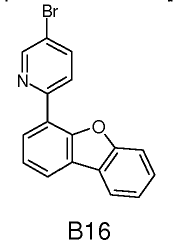 | 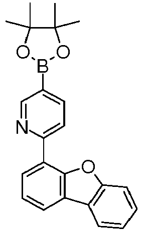 | 67 % |
| B30 | 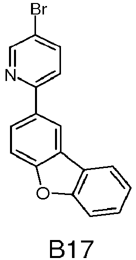 | 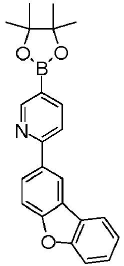 | 70 % |
| B31 | 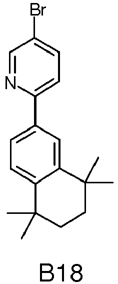 | 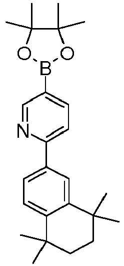 | 80 % |
| B32 | 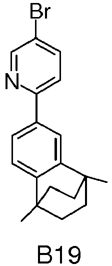 | 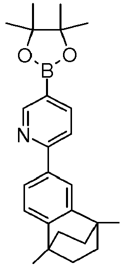 | 80 % |
| B33 | 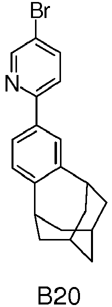 | 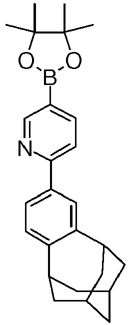 | 78 % |
| B34 | 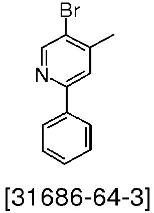 | 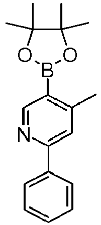 | 74 % |
| B35 | 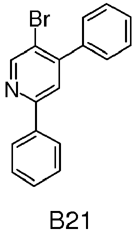 | 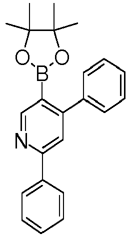 | 70 % |
| B36 | 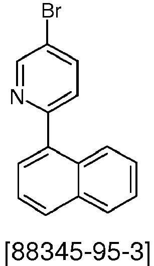 | 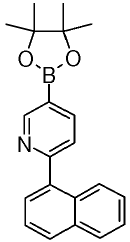 | 68 % |
| B37 | 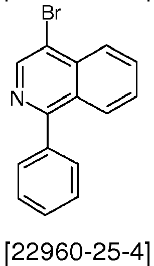 | 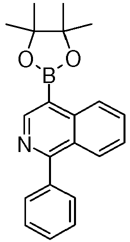 | 76 % |
| B38 | 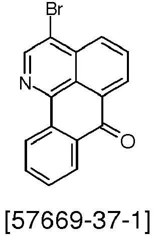 | 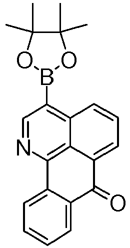 | 83 % |
| B39 | 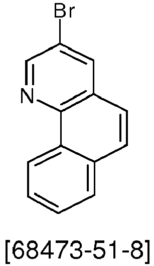 | 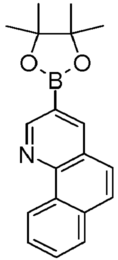 | 85 % |
| B40 | 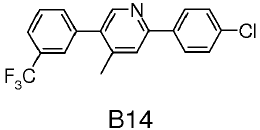 | 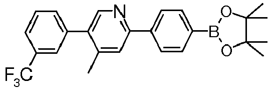 | 55 % |
| B41 | 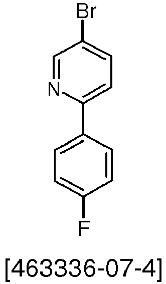 | 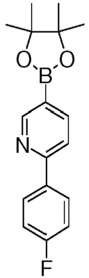 | 72 % |
| B42 | 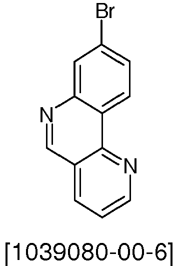 | 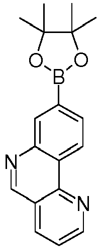 | 78% |
| B43 | 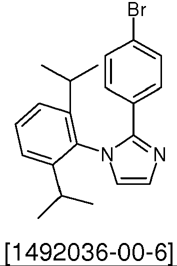 | 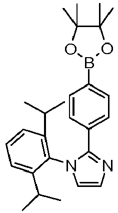 | 82 % |
| B44 | 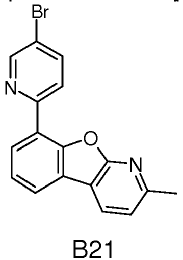 | 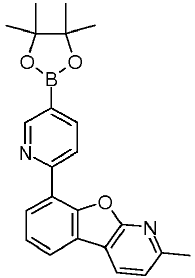 | 60 % |
| B45 | 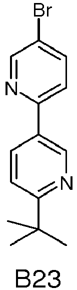 | 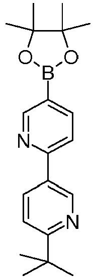 | 75 % |
| B46 | 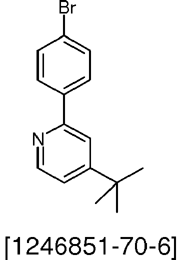 | 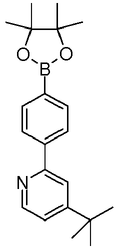 | 88 % |
| B47 | 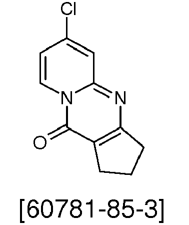 | 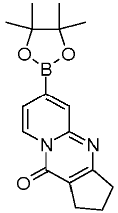 | 78 % |
| B48 | 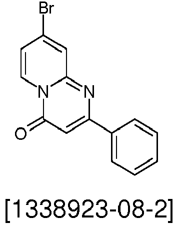 | 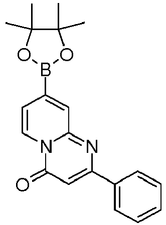 | 82 % |
| B49 | 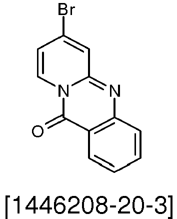 | 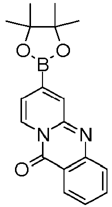 | 80 % |
| B50 | 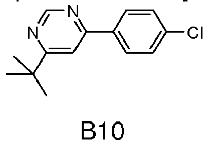 | 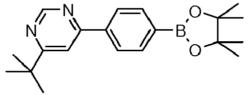 | 85% |
| B51 | 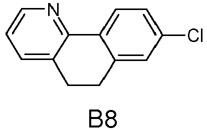 | 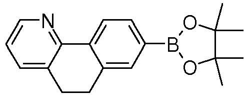 | 88 % |
| B52 | 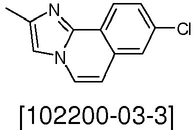 | 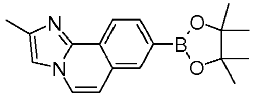 | 76 % |
| B53 | 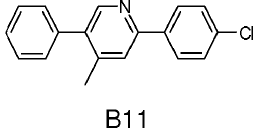 | 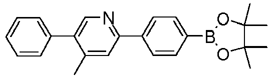 | 81 % |
| B54 | 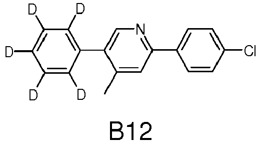 | 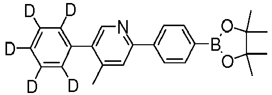 | 78 % |
| B55 | 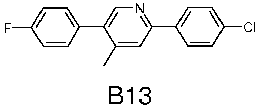 | 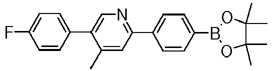 | 75 % |

### Beispiel B56:

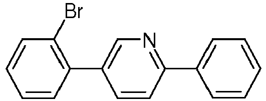

Ein Gemisch aus 28.1 g (100 mmol) B25, 28.2 g (100 mmol) 1-Brom-2-iodbenzol [583-55-1], 31.8 g (300 mmol) Natriumcarbonat, 787 mg (3 mmol) Triphenylphosphin, 225 mg (1 mmol) Palladium(II)acetat, 300 ml Toluol, 150 mol Ethanol und 300 ml Wasser wird 24 h unter Rückfluss erhitzt. Nach Erkalten wird mit 500 ml Toluol erweitert, die organische Phase wird abgetrennt, einmal mit 500 ml Wasser, einmal mit 500 ml gesättigter Kochsalzlösung gewaschen und über Magnesiumsulfat getrocknet. Nach Entfernen das Lösungsmittels wird der Rückstand aus Ethylacetat/n-Heptan umkristallisiert oder an Kieselgel (Toluol/Ethylacetat, 9:1 vv) chromatographiert. Ausbeute: 22.7 g (73 mmol), 73 %. Reinheit: ca. 97 %ig n. ¹H-NMR.

Analog können folgende Verbindungen dargestellt werden, wobei zur Umkristallisation Lösemittel wie z. B. Ethylacetat, Cyclohexan, Toluol, Acetonitril, n-Heptan, Ethanol oder Methanol verwendet werden können. Es kann auch mit diesen Lösungsmitteln heißextrahiert werden, oder die Aufreinigung kann chromatographisch an Kieselgel auf einem Säulenautomaten (Torrent der Firma Axel Semrau) erfolgen.

| Bsp. | Boronester | Produkt | Ausbeute |
|---|---|---|---|
| B57 | 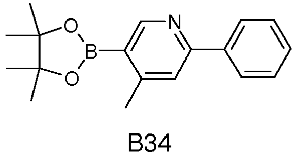 | 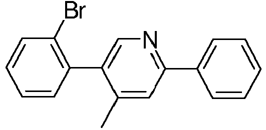 | 56 % |
| B58 | 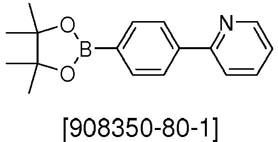 | 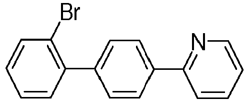 | 72 % |
| B59 | 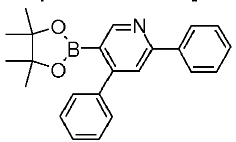 | 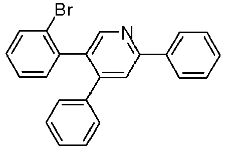 | 71 % |
| | 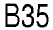 | | |
| B60 | 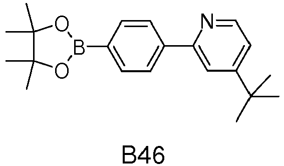 | 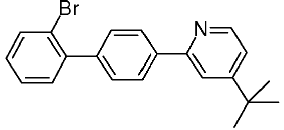 | 70 % |
| B61 | 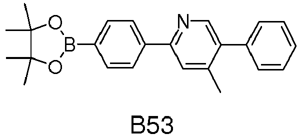 | 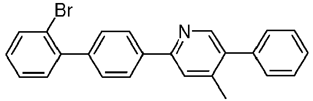 | 69 % |
| B62 | 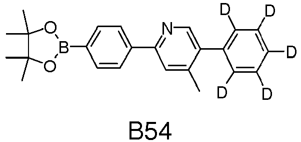 | 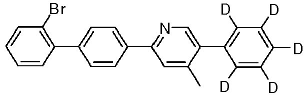 | 67 % |
| B63 | 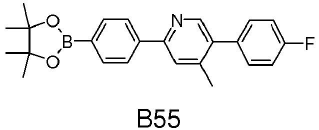 | 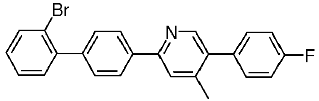 | 63 % |
| B64 | 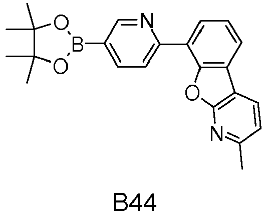 | 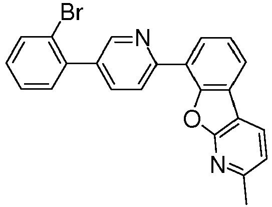 | 70 % |
| B65 | 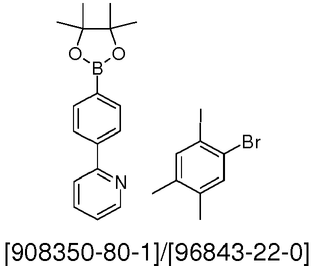 | 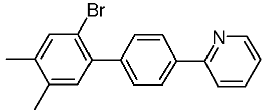 | 73 % |
| B66 | 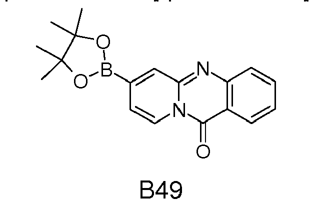 | 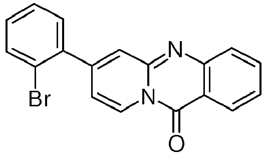 | 72 % |
| B67 | 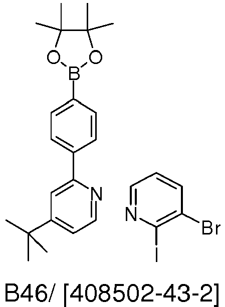 | 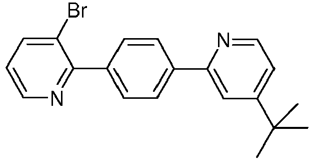 | 48 % |
| B68 | 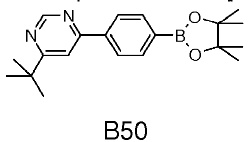 | 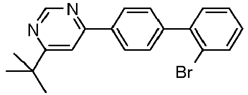 | 65% |
| B69 | 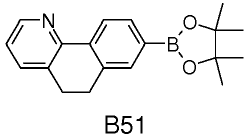 | 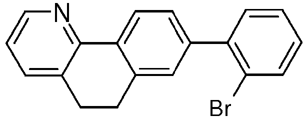 | 65 % |
| B70 | 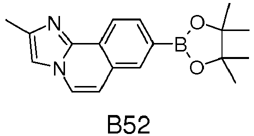 | 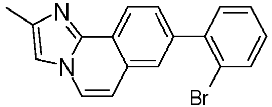 | 68% |
| B71 | 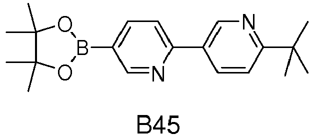 | 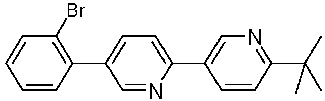 | 77% |
| B72 | 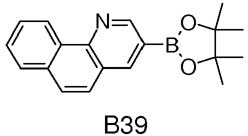 | 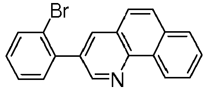 | 70% |
| B73 | 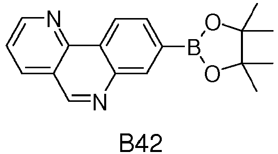 | 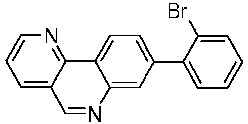 | 66% |
| B74 | 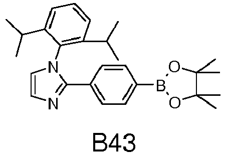 | 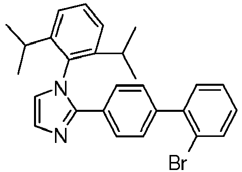 | 71% |
| B75 | 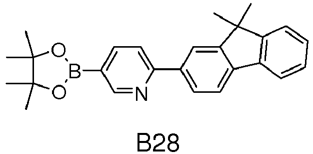 | 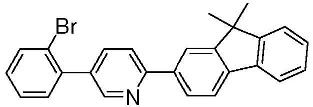 | 64% |
| B76 | 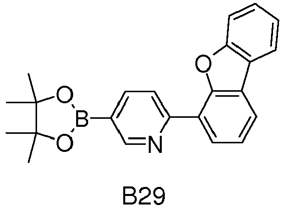 | 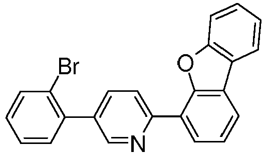 | 58 % |
| B77 | 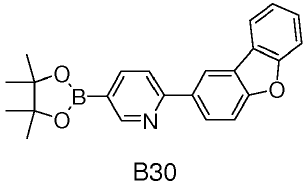 | 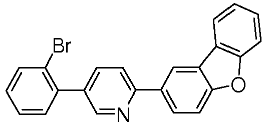 | 62 % |
| B78 | 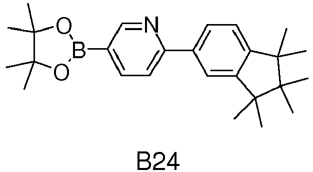 | 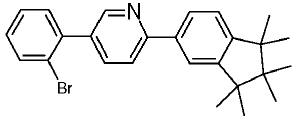 | 75% |
| B79 | 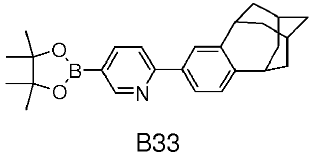 | 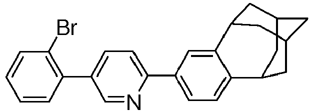 | 78 % |
| B80 | 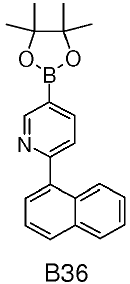 | 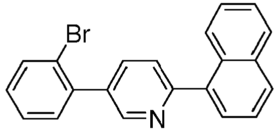 | 82% |

### Beispiel B81:

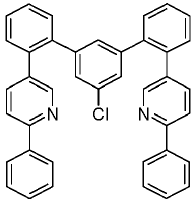

Ein Gemisch aus 36.4 g (100 mmol) 2,2'-(5-Chloro-1,3-phenylen)-bis-[4,4,5,5-tetramethyl-1,3,2-dioxaborolan] [1417036-49-7], 65.2 g (210 mmol) B56, 42.4 g (400 mmol) Natriumcarbonat, 1.57 g (6 mmol) Triphenylphosphin, 500 mg (2 mmol) Palladium(II)acetat, 500 ml Toluol, 200 ml Ethanol und 500 ml Wasser wird 48 h unter Rückfluss erhitzt. Nach Erkalten wird mit 500 ml Toluol erweitert, die organische Phase wird abgetrennt, einmal mit 500 ml Wasser, einmal mit 500 ml gesättigter Kochsalzlösung gewaschen und über Magnesiumsulfat getrocknet. Nach Entfernen des Lösungsmittels wird der Rückstand an Kieselgel (n-Heptan/Ethylacetat 2:1 vv) chromatographiert. Ausbeute: 41.4 g (68 mmol), 68 %. Reinheit: ca. 95 %ig nach ¹H-NMR.

Analog können folgende Verbindungen dargestellt werden, wobei zur Umkristallisation Lösemittel wie z. B. Ethylacetat, Cyclohexan, Toluol, Acetonitril, n-Heptan, Ethanol oder Methanol verwendet werden können. Es kann auch mit diesen Lösungsmitteln heißextrahiert werden, oder die Aufreinigung kann chromatographisch an Kieselgel auf einem Säulenautomaten (Torrent der Firma Axel Semrau) erfolgen.

| Bsp. | Bromid | Produkt | Ausbeute |
|---|---|---|---|
| B82 | 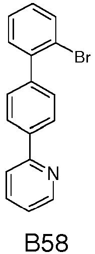 | 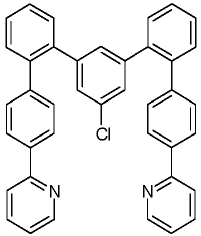 | 67 % |
| B83 | 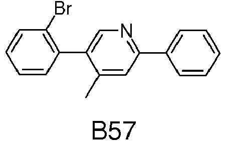 | 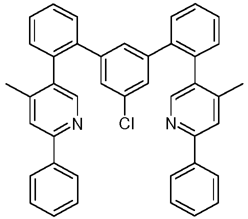 | 62% |
| B84 | 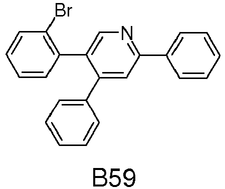 | 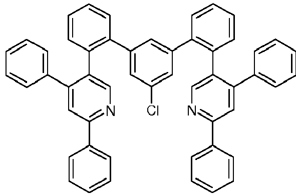 | 55% |
| B85 | 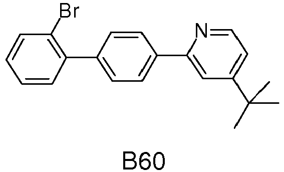 | 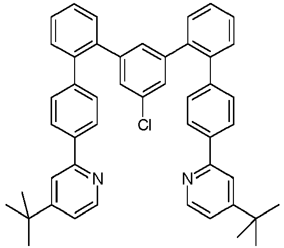 | 63% |
| B86 | 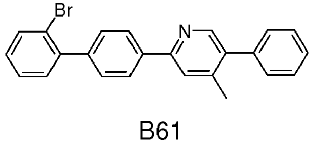 | 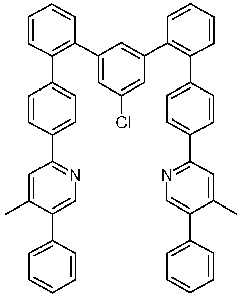 | 60% |
| B87 | 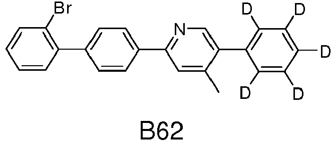 | 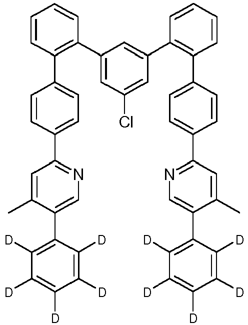 | 61% |
| B88 | 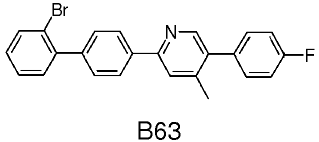 | 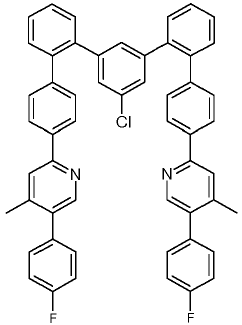 | 58% |
| B89 | 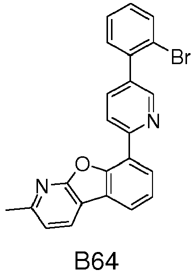 | 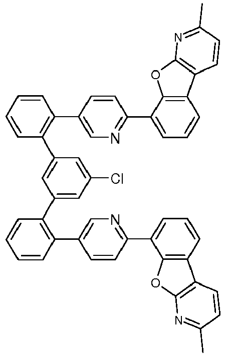 | 56% |
| B90 | 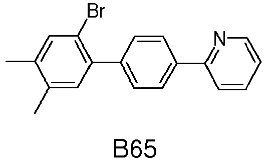 | 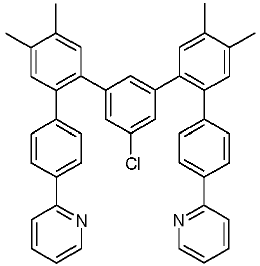 | 60% |
| B91 | 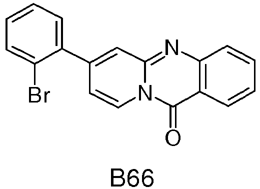 | 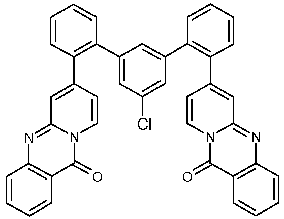 | 64% |
| B92 | 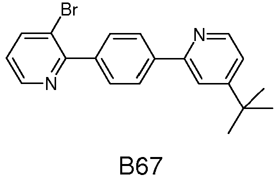 | 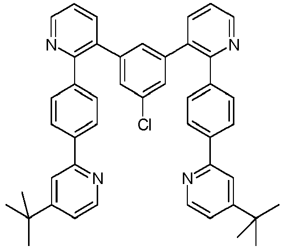 | 60% |
| B200 | 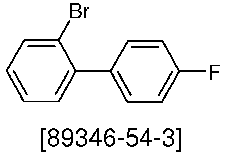 | 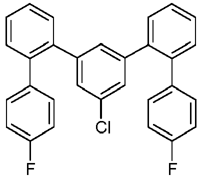 | 67% |

### Beispiel B93:

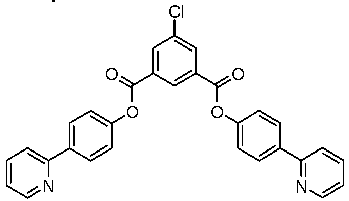

Ein Gemisch aus 17.1 g (100 mmol) 4-(2-Pyridyl)phenol [51035-40-6] und 12.9 g (100 mmol) Diisopropylethylamin [7087-68-5] wird in 400 mL Dichlormethan für 10 min bei Raumtemperatur gerührt. Es werden 6.2 mL (40 mmol) 5-Chlorisophthaloyl-dichlorid [2855-02-9], gelöst in 30 mL Dichlormethan, zugetropft, und die Reaktionsmischung wird 14 h bei Raumtemperatur gerührt. Anschließend werden 10 mL Wasser zugetropft und die Reaktionsmischung in einen Scheidetrichter überführt. Die organische Phase wird zweimal mit 100 mL Wasser und einmal mit 50 mL gesättigter NaCl-Lösung gewaschen, über Natriumsulfat getrocknet und zur Trockene eingeengt. Ausbeute: Ausbeute: 18.0 g (38 mmol), 95 %. Reinheit: ca. 95 %ig nach ¹H-NMR.

Analog können folgende Verbindungen hergestellt werden. Die Stoffmengen der eingesetzten Edukte sind angegeben, falls sie von denen, wie sie in der Durchführung zu B93 beschrieben sind abweichen.

| Bsp. | Alkohol oder Amin Säurechlorid Reaktionszeit | | Produkt | Ausbeute |
|---|---|---|---|---|
| B94 | 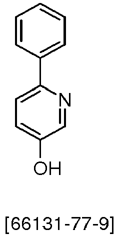 | 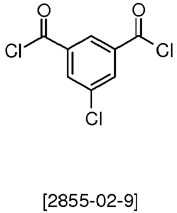 | 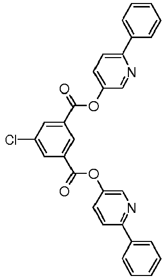 | 90 % |
| | 12 h | | | |
| B95 | 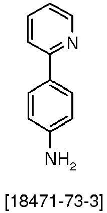 | 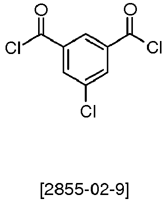 | 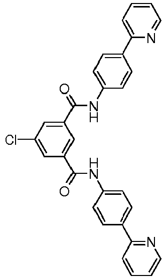 | 96% |
| | 1 h | | | |
| B96 | 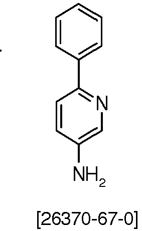 | 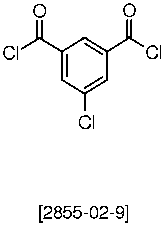 | 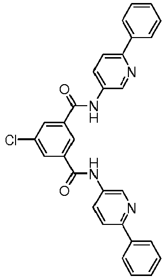 | 88% |
| | 0.5 h | | | |
| B97 | 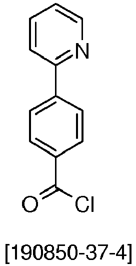 | 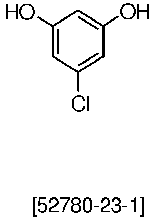 | 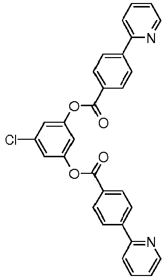 | 76% |
| | 100 mmol | 50 mmol | | |
| | 14 h, Rückfluss | | | |
| B98 | 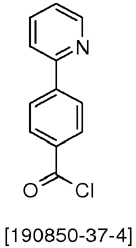 | 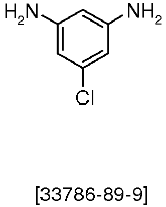 | 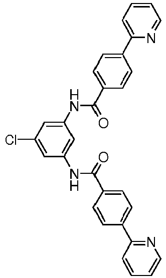 | 80% |
| | 100 mmol | 50 mmol | | |
| | 10 h | | | |
| B99 | 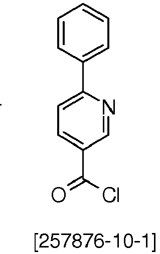 | 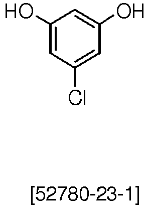 | 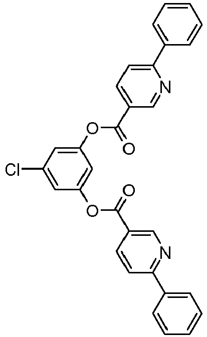 | 73% |
| | 100 mmol | 50 mmol | | |
| | 18 h, Rückfluss | | | |
| B100 | 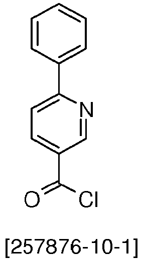 | 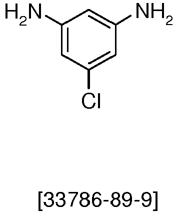 | 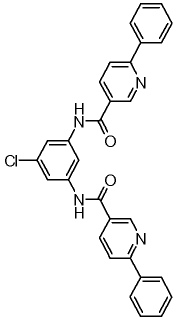 | 78% |
| | 100 mmol | 50 mmol | | |
| | 5 h | | | |

### Beispiel B101:

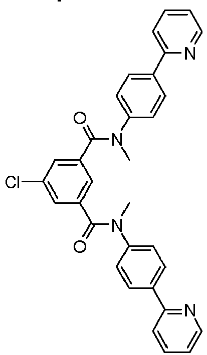

2.0 g (50 mmol) Natriumhydrid (60%ige Dispersion in Paraffinöl) [7646-69-7] werden in 300 mL THF suspensiert, dann werden 5.0 g (10 mmol) B95 zugegeben, und die Suspension wird 30 Minuten bei Raumtemperatur gerührt. Anschließend werden 1.2 mL lodmethan (50 mmol) [74-88-4] zugegeben und die Reaktionsmischung 50 h bei Raumtemperatur gerührt. Es werden 20 mL konz. Ammoniaklösung zugegeben, 30 Minuten nachgerührt und das Lösungsmittel weitgehend im Vakuum abgezogen. Man nimmt den Rückstand in 300 ml Dichlormethan auf, wäscht einmal mit 200 ml 5 Gew.-%igem Ammoniakwasser, zweimal mit je 100 ml Wasser und einmal mit 100 ml gesättigter Kochsalzlösung und trocknet über Magnesiumsulfat. Man entfernt das Dichlormethan im Vakuum und kristallisiert das Rohprodukt aus Ethylacetat/Methanol um. Ausbeute: 4.3 g (8 mmol), 80 %. Reinheit: ca. 98 %ig n. ¹H-NMR.

Analog können folgende Verbindungen dargestellt werden:

| Bsp. | Edukt | Produkt | Ausbeute |
|---|---|---|---|
| B102 | 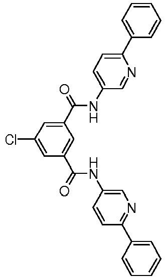 | 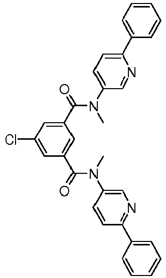 | 70% |
| | 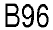 | | |
| B103 | 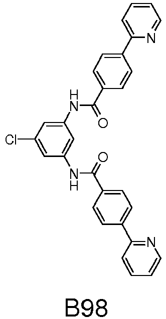 | 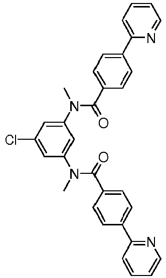 | 69% |
| B104 | 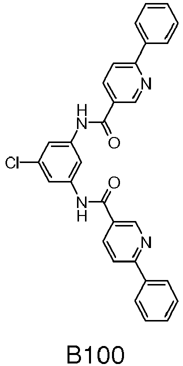 | 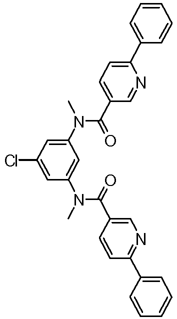 | 72% |

### Beispiel B105:

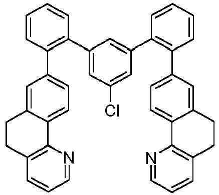

Ein Gemisch aus 36.4 g (100 mmol) 2,2'-(5-Chlor-1,3-phenylen)-bis-[4,4,5,5-tetramethyl-1,3,2-dioxaborolan][1417036-49-7], 70.6 g (210 mmol) B69, 42.4 g (400 mmol) Natriumcarbonat, 2.3 g (2 mmol) Tetrakis(triphenylphosphin)palladium(0), 1000 ml 1,2-Dimethoxyethan und 500 ml Wasser wird 48 h unter Rückfluss erhitzt. Nach Erkalten wird der ausgefallene Feststoff abgesaugt und zweimal mit 20 mL Ethanol gewaschen. Der Feststoff wird in 500 mL Dichlormethan gelöst und über ein Celitebett filtriert. Das Filtrat wird bis auf 100 mL eingeengt, dann werden 400 mL Ethanol zugegeben und der ausgefallene Feststoff abgesaugt. Das Rohprodukt wird einmal aus Ethylacetat umkristallisiert. Ausbeute: 43.6 g (70 mmol), 70 %. Reinheit: ca. 96 %ig nach ¹H-NMR.

Analog können folgende Verbindungen dargestellt werden, wobei zur Umkristallisation Lösemittel wie z. B. Ethylacetat, Cyclohexan, Toluol, Acetonitril, n-Heptan, Ethanol oder Methanol verwendet werden können. Es kann auch mit diesen Lösungsmitteln heißextrahiert werden, oder die Aufreinigung kann chromatographisch an Kieselgel auf einem Säulenautomaten (Torrent der Firma Axel Semrau) erfolgen.

| | | | |
|---|---|---|---|
| B106 | 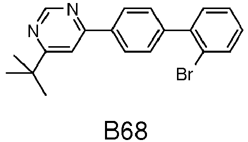 | 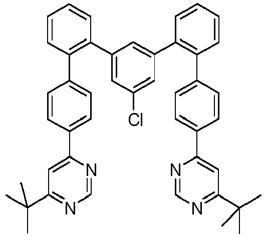 | 64% |
| B107 | 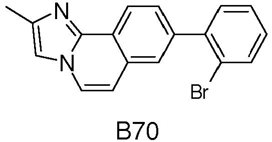 | 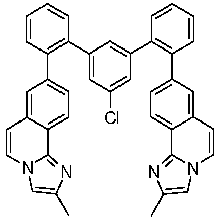 | 54% |
| B108 | 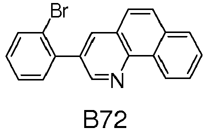 | 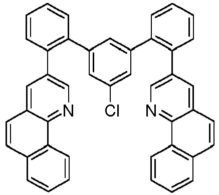 | 75% |
| B109 | 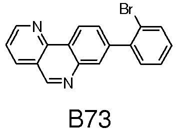 | 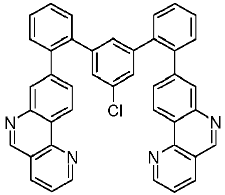 | 71% |
| B110 | 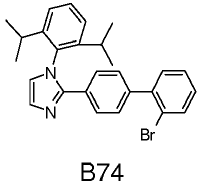 | 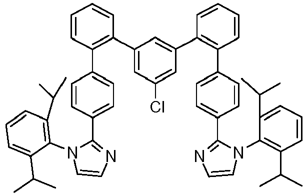 | 58% |
| B111 | 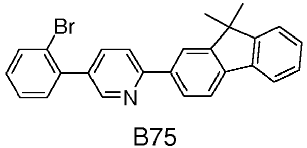 | 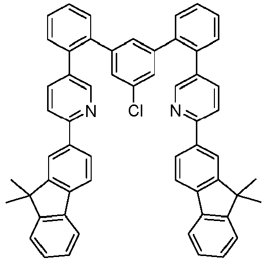 | 60% |
| B112 | 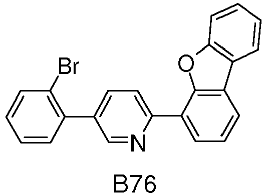 | 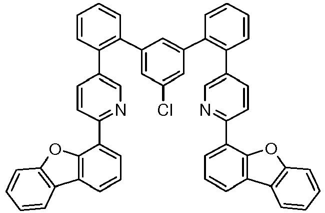 | 66% |
| B113 | 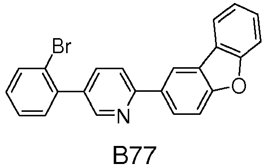 | 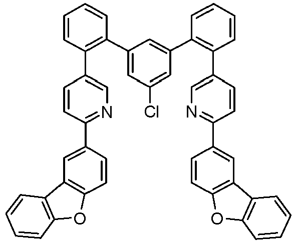 | 70% |
| B114 | 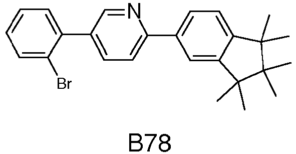 | 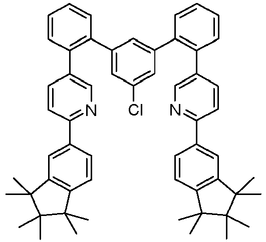 | 70% |
| B115 | 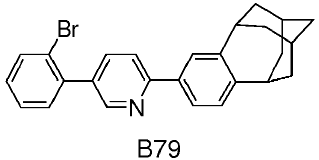 | 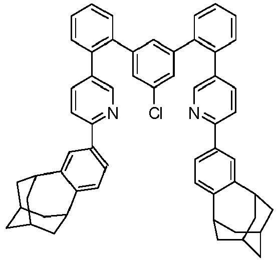 | 63% |
| B116 | 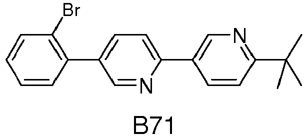 | 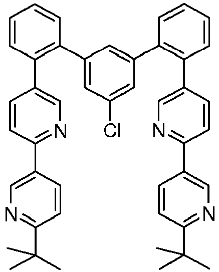 | 60% |
| B117 | 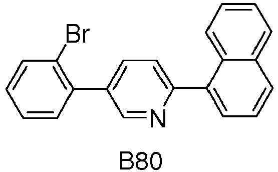 | 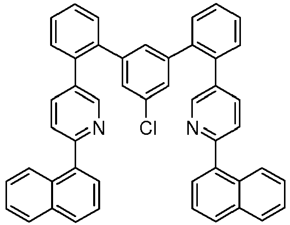 | 61% |
| B152 | 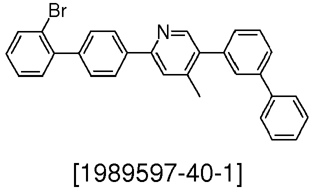 | 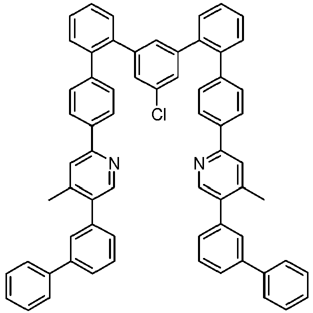 | 57% |
| B153 | 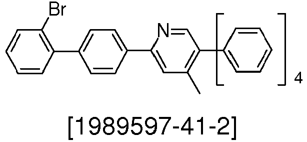 | 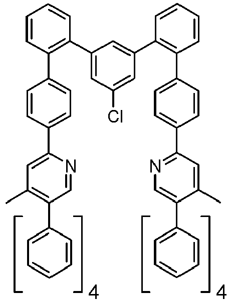 | 60% |
| B154 | 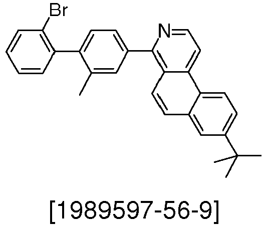 | 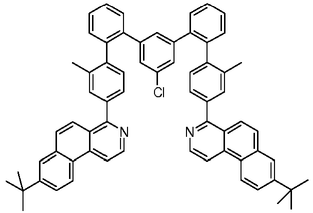 | 66% |
| B155 | 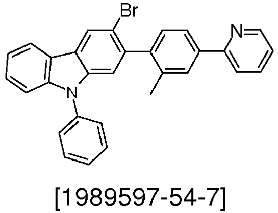 | 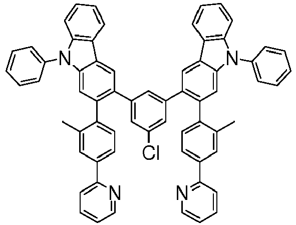 | 62% |

### Beispiel B119

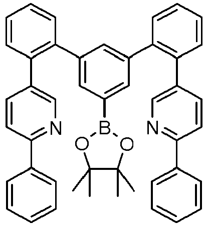

Ein Gemisch aus 57.1 g (100 mmol) B81, 25.4 g (100 mmol) Bis(pinacolato)diboran [73183-34-3], 49.1 g (500 mmol) Kaliumacetat, 2 mmol SPhos [657408-07-6], 1 mmol Palladium(II)acetat, 200 g Glaskugeln (3 mm Durchmesser) und 700 ml 1,4-Dioxan werden 16 h unter Rühren auf Rückfluss erhitzt. Nach Abkühlen wird die Suspension über ein Celite-Bett filtriert und das Lösemittel im Vakuum entfernt. Der schwarze Rückstand wird mit 1000 ml heißem Ethylacetat digeriert, es wird noch heiß über ein Celite-Bett abfiltriert, dann auf ca. 200 ml eingeengt, wobei das Produkt zu kristallisieren beginnt. Die Kristallisation wird über Nacht im Kühlschrank vervollständigt, die Kristalle werden abfiltriert und mit wenig Ethylacetat gewaschen. Aus der Mutterlauge kann eine zweite Produktfraktion gewonnen werden. Ausbeute: 31.6 g (78 mmol), 78 %. Reinheit: ca. 95 %ig n. ¹H-NMR.

Analog können folgende Verbindungen dargestellt werden, wobei anstelle von Ethylacetat auch Toluol, n-Heptan, Cyclohexan oder Acetonitril zur Umkristallisation oder bei schlecht löslichen Produkten zur Heißextraktion verwendet werden können:

| Bsp. | Bromid | Produkt | Ausbeute |
|---|---|---|---|
| B120 | 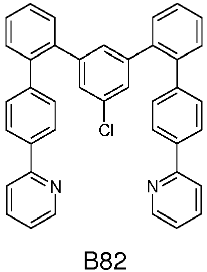 | 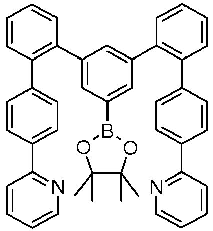 | 80% |
| B121 | 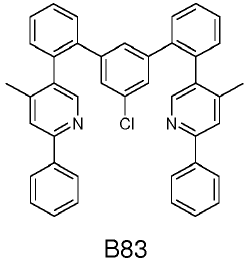 | 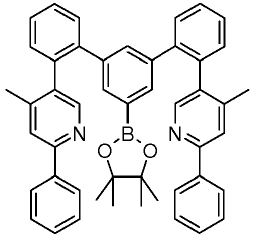 | 84% |
| B122 | 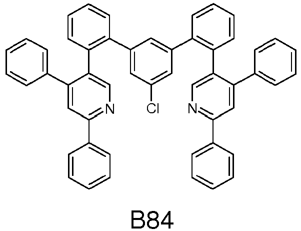 | 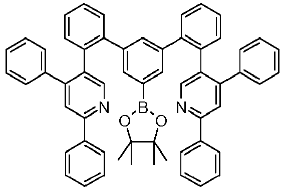 | 71% |
| B123 | 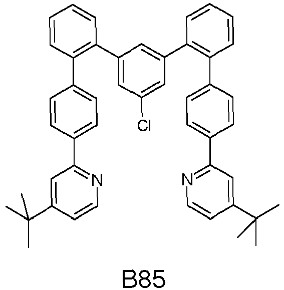 | 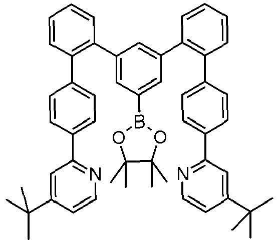 | 80% |
| B124 | 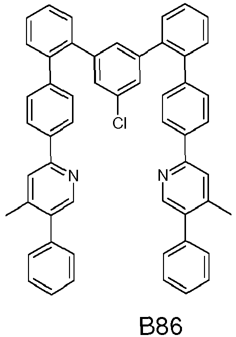 | 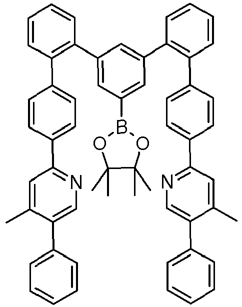 | 85% |
| B125 | 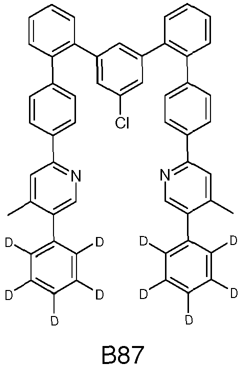 | 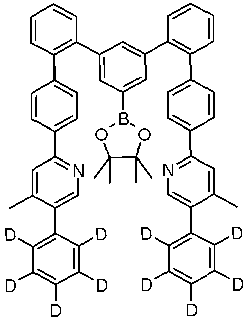 | 82% |
| B126 | 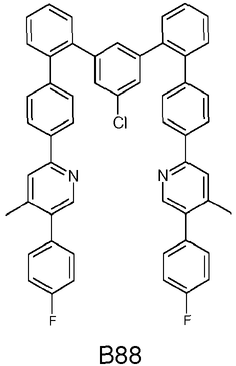 | 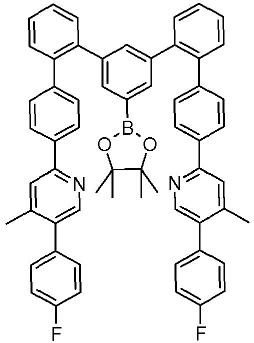 | 77% |
| B127 | 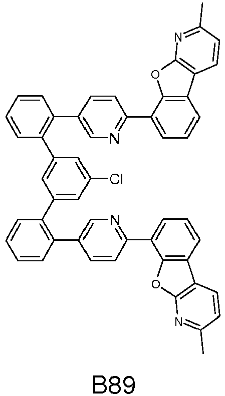 | 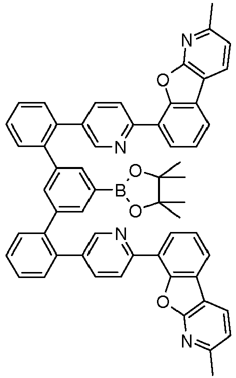 | 72% |
| B128 | 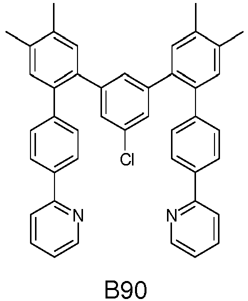 | 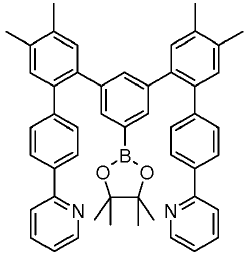 | 77% |
| B129 | 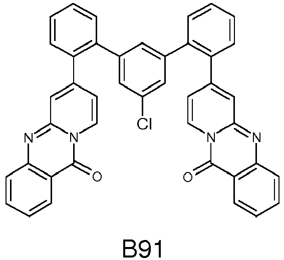 | 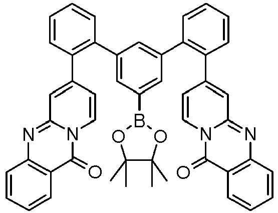 | 80% |
| B130 | 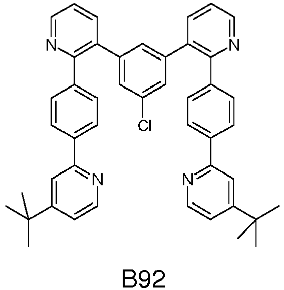 | 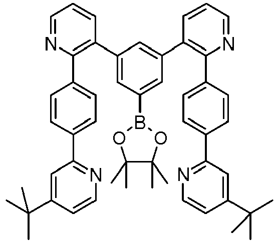 | 81% |
| B131 | 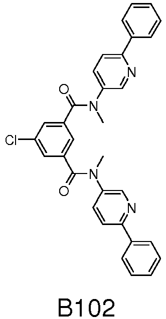 | 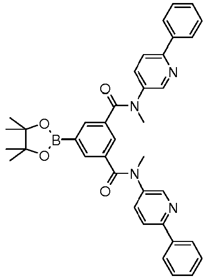 | 88% |
| B132 | 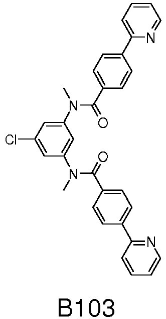 | 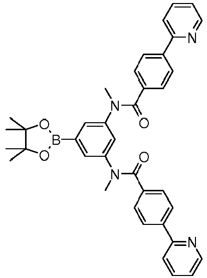 | 79% |
| B133 | 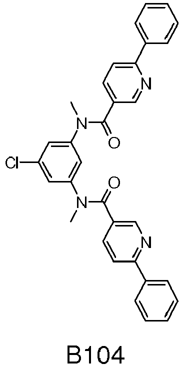 | 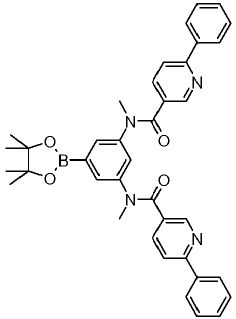 | 76% |
| B134 | 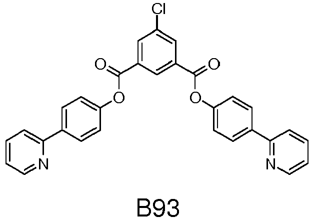 | 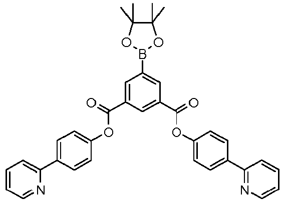 | 89% |
| B135 | 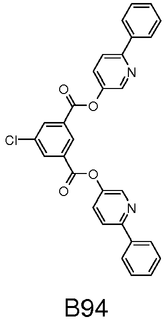 | 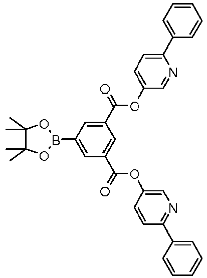 | 84% |
| B136 | 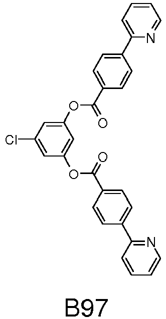 | 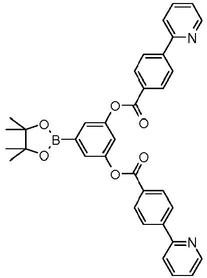 | 79% |
| B137 | 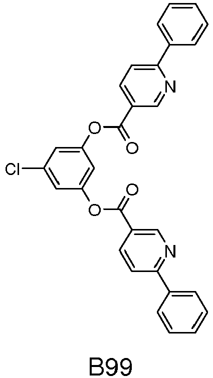 | 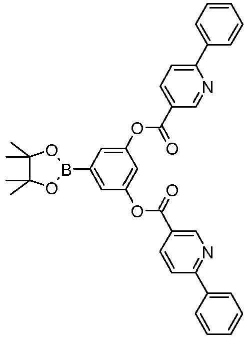 | 75% |
| B138 | 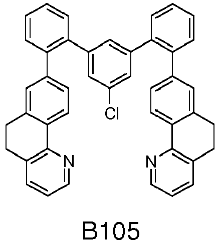 | 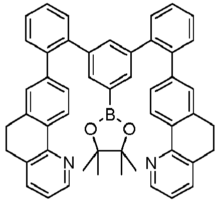 | 77% |
| B139 | 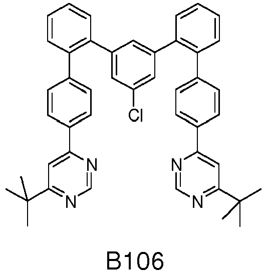 | 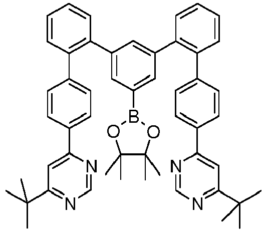 | 80% |
| B140 | 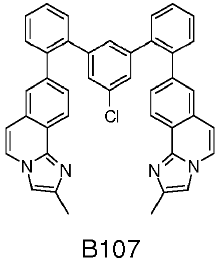 | 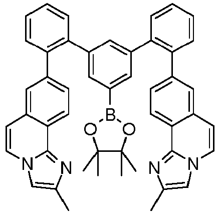 | 82% |
| B141 | 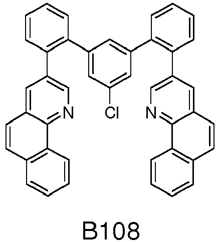 | 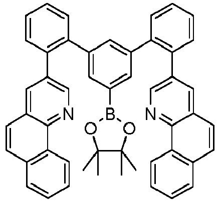 | 88% |
| B142 | 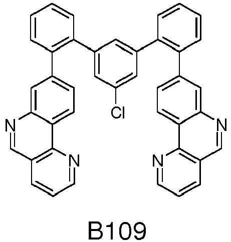 | 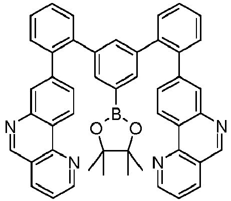 | 90% |
| B143 | 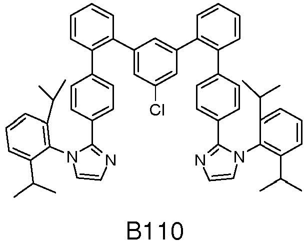 | 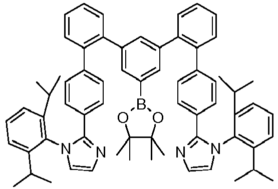 | 76% |
| B144 | 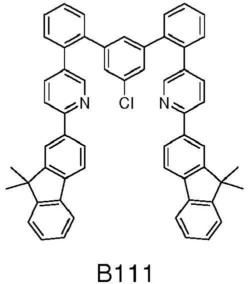 | 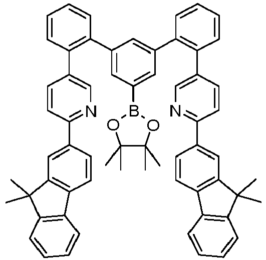 | 80% |
| B145 | 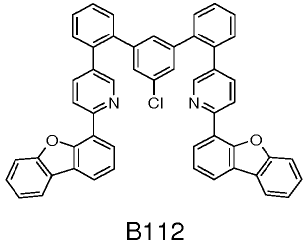 | 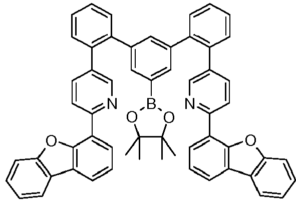 | 81% |
| B146 | 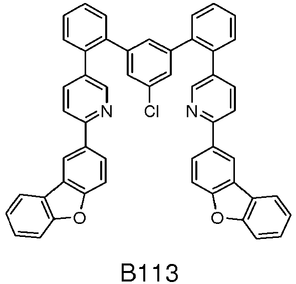 | 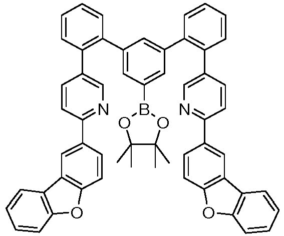 | 84% |
| B147 | 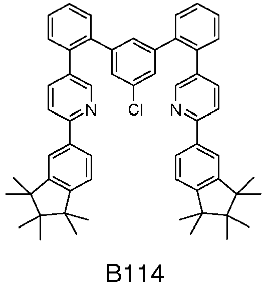 | 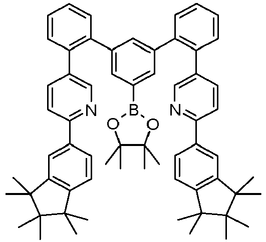 | 74% |
| B148 | 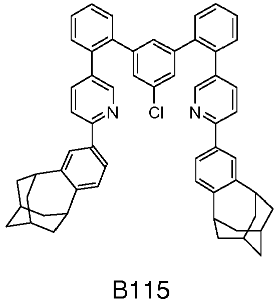 | 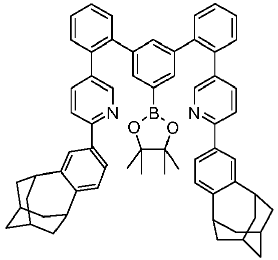 | 73% |
| B149 | 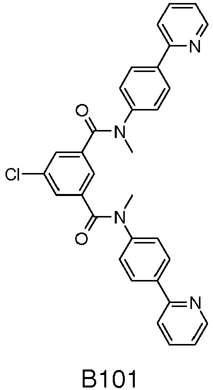 | 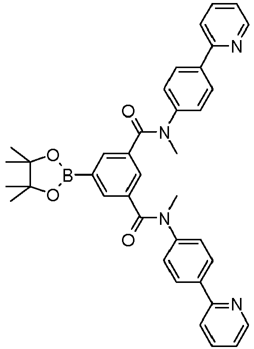 | 76% |
| B150 | 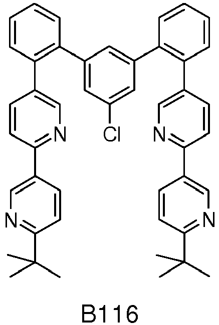 | 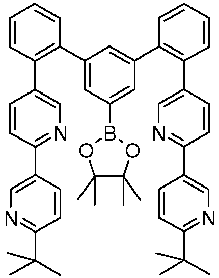 | 72% |
| B151 | 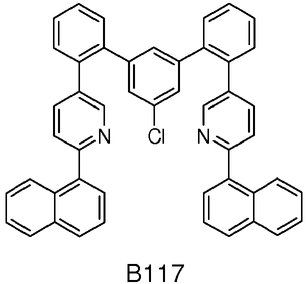 | 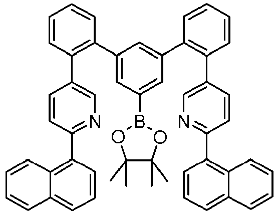 | 75% |
| B156 | 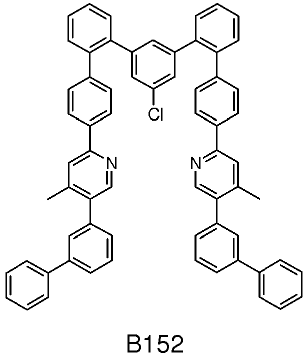 | 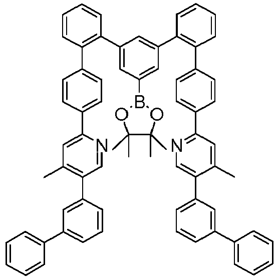 | 70% |
| B157 | 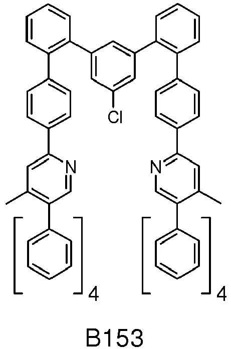 | 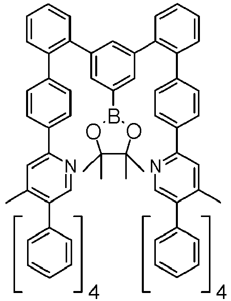 | 72% |
| B158 | 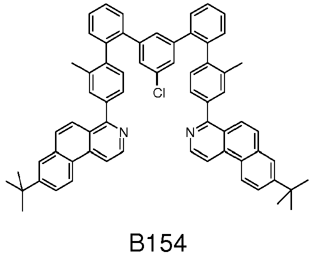 | 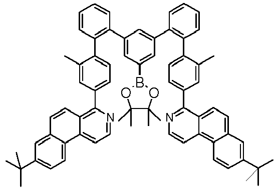 | 69% |
| B159 | 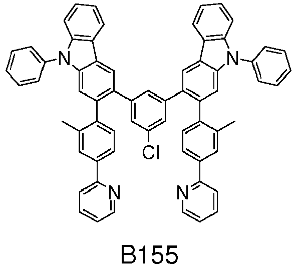 | 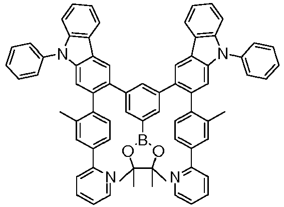 | 74% |
| B210 | 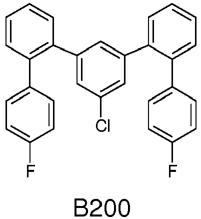 | 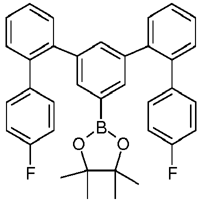 | 69% |

### B: Synthese der Liganden L und Ligandenvorstufen LV:

### Beispiel L1:

### Variante A:

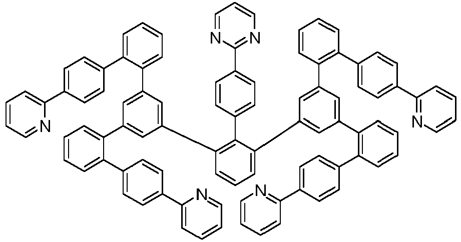

Ein Gemisch aus 5.9 g (15 mmol) B3, 19.9 g (30.0 mmol) B120, 9.2 g (87 mmol) Natriumcarbonat, 340 mg (1.3 mmol) Triphenylphosphin, 98 mg (0.44 mmol) Palladium(II)acetat, 200 ml Toluol, 100 ml Ethanol und 200 ml Wasser wird 40 h unter Rückfluss erhitzt. Nach Abkühlen wird der ausgefallene Feststoff abgesaugt und zweimal mit je 30 mL Ethanol gewaschen. Das Rohprodukt wird in 300 mL Dichlormethan gelöst und über ein Kieselgelbett filtriert. Das Kieselgelbett wird dreimal mit je 200 mL Dichlormethan /Ethylacetat 1:1 nachgewaschen. Das Filtrat wird zweimal mit Wasser und einmal mit gesättigter Kochsalzlösung gewaschen und über Natriumsulfat getrocknet. Das Filtrat wird zur Trockene eingeengt. Der Rückstand wird aus Ethylacetat am Rückfluss umkristallisiert. Ausbeute: 8.8 g (10.7 mmol), 55%. Reinheit: ca. 99 %ig n. ¹H-NMR.

### Variante B:

Ein Gemisch aus 4.5 g (15 mmol) B160, 19.9 g (30.0 mmol) B120, 13.8 g (87 mmol) Kaliumphosphat Monohydrat, 507 mg (0.6 mmol) XPhos Palladacycle Gen. 3 [1445085-55-1], 200 ml THF und 100 ml Wasser wird 20 h unter Rückfluss erhitzt. Nach Abkühlen wird der ausgefallene Feststoff abgesaugt, zweimal mit je 30 mL Wasser und zweimal mit je 30 mL Ethanol gewaschen. Das Rohprodukt wird in 200 mL Dichlormethan gelöst und über ein Kieselgelbett filtriert. Das Kieselgelbett wird dreimal mit je 200 mL Dichlormethan/Ethylacetat 1:1 nachgewaschen. Das Filtrat wird zweimal mit Wasser und einmal mit gesättigter Kochsalzlösung gewaschen, über Natriumsulfat getrocknet und zur Trockene eingeengt. Der Rückstand wird aus Ethylacetat am Rückfluss umkristallisiert. Ausbeute: 12.0 g (9.2 mmol), 61%. Reinheit: ca. 99 %ig n. ¹H-NMR.

Analog der für L1 (Variante B) beschriebenen Durchführung können die folgenden Verbindungen dargestellt werden. Hierbei können zur Aufreinigung durch Umkristallation oder Heißextraktion auch Toluol, Cyclohexan, Ethylacetat oder Dimethylformamid eingesetzt werden. Alternativ können die Liganden chromatographisch aufgereinigt werden.

| Bsp. | Edukte | Produkt | Ausbeute |
|---|---|---|---|
| L2 | B160 + B119 | 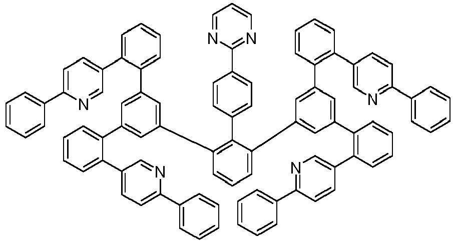 | 64% |
| L3 | B160 + B123 | 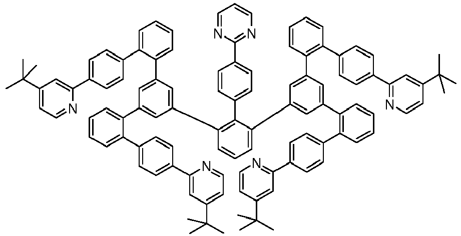 | 61% |
| L4 | B160 + B139 | 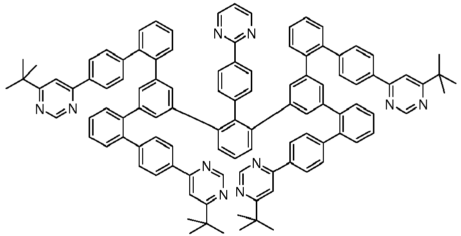 | 68% |
| L5 | B160 + B149 | 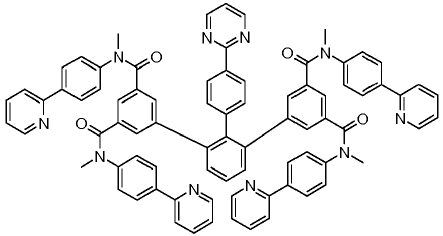 | 65% |
| L6 | B160 + B138 | 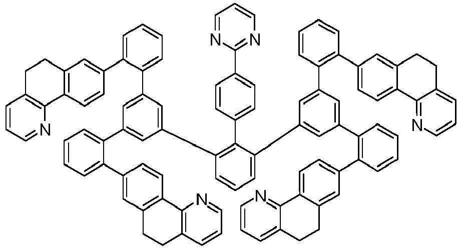 | 66% |
| L7 | B160 + B127 | 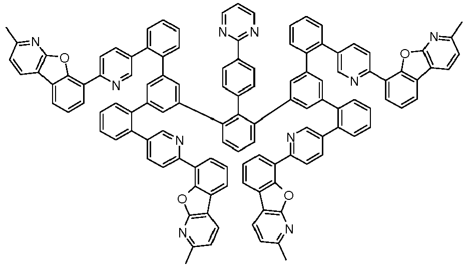 | 70% |
| L8 | B160 + B136 | 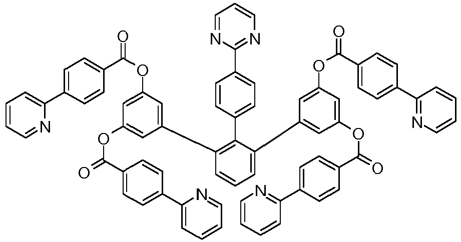 | 57% |
| L9 | B160 + B140 | 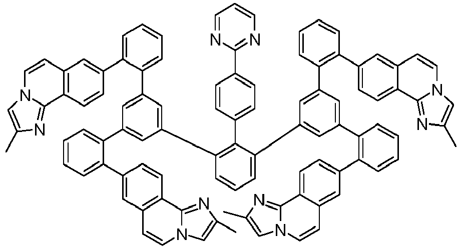 | 69% |
| L10 | B160 + B129 | 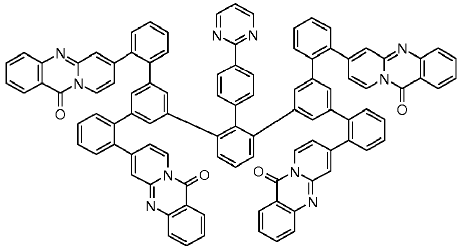 | 64% |
| L11 | B160 + B125 | 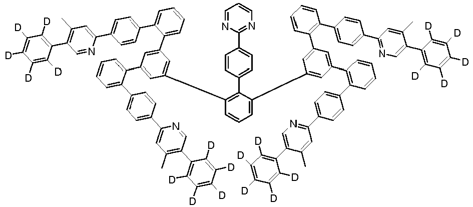 | 62% |
| L12 | B160 + B126 | 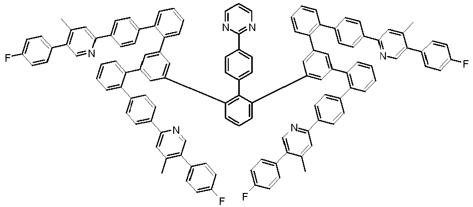 | 63% |
| L13 | B160 + B128 | 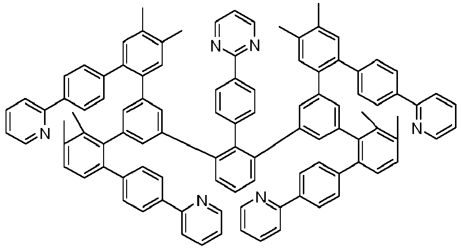 | 61% |
| L14 | B160 + B142 | 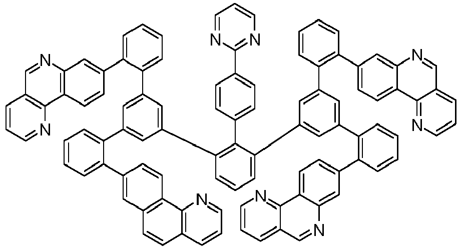 | 67% |
| L15 | B4 + B119 | 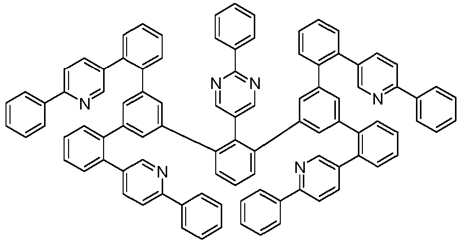 | 60% |
| L16 | B4 + B120 | 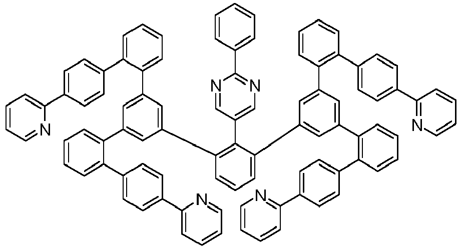 | 58% |
| L17 | B4 + B127 | 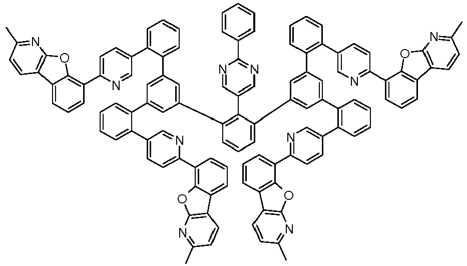 | 56% |
| L18 | B4 + B131 | 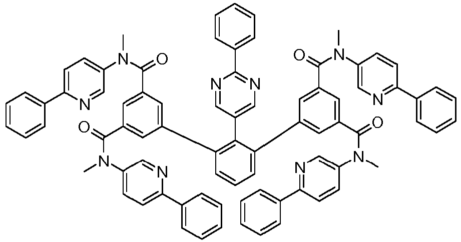 | 53% |
| L19 | B4 + B146 | 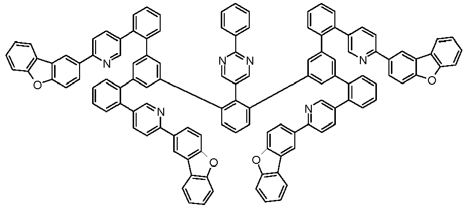 | 70% |
| L20 | B4 + B147 | 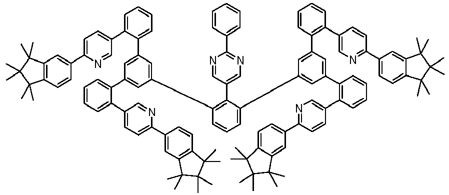 | 58% |
| L21 | B4 + B122 | 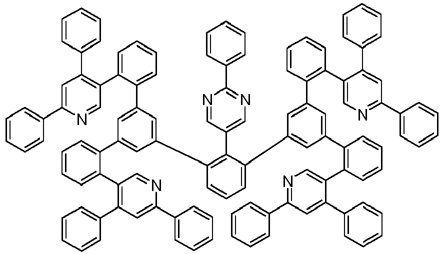 | 63% |
| L22 | B4 + B150 | 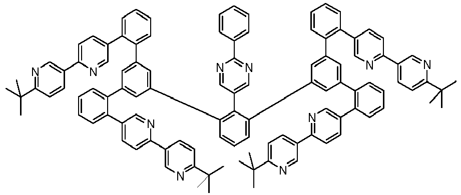 | 57% |
| L23 | B4 + B131 | 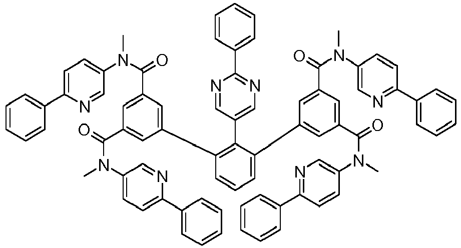 | 56% |
| L24 | B4 + B145 | 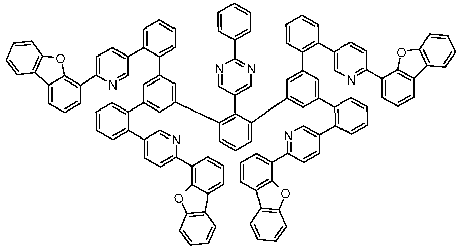 | 65% |
| L25 | B4+ B148 | 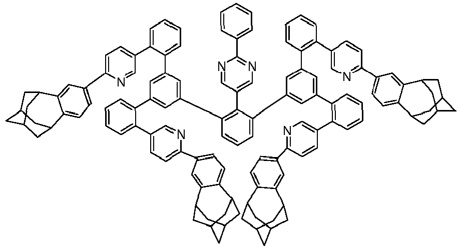 | 60% |
| L26 | B5 + B119 | 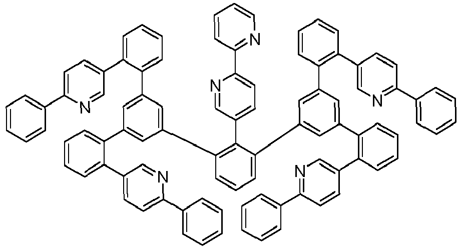 | 60% |
| L27 | B5 + B120 | 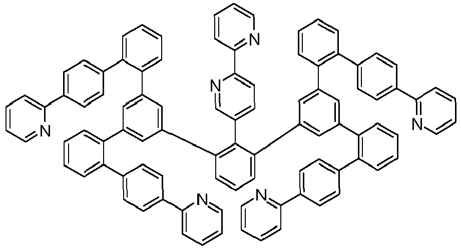 | 58% |
| L28 | B5 + B143 | 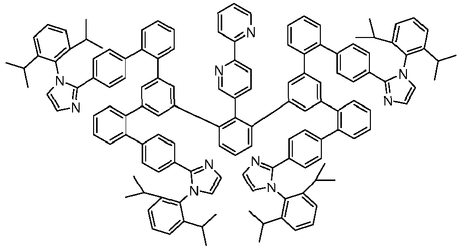 | 62% |
| L29 | B5 + B129 | 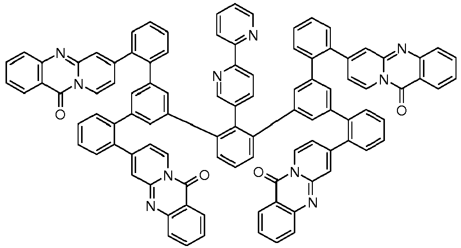 | 57% |
| L30 | B5 + B144 | 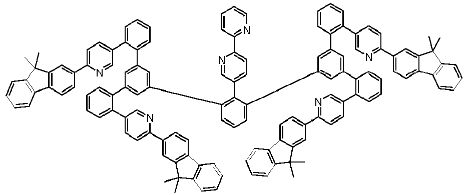 | 63% |
| L31 | B6 + B120 | 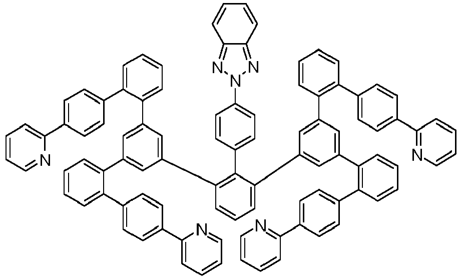 | 65% |
| L32 | B6 + B143 | 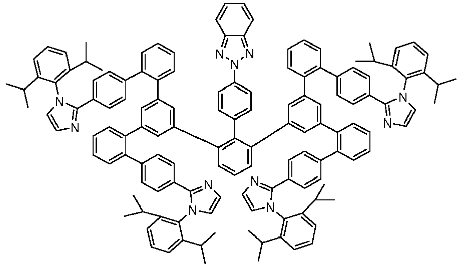 | 61% |
| L33 | B6 + B129 | 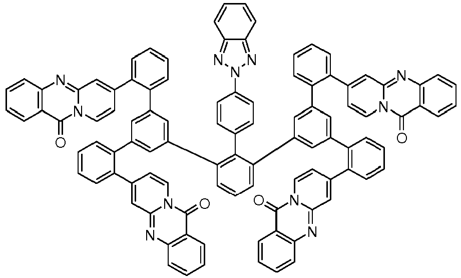 | 55% |
| L34 | B6 + B119 | 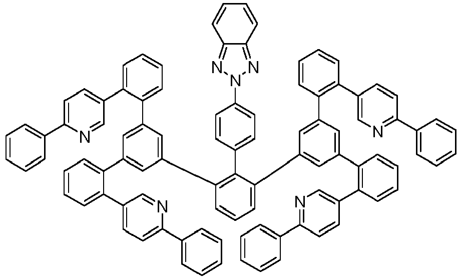 | 60% |
| L35 | B7 + B119 | 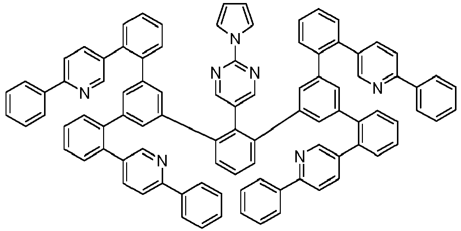 | 62% |
| L36 | B7 + B128 | 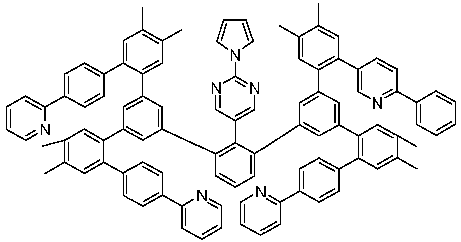 | 57% |
| L37 | B7 + B131 | 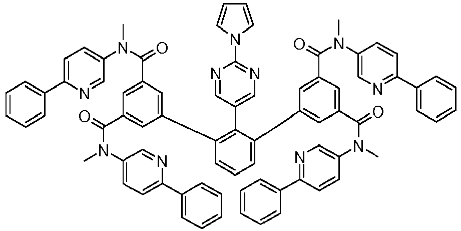 | 50% |
| L38 | B7 + B150 | 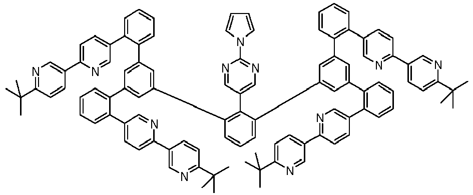 | 63% |
| L39 | B160 + B130 | 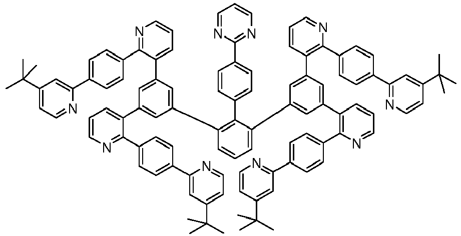 | 58% |
| L40 | B160 + B156 | 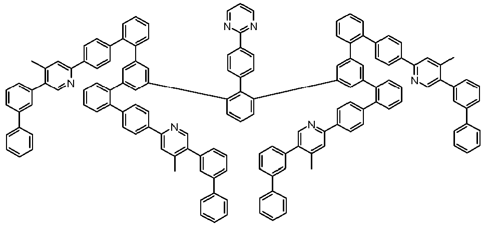 | 55% |
| L41 | B160 + B157 | 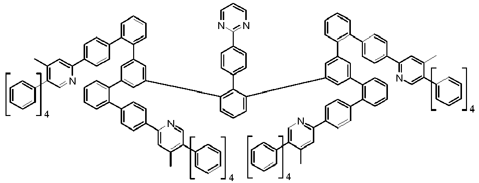 | 58% |
| L42 | B160 + B158 | 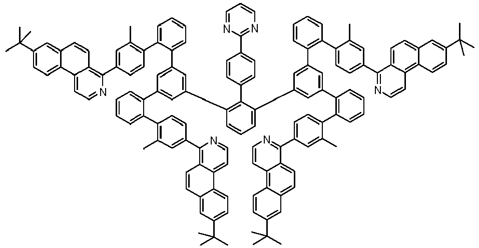 | 60% |
| L43 | B160 + B159 | 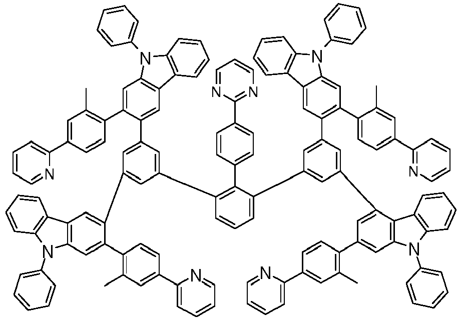 | 59% |
| L44 | B160 + 15 mmol B123 + 15 mmol B139 | 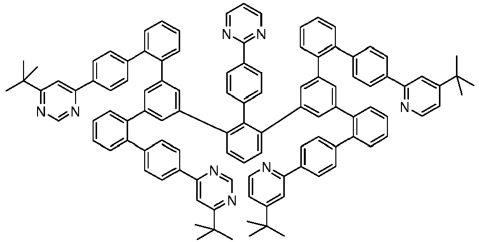 | 20% |
| | | Chromatographische Trennung des Gemischs an einem Säulenautomaten (Torrent der Fa. A. Semrau) unter Isolierung des unsymmetrischen Liganden | |
| L45 | B160 + 15 mmol B120 + 15 mmol B156 | 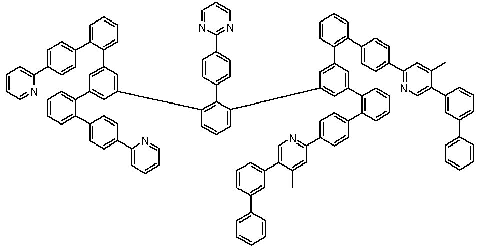 | 22% |
| | | Chromatographische Trennung des Gemischs an einem Säulenautomaten (Torrent der Fa. A. Semrau) unter Isolierung des unsymmetrischen Liganden | |
| LV100 | B160 + B210 | 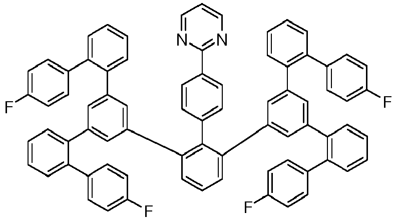 | 68% |

### Beispiel LV110:

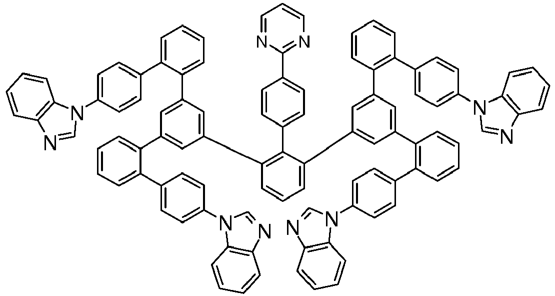

Analog F. Diness et al., Angew. Chem. Int. Ed., 2012, 51, 8012.

Ein Gemisch aus 21.3 g (20 mmol) LV1, 11.8 g (100 mmol) Benzimidazol und 97.9 g (300 mmol) Cäsiumcarbonat in 500 ml N,N-Dimethylacetamid wird im Rührautoklaven 18 h auf 175 °C erhitzt. Nach Erkalten zieht man das Lösungsmittel weitgehend ab, nimmt den Rückstand in 500 ml Toluol auf, wäscht dreimal mit je 300 ml Wasser, einmal mit 300 ml gesättigter Natriumchloridlösung, trocknet über Magnesiumsulfat und filtriert dann über ein vorgeschlämmtes Celite-Bett ab. Nach Entfernen des Lösungsmittels im Vakuum wird der Rückstand aus Ethylacetat/Methanol umkristallisiert. Ausbeute: 16.0 g (11 mmol), 55 %. Reinheit: ca. 96 %-ig n. ¹H-NMR.

Analog können die folgenden Verbindungen synthetisiert werden:

| Bsp. | Edukte | Produkt | Ausbeute |
|---|---|---|---|
| LV111 | 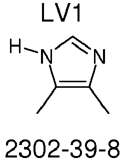 | 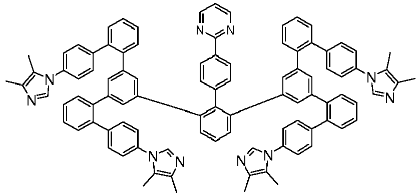 | 51 % |
| LV112 | 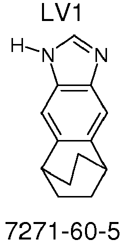 | 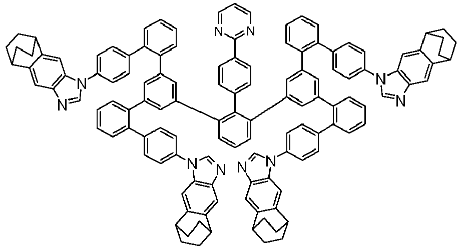 | 57% |
| LV113 | 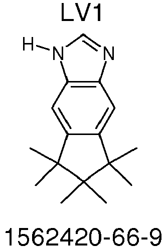 | 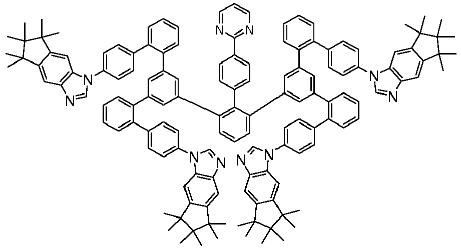 | 60 % |

### Beispiel LV120:

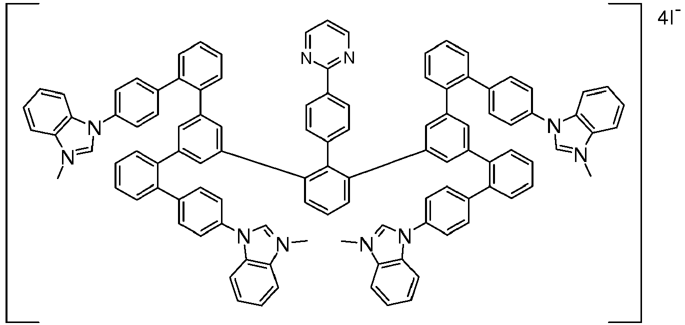

Eine Lösung von 14.6 g (10 mmol) LV110 in 100 ml DCM wird tropfenweise mit 2.8 ml (44 mmol) Methyliodid [74-88-4] versetzt und 24 h im Rührautoklaven auf 60 °C erhitzt. Nach Erkalten zieht man das Lösungsmittel und überschüssiges Methyliodid im Vakuum ab. Die so erhaltene Ligandenvorstufe wird ohne weitere Reinigung umgesetzt. Ausbeute: 20.3 g (10 mmol), quantitativ. Reinheit: ca. 95 %-ig n. ¹H-NMR.

Analog können die folgenden Verbindungen synthetisiert werden:

| Bsp. | Produkt Edukt | Ausbeute |
|---|---|---|
| LV121 | 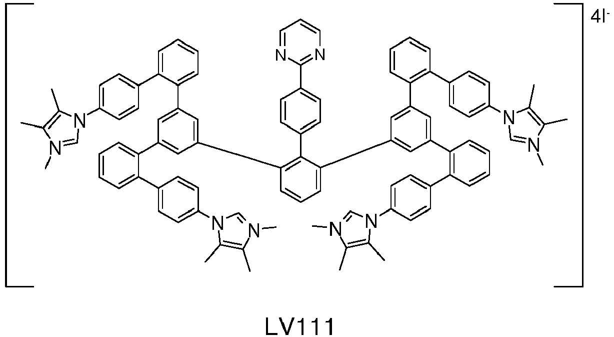 | quant. |
| LV122 | 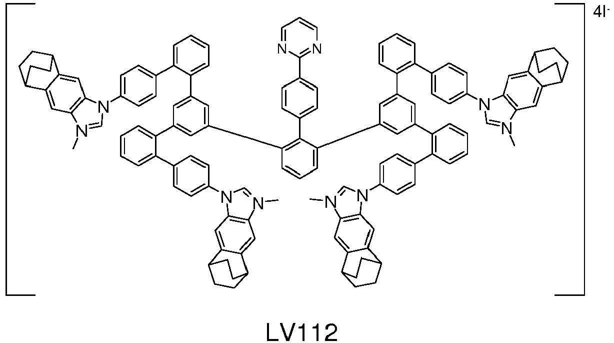 | quant. |
| LV123 | 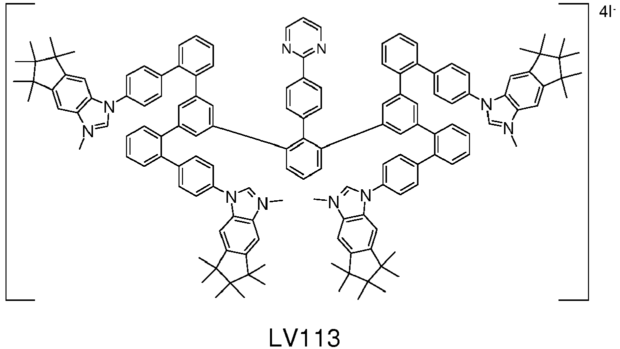 | quant. |

### Beispiel LV130:

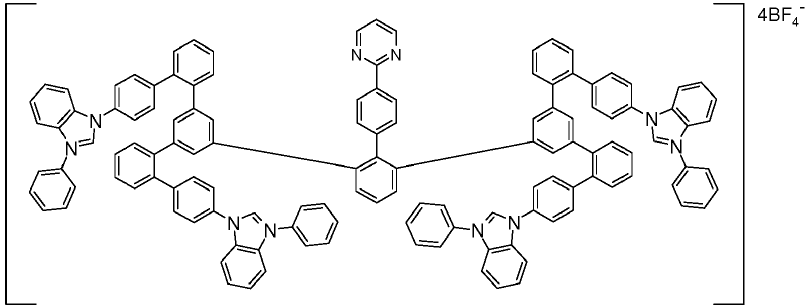

Ein Gemisch von 14.6 g (10 mmol) LV110, 16.6 g (45 mmol) Diphenyliodonium-tetrafluoroborat [313-39-3], 363 mg (2 mmol) Kupfer(II)aceat [142-71-2] in 200 ml DMF wird 8 h auf 100 °C erhitzt. Nach Erkalten entfernt man das Lösungsmittel im Vakuum, nimmt den Rückstand in einem Gemisch aus 100 ml Dichlormethan, 100 ml Aceton und 20 ml Methanol auf, filtriert über ein Kieselgelbett, schneidet die Kernfraktion heraus und engt diese zur Trockene ein. Die so erhaltene Liganden-Vorstufe wird ohne weitere Reinigung umgesetzt. Ausbeute: 14.8 g (7 mmol), 70 %. Reinheit: ca. 90 %ig n. ¹H-NMR.

Analog können die folgenden Verbindungen synthetisiert werden:

| Bsp. | Produkt Edukt | Ausbeute |
|---|---|---|
| LV131 | 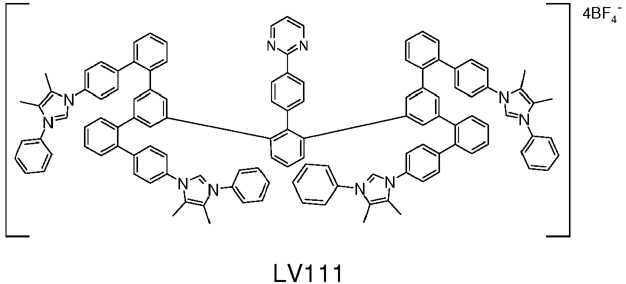 | 65% |
| LV132 | 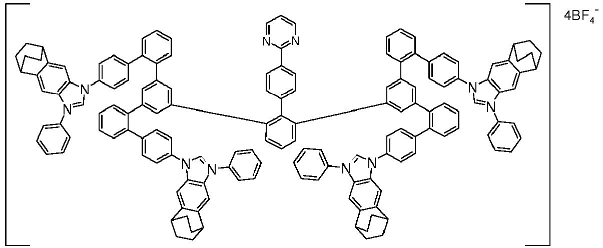 | 68% |
| | 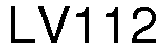 | |
| LV133 | 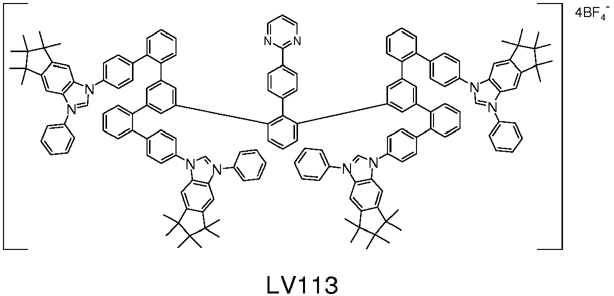 | 63% |

### C: Synthese der Metallkomplexe:

### Variante A:

### Beispiel Ir₂(L1):

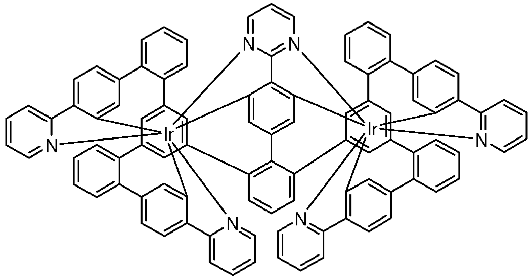

Ein Gemisch aus 13.0 g (10 mmol) des Liganden L1, 9.8 g (20 mmol) Tris-acetylacetonato-iridium(III) [15635-87-7] und 100 g Hydrochinon [123-31-9] werden in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen und in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Die Apparatur wird mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 °C, gemessen am Pt-100 Thermof ühler, der in die aufgeschmolzene, gerührte Reaktionsmischung eintaucht, erhitzt. Während der nächsten 2 h wird das Reaktionsgemisch bei 250 °C gehalten, wobei wenig Kondensat abdestilliert und sich im Wasserabscheider sammelt. Die Reaktionsmischung wird bis auf 190 °C abkühlen gelassen, dann werden 100 mL Ethylenglykol zugetropft. Man lässt weiter bis auf 80 °C abkühlen, tropft dann 500 mL Methanol zu und erhitzt 1 h auf Rückfluss. Die so erhaltene Suspension wird über eine Umkehrfritte filtriert, der Feststoff wird zweimal mit 50 ml Methanol gewaschen und im Vakuum getrocknet. Der so erhaltene Feststoff wird in 220 mL Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten und am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung durch fünfmalige Heißextraktion mit Toluol (Vorlagemenge jeweils ca. 150 ml, Extraktionshülse: Standard Soxhletthülsen aus Cellulose der Fa. Whatman) unter sorgfältigem Luft- und Lichtausschluss. Abschließend werden die Produkte im Hochvakuum bei 280 °C getempert. 10.8 g roter Feststoff (6.4 mmol), 64%. Reinheit: > 99.9 % nach HPLC.

Analog können folgende Verbindungen synthetisiert werden. Die nachfolgend gezeigten Metallkomplexe können prinzipiell durch Chromatographie, typischerweise unter Verwendung eines Säulenautomaten (Torrent der Firma Axel Semrau), Umkristallisation oder Heißextraktion (in der folgenden Tabelle auch als HE abgekürzt) gereinigt werden. Restlösemittel kann durch Tempern im Hochvakuum bei typischerweise 250 - 330 °C entfernt werden.

Analog können gemischtmetallische Rh-Ir-Komplexe erhalten werden, indem man zunächst statt 20 mmol Tris-acetylacetonato-iridium(III) [15635-87-7] nur 10 mmol einsetzt und dann nach der Hälfte der angegebenen Reaktionszeit 4.0 g (10 mmol) Tris-acetylacetonato-rhodium(III) [14284-92-5] zugibt.

### Variante B: Carben-Komplexe

Eine Suspension von 10 mmol der Carben-Ligandenvorstufe LV und 40 mmol Ag₂O in 300 ml Dioxan wird 12 h bei 30 °C gerührt. Dan n gibt man 20 mmol [Ir(COD)Cl]₂ [12112-67-3] zu und erhitzt 8 h unter Rückfluss. Man saugt noch heiß vom Feststoff ab, wäscht diesen dreimal mit je 50 ml heißem Dioxan, vereinigt die Filtrate und engt diese im Vakuum zur Trockene ein. Das so erhaltene Rohprodukt wird an basischem Aluminiumoxid mit Ethylacetat / Cyclohexan bzw. Toluol zweimal chromatographiert. Die weitere Reinigung des Produkts erfolgt durch fünfmalige kontinuierliche Heißextraktion mit Acetonitril/Dichlormethan und zweimalige Heißextraktion mit Ethylacetat/Methanol (Vorlagemenge jeweils ca. 200 ml, Extraktionshülse: Standard Soxhletthülsen aus Cellulose der Fa. Whatman) unter sorgfältigem Luft- und Lichtausschluss. Abschließend wird das Produkt im Hochvakuum getempert. Reinheit: > 99.8 % nach HPLC.

Analog der Variante A und B können folgende Verbindungen dargestellt werden.

| Bsp. | Edukt | Produkt / Reaktionsbedingungen / Heißextraktionsmittel (HE) | Ausbeute |
|---|---|---|---|
| Variante A | | | |
| Rh₂(L1 ) | L1 Rh (acac)₃ [14284-92-5] statt Ir(acac)₃ | 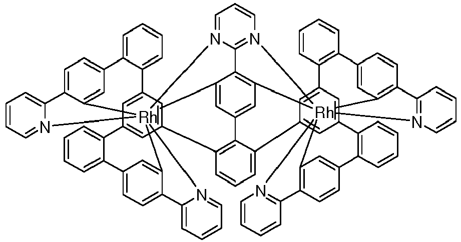 | 50% |
| | | Rh₂(L1 ) 250°C; 2 h Heißextraktion: Toluol | |
| Ir₂(L2) | L2 | 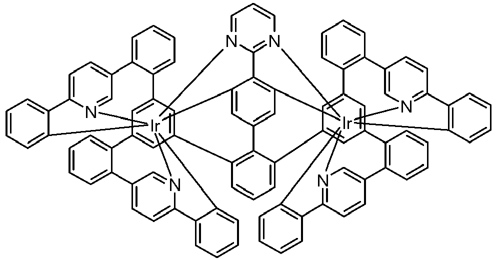 | 60% |
| | | Ir₂(L2) 250°C; 4 h Heißextraktion: Ethylacetat | |
| Rh₂(L2) | L2 Rh (acac)₃ [14284-92-5] statt Ir(acac) | 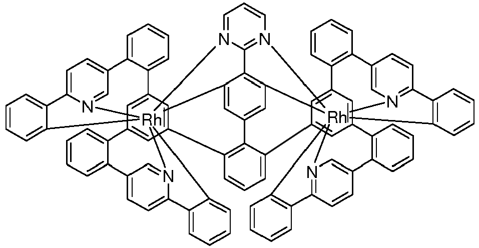 | 48% |
| | | Rh₂(L2) 250°C; 2 h Heißextraktion: Ethylacetat | |
| Ir₂(L3) | L3 | 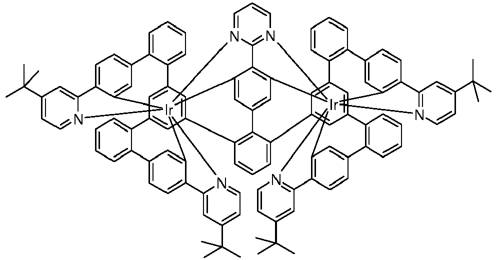 | 56% |
| | | Ir₂(L3) 250°C; 3 h HE: Ethylacetat/Acetonitril 4:1 | |
| I r₂(L4) | L4 | 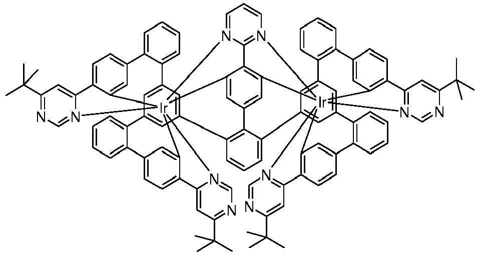 | 62% |
| | | Ir₂(L4) 250°C; 3 h HE: Ethylacetat/Acetonitril 2:1 | |
| Ir₂(L5) | L5 | 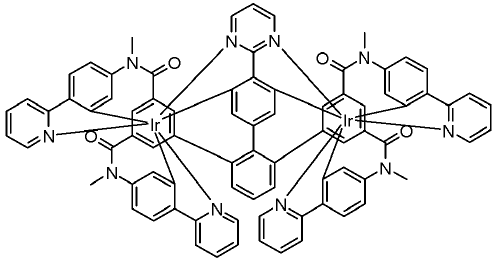 | 52% % |
| | | Ir₂(L5) 250°C; 2 h Umkristallisation: DMF | |
| Ir₂(L6) | L6 | 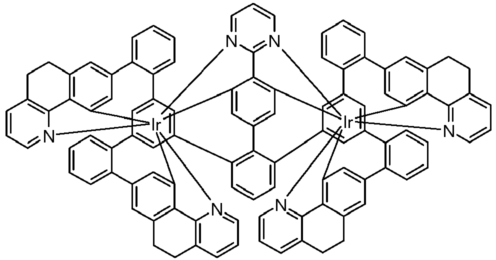 | 65% |
| | | Ir₂(L6) 250°C; 5 h Heißextraktion: o-Xylol | |
| Ir₂(L7) | L7 | 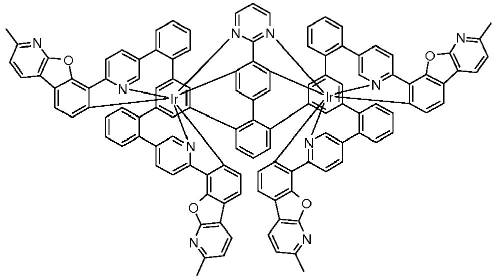 | 60% |
| | | Ir₂(L7) 250°C; 5 h Heißextraktion: Toluol | |
| Ir₂(L8) | L8 | 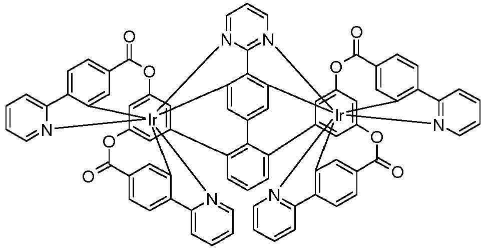 | 43% |
| | | Ir₂(L8) 220°C; 5 h Umkristallisation: DMSO | |
| Ir₂(L9) | L9 | 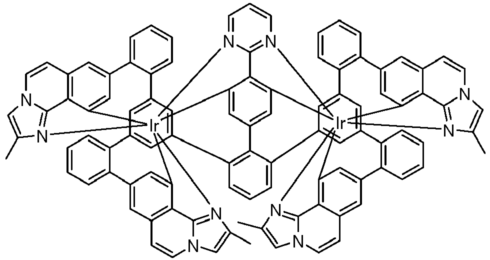 | 56% |
| | | Ir₂(L9) 250°C; 3 h Heißextraktion: Toluol | |
| Ir₂(L10) | L10 | 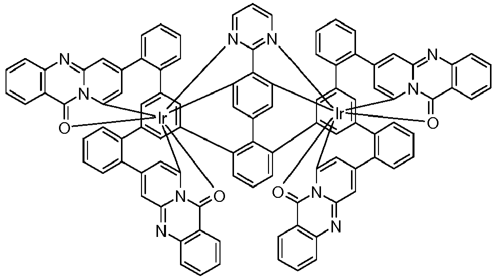 | 58% |
| | | I r₂(L10) 250°C; 1.5 h Heißextraktion: Ethylacetat | |
| Ir₂(L11) | L11 | 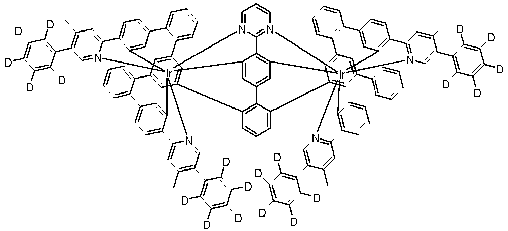 | 62% |
| | | Ir₂(L11) 250°C; 2 h Heißextraktion: *n*-Butylacetat | |
| Ir₂(L1 2) | L12 | 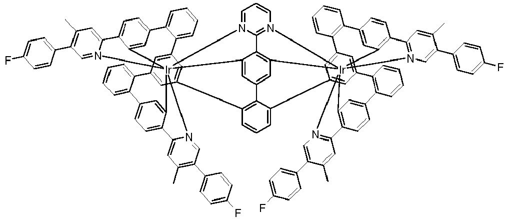 | 58% |
| | | Ir₂(L12) 250°C; 2 h Heißextraktion: Toluol | |
| Ir₂(L13) | L13 | 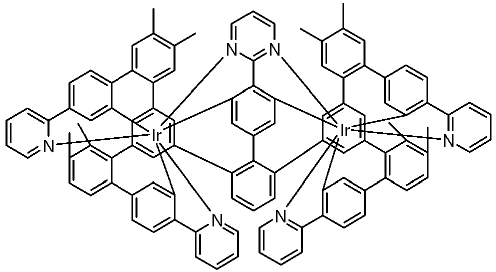 | 61% |
| | | I r₂(L1 3) 250°C; 3 h Heißextraktion: n-Butylacetat | |
| Ir₂(L14) | L14 | 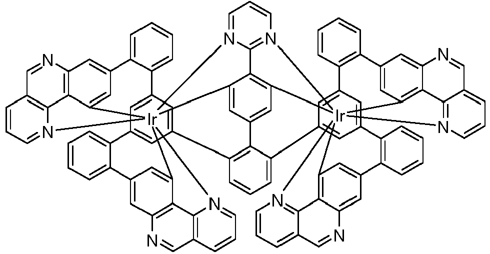 | 57% |
| | | Ir₂(L14) 260°C; 3 h Heißextraktion: o-Xylol | |
| Ir₂(L15) | L15 | 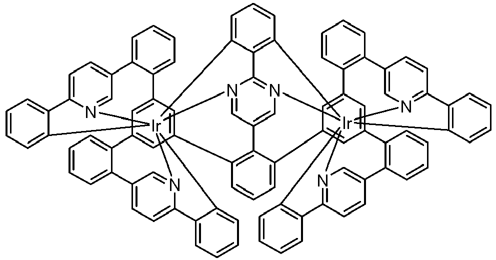 | 62% |
| | | I r₂(L1 5) 250°C; 2 h Heißextraktion: Toluol | |
| Ir₂(L16) | L16 | 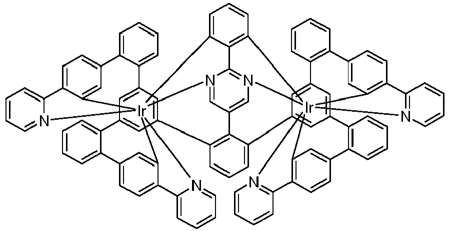 | 56% |
| | | Ir₂(L1 6) 250°C; 2 h Heißextraktion: Ethylacetat | |
| Ir₂(L1 7) | L17 | 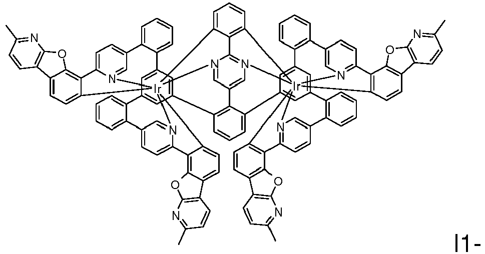 | 53% |
| | | Ir₂(L17) 265°C; 3 h Heißextraktion: Toluol | |
| Ir₂(L18) | L18 | 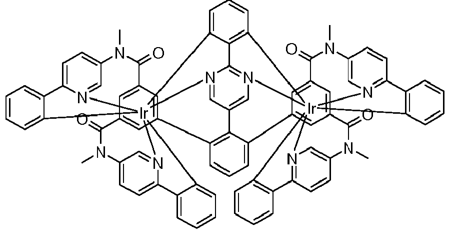 | 41% |
| | | Ir₂(L18) 255°C; 2 h Umkristallisation: DMF | |
| Ir₂(L19) | L19 | 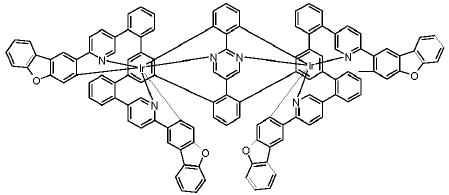 | 65% |
| | | I r₂(L1 9) 250°C; 3 h Heißextraktion: o-Xylol | |
| Ir₂(L20) | L20 | 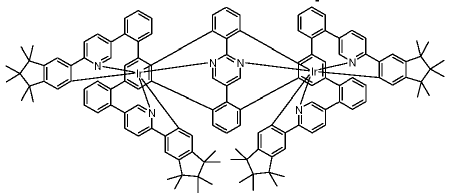 | 50% |
| | | Ir₂(L20) 250°C; 3 h Heißextraktion: Cyclohexan | |
| Ir₂(L21) | L21 | 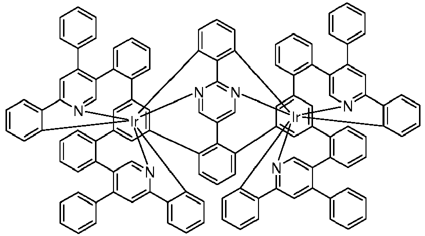 | 55% |
| | | Ir₂(L21) 250°C; 3 h Heißextraktion: Toluol | |
| Ir₂(L22) | L22 | 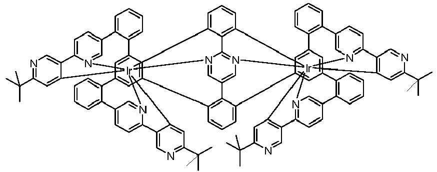 | 58% |
| | | Ir₂(L22) 265°C; 5 h Heißextraktion: n-Butylacetat | |
| Ir₂(L23) | L23 | 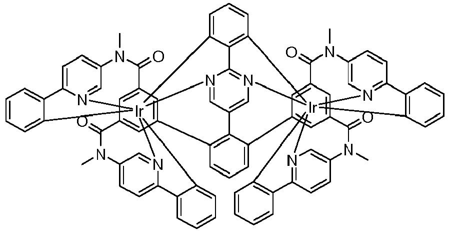 | 48% |
| | | Ir₂(L23) 250°C; 3 h Heißextraktion: n-Butylacetat | |
| Ir₂(L24) | L24 | 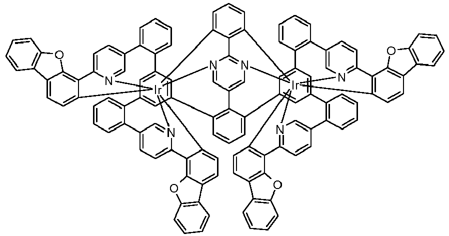 | 63% |
| | | Ir₂(L24) 250°C; 2 h Heißextraktion: o-Xylol | |
| Ir₂(L25) | L25 | 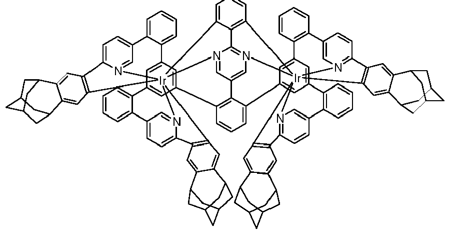 | 54% |
| | | Ir₂(L25) 250°C; 2 h Heißextraktion: Ethylacetat | |
| Ir₂(L26) | L26 | 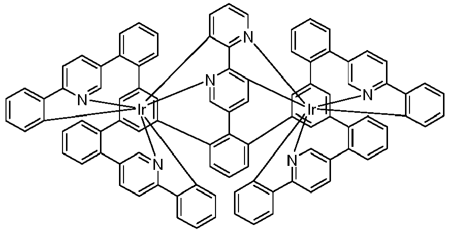 | 63% |
| | | Ir₂(L26) 250°C; 3.5 h Heißextraktion: n-Butylacetat | |
| Ir₂(L27) | L27 | 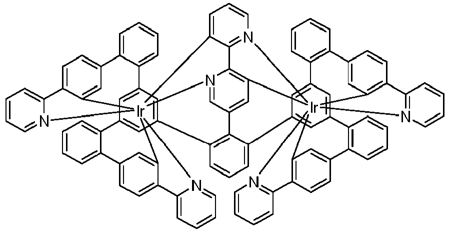 | 66% |
| | | Ir₂(L27) 260°C; 3 h Heißextraktion: Ethylacetat | |
| Ir₂(L28) | L28 | 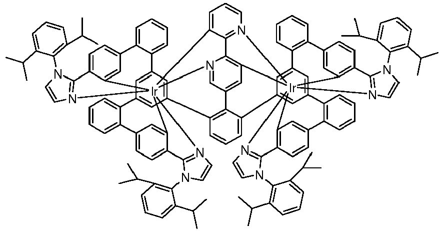 | 56% |
| | | Ir₂(L28) 250°C; 3 h Heißextratkion: n-Butylacetat | |
| Ir₂(L29) | L29 | 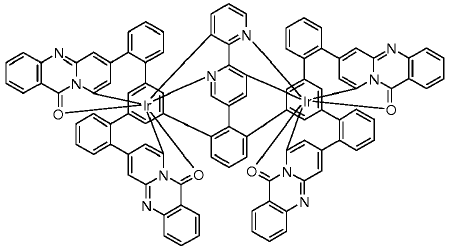 | 60% |
| | | Ir₂(L29) 235°C; 2 h Heißextraktion: Toluol | |
| Ir₂(L30) | L30 | 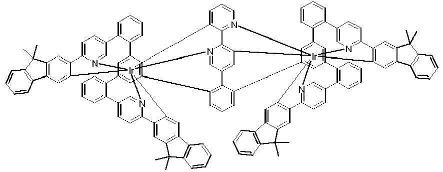 | 52% |
| | | Ir₂(L30) 250°C; 2 h Heißextraktion: Toluol | |
| Ir₂(L31) | L31 | 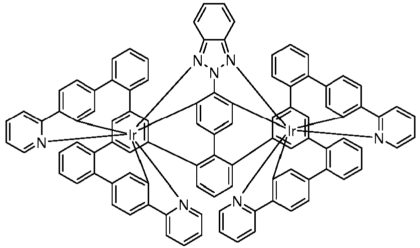 | 48% |
| | | Ir₂(L31) 240°C; 2 h Heißextraktion: Dichlormethan | |
| Ir₂(L32) | L32 | 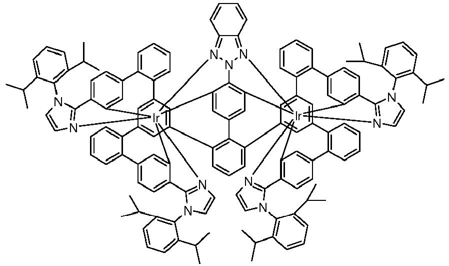 | 46% |
| | | Ir₂(L32) 230°C; 2 h Heißextraktion: Toluol | |
| Ir₂(L33) | L33 | 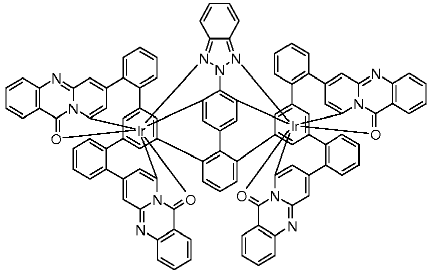 | 47% |
| | | Ir₂(L33) 250°C; 2 h Umkristallisation: Dimetehylformamid | |
| Ir₂(L34) | L34 | 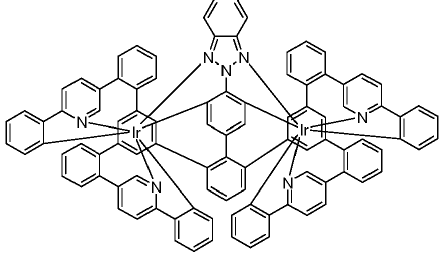 | 50% |
| | | Ir₂(L34) 250°C; 3 h Heißextraktion: n-Butylacetat | |
| Ir₂(L35) | L35 | 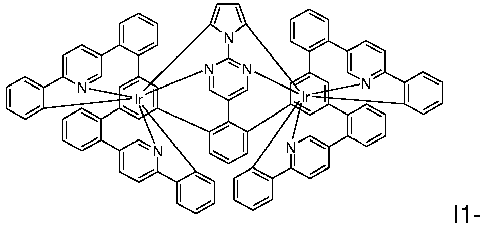 | 43% |
| | | Ir₂(L35) 270°C; 3 h Heißextraktion: Toluol | |
| Ir₂(L36) | L36 | 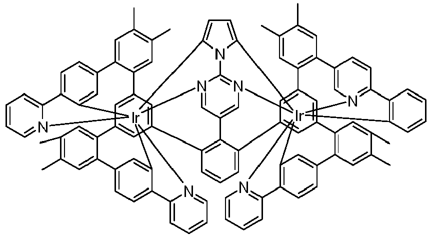 | 52% |
| | | Ir₂(L36) 260°C; 3 h Heißextraktion: Ethylacetat | |
| Ir₂(L37) | L37 | 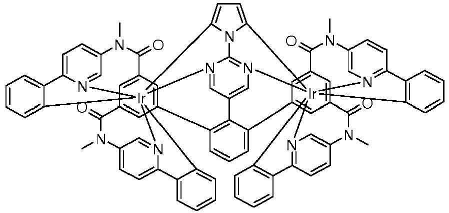 | 41% |
| | | Ir₂(L37) 250°C; 4 h Heißextraktion: 2-Proanol | |
| Ir₂(L38) | L38 | 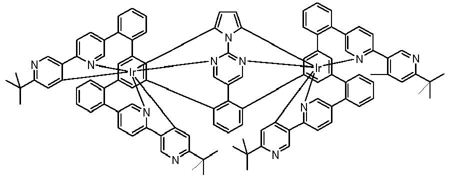 | 44% |
| | | Ir₂(L38) 250°C; 3 h Heißextraktion: Ethylacetat | |
| Ir₂(L39) | L39 | 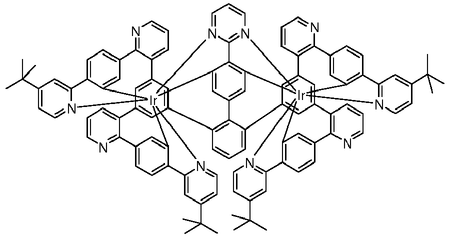 | 58% |
| | | Ir₂(L39) 260°C; 3 h Heißextraktion: Ethylacetat | |
| Ir₂(L40) | L40 | 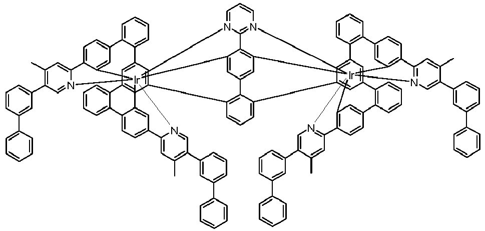 | 55% |
| | | Ir₂(L40) 260°C; 3 h Heißextraktion: Ethylacetat | |
| Ir₂(L41) | L41 | 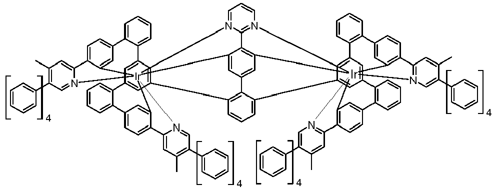 | 57% |
| | | Ir₂(L41 ) 260°C; 3 h Heißextraktion: Toluol | |
| Ir₂(L42) | L42 | 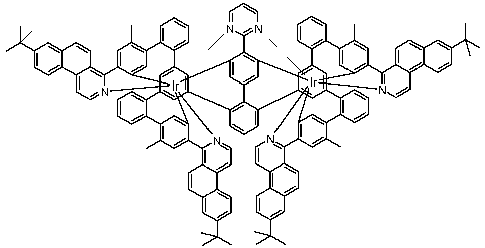 | 51% |
| | | Ir₂(L42) 260°C; 3 h Heißextraktion: Toluol | |
| Ir₂(L43) | L43 | 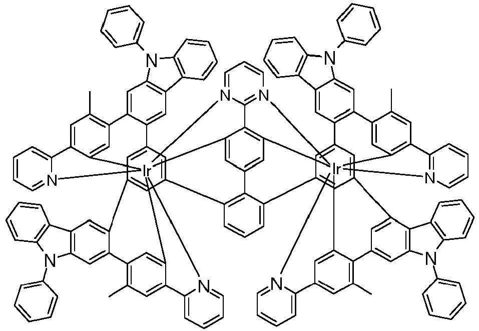 | 54% |
| | | Ir₂(L43) 260°C; 3 h Heißextraktion: Butylacetat | |
| Ir₂(L44) | L44 | 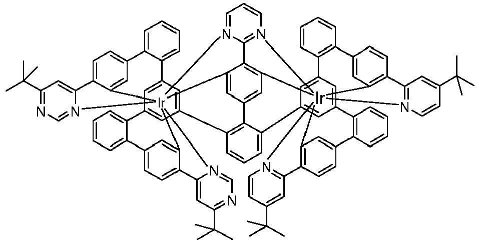 | 50% |
| | | Ir₂(L44) 260°C; 3 h Heißextraktion: Ethylacetat | |
| Ir₂(L45) | L45 | 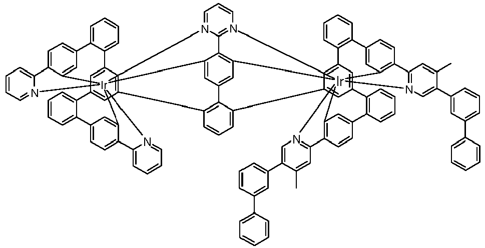 | 57% |
| | | Ir₂(L45) 260°C; 3 h Heißextraktion: Ethylacetat | |
| Rh-Ir(L1) | L1 Rh(acac)₃ Ir(acac)₃ | 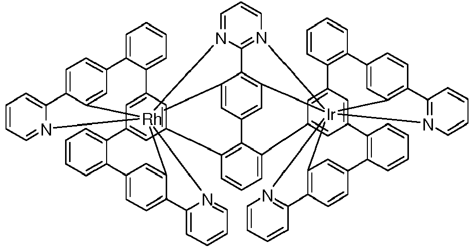 | 48% |
| | | Rh-Ir(L1 ) 250°C; 2 h Heißextraktion: Toluol | |
| Rh-Ir(L17) | L17 Rh(acac)₃ Ir(acac)₃ | 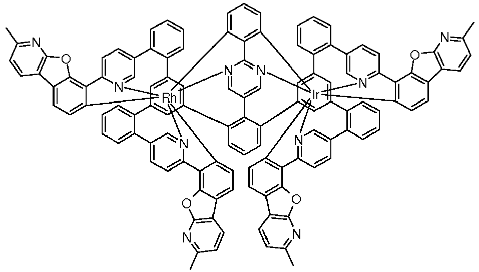 | 45% |
| | | Rh-Ir(L17) 260°C; 3 h Heißextraktion: Toluol | |

| Variante B - Carbenkomplexe | | | |
|---|---|---|---|
| Ir₂(L120) | LV120 | 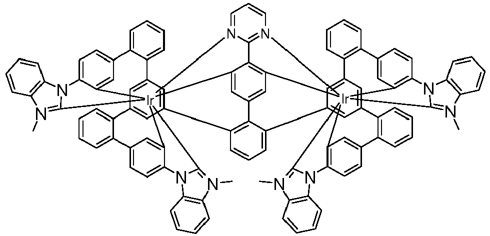 | 22% |
| Ir₂(L121) | LV121 | 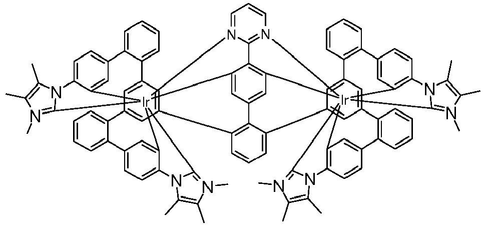 | 25% |
| Ir₂(L122) | LV122 | 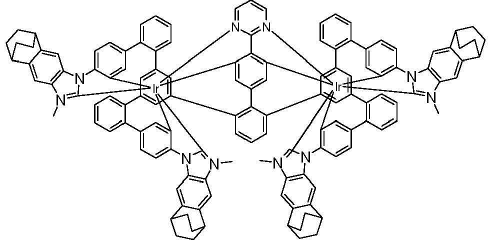 | 23% |
| Ir₂(L123) | LV123 | 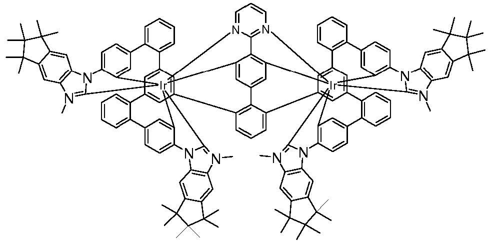 | 27% |
| Ir₂(L130) | LV130 | 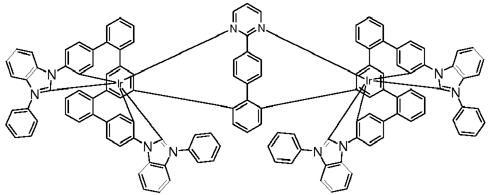 | 24% |
| Ir₂(L131) | LV131 | 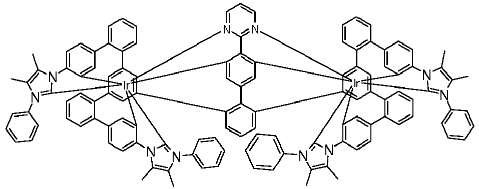 | 20% |
| Ir₂(L132) | LV132 | 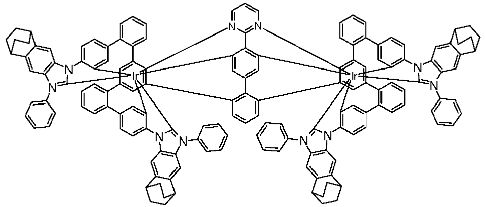 | 26% |
| Ir₂(L133) | LV133 | 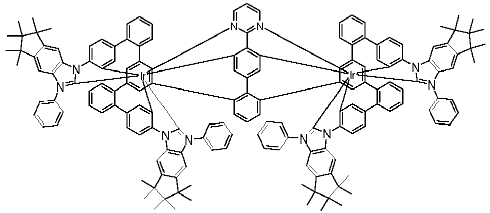 | 28% |

### D: Funktionalisierung der Metallkomplexe:

### 1) Halogenierung der Iridiumkomplexe:

Eine Lösung bzw. Suspension von 10 mmol eines Komplexes, der in para-Position zum Iridium am bidentaten Teilliganden A x C-H-Gruppen (mit A = 1-4) trägt, in 500 bis 2000 ml Dichlormethan, je nach Löslichkeit der Metallkomplexe, wird unter Licht- und Luftausschluss bei -30 bis +30 °C mit A x 10.5 mmol N-Halogensuccinimid (Halogen: Cl, Br, l) versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit 30 ml Methanol gewaschen und dann im Vakuum getrocknet. Man erhält so die in para-Position zum Iridium bromierten/halogenierten Iridiumkomplexe. Komplexe mit einem HOMO (CV) von ca. -5.1 bis -5.0 eV und betragsmäßig kleiner neigen zur Oxidation (Ir(III)→Ir(IV)), wobei das Oxidationsmittel Brom, freigesetzt aus NBS, ist. Diese Oxidationsreaktion ist durch eine deutliche Grün- oder Braunfärbung der ansonsten gelben bis roten Lösungen bzw. Suspensionen der Emitter zu erkennen. In solchen Fällen werden 1-2 weitere Äquivalente NBS zugesetzt. Zur Aufarbeitung setzt man 300-500 ml Methanol und 4 ml Hydrazin-Hydrat als Reduktionsmittel zu, wodurch sich die grünen bzw. braunen Lösungen/Suspension gelb bzw. rot verfärbt (Reduktion Ir(IV)→Ir(III)). Dann zieht man im Vakuum das Lösungsmittel weitgehend ab, versetzt mit 300 ml Methanol, saugt den Feststoff ab, wäscht dreimal mit je 100 ml Methanol und trocknet im Vakuum.

Unterstöchiometrische Bromierungen, z. B. Mono- und Dibromierungen von Komplexen mit 4 C-H-Gruppen in para-Position zu den Iridiumatomen, verlaufen meist weniger selektiv als die stöchiometrischen Bromierungen. Die Rohprodukte dieser Bromierungen können chromatographisch (CombiFlash Torrent der Fa. A. Semrau) getrennt werden.

### Synthese von Ir₂(L1-4Br):

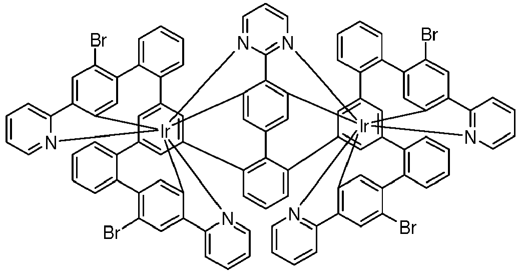

Eine Suspension von 16.8 g (10 mmol) Ir₂(L1) in 2000 ml DCM wird auf einmal mit 5.0 g (45 mmol) N-Bromsuccinimid versetzt und dann 20 h gerührt. Es werden 2 mL Hydrazinhydrat und anschließend 300 mL MeOH zugegeben. Nach Entfernen von ca. 1900 ml des DCMs im Vakuum wird der rote Feststoff abgesaugt, dreimal mit ca. 50 ml Methanol gewaschen und im Vakuum getrocknet. Ausbeute: 18.5 g (9.3 mmol), 93 %; Reinheit: > 99.0 %ig nach NMR.

Analog können folgende Verbindungen synthetisiert werden:

| Bsp. | Edukt | Produkt/ Menge NBS | Ausbeute |
|---|---|---|---|
| Rh₂(L1-4Br) | Rh₂(L1 ) | 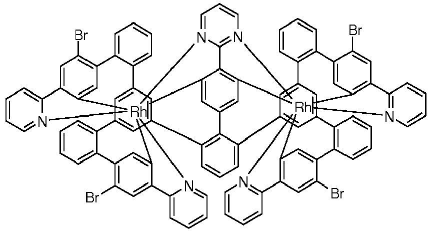 | 90% |
| | | Rh₂(L1-4Br) 4.5 equiv. NBS | |
| Ir₂(L2-4Br) | Ir2(L2) | 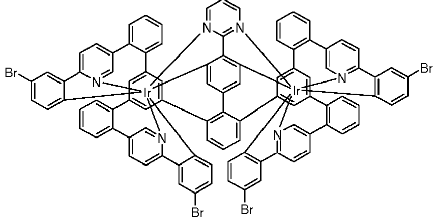 | 95% |
| | | Ir₂(L2-4Br) 4.5 equiv. NBS | |
| Rh₂(L2-4Br) | Rh₂(L2) | Rh₂(L2-4Br) 4.5 equiv. NBS | 88% |
| Ir₂(L3-4Br) | Ir₂(L3) | Ir₂(L3-4Br) 4.5 equiv. NBS | 96% |
| Ir₂(L4-4Br) | I r2(L4) | Ir₂(L4-4Br) 4.5 equiv. NBS | 92% |
| Ir₂(L5-4Br) | Ir₂(L5) | Ir₂(L5-4Br) 5 equiv. NBS | 84% |
| Ir₂(L6-4Br) | Ir₂(L6) | Ir₂(L6-4Br) 5 equiv NBS; 0.01 equiv HBr (aq) | 95% |
| Ir₂(L8-4Br) | Ir₂(L8) | Ir₂(L8-4Br) 5 equiv. NBS | 83% |
| Ir₂(L9-4Br) | Ir₂(L9) | Ir₂(L9-4Br) 4.5 equiv. NBS | 87% |
| Ir₂(L1 0-4Br) | Ir₂(L10) | Ir₂(L1 0-4Br) 5 equiv. NBS | 88% |
| Ir₂(L 11-4Br) | Ir₂(L11) | I1-Ir₂(L11-4Br) 4.5 equiv. NBS | 91% |
| Ir₂(L 12-4Br) | Ir₂(L1 2) | Ir₂(L 12-4Br) 4.5 equiv. NBS | 92% |
| Ir₂(L 13-4Br) | Ir₂(L13) | Ir₂(L 13-4Br) 4.5 equiv. NBS | 94% |
| Ir₂(L 14-4Br) | Ir₂(L14) | Ir₂(L 14-4Br) 5 equiv. NBS, 0.02 equiv. HBr (aq) | 90% |
| Ir₂(L 15-4Br) | Ir₂(L15) | 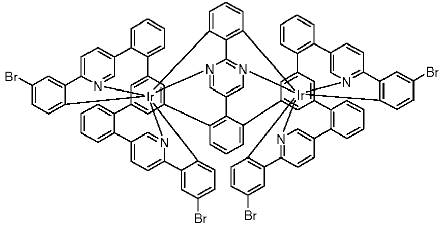 | 92% |
| | | Ir₂(L 15-4Br) 5 equiv. NBS | |
| Ir₂(L 16-4Br) | Ir₂(L16) | 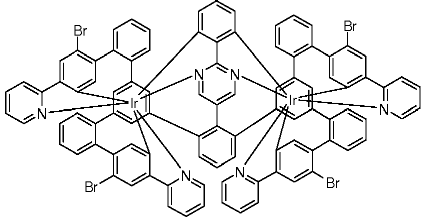 | 86% |
| | | Ir₂(L 16-4Br) 4.5 equiv. NBS | |
| Ir₂(L 18-4Br) | Ir₂(L18) | Ir₂(L 18-4Br) 5 equiv. NBS | 81% |
| Ir₂(L21-4Br) | Ir₂(L21) | Ir₂(L21-4Br) 4.5 equiv. NBS | 95% |
| Ir₂(L23-4Br) | Ir₂(L23) | Ir₂(L23-4Br) 5 equiv. NBS | 83% |
| Ir₂(L26-4Br) | Ir₂(L26) | 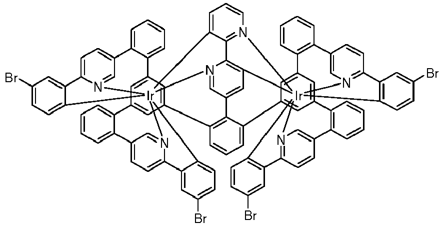 | 90% |
| | | Ir₂(L26-4Br) 4.5 equiv. NBS | |
| Ir₂(L27-4Br) | Ir₂(L27) | 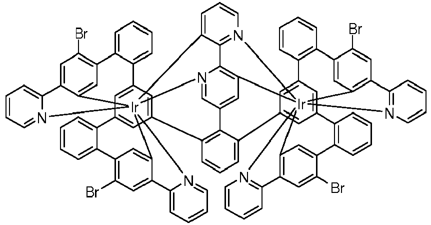 | 95% |
| | | Ir₂(L27-4Br) 4.5 equiv. NBS | |
| Ir₂(L31-4Br) | Ir₂(L31) | 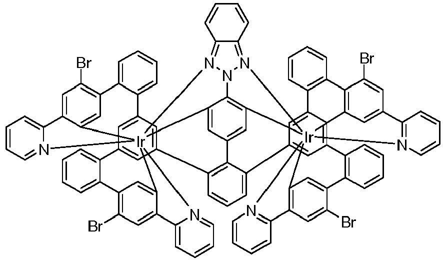 | 86% |
| | | Ir₂(L31-4Br) 4.5 equiv. NBS | |
| Ir₂(L32-4Br) | Ir₂(L32) | Ir₂(L32-4Br) 4.5 equiv. NBS: | 91% |
| Ir₂(L33-4Br) | Ir₂(L33) | 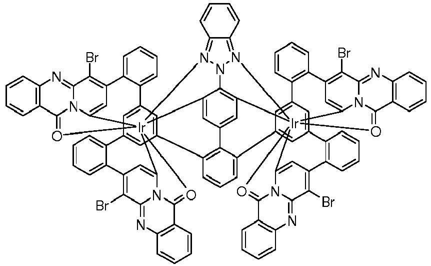 | 90% |
| | | Ir₂(L33-4Br) 4.5 equiv. NBS | |
| Ir₂(L34-4Br) | Ir₂(L34) | Ir₂(L34-4Br) 4.5 equiv. NBS | 85% |
| Ir₂(L35-4Br) | Ir₂(L35) | 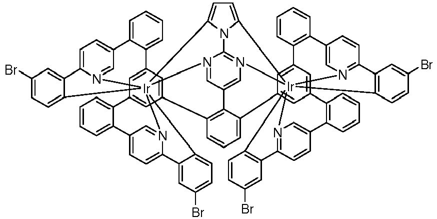 | 89% |
| | | Ir₂(L35-4Br) 4.5 equiv. NBS | |
| Ir₂(L36-4Br) | Ir₂(L36) | 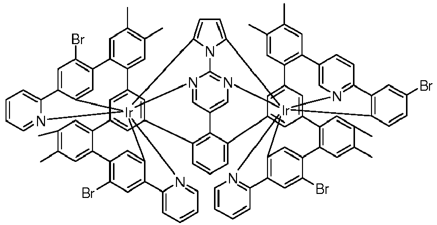 | 84% |
| | | Ir₂(L36-4Br) 4.5 equiv. NBS | |
| Ir₂(L39-4Br) | Ir₂(L39) | 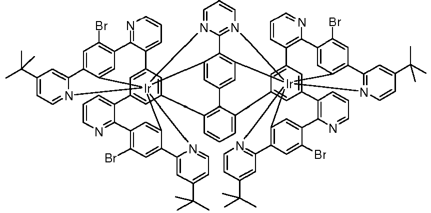 | 88% |
| | | Ir₂(L39-4Br) 4.5 equiv. NBS | |
| Ir₂(L1 20-4Br) | Ir₂(L1 20) | 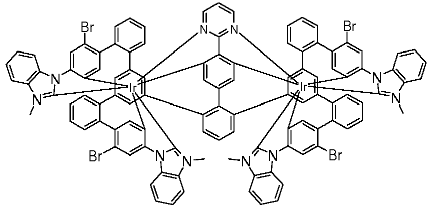 | 90% |
| Ir₂(L131-4Br) | Ir₂(L131) | 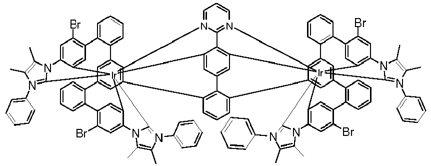 | 87% |

### 2) Suzuki-Kupplung an den bromierten Iridium-Komplexen:

### Variante A, zweiphasige Reaktionsmischung:

Eine Suspension von 10 mmol eines bromierten Komplexes, 12 - 20 mmol Boronsäure bzw. Boronsäureester pro Br-Funktion und 60 - 100 mmol Trikaliumphosphat in einem Gemisch aus 300 ml Toluol, 100 ml Dioxan und 300 ml Wasser wird mit 0.6 mmol Tri-o-tolylphosphin und dann mit 0.1 mmol Palladium(II)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser und einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Methanol zu, saugt vom ausgefallenen Rohprodukt ab, wäscht dieses dreimal mit je 50 ml Methanol und trocknet im Vakuum. Das Rohprodukt wird an Kieselgel chromatographiert auf einem Säulenautomaten (Torrent der Firma Semrau). Anschließend wird der Komplex durch Heißextraktion in Lösungsmitteln wie Ethylacetat, Toluol, Dioxan, Acetonitril, Cyclohexan, ortho- oder para-Xylol, n-Butylacetat etc. weiter gereinigt. Alternativ kann aus diesen Lösungsmitteln sowie Hochsiedern wie Dimethylformamid, Dimethylsulfoxid oder Mesitylen umkristallisiert werden. Der Metallkomplex wird abschließend getempert. Das Tempern erfolgt im Hochvakuum (p ca. 10⁻⁶ mbar) im Temperaturbereich von ca. 200 - 350 °C.

### Variante B, einphasige Reaktionsmischung:

Eine Suspension von 10 mmol eines bromierten Komplexes, 12 - 20 mmol Boronsäure bzw. Boronsäureester pro Br-Funktion und 100 - 180 mmol der Base (Kaliumfluorid, Trikaliumphosphat (wasserfrei, Monohydrat oder Trihydrat), Kaliumcarbonat, Cäsiumcarbonat, etc.) und 100 g Glaskugeln (3 mm Durchmesser) in 100 ml - 500 ml eines aprotischen Lösungsmittels (THF, Dioxan, Xylol, Mesitylen, Dimethylacetamid, NMP, DMSO, etc.) wird mit 0.2 mmol Tetrakis(triphenylphosphin)palladium(0) versetzt [14221-01-3] und 24 h unter Rückfluss erhitzt. Alternativ können andere Phosphine wie Triphenylphosphin, Tri-tert-butylphosphin, SPhos, XPhos, RuPhos, XanthPhos, etc. in Kombination mit Pd(OAc)₂ eingesetzt werden, wobei bei diesen Phosphinen das bevorzugte Phosphin: Palladium Verhältnis 3:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

### Synthese von Ir₂100:

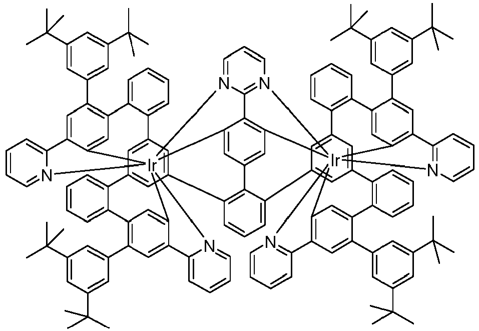

### Variante B:

Einsatz von 19.92 g (10.0 mmol) Ir(L1-4Br) und 25.3 g (80.0 mmol) 2-(3,5-Di-tert-butylphenyl)-4,4,5,5-tetramethyl-1,3,2-dioxaborolan [1071924-13-4], 27.6 g (120 mmol) Trikaliumphosphat Monohydrat, 116 mg (0.1 mmol) Tetrakis(triphenylphosphin)palladium(0), 500 mL trockenes Dimethylsulfoxid, 100 °C, 16 h. Chromatographische Trennung an Kieselgel mit Toluol/Heptan (Säulenautomat, Torrent der Firma Axel Semrau) anschließend fünfmalige Heißextraktion mit Ethylacetat. Ausbeute: 13.6 g (5.6 mmol), 56 %; Reinheit: ca. 99.9 %ig nach HPLC.

Analog können folgende Verbindungen dargestellt werden:

| Bsp. | **Edukt Variante/ Reaktions-bedingungen Boronsäure** | Produkt/Heißextratkionsmittel (HE) | Ausbeute |
|---|---|---|---|
| Rh₂100 | Rh₂(L1-4Br) Variante B Pd(Oac)₂/SPh os, 1:1.3, Cs₂CO₃, Dioxan | 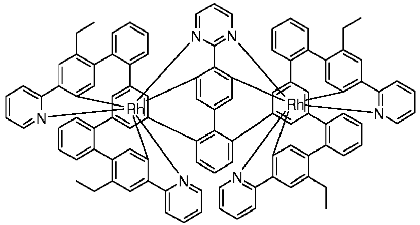 | 28% |
| | 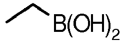 | | |
| | [4433-63-0] | HE: Ethylacetat/Acetonitril 1:1 | |
| Ir₂101 | Ir(L1-4Br) Variante A | 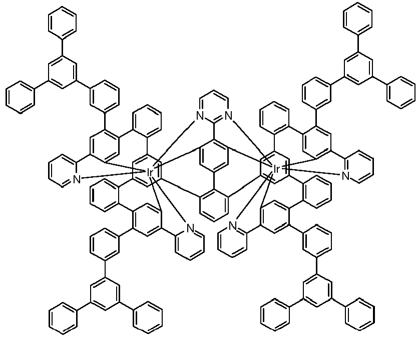 | 53% |
| | 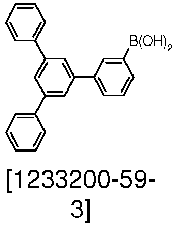 | | |
| | | HE:Toluol | |
| Ir₂102 | Ir₂(L2-4Br) Variante A | 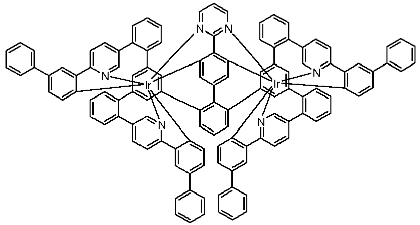 | 56% |
| | 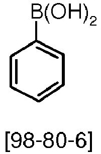 | | |
| | | HE:Toluol | |
| Ir₂103 | Ir₂(L 15-4Br) Variante B | 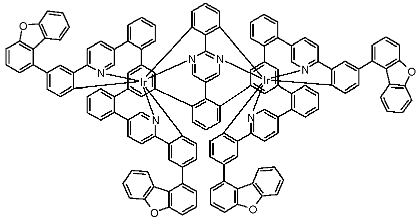 | 48% |
| | 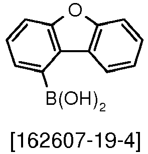 | | |
| | | HE:Dichlormethan | |
| Ir₂104 | Ir₂(L 16-4Br) Variante B | 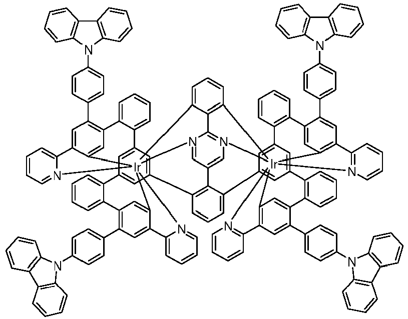 | 47% |
| | 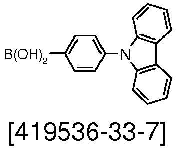 | | |
| | | HE: n-Butylacetat | |
| Ir₂105 | 11-Ir₂(L 18-4Br) Variante B Pd(Oac)₂/SPh os, 1:1.3, Cs₂CO₃, Dioxan | 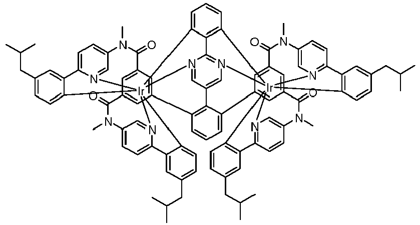 | 21% |
| | 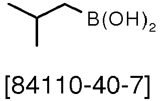 | | |
| | | Heißextraktion: Ethylacetat | |
| Ir₂106 | Ir₂(L26-4Br) Variante B | 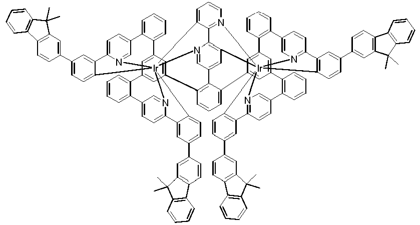 | 51% |
| | 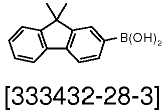 | | |
| | | HE: n-Butylacetat | |
| Ir₂107 | Ir₂(L27-4Br) Variante B | 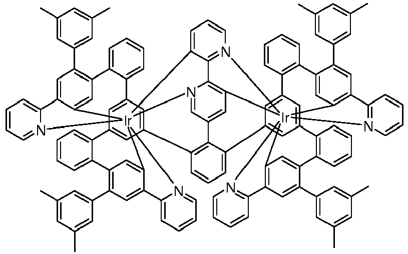 | 52% |
| | 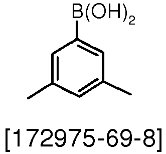 | | |
| | | HE: Ethylacetat | |
| Ir₂108 | Ir₂(L31-4Br) Variante B Pd(Oac)₂/Xant hphos, 1:1.3, K₂CO₃, Dioxan | 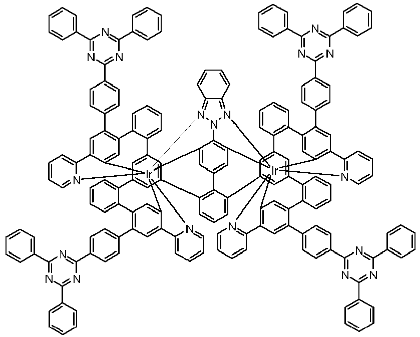 | 50% |
| | 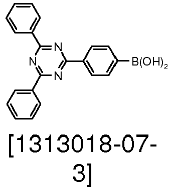 | | |
| | | HE: Toluol | |
| Ir₂109 | Ir₂(L32-4Br) Variante B | 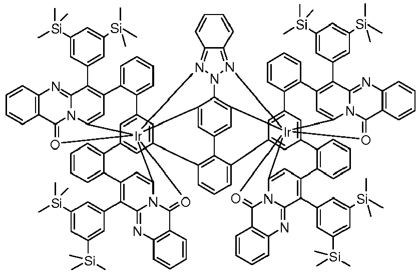 | 45% |
| | 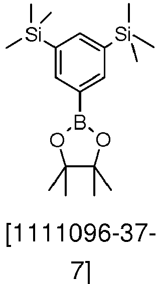 | | |
| | | HE: Ethylacetat | |
| Ir₂110 | Ir₂(L35-4Br) Variante B | 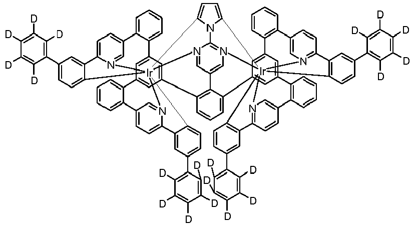 | 48% |
| | 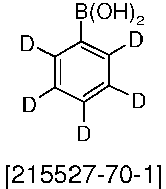 | | |
| | | Heißextraktion: Ethylacetat | |
| Ir₂111 | Ir₂(L36-4Br) Variante A | 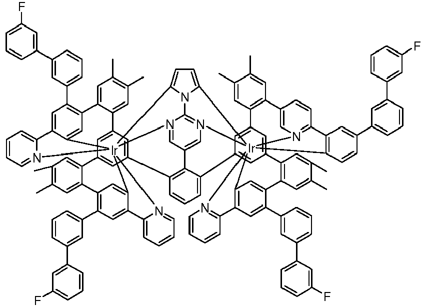 | 54% |
| | 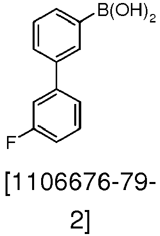 | | |
| | | UK: n-Butylacetat | |
| Ir₂112 | Ir₂(L 120-4Br) Variante A | 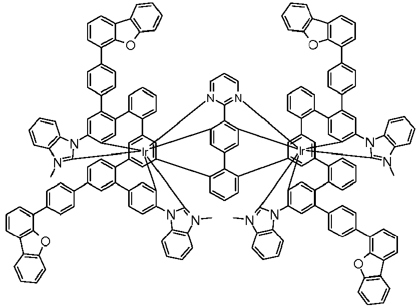 | 47% |
| | 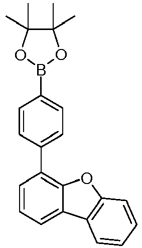 | | |
| | | HE: Toluol | |
| | 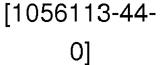 | | |
| Ir₂113 | Ir₂(L131-4Br) Variante A | 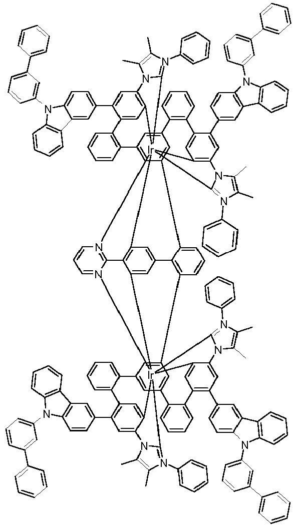 | 51% |
| | 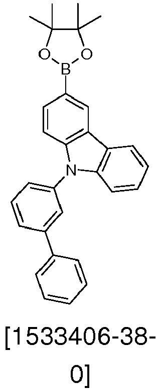 | | |
| | | HE: Butylacetat | |

### 3) Deuterierung von Ir-Komplexen:

### Beispiel: Ir₂(L12-D12)

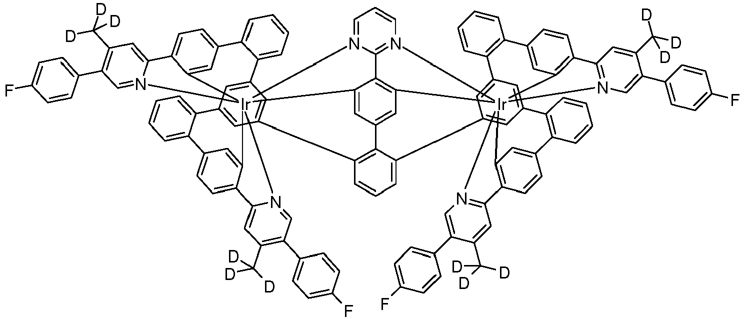

Ein Gemisch von 2.12 g (1 mmol) Ir₂(L12), 68 mg (1 mmol) Natriumethanolat, 5 ml Methanol-D4 und 80 ml DMSO-D6 wird 2 h auf 120 °C erhitzt. Nach Erkalten auf 50 °C gibt man 1 ml DCl (10 %ige wässrige Lösung) zu. Man entfernt das Lösungsmittel im Vakuum und chromatographiert den Rückstand mit DCM an Kieselgel. Ausbeute: 2.11 g (0.95 mmol), 95 %, Deuterierungsgrad > 95 %.

Analog können folgende Verbindungen dargestellt werden:

| Bsp. | Edukt / Produkt | Ausbeute |
|---|---|---|
| Ir₂(L17-D12) | Ir₂(L17) | 90 % |
| | 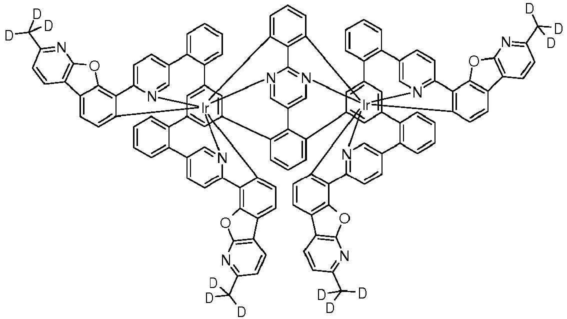 | |

### Beispiel: Photophysikalischen Eigenschaften von Ir₂(L1)

Das Maximum des Photolumineszenz-Spektrums in nm wird in einer entgasten ca. 10⁻⁵ molaren Lösung von Ir₂(L1) in Toluol bei Raumtemperatur bei einer Anregungswellenlänge von 400 nm bestimmt. Das Photolumineszenzmaximum liegt bei 603 nm.

### Device Beispiele:

### Beispiel 1: Herstellung der OLEDs

Die erfindungsgemäßen Komplexe können aus Lösung verarbeitet werden und führen gegenüber vakuumprozessierten OLEDs zu wesentlich einfacher herstellbaren OLEDs mit dennoch guten Eigenschaften. Die Herstellung vollständig lösungsbasierter OLEDs ist in der Literatur bereits vielfach beschrieben, z. B. in WO 2004/037887. Die Herstellung vakuumbasierter OLEDs ist ebenfalls vielfach beschrieben, u.a. in WO 2004/058911. In den im Folgenden diskutierten Beispielen werden lösungsbasiert und vakuumbasiert aufgebrachte Schichten innerhalb einer OLED kombiniert, so dass die Prozessierung bis einschließlich zur Emissionsschicht aus Lösung und in den darauffolgenden Schichten (Lochblockierschicht und Elektronentransportschicht) aus dem Vakuum erfolgt. Die vorbeschriebenen allgemeinen Verfahren werden dafür wie folgt auf die hier beschriebenen Gegebenheiten (Schichtdickenvariation, Materialien) angepasst und kombiniert. Der generelle Aufbau ist wie folgt: Substrat / ITO (50 nm) / Lochinjektionsschicht (HIL) / Lochtransportschicht (HTL) / Emissionsschicht (EML) / Lochblockierschicht (HBL) / Elektronentransportschicht (ETL) / Kathode (Aluminium, 100 nm). Als Substrat dienen Glasplättchen, die mit strukturiertem ITO (Indium Zinn Oxid) der Dicke 50 nm beschichtet sind. Zur besseren Prozessierung werden diese mit PEDOT:PSS beschichtet (Poly(3,4-ethylendioxy-2,5-thiophen) : Polystyrolsulfonat, bezogen von Heraeus Precious Metals GmbH & Co. KG, Deutschland). PEDOT:PSS wird an Luft aus Wasser aufgeschleudert und nachfolgend an Luft bei 180 °C für 10 Minuten ausge heizt, um Restwasser zu entfernen. Auf diese beschichteten Glasplättchen werden die Lochtransportschicht sowie die Emissionsschicht aufgebracht. Die verwendete Lochtransportschicht ist vernetzbar. Es wird ein Polymer gemäß der nachfolgenden abgebildeten Struktur verwendet, das gemäß WO 2010/097155 bzw. WO 2013/156130 synthetisiert werden kann:

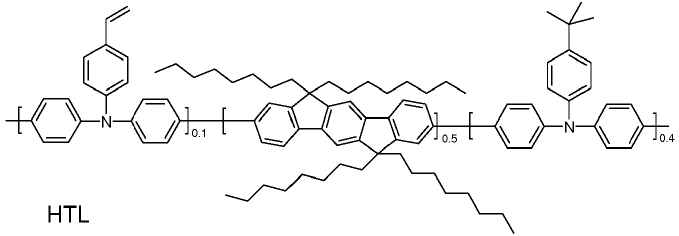

Das Lochtransport-Polymer wird in Toluol gelöst. Der typische Feststoffgehalt solcher Lösungen liegt bei ca. 5 g/l, wenn, wie hier, die für eine Device typische Schichtdicke von 20 nm mittels Spincoating erzielt werden soll. Die Schichten werden in einer Inertgasatmosphäre, im vorliegenden Fall Argon, aufgeschleudert und 60 Minuten bei 180 °C ausgeheizt.

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin aufreten können Mischungen aus mehreren Matrixmaterialien sowie Co-Dotanden. Eine Angabe wie TMM-A (92%) : Dotand (8%) bedeutet hierbei, dass das Material TMM-A in einem Gewichtsanteil von 92% und Dotand in einem Gewichtsanteil von 8% in der Emissionsschicht vorliegt. Die Mischung für die Emissionsschicht wird in Toluol oder ggf. Chlorbenzol gelöst. Der typische Feststoffgehalt solcher Lösungen liegt bei ca. 17 g/l, wenn, wie hier, die für eine Device typische Schichtdicke von 60 nm mittels Spincoating erzielt werden soll. Die Schichten werden in einer Inertgasatmosphäre, im vorliegenden Fall Argon, aufgeschleudert und 10 Minuten bei 150 °C au sgeheizt. Die im vorliegenden Fall verwendeten Materialien sind in Tabelle 1 gezeigt.

**Tabelle 1: Verwendete EML-Materialien**

| | | |
|---|---|---|
| 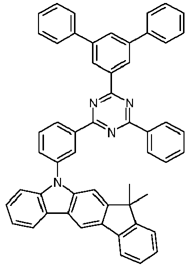 | 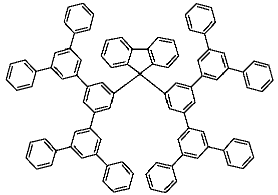 | 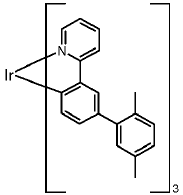 |
| A-1 [1616231-83-41 | B-1 [1257248-89-7] | C-1 [1338784-40-9] |

Die Materialien für die Lochblockierschicht und Elektronentransportschicht werden in einer Vakuumkammer thermisch aufgedampft. Dabei kann z. B. die Elektronentransportschicht aus mehr als einem Material bestehen, die einander durch Co-Verdampfung in einem bestimmten Volumenanteil beigemischt werden. Eine Angabe wie ETM1:ETM2 (50%:50%) bedeutet hierbei, dass die Materialien ETM1 und ETM2 in einem Volumenanteil von je 50% in der Schicht vorliegen. Die im vorliegenden Fall verwendeten Materialien sind in Tabelle 2 gezeigt.

**Tabelle 2: Verwendete HBL- und ETL-Materialien**

| | |
|---|---|
| 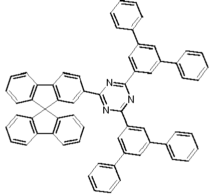 | 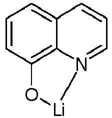 |
| ETM1 [1233200-52-6] | ETM2 [25387-93-3] |

Die Kathode wird durch die thermische Verdampfung einer 100 nm Aluminiumschicht gebildet. Die OLEDs werden standardmäßig charakterisiert. Die EML-Mischungen und Aufbauten der untersuchten OLED-Bauteile sind in Tabelle 3 und Tabelle 4 dargestellt. In allen Fällen wird intensive gelbe über orange-rote bis rote Emission beobachtet.

**Tabelle 3: EML-Mischungen der untersuchten OLED-Bauteile**

| Bsp. | Matrix A | | Co-Matrix B | | Co-Dotand C | | Dotand D | |
|---|---|---|---|---|---|---|---|---|
| | material | % | material | % | material | % | material | % |
| E-1 | A-1 | 30 | B-1 | 34 | C-1 | 30 | Ir2(L1) | 6 |
| E-2 | A-1 | 50 | B-1 | 25 | C-1 | 15 | Ir2(L1) | 10 |
| E-3 | A-1 | 40 | B-1 | 45 | --- | --- | Ir2(L1) | 15 |
| E-4 | A-1 | 50 | B-1 | 25 | C-1 | 15 | Rh₂(L1) | 10 |
| E-5 | A-1 | 50 | B-1 | 25 | C-1 | 15 | Ir₂(L2) | 10 |
| E-6 | A-1 | 50 | B-1 | 25 | C-1 | 15 | Rh₂(L2) | 10 |
| E-7 | A-1 | 50 | B-1 | 25 | C-1 | 15 | Ir₂(L3) | 10 |
| E-8 | A-1 | 50 | B-1 | 25 | C-1 | 15 | Ir₂(L4) | 10 |
| E-9 | A-1 | 50 | B-1 | 25 | C-1 | 15 | Ir₂(L5) | 10 |
| E-10 | A-1 | 50 | B-1 | 25 | C-1 | 15 | Ir₂(L6) | 10 |
| E-11 | A-1 | 50 | B-1 | 25 | C-1 | 15 | Ir₂(L7) | 10 |
| E-12 | A-1 | 50 | B-1 | 25 | C-1 | 15 | Ir₂(L8) | 10 |
| E-13 | A-1 | 50 | B-1 | 25 | C-1 | 15 | Ir₂(L9) | 10 |
| E-14 | A-1 | 50 | B-1 | 25 | C-1 | 15 | Ir₂(L10) | 10 |
| E-15 | A-1 | 50 | B-1 | 25 | C-1 | 15 | Ir₂(L11) | 10 |
| E-16 | A-1 | 50 | B-1 | 25 | C-1 | 15 | Ir₂(L12) | 10 |
| E-17 | A-1 | 50 | B-1 | 25 | C-1 | 15 | Ir₂(L13) | 10 |
| E-18 | A-1 | 50 | B-1 | 25 | C-1 | 15 | Ir₂(L14) | 10 |
| E-19 | A-1 | 50 | B-1 | 25 | C-1 | 15 | Ir₂(L15) | 10 |
| E-20 | A-1 | 50 | B-1 | 25 | C-1 | 15 | Ir₂(L16) | 10 |
| E-21 | A-1 | 50 | B-1 | 25 | C-1 | 15 | Ir₂(L1 7) | 10 |
| E-22 | A-1 | 50 | B-1 | 25 | C-1 | 15 | Ir₂(L18) | 10 |
| E-23 | A-1 | 50 | B-1 | 25 | C-1 | 15 | Ir₂(L19) | 10 |
| E-24 | A-1 | 50 | B-1 | 25 | C-1 | 15 | Ir₂(L20) | 10 |
| E-25 | A-1 | 50 | B-1 | 25 | C-1 | 15 | Ir₂(L21) | 10 |
| E-26 | A-1 | 50 | B-1 | 25 | C-1 | 15 | Ir₂(L22) | 10 |
| E-27 | A-1 | 50 | B-1 | 25 | C-1 | 15 | Ir₂(L23) | 10 |
| E-28 | A-1 | 50 | B-1 | 25 | C-1 | 15 | Ir₂(L24) | 10 |
| E-29 | A-1 | 50 | B-1 | 25 | C-1 | 15 | Ir₂(L25) | 10 |
| E-30 | A-1 | 50 | B-1 | 25 | C-1 | 15 | Ir₂(L26) | 10 |
| E-31 | A-1 | 50 | B-1 | 25 | C-1 | 15 | Ir₂(L27) | 10 |
| E-32 | A-1 | 50 | B-1 | 25 | C-1 | 15 | Ir₂(L28) | 10 |
| E-33 | A-1 | 50 | B-1 | 25 | C-1 | 15 | Ir₂(L29) | 10 |
| E-34 | A-1 | 50 | B-1 | 25 | C-1 | 15 | Ir₂(L30) | 10 |
| E-35 | A-1 | 50 | B-1 | 25 | C-1 | 15 | Ir₂(L31) | 10 |
| E-36 | A-1 | 50 | B-1 | 25 | C-1 | 15 | Ir₂(L32) | 10 |
| E-37 | A-1 | 50 | B-1 | 25 | C-1 | 15 | Ir₂(L33) | 10 |
| E-38 | A-1 | 50 | B-1 | 25 | C-1 | 15 | Ir₂(L34) | 10 |
| E-39 | A-1 | 50 | B-1 | 25 | C-1 | 15 | Ir₂(L35) | 10 |
| E-40 | A-1 | 50 | B-1 | 25 | C-1 | 15 | Ir₂(L36) | 10 |
| E-41 | A-1 | 50 | B-1 | 25 | C-1 | 15 | Ir₂(L37) | 10 |
| E-42 | A-1 | 50 | B-1 | 25 | C-1 | 15 | Ir₂(L38) | 10 |
| E-43 | A-1 | 50 | B-1 | 25 | C-1 | 15 | Ir₂(L39) | 10 |
| E-44 | A-1 | 50 | B-1 | 25 | C-1 | 15 | Ir₂(L40) | 10 |
| E-45 | A-1 | 50 | B-1 | 25 | C-1 | 15 | Ir₂(L41) | 10 |
| E-46 | A-1 | 50 | B-1 | 25 | C-1 | 15 | Ir₂(L42) | 10 |
| E-47 | A-1 | 50 | B-1 | 25 | C-1 | 15 | Ir₂(L43) | 10 |
| E-48 | A-1 | 50 | B-1 | 25 | C-1 | 15 | Ir₂(L44) | 10 |
| E-49 | A-1 | 50 | B-1 | 25 | C-1 | 15 | Ir₂(L45) | 10 |
| E-50 | A-1 | 50 | B-1 | 25 | C-1 | 15 | Rh-Ir(L1) | 10 |
| E-51 | A-1 | 50 | B-1 | 25 | C-1 | 15 | Rh-Ir(L17) | 10 |
| E-52 | A-1 | 50 | B-1 | 25 | C-1 | 15 | Ir₂(L120) | 10 |
| E-53 | A-1 | 50 | B-1 | 25 | C-1 | 15 | Ir₂(L121) | 10 |
| E-54 | A-1 | 50 | B-1 | 25 | C-1 | 15 | Ir₂(L122) | 10 |
| E-55 | A-1 | 50 | B-1 | 25 | C-1 | 15 | Ir₂(L123) | 10 |
| E-56 | A-1 | 50 | B-1 | 25 | C-1 | 15 | Ir₂(L130) | 10 |
| E-57 | A-1 | 50 | B-1 | 25 | C-1 | 15 | Ir₂(L131) | 10 |
| E-58 | A-1 | 50 | B-1 | 25 | C-1 | 15 | Ir₂(L132) | 10 |
| E-59 | A-1 | 50 | B-1 | 25 | C-1 | 15 | Ir₂(L133) | 10 |
| E-60 | A-1 | 50 | B-1 | 25 | C-1 | 15 | Ir₂100 | 10 |
| E-61 | A-1 | 50 | B-1 | 25 | C-1 | 15 | Rh₂100 | 10 |
| E-62 | A-1 | 50 | B-1 | 25 | C-1 | 15 | Ir₂101 | 10 |
| E-63 | A-1 | 50 | B-1 | 25 | C-1 | 15 | Ir₂102 | 10 |
| E-64 | A-1 | 50 | B-1 | 25 | C-1 | 15 | Ir₂103 | 10 |
| E-65 | A-1 | 50 | B-1 | 25 | C-1 | 15 | Ir₂104 | 10 |
| E-66 | A-1 | 50 | B-1 | 25 | C-1 | 15 | Ir₂105 | 10 |
| E-67 | A-1 | 50 | B-1 | 25 | C-1 | 15 | Ir₂106 | 10 |
| E-68 | A-1 | 50 | B-1 | 25 | C-1 | 15 | Ir₂107 | 10 |
| E-69 | A-1 | 50 | B-1 | 25 | C-1 | 15 | Ir₂108 | 10 |
| E-70 | A-1 | 50 | B-1 | 25 | C-1 | 15 | Ir₂109 | 10 |
| E-71 | A-1 | 50 | B-1 | 25 | C-1 | 15 | Ir₂110 | 10 |
| E-72 | A-1 | 50 | B-1 | 25 | C-1 | 15 | Ir₂111 | 10 |
| E-73 | A-1 | 50 | B-1 | 25 | C-1 | 15 | Ir₂112 | 10 |
| E-74 | A-1 | 50 | B-1 | 25 | C-1 | 15 | Ir₂113 | 10 |
| E-75 | A-1 | 50 | B-1 | 25 | C-1 | 15 | Ir₂(L12-D12) | 10 |
| E-76 | A-1 | 50 | B-1 | 25 | C-1 | 15 | Ir₂(L17-D12) | 10 |

**Tabelle 4: Aufbau der untersuchten OLED-Bauteile**

| Bsp. | HIL (Dicke) | HTL (Dicke) | EML-Dicke | HBL (Dicke) | ETL (Dicke) |
|---|---|---|---|---|---|
| E-1 | PEDOT (60nm) | HTL2 (20nm) | 60nm | ETM-1 (10nm) | ETM-1 (50%) : ETM-2 (50%) (60nm) |
| E-2 | PEDOT (60nm) | HTL2 (20nm) | 60nm | ETM-1 (10nm) | ETM-1 (50%) : ETM-2 (50%) (40nm) |
| E-3 | PEDOT (60nm) | HTL2 (20nm) | 70nm | ETM-1 (10nm) | ETM-1 (50%) : ETM-2 (50%) (40nm) |
| E-4 | PEDOT (60nm) | HTL2 (20nm) | 60nm | ETM-1 (10nm) | ETM-1 (50%) : ETM-2 (50%) (40nm) |
| E-5 | PEDOT (60nm) | HTL2 (20nm) | 60nm | ETM-1 (10nm) | ETM-1 (50%) : ETM-2 (50%) (40nm) |
| E-6 | PEDOT (60nm) | HTL2 (20nm) | 60nm | ETM-1 (10nm) | ETM-1 (50%) : ETM-2 (50%) (40nm) |
| E-7 | PEDOT (60nm) | HTL2 (20nm) | 60nm | ETM-1 (10nm) | ETM-1 (50%) : ETM-2 (50%) (40nm) |
| E-8 | PEDOT (60nm) | HTL2 (20nm) | 60nm | ETM-1 (10nm) | ETM-1 (50%) : ETM-2 (50%) (40nm) |
| E-9 | PEDOT (60nm) | HTL2 (20nm) | 60nm | ETM-1 (10nm) | ETM-1 (50%) : ETM-2 (50%) (40nm) |
| E-10 | PEDOT (60nm) | HTL2 (20nm) | 60nm | ETM-1 (10nm) | ETM-1 (50%) : ETM-2 (50%) (40nm) |
| E-11 | PEDOT (60nm) | HTL2 (20nm) | 60nm | ETM-1 (10nm) | ETM-1 (50%) : ETM-2 (50%) (40nm) |
| E-12 | PEDOT (60nm) | HTL2 (20nm) | 60nm | ETM-1 (10nm) | ETM-1 (50%) : ETM-2 (50%) (40nm) |
| E-13 | PEDOT (60nm) | HTL2 (20nm) | 60nm | ETM-1 (10nm) | ETM-1 (50%) : ETM-2 (50%) (40nm) |
| E-14 | PEDOT (60nm) | HTL2 (20nm) | 60nm | ETM-1 (10nm) | ETM-1 (50%) : ETM-2 (50%) (40nm) |
| E-15 | PEDOT (60nm) | HTL2 (20nm) | 60nm | ETM-1 (10nm) | ETM-1 (50%) : ETM-2 (50%) (40nm) |
| E-16 | PEDOT (60nm) | HTL2 (20nm) | 60nm | ETM-1 (10nm) | ETM-1 (50%) : ETM-2 (50%) (40nm) |
| E-17 | PEDOT (60nm) | HTL2 (20nm) | 60nm | ETM-1 (10nm) | ETM-1 (50%) : ETM-2 (50%) (40nm) |
| E-18 | PEDOT (60nm) | HTL2 (20nm) | 60nm | ETM-1 (10nm) | ETM-1 (50%) : ETM-2 (50%) (40nm) |
| E-19 | PEDOT (60nm) | HTL2 (20nm) | 60nm | ETM-1 (10nm) | ETM-1 (50%) : ETM-2 (50%) (40nm) |
| E-20 | PEDOT (60nm) | HTL2 (20nm) | 60nm | ETM-1 (10nm) | ETM-1 (50%) : ETM-2 (50%) (40nm) |
| E-21 | PEDOT (60nm) | HTL2 (20nm) | 60nm | ETM-1 (10nm) | ETM-1 (50%) : ETM-2 (50%) (40nm) |
| E-22 | PEDOT (60nm) | HTL2 (20nm) | 60nm | ETM-1 (10nm) | ETM-1 (50%) : ETM-2 (50%) (40nm) |
| E-23 | PEDOT (60nm) | HTL2 (20nm) | 60nm | ETM-1 (10nm) | ETM-1 (50%) : ETM-2 (50%) (40nm) |
| E-24 | PEDOT (60nm) | HTL2 (20nm) | 60nm | ETM-1 (10nm) | ETM-1 (50%) : ETM-2 (50%) (40nm) |
| E-25 | PEDOT (60nm) | HTL2 (20nm) | 60nm | ETM-1 (10nm) | ETM-1 (50%) : ETM-2 (50%) (40nm) |
| E-26 | PEDOT (60nm) | HTL2 (20nm) | 60nm | ETM-1 (10nm) | ETM-1 (50%) : ETM-2 (50%) (40nm) |
| E-27 | PEDOT (60nm) | HTL2 (20nm) | 60nm | ETM-1 (10nm) | ETM-1 (50%) : ETM-2 (50%) (40nm) |
| E-28 | PEDOT (60nm) | HTL2 (20nm) | 60nm | ETM-1 (10nm) | ETM-1 (50%) : ETM-2 (50%) (40nm) |
| E-29 | PEDOT (60nm) | HTL2 (20nm) | 60nm | ETM-1 (10nm) | ETM-1 (50%) : ETM-2 (50%) (40nm) |
| E-30 | PEDOT (60nm) | HTL2 (20nm) | 60nm | ETM-1 (10nm) | ETM-1 (50%) : ETM-2 (50%) (40nm) |
| E-31 | PEDOT (60nm) | HTL2 (20nm) | 60nm | ETM-1 (10nm) | ETM-1 (50%) : ETM-2 (50%) (40nm) |
| E-32 | PEDOT (60nm) | HTL2 (20nm) | 60nm | ETM-1 (10nm) | ETM-1 (50%) : ETM-2 (50%) (40nm) |
| E-33 | PEDOT (60nm) | HTL2 (20nm) | 60nm | ETM-1 (10nm) | ETM-1 (50%) : ETM-2 (50%) (40nm) |
| E-34 | PEDOT (60nm) | HTL2 (20nm) | 60nm | ETM-1 (10nm) | ETM-1 (50%) : ETM-2 (50%) (40nm) |
| E-35 | PEDOT (60nm) | HTL2 (20nm) | 60nm | ETM-1 (10nm) | ETM-1 (50%) : ETM-2 (50%) (40nm) |
| E-36 | PEDOT (60nm) | HTL2 (20nm) | 60nm | ETM-1 (10nm) | ETM-1 (50%) : ETM-2 (50%) (40nm) |
| E-37 | PEDOT (60nm) | HTL2 (20nm) | 60nm | ETM-1 (10nm) | ETM-1 (50%) : ETM-2 (50%) (40nm) |
| E-38 | PEDOT (60nm) | HTL2 (20nm) | 60nm | ETM-1 (10nm) | ETM-1 (50%) : ETM-2 (50%) (40nm) |
| E-39 | PEDOT (60nm) | HTL2 (20nm) | 60nm | ETM-1 (10nm) | ETM-1 (50%) : ETM-2 (50%) (40nm) |
| E-40 | PEDOT (60nm) | HTL2 (20nm) | 60nm | ETM-1 (10nm) | ETM-1 (50%) : ETM-2 (50%) (40nm) |
| E-41 | PEDOT (60nm) | HTL2 (20nm) | 60nm | ETM-1 (10nm) | ETM-1 (50%) : ETM-2 (50%) (40nm) |
| E-42 | PEDOT (60nm) | HTL2 (20nm) | 60nm | ETM-1 (10nm) | ETM-1 (50%) : ETM-2 (50%) (40nm) |
| E-43 | PEDOT (60nm) | HTL2 (20nm) | 60nm | ETM-1 (10nm) | ETM-1 (50%) : ETM-2 (50%) (40nm) |
| E-44 | PEDOT (60nm) | HTL2 (20nm) | 60nm | ETM-1 (10nm) | ETM-1 (50%) : ETM-2 (50%) (40nm) |
| E-45 | PEDOT (60nm) | HTL2 (20nm) | 60nm | ETM-1 (10nm) | ETM-1 (50%) : ETM-2 (50%) (40nm) |
| E-46 | PEDOT (60nm) | HTL2 (20nm) | 60nm | ETM-1 (10nm) | ETM-1 (50%) : ETM-2 (50%) (40nm) |
| E-47 | PEDOT (60nm) | HTL2 (20nm) | 60nm | ETM-1 (10nm) | ETM-1 (50%) : ETM-2 (50%) (40nm) |
| E-48 | PEDOT (60nm) | HTL2 (20nm) | 60nm | ETM-1 (10nm) | ETM-1 (50%) : ETM-2 (50%) (40nm) |
| E-49 | PEDOT (60nm) | HTL2 (20nm) | 60nm | ETM-1 (10nm) | ETM-1 (50%) : ETM-2 (50%) (40nm) |
| E-50 | PEDOT (60nm) | HTL2 (20nm) | 60nm | ETM-1 (10nm) | ETM-1 (50%) : ETM-2 (50%) (40nm) |
| E-51 | PEDOT (60nm) | HTL2 (20nm) | 60nm | ETM-1 (10nm) | ETM-1 (50%) : ETM-2 (50%) (40nm) |
| E-52 | PEDOT (60nm) | HTL2 (20nm) | 60nm | ETM-1 (10nm) | ETM-1 (50%) : ETM-2 (50%) (40nm) |
| E-53 | PEDOT (60nm) | HTL2 (20nm) | 60nm | ETM-1 (10nm) | ETM-1 (50%) : ETM-2 (50%) (40nm) |
| E-54 | PEDOT (60nm) | HTL2 (20nm) | 60nm | ETM-1 (10nm) | ETM-1 (50%) : ETM-2 (50%) (40nm) |
| E-55 | PEDOT (60nm) | HTL2 (20nm) | 60nm | ETM-1 (10nm) | ETM-1 (50%) : ETM-2 (50%) (40nm) |
| E-56 | PEDOT (60nm) | HTL2 (20nm) | 60nm | ETM-1 (10nm) | ETM-1 (50%) : ETM-2 (50%) (40nm) |
| E-57 | PEDOT (60nm) | HTL2 (20nm) | 60nm | ETM-1 (10nm) | ETM-1 (50%) : ETM-2 (50%) (40nm) |
| E-58 | PEDOT (60nm) | HTL2 (20nm) | 60nm | ETM-1 (10nm) | ETM-1 (50%) : ETM-2 (50%) (40nm) |
| E-59 | PEDOT (60nm) | HTL2 (20nm) | 60nm | ETM-1 (10nm) | ETM-1 (50%) : ETM-2 (50%) (40nm) |
| E-60 | PEDOT (60nm) | HTL2 (20nm) | 60nm | ETM-1 (10nm) | ETM-1 (50%) : ETM-2 (50%) (40nm) |
| E-61 | PEDOT (60nm) | HTL2 (20nm) | 60nm | ETM-1 (10nm) | ETM-1 (50%) : ETM-2 (50%) (40nm) |
| E-62 | PEDOT (60nm) | HTL2 (20nm) | 60nm | ETM-1 (10nm) | ETM-1 (50%) : ETM-2 (50%) (40nm) |
| E-63 | PEDOT (60nm) | HTL2 (20nm) | 60nm | ETM-1 (10nm) | ETM-1 (50%) : ETM-2 (50%) (40nm) |
| E-64 | PEDOT (60nm) | HTL2 (20nm) | 60nm | ETM-1 (10nm) | ETM-1 (50%) : ETM-2 (50%) (40nm) |
| E-65 | PEDOT (60nm) | HTL2 (20nm) | 60nm | ETM-1 (10nm) | ETM-1 (50%) : ETM-2 (50%) (40nm) |
| E-66 | PEDOT (60nm) | HTL2 (20nm) | 60nm | ETM-1 (10nm) | ETM-1 (50%) : ETM-2 (50%) (40nm) |
| E-67 | PEDOT (60nm) | HTL2 (20nm) | 60nm | ETM-1 (10nm) | ETM-1 (50%) : ETM-2 (50%) (40nm) |
| E-68 | PEDOT (60nm) | HTL2 (20nm) | 60nm | ETM-1 (10nm) | ETM-1 (50%) : ETM-2 (50%) (40nm) |
| E-69 | PEDOT (60nm) | HTL2 (20nm) | 60nm | ETM-1 (10nm) | ETM-1 (50%) : ETM-2 (50%) (40nm) |
| E-70 | PEDOT (60nm) | HTL2 (20nm) | 60nm | ETM-1 (10nm) | ETM-1 (50%) : ETM-2 (50%) (40nm) |
| E-71 | PEDOT (60nm) | HTL2 (20nm) | 60nm | ETM-1 (10nm) | ETM-1 (50%) : ETM-2 (50%) (40nm) |
| E-72 | PEDOT (60nm) | HTL2 (20nm) | 60nm | ETM-1 (10nm) | ETM-1 (50%) : ETM-2 (50%) (40nm) |
| E-73 | PEDOT (60nm) | HTL2 (20nm) | 60nm | ETM-1 (10nm) | ETM-1 (50%) : ETM-2 (50%) (40nm) |
| E-74 | PEDOT (60nm) | HTL2 (20nm) | 60nm | ETM-1 (10nm) | ETM-1 (50%) : ETM-2 (50%) (40nm) |
| E-75 | PEDOT (60nm) | HTL2 (20nm) | 60nm | ETM-1 (10nm) | ETM-1 (50%) : ETM-2 (50%) (40nm) |
| E-76 | PEDOT (60nm) | HTL2 (20nm) | 60nm | ETM-1 (10nm) | ETM-1 (50%) : ETM-2 (50%) (40nm) |

## Patentansprüche

1. Verbindung gemäß Formel (1), 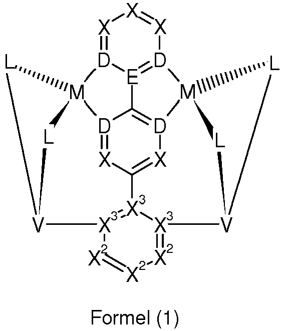 wobei für die verwendeten Symbole gilt:
M ist bei jedem Auftreten gleich oder verschieden Iridium oder Rhodium;
D ist bei jedem Auftreten gleich oder verschieden C oder N;
X ist gleich oder verschieden bei jedem Auftreten und ist CR oder N; oder zwei benachbarte X stehen zusammen für CR oder N und das dritte X ist CR oder N, wenn entweder ein D in diesem Cyclus als anionisches Stickstoffatom an M koordiniert oder wenn E für N steht;
E ist C oder N, wobei E nur dann N sein kann, wenn zwei benachbarte X zusammen für CR oder N stehen und das dritte X CR oder N ist;
V ist bei jedem Auftreten gleich oder verschieden eine Gruppe der Formel (2) oder (3), 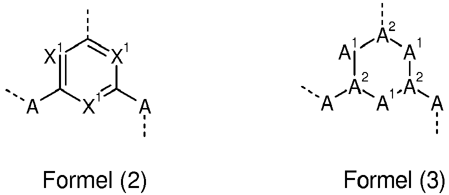 wobei die gestrichelte Bindung, die direkt an den Cyclus gebunden ist, die Bindung an die entsprechende in Formel (1) dargestellte 6-Ring-Aryl- bzw. Heteroarylgruppe darstellt und die beiden gestrichelten Bindungen an A jeweils die Bindungen an die Teilliganden L darstellen;
L ist bei jedem Auftreten gleich oder verschieden ein bidentater, monoanionischer Teilligand;
X¹ ist bei jedem Auftreten gleich oder verschieden CR oder N;
X² ist bei jedem Auftreten gleich oder verschieden CR oder N oder zwei benachbarte Gruppen X² stehen zusammen für NR, O oder S, so dass ein Fünfring entsteht, und die verbleibenden X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² für N stehen;
X³ ist bei jedem Auftreten C oder eine Gruppe X³ steht für N und die anderen Gruppen X³ in demselben Cyclus stehen für C; mit der Maßgabe, dass zwei benachbarte Gruppen X² zusammen für CR oder N stehen, wenn in dem Cyclus eine der Gruppen X³ für N steht;
A¹ ist bei jedem Auftreten gleich oder verschieden C(R)₂ oder O;
A² ist bei jedem Auftreten gleich oder verschieden CR, P(=O), B oder SiR, mit der Maßgabe, dass für A² = P(=O), B oder SiR das Symbol A¹ für O steht und das Symbol A, das an dieses A² gebunden ist, nicht für -C(=O)-NR'- oder -C(=O)-O- steht;
A ist bei jedem Auftreten gleich oder verschieden -CR=CR-, -C(=O)-NR'-, -C(=O)-O-, -CR₂-CR₂-, -CR₂-O- oder eine Gruppe der folgenden Formel (4), 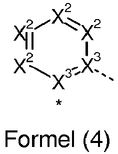 wobei die gestrichelte Bindung die Position der Bindung eines bidentaten Teilliganden L an diese Struktur darstellt und * die Position der Verknüpfung der Einheit der Formel (4) mit der zentralen cyclischen Gruppe darstellt und X² und X³ die oben genannten Bedeutungen aufweisen;
R ist bei jedem Auftreten gleich oder verschieden H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(Kation), SO₃(Kation), OSO₃(Kation), OPO₃(Kation)₂, O(Kation), N(R¹)₃(Anion), P(R¹)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder hetero-aromatisches Ringsystem mit 5 bis 40 aromatischen Ringatomen, das jeweils durch einen oder mehrere Reste R¹ substituiert sein kann; dabei können zwei Reste R auch miteinander ein Ring-system bilden;
R' ist bei jedem Auftreten gleich oder verschieden H, D, eine gerad-kettige Alkylgruppe mit 1 bis 20 C-Atomen oder eine verzweigte oder cyclische Alkylgruppe mit 3 bis 20 C-Atomen, wobei die Alkyl-gruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
R¹ ist bei jedem Auftreten gleich oder verschieden H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(Kation), SO₃(Kation), OSO₃(Kation), OPO₃(Kation)₂, O(Kation), N(R²)₃(Anion), P(R²)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch F ersetzt sein können;
Kation ist bei jedem Auftreten gleich oder verschieden ausgewählt aus der Gruppe bestehend aus Proton, Deuteron, Alkaliionen, Erdalkaliionen, Ammonium, Tetraalkylammonium und Tetraalkylphosphonium;
Anion ist bei jedem Auftreten gleich oder verschieden ausgewählt aus der Gruppe bestehend aus Halogeniden, Carboxylaten R²-COO-, Cyanid, Cyanat, Isocyanat, Thiocyanat, Thioisocyanat, Hydroxid, BF₄-, PF₆-, B(C₆F₅)₄⁻, Carbonat und Sulfonaten.

2. Verbindung nach Anspruch 1, **dadurch gekennzeichnet, dass** beide Metalle M für Ir(III) stehen und es sich um eine ungeladene Verbindung handelt.

3. Verbindung nach Anspruch 1 oder 2, gewählt aus den Verbindungen der Formeln (1'), (1") oder (1'"), 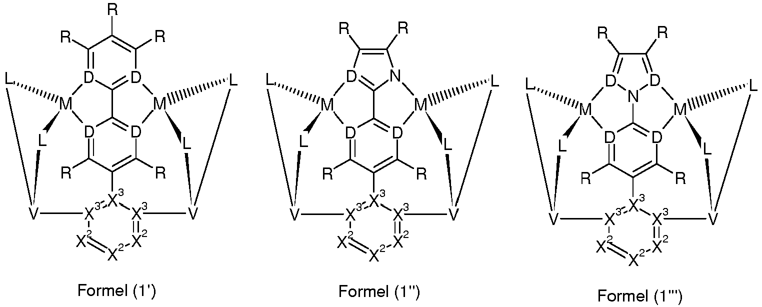 wobei die Reste R in ortho-Position zu den Gruppen D und in ortho-Position zu dem explizit eingezeichneten koordinierenden Stickstoffatom in Formel (1") jeweils gleich oder verschieden bei jedem Auftreten ausgewählt sind aus der Gruppe bestehend aus H, D, F, CH₃ und CD₃ und die weiteren verwendeten Symbole die in Anspruch 1 aufgeführten Bedeutungen aufweisen.

4. Verbindung nach einem oder mehreren der Ansprüche 1 bis 3, ausgewählt aus den Strukturen der Formeln (1a) bis (1h), 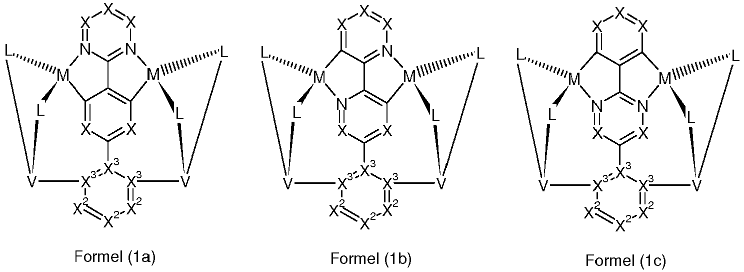 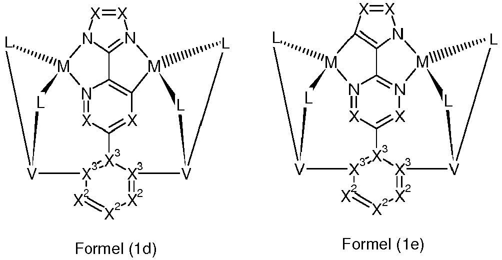 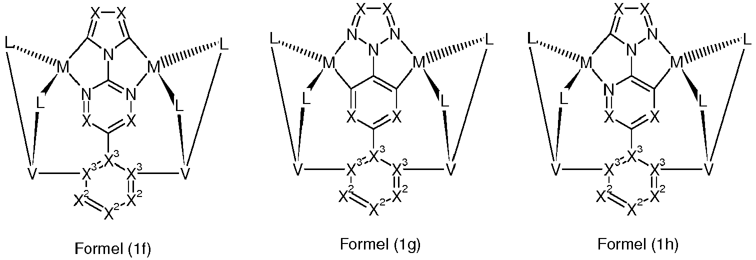 wobei die verwendeten Symbole die in Anspruch 1 genannten Bedeutungen aufweisen und X in dem Fünfring der Formel (1d) bis (1h) gleich oder verschieden bei jedem Auftreten für CR oder N steht.

5. Verbindung nach einem oder mehreren der Ansprüche 1 bis 4, ausgewählt aus den Verbindungen gemäß den Formeln (1a') bis (1h'), 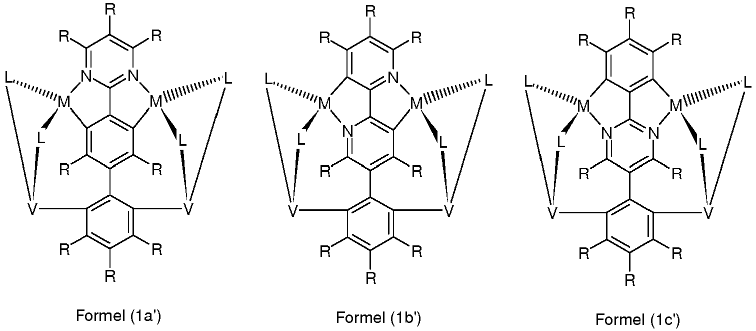 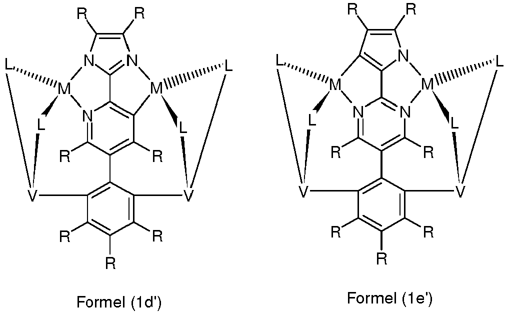 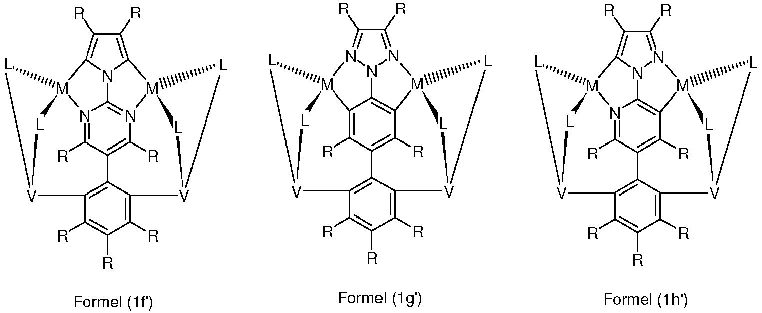 wobei die explizit eingezeichneten Reste R in ortho-Position zu den koordinierenden Kohlenstoff- bzw. Stickstoffatomen jeweils gleich oder verschieden bei jedem Auftreten ausgewählt sind aus der Gruppe bestehend aus H, D, F, CH₃ und CD₃ und die weiteren verwendeten Symbole die in Anspruch 1 genannten Bedeutungen aufweisen.

6. Verbindung nach einem oder mehreren der Ansprüche 1 bis 5, **dadurch gekennzeichnet, dass** die Gruppe der Formel (2) ausgewählt ist aus den Strukturen der Formeln (5) bis (8) und die Gruppe der Formel (3) ausgewählt ist aus den Strukturen der Formeln (9) bis (13), 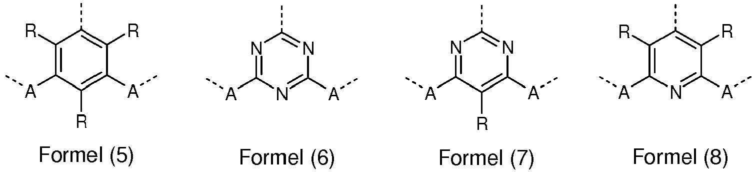 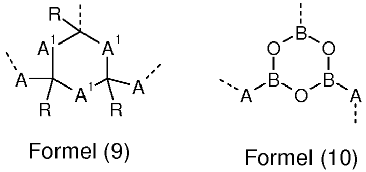 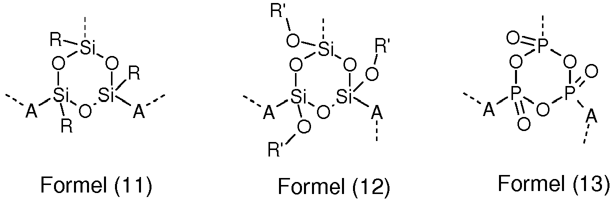 wobei die Symbole die in Anspruch 1 genannten Bedeutungen aufweisen.

7. Verbindung nach einem oder mehreren der Ansprüche 1 bis 6, **dadurch gekennzeichnet, dass** die Gruppe der Formel (2) eine Strukur der Formel (5') aufweist und die Gruppe der Formel (3) eine Struktur der Formel (9') oder (9") aufweist, 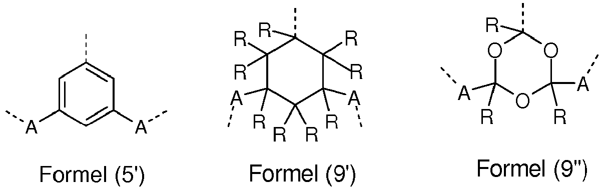 wobei die Symbole die in Anspruch 1 genannten Bedeutungen aufweisen.

8. Verbindung nach einem oder mehreren der Ansprüche 1 bis 7, **dadurch gekennzeichnet, dass** A gleich oder verschieden bei jedem Auftreten ausgewählt ist aus der Gruppe bestehend aus -C(=O)-O-, -C(=O)-NR'- oder einer Gruppe der Formel (4), wobei die Gruppe der Formel (4) ausgewählt ist aus den Strukturen der Formeln (14) bis (38), 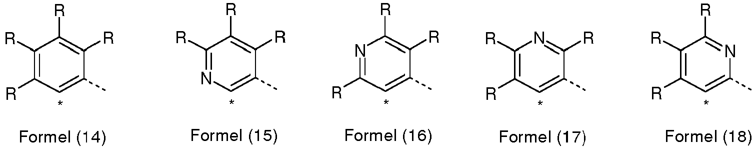 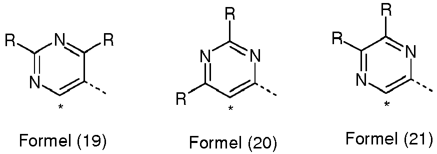 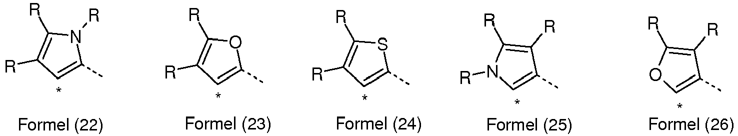 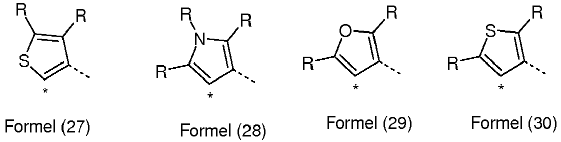 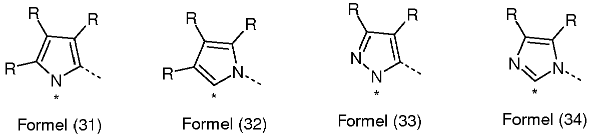 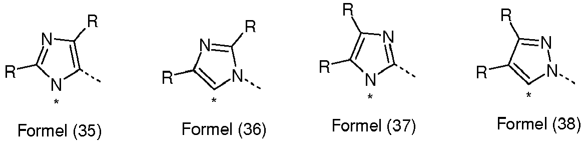 wobei die Symbole die in Anspruch 1 genannten Bedeutungen aufweisen.

9. Verbindung nach einem oder mehreren der Ansprüche 1 bis 8, **dadurch gekennzeichnet, dass** die Gruppe der Formel (2) ausgewählt ist aus den Strukturen der Formeln (2a) bis (2i) und die Gruppe der Formel (3) ausgewählt ist aus den Strukturen der Formeln (3a) bis (3i): 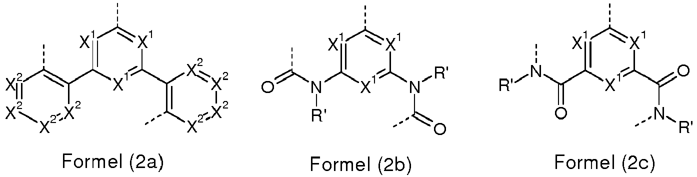 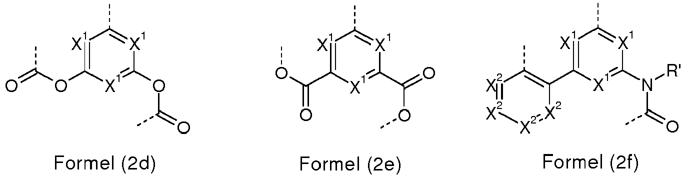 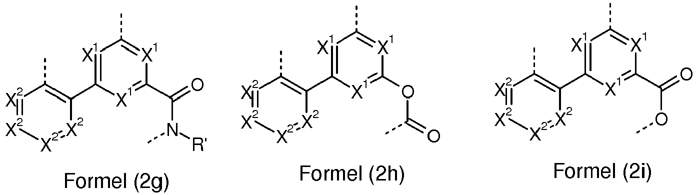 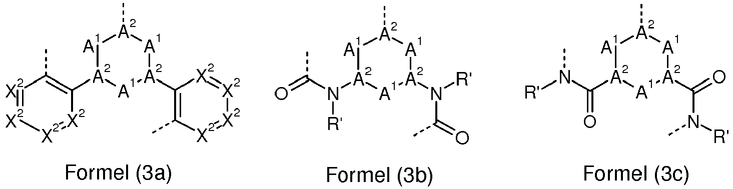 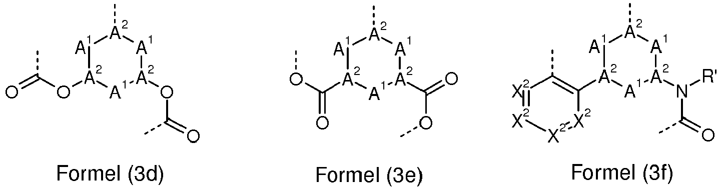 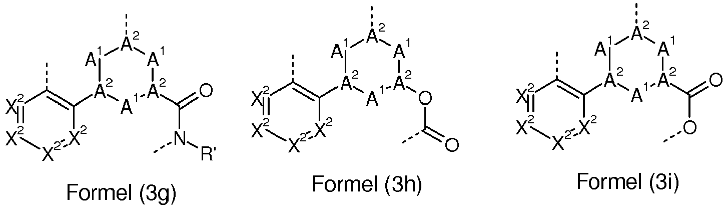 wobei die Symbole die in Anspruch 1 genannten Bedeutungen aufweisen.

10. Verbindung nach einem oder mehreren der Ansprüche 1 bis 9, **dadurch gekennzeichnet, dass** V ausgewählt ist aus den Strukturen der Formeln (5a") und (5a'"), 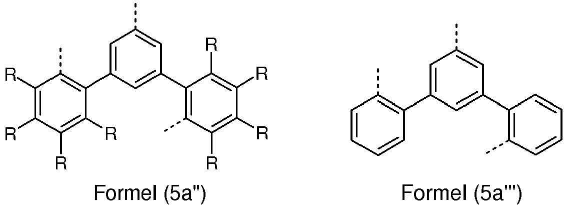 wobei die Symbole die in Anspruch 1 genannten Bedeutungen aufweisen.

11. Verbindung nach einem oder mehreren der Ansprüche 1 bis 10, **dadurch gekennzeichnet, dass** die bidentaten Teilliganden L gleich oder verschieden bei jedem Auftreten ausgewählt sind aus den Strukturen der Formeln (L-1), (L-2) oder (L-3), 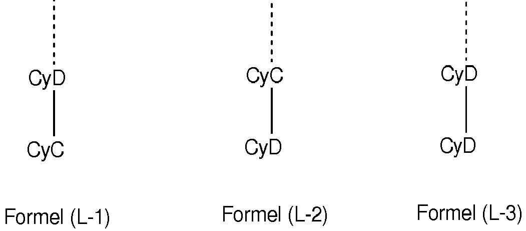 wobei die gestrichelte Bindung die Bindung des Teilliganden L an die Gruppe der Formel (2) bzw. (3) darstellt und für die weiteren Symbole gilt:
CyC ist gleich oder verschieden bei jedem Auftreten eine substituierte oder unsubstituierte Aryl- oder Heteroarylgruppe mit 5 bis 14 aromatischen Ringatomen, welche über ein Kohlenstoffatom an M koordiniert und welche über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an M koordiniert und welche über eine kovalente Bindung mit CyC verbunden ist;
dabei können mehrere der optionalen Substituenten miteinander ein Ringsystem bilden.

12. Verfahren zur Herstellung einer Verbindung nach einem oder mehreren der Ansprüche 1 bis 11 durch Umsetzung des Liganden mit Metallalkoholaten der Formel (57), mit Metallketoketonaten der Formel (58), mit Metallhalogeniden der Formel (59) oder mit Metallcarboxylaten der Formel (60), 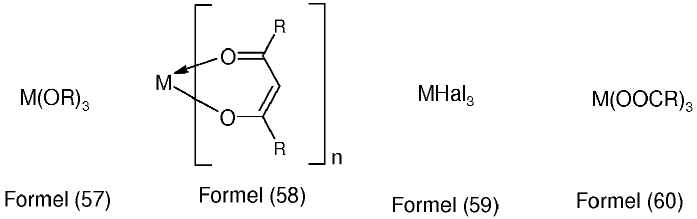 wobei M und R die in Anspruch 1 angegebenen Bedeutungen aufweisen, Hal = F, Cl, Br oder I ist und die Iridium- bzw. Rhodiumedukte auch als die entsprechenden Hydrate vorliegen können und/oder auch Iridium- bzw. Rhodiumverbindungen, die sowohl Alkoholat- und/oder Halogenid- und/oder Hydroxy- wie auch Ketoketonatreste tragen, verwendet werden können.

13. Formulierung, enthaltend mindestens eine Verbindung nach einem oder mehreren der Ansprüche 1 bis 11 und mindestens ein Lösemittel.

14. Verwendung einer Verbindung nach einem oder mehreren der Ansprüche 1 bis 11 in einer elektronischen Vorrichtung oder als Sauerstoff-Sensibilisator.

15. Elektronische Vorrichtung enthaltend mindestens eine Verbindung nach einem oder mehreren der Ansprüche 1 bis 11.

16. Elektronische Vorrichtung nach Anspruch 15, wobei es sich um eine organische Elektrolumineszenzvorrichtung handelt und die Verbindung nach einem oder mehreren der Ansprüche 1 bis 11 als emittierende Verbindung in einer oder mehreren emittierenden Schichten vorliegt.

## Claims

1. Compound of formula (1) 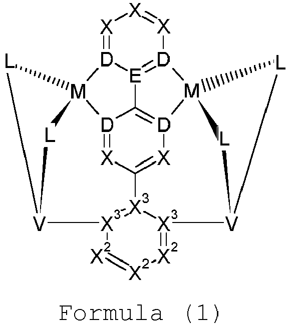 where the symbols used are as follows:
M is the same or different at each instance and is iridium or rhodium;
D is the same or different at each instance and is C or N;
X is the same or different at each instance and is CR or N; or two adjacent X together are CR or N and the third X is CR or N when either one D in this cycle coordinates as an anionic nitrogen atom to M or when E is N;
E is C or N, where E can only be N when two adjacent X together are CR or N and the third X is CR or N;
V is the same or different at each instance and is a group of the formula (2) or (3) 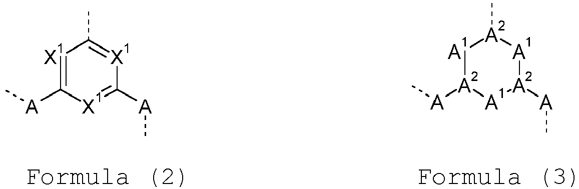
where the dotted bond bonded directly to the cycle represents the bond to the corresponding 6-membered aryl or heteroaryl group shown in formula (1) and the two dotted bonds to A each represent the bonds to the sub-ligands L;
L is the same or different at each instance and is a bidentate monoanionic sub-ligand;
X¹ is the same or different at each instance and is CR or N;
X² is the same or different at each instance and is CR or N or two adjacent X² groups together are NR, 0 or S, thus forming a five-membered ring, and the remaining X² are the same or different at each instance and are CR or N; or two adjacent X² groups together are CR or N when one of the X³ groups in the cycle is N, thus forming a five-membered ring; with the proviso that not more than two adjacent X² groups are N;
X³ is C at each instance or one X³ group is N and the other X³ groups in the same cycle are C; with the proviso that two adjacent X² groups together are CR or N when one of the X³ groups in the cycle is N;
A¹ is the same or different at each instance and is C(R)₂ or O;
A² is the same or different at each instance and is CR, P(=O), B or SiR, with the proviso that, when A² = P(=O), B or SiR, the symbol A¹ is 0 and the symbol A bonded to this A² is not -C(=O)-NR'- or -C(=O)-O-;
A is the same or different at each instance and is -CR=CR-, -C(=O)-NR'-, -C(=O)-O-, -CR₂-CR₂-, -CR₂-O- or a group of the following formula (4): 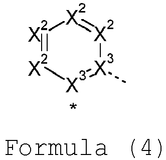
where the dotted bond represents the position of the bond of a bidentate sub-ligand L to this structure and * represents the position of the linkage of the unit of the formula (4) to the central cyclic group and X² and X³ have the definitions given above;
R is the same or different at each instance and is H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O) (R¹)₂, S(=O)R¹, S(=O)₂R¹, OSO₂R¹, COO (cation), SO₃(cation), OSO₃(cation), OPO₃(cation)₂, O(cation), N(R¹)₃(anion), P(R¹)₃(anion), a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R¹ radicals, where one or more nonadjacent CH₂ groups may be replaced by Si(R¹)₂, C=O, NR¹, 0, S or CONR¹, or an aromatic or heteroaromatic ring system which has 5 to 40 aromatic ring atoms and may be substituted in each case by one or more R¹ radicals; at the same time, two R radicals together may also form a ring system;
R' is the same or different at each instance and is H, D, a straight-chain alkyl group having 1 to 20 carbon atoms or a branched or cyclic alkyl group having 3 to 20 carbon atoms, where the alkyl group in each case may be substituted by one or more R¹ radicals and where one or more nonadjacent CH₂ groups may be replaced by Si(R¹)₂, or an aromatic or heteroaromatic ring system which has 5 to 40 aromatic ring atoms and may be substituted in each case by one or more R¹ radicals;
R¹ is the same or different at each instance and is H, D, F, Cl, Br, I, N(R²)₂, CN, NO₂, OR², SR², Si (R²)₃, B(OR²)₂, C(=O)R², P(=O) (R²)₂, S(=O)R², S(=O)₂R², OSO₂R², COO (cation), SO₃ (cation), OSO₃(cation), OPO₃(cation)₂, O(cation), N(R²)₃(anion), P(R²)₃(anion), a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R² radicals, where one or more nonadjacent CH₂ groups may be replaced by Si(R²)₂, C=O, NR², 0, S or CONR², or an aromatic or heteroaromatic ring system which has 5 to 40 aromatic ring atoms and may be substituted in each case by one or more R² radicals; at the same time, two or more R¹ radicals together may form a ring system;
R² is the same or different at each instance and is H, D, F or an aliphatic, aromatic or heteroaromatic organic radical having 1 to 20 carbon atoms, in which one or more hydrogen atoms may also be replaced by F;
cation is the same or different at each instance and is selected from the group consisting of proton, deuteron, alkali metal ions, alkaline earth metal ions, ammonium, tetraalkylammonium and tetraalkylphosphonium;
anion is the same or different at each instance and is selected from the group consisting of halides, carboxylates R²-COO⁻, cyanide, cyanate, isocyanate, thiocyanate, thioisocyanate, hydroxide, BF₄⁻, PF₆⁻, B (C₆F₅)₄⁻, carbonate and sulfonates.

2. Compound according to Claim 1, **characterized in that** both metals M are Ir(III) and the compound is an uncharged compound.

3. Compound according to Claim 1 or 2, selected from the compounds of the formulae (1'), (1") and (1"') 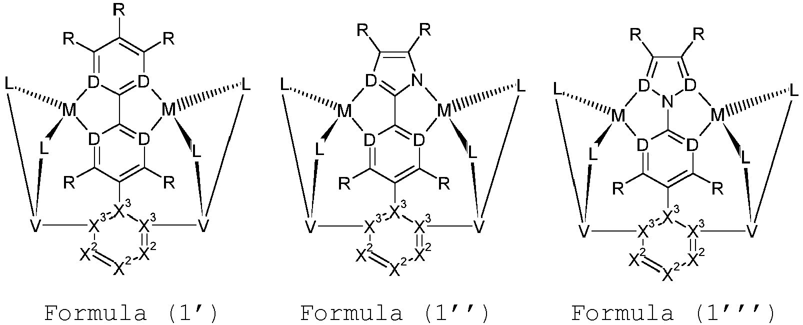 where the R radicals in the ortho position to the D groups and in the ortho position to the coordinating nitrogen atom shown explicitly in formula (1") are each the same or different at each instance and are selected from the group consisting of H, D, F, CH₃ and CD₃, and the other symbols used have the definitions detailed in Claim 1.

4. Compound according to one or more of Claims 1 to 3, selected from the structures of the formulae (1a) to (1h) 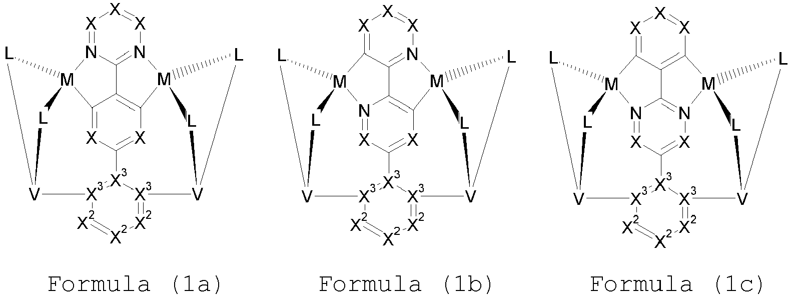 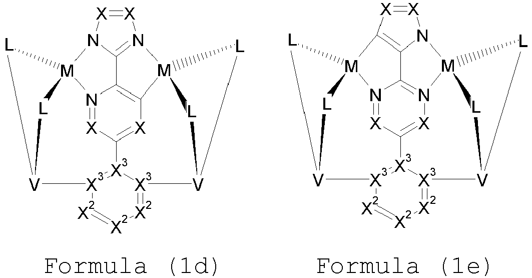 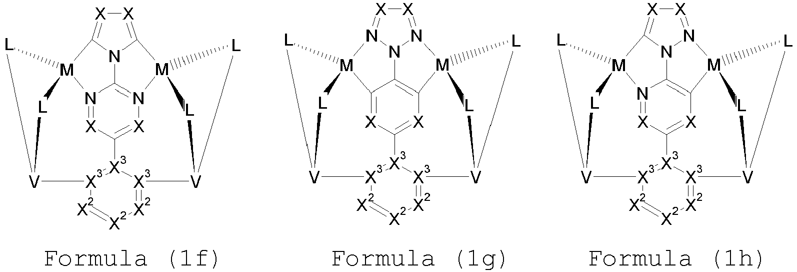 where the symbols used have the definitions given in Claim 1 and X in the five-membered ring of the formula (1d) to (1h) is the same or different at each instance and is CR or N.

5. Compound according to one or more of Claims 1 to 4, selected from the compounds of the formulae (1a') to (1h') 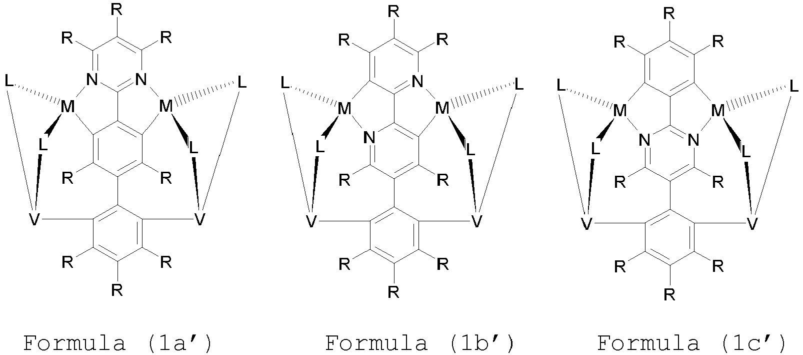 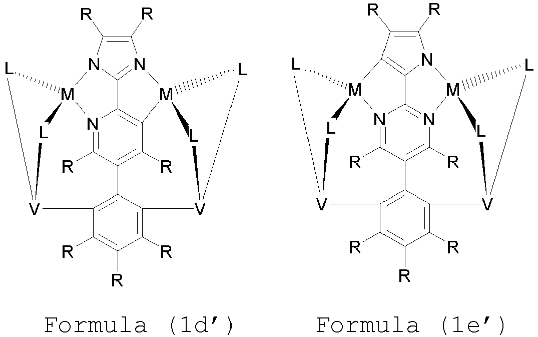 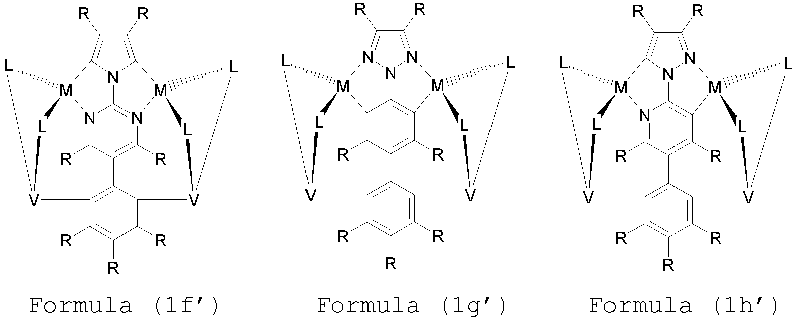 where the R radicals shown explicitly in ortho position to the coordinating carbon or nitrogen atoms are each the same or different at each instance and are selected from the group consisting of H, D, F, CH₃ and CD₃, and the other symbols used have the definitions given in Claim 1.

6. Compound according to one or more of Claims 1 to 5, **characterized in that** the group of the formula (2) is selected from the structures of the formulae (5) to (8) and the group of the formula (3) is selected from the structures of the formulae (9) to (13) 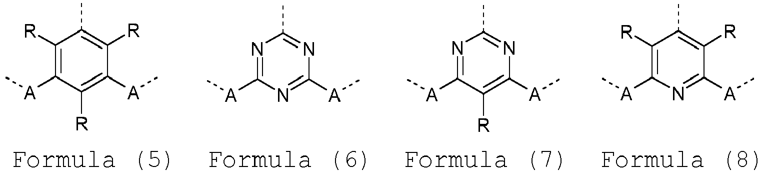 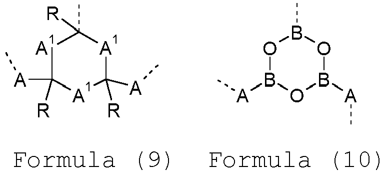 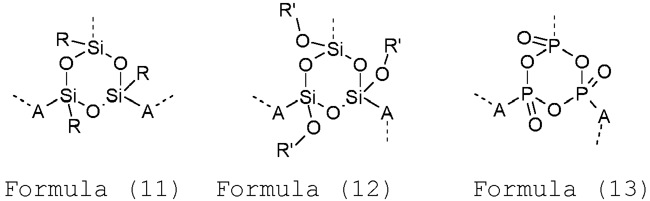 where the symbols have the definitions given in Claim 1.

7. Compound according to one or more of Claims 1 to 6, **characterized in that** the group of the formula (2) has a structure of the formula (5') and the group of the formula (3) has a structure of the formula (9') or (9") 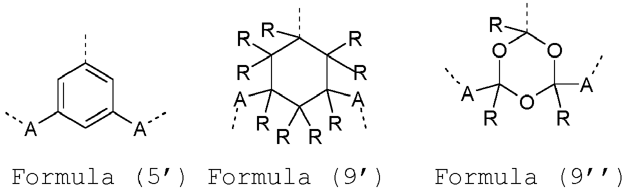 where the symbols have the definitions given in Claim 1.

8. Compound according to one or more of Claims 1 to 7, **characterized in that** A is the same or different at each instance and is selected from the group consisting of -C(=O)-O-, -C(=O)-NR'- or a group of the formula (4), where the group of the formula (4) is selected from the structures of the formulae (14) to (38) 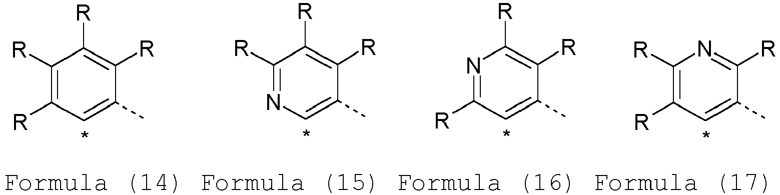 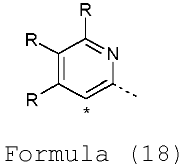 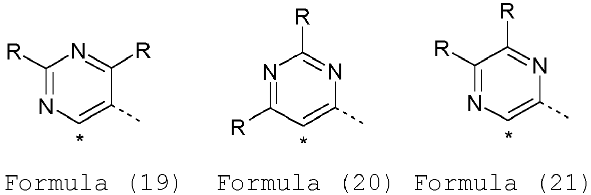 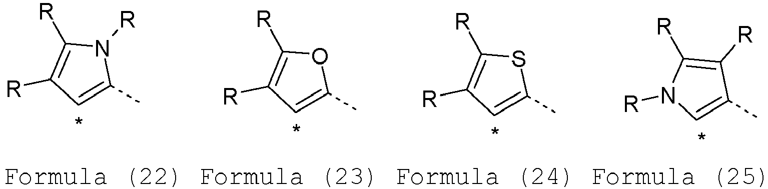 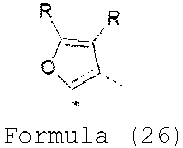 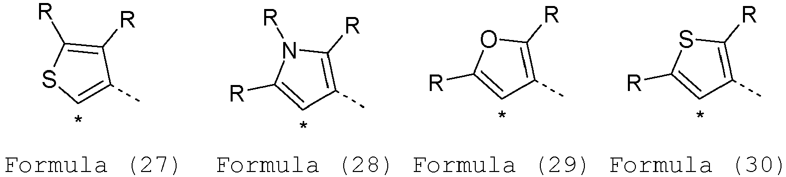 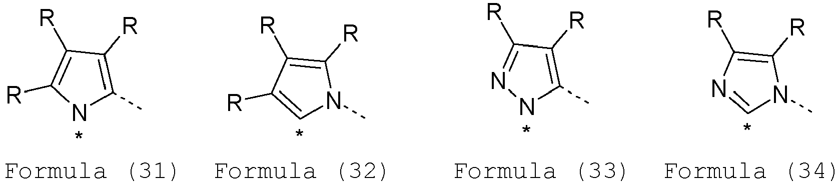 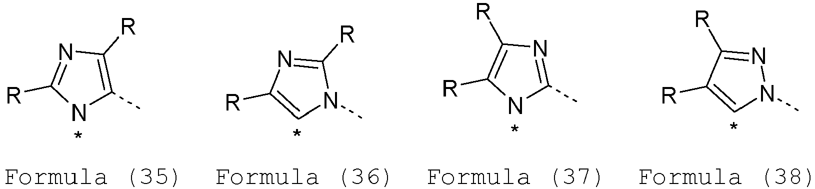 where the symbols have the definitions given in Claim 1.

9. Compound according to one or more of Claims 1 to 8, **characterized in that** the group of the formula (2) is selected from the structures of the formulae (2a) to (2i) and the group of the formula (3) is selected from the structures of the formulae (3a) to (3i): 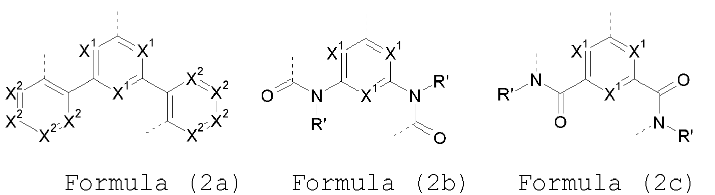 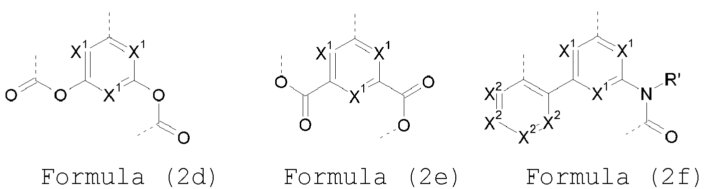 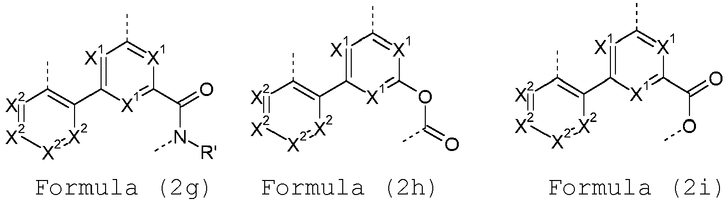 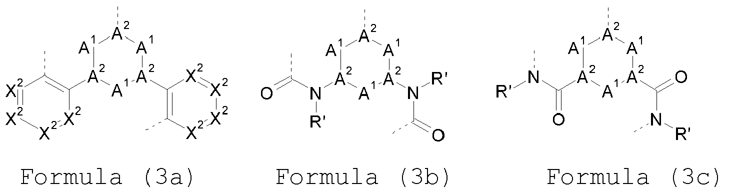 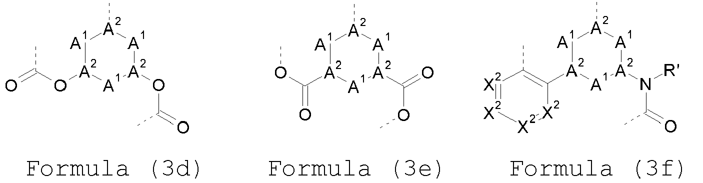 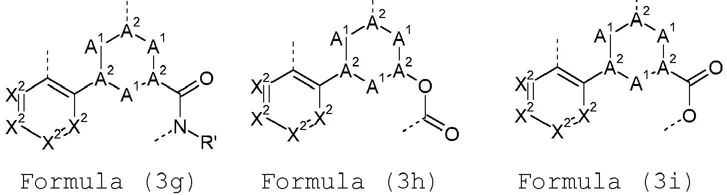 where the symbols have the definitions given in Claim 1.

10. Compound according to one or more of Claims 1 to 9, **characterized in that** V is selected from the structures of the formulae (5a") and (5a"') 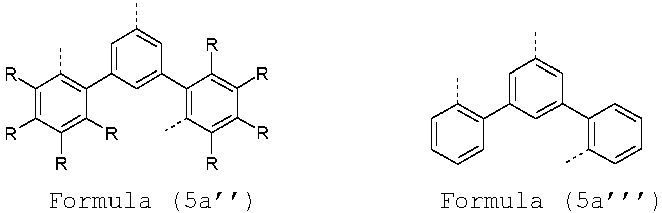 where the symbols have the definitions given in Claim 1.

11. Compound according to one or more of Claims 1 to 10, **characterized in that** the bidentate sub-ligands L are the same or different at each instance and are selected from the structures of the formulae (L-1), (L-2) or (L-3) 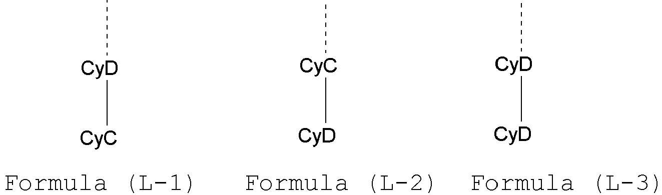 where the dotted bond represents the bond of the sub-ligand L to the group of the formula (2) or (3) and the other symbols are as follows:
CyC is the same or different at each instance and is a substituted or unsubstituted aryl or heteroaryl group which has 5 to 14 aromatic ring atoms and coordinates to M via a carbon atom and is bonded to CyD via a covalent bond;
CyD is the same or different at each instance and is a substituted or unsubstituted heteroaryl group which has 5 to 14 aromatic ring atoms and coordinates to M via a nitrogen atom or via a carbene carbon atom and is bonded to CyC via a covalent bond;
at the same time, two or more of the optional substituents together may form a ring system.

12. Process for preparing a compound according to one or more of Claims 1 to 11 by reacting the ligand with metal alkoxides of the formula (57), with metal ketoketonates of the formula (58), with metal halides of the formula (59) or with metal carboxylates of the formula (60) 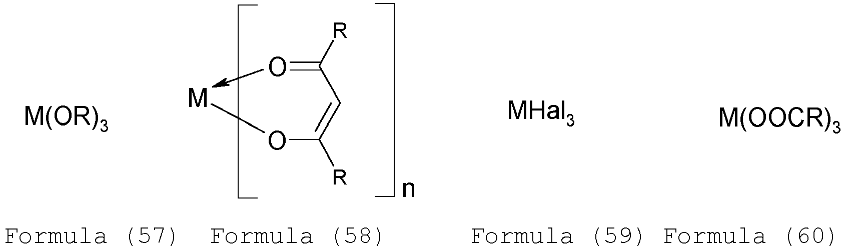 where M and R have the definitions specified in Claim 1, Hal = F, Cl, Br or I and the iridium or rhodium reactants may also take the form of the corresponding hydrates and/or iridium or rhodium compounds that bear both alkoxide and/or halide and/or hydroxyl and also ketoketonate radicals may also be used.

13. Formulation comprising at least one compound according to one or more of Claims 1 to 11 and at least one solvent.

14. Use of a compound according to one or more of Claims 1 to 11 in an electronic device or as oxygen sensitizer.

15. Electronic device comprising at least one compound according to one or more of Claims 1 to 11.

16. Electronic device according to Claim 15 which is an organic electroluminescent device, and wherein the compound according to one or more of Claims 1 to 11 is present as emitting compound in one or more emitting layers.

## Revendications

1. Composé selon la formule (1), 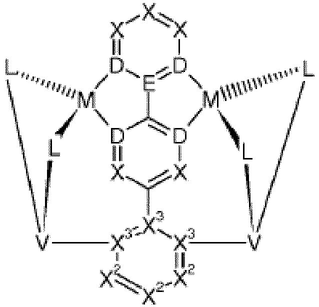 formule (1)
ce qui suit s'appliquant aux symboles utilisés :
M identique ou différent en chaque occurrence, étant iridium ou rhodium ;
D identique ou différent en chaque occurrence, étant C ou N ;
X étant identique ou différent en chaque occurrence et étant CR ou N ; ou deux X voisins représentant ensemble CR ou N et le troisième X étant CR ou N, soit lorsqu'un D dans ce cycle est coordiné à M en tant qu'atome d'azote anionique, soit lorsqu'E représente N ;
E étant C ou N, E ne pouvant être N que lorsque deux X voisins représentent ensemble CR ou N et que le troisième X est CR ou N ;
V identique ou différent en chaque occurrence, étant un groupe de formule (2) ou (3), 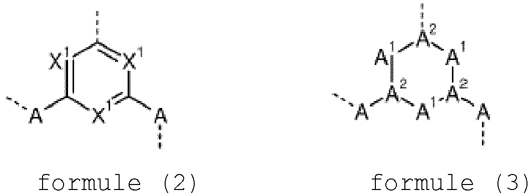 la liaison en pointillés qui est directement liée au cycle indiquant la liaison au groupe correspondant hétéroaryle ou aryle à 6 chaînons représenté dans la formule (1) et les deux liaisons en pointillés au niveau de A indiquant à chaque fois les liaisons aux ligands partiels L ;
L identique ou différent en chaque occurrence, ; étant un ligand partiel bidentate monoanionique ;
X¹ identique ou différent en chaque occurrence, étant CR ou N ;
X² identique ou différent en chaque occurrence, étant CR ou N ou deux groupes X² voisins représentant ensemble NR, O ou S, de sorte qu'un cycle à cinq chaînons est formé, et les X² restants, identiques ou différents en chaque occurrence, représentant CR ou N ; ou deux groupes X² voisins représentant ensemble CR ou N, lorsqu'un des groupes X³ représente N dans le cycle, de sorte qu'un cycle à cinq chaînons est formé ; étant entendu qu'au maximum deux groupes X² voisins représentent N ;
X³ étant en chaque occurrence C ou un groupe X³ représentant N et les autres groupes X³ dans le même cycle représentant C ; étant entendu que deux groupes X² voisins représentent ensemble CR ou N, lorsqu'un des groupes X³ représente N dans le cycle ;
A¹ identique ou différent en chaque occurrence, étant C(R)₂ ou O ;
A² identique ou différent en chaque occurrence, étant CR, P(=O), B ou SiR, étant entendu que lorsque A² = P(=O), B ou SiR, le symbole A¹ représente O et le symbole A, qui est lié à cet A², ne représente pas -C(=O)-NR'- ou -C(=O)-O- ;
A identique ou différent en chaque occurrence, étant -CR=CR-, -C(=O)-NR'-, -C(=O)-O-, -CR₂-CR₂-, -CR₂-O- ou un groupe de formule suivante (4), 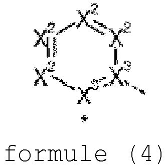 la liaison en pointillés indiquant la position de la liaison d'un ligand partiel bidentate L à cette structure et * indiquant la position de la liaison de l'unité de formule (4) avec le groupe cyclique central et X² et X³ présentant les significations mentionnées ci-dessus ;
R identique ou différent en chaque occurrence, étant H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(cation), SO₃(cation), OSO₃(cation), OPO₃(cation)₂, O(cation), N(R¹)₃(anion), P(R¹)₃(anion), un groupe alkyle linéaire comportant 1 à 20 atome (s) de C ou un groupe alcényle ou alcynyle comportant 2 à 20 atomes de C ou un groupe alkyle ramifié ou cyclique comportant 3 à 20 atomes de C, le groupe alkyle, alcényle ou alcynyle pouvant à chaque fois être substitué par un ou plusieurs radicaux R¹, un ou plusieurs groupes CH₂ non voisins pouvant être remplacés par Si(R¹)₂, C=O, NR¹, O, S or CONR¹, ou un système cyclique aromatique ou hétéroaromatique comportant 5 à 40 atomes de cycle aromatiques, qui peut à chaque fois être substitué par un ou plusieurs radicaux R¹ ; à cet égard, deux radicaux R pouvant également former ensemble un système cyclique ;
R' identique ou différent en chaque occurrence, étant H, D, un groupe alkyle linéaire comportant 1 à 20 atome (s) de C ou un groupe alkyle ramifié ou cyclique comportant 3 à 20 atomes de C, le groupe alkyle pouvant à chaque fois être substitué par un ou plusieurs radicaux R¹ et un ou plusieurs groupes CH₂ non voisins pouvant être remplacés par Si(R¹)₂, ou un système cyclique aromatique ou hétéroaromatique comportant 5 à 40 atomes de cycle aromatiques, qui peut à chaque fois être substitué par un ou plusieurs radicaux R¹ ;
R¹ identique ou différent en chaque occurrence, étant H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(cation), SO₃(cation), OSO₃(cation), OPO₃(cation)₂, O(cation), N(R²)₃(anion), P(R²)₃(anion), un groupe alkyle linéaire comportant 1 à 20 atome(s) de C ou un groupe alcényle ou alcynyle comportant 2 à 20 atomes de C ou un groupe alkyle ramifié ou cyclique comportant 3 à 20 atomes de C, le groupe alkyle, alcényle ou alcynyle pouvant à chaque fois être substitué par un ou plusieurs radicaux R², un ou plusieurs groupes CH₂ non voisins pouvant être remplacés par Si(R²)₂, C=O, NR², O, S ou CONR², ou un système cyclique aromatique ou hétéroaromatique comportant 5 à 40 atomes de cycle aromatiques, qui peut à chaque fois être substitué par un ou plusieurs radicaux R² ; à cet égard deux radicaux R¹ ou plus pouvant former ensemble un système cyclique ;
R² identique ou différent en chaque occurrence, étant H, D, F ou un radical organique aliphatique, aromatique ou hétéroaromatique comportant 1 à 20 atome (s) de C, dans lequel également un ou plusieurs atomes de H peuvent être remplacés par F ;
cation identique ou différent en chaque occurrence, étant choisi dans le groupe constitué par proton, deutéron, des ions de métal alcalin, des ions de métal alcalino-terreux, un ammonium, tétraalkylammonium et tétraalkylphosphonium ;
anion identique ou différent en chaque occurrence, étant choisi dans le groupe constitué par halogénures, carboxylates R²-COO⁻, cyano, cyanate, isocyanate, thiocyanate, thioisocyanate, hydroxyde, BF₄⁻, PF₆⁻, B(C₆F₅)₄⁻, carbonate et sulfonates.

2. Composé selon la revendication 1, **caractérisé en ce que** les deux métaux M représentent Ir(III) et que c'est un composé non chargé.

3. Composé selon la revendication 1 ou 2, choisi parmi les composés des formules (1'), (1") et (1"') 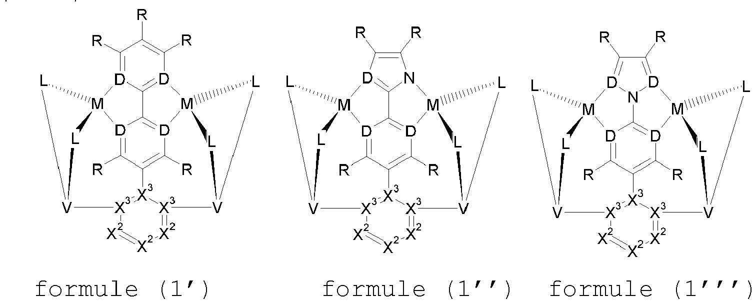 les radicaux R en position ortho par rapport aux groupes D et en position ortho par rapport à l'atome d'azote coordinant explicitement indiqué dans la formule (1"), identiques ou différents en chaque occurrence, étant respectivement choisis dans le groupe constitué par H, D, F, CH₃ et CD₃ et les autres symboles utilisés présentant les significations indiquées dans la revendication 1.

4. Composé selon l'une ou plusieurs des revendications 1 à 3, choisi parmi les structures des formules (1a) à (1h), 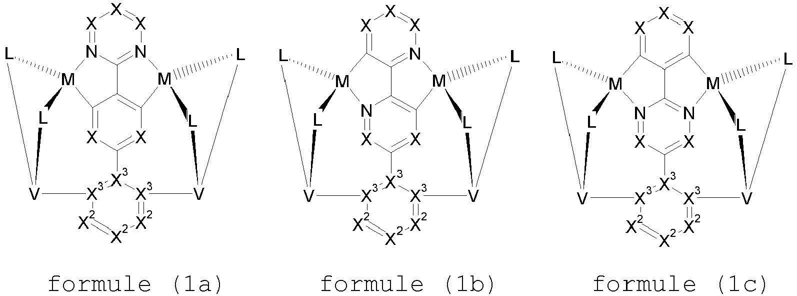 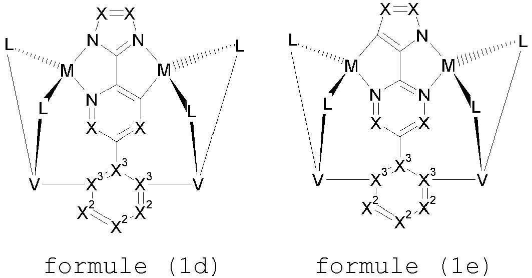 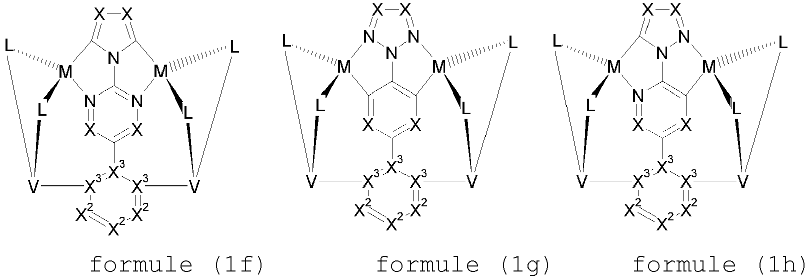 les symboles utilisés présentant les significations mentionnées dans la revendication 1 et X dans le cycle à 5 chaînons des formules (1d) à (1h), identique ou différent en chaque occurrence, représentant CR ou N.

5. Composé selon l'une ou plusieurs des revendications 1 à 4, choisi parmi les composés selon les formules (1a') à (1h'), 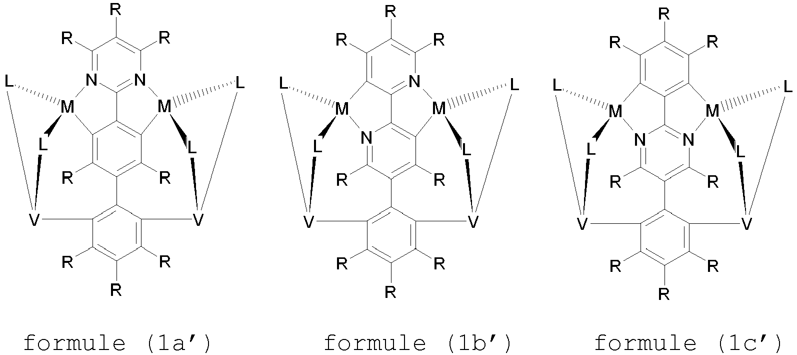 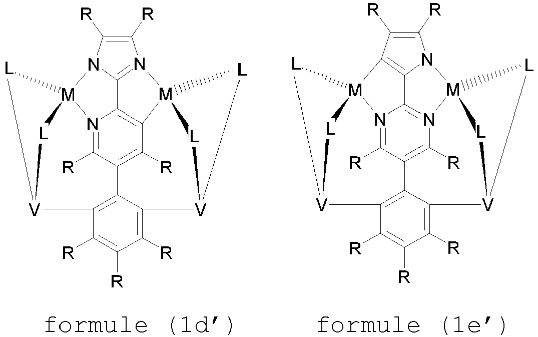 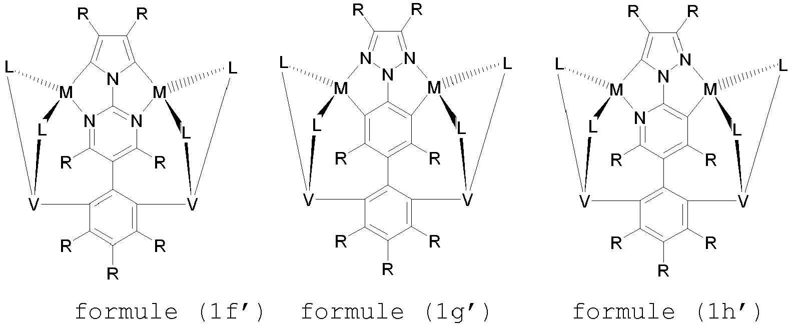 les radicaux R, à chaque fois identiques ou différents en chaque occurrence, explicitement indiqués en position ortho par rapport aux atomes de carbone ou d'azote coordinants, étant choisis respectivement dans le groupe constitué par H, D, F, CH₃ et CD₃ et les autres symboles utilisés présentant les significations mentionnées dans la revendication 1.

6. Composé selon l'une ou plusieurs des revendications 1 à 5, **caractérisé en ce que** le groupe de formule (2) est choisi parmi les structures des formules (5) à (8) et le groupe de formule (3) est choisi parmi les structures des formules (9) à (13), 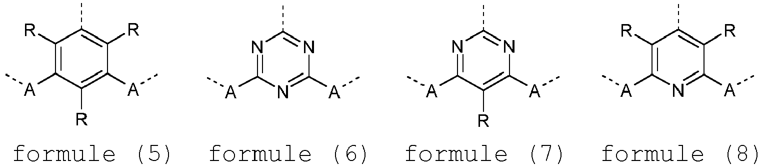 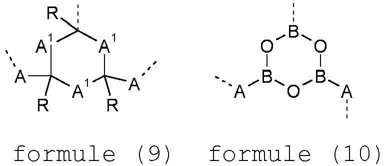 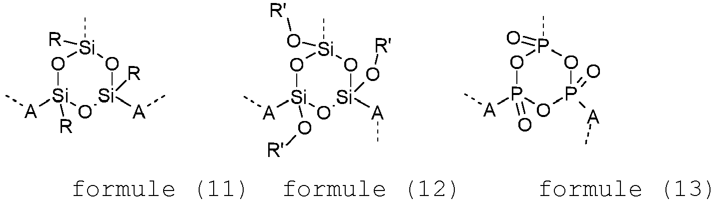 les symboles présentant les significations mentionnées dans la revendication 1.

7. Composé selon l'une ou plusieurs des revendications 1 à 6, **caractérisé en ce que** le groupe de formule (2) présente une structure de formule (5') et le groupe de formule (3) présente une structure de formule (9') ou (9"), 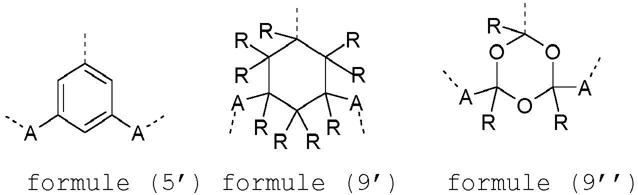 les symboles présentant les significations mentionnées dans la revendication 1.

8. Composé selon l'une ou plusieurs des revendications 1 à 7, **caractérisé en ce que** A, identique ou différent en chaque occurrence, est choisi dans le groupe constitué par -C(=O)-O-, -C(=O)-NR'- ou un groupe de formule (4), le groupe de formule (4) étant choisi parmi les structures des formules (14) à (38), 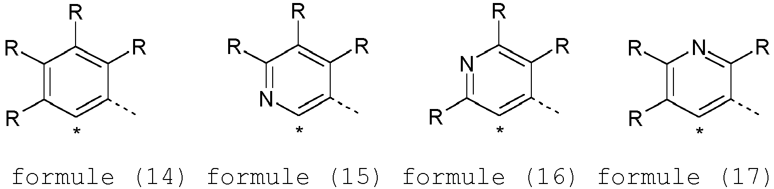 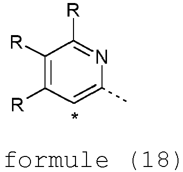 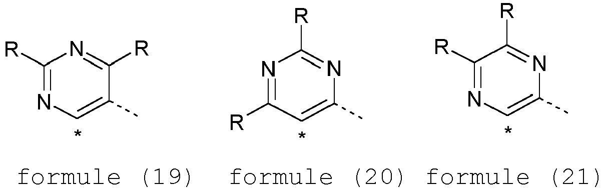 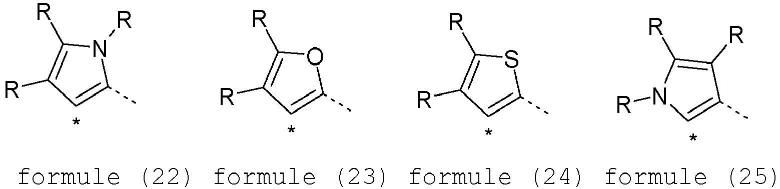 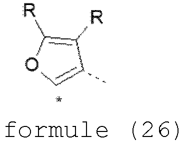 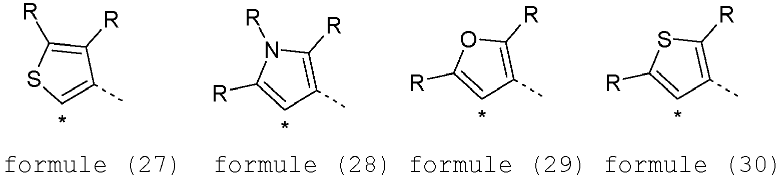 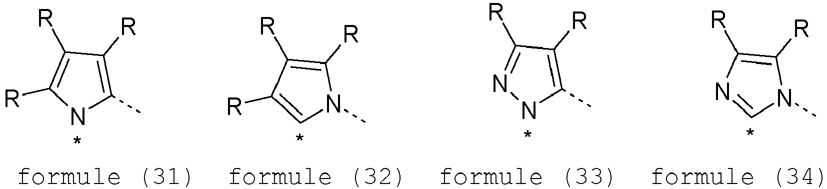 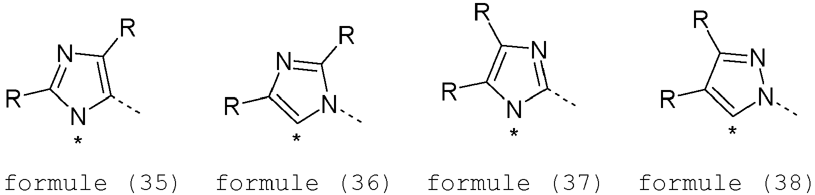 les symboles présentant les significations mentionnées dans la revendication 1.

9. Composé selon l'une ou plusieurs des revendications 1 à 8, **caractérisé en ce que** le groupe de formule (2) est choisi parmi les structures des formules (2a) à (2i) et le groupe de formule (3) est choisi parmi les structures des formules (3a) à (3i) : 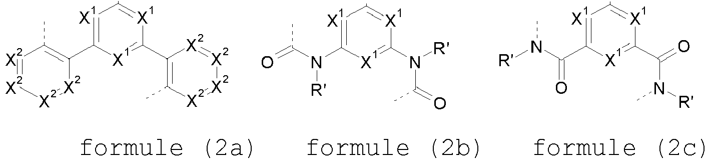 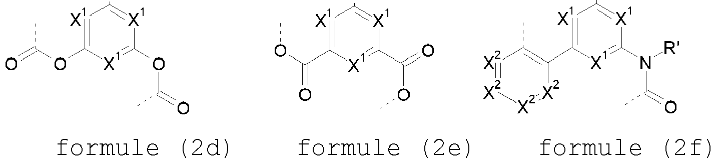 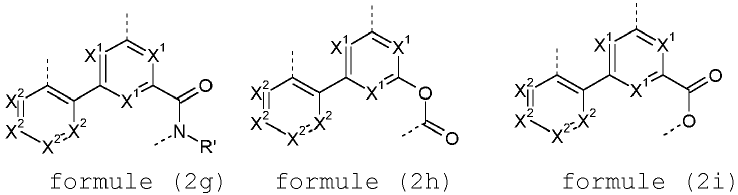 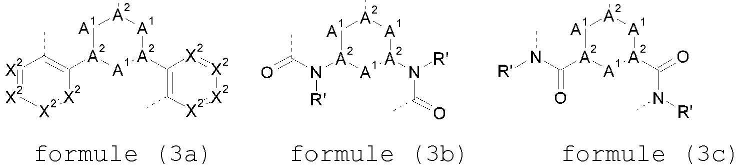 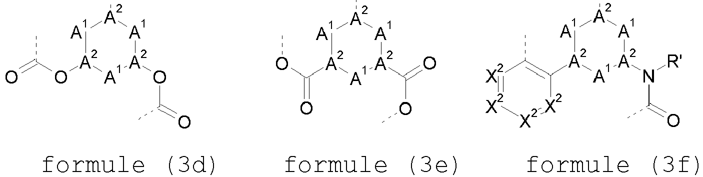 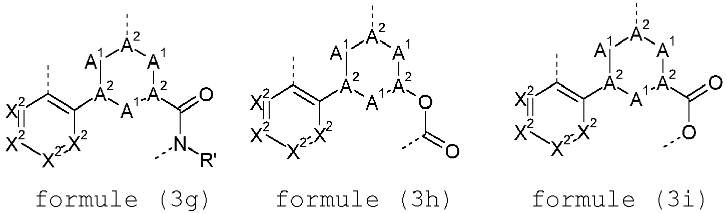 les symboles présentant les significations mentionnées dans la revendication 1.

10. Composé selon l'une ou plusieurs des revendications 1 à 9, **caractérisé en ce que** V est choisi parmi les structures des formules (5a") et (5a'"), 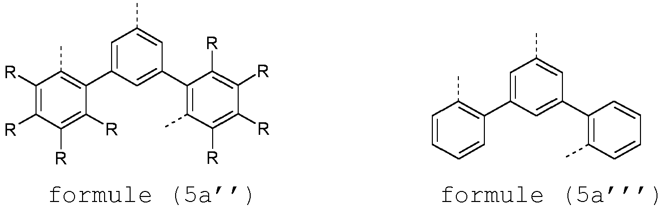 les symboles présentant les significations mentionnées dans la revendication 1.

11. Composé selon l'une ou plusieurs des revendications 1 à 10, **caractérisé en ce que** les ligands partiels bidentates L, identiques ou différents en chaque occurrence, sont choisis parmi les structures des formules (L-1), (L-2) ou (L-3), 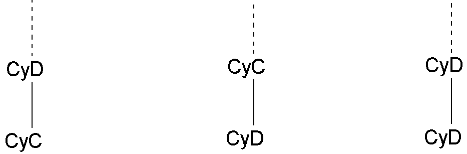 formule (L-1) formule (L-2) formule (L-3) la liaison en pointillés indiquant la liaison du ligand partiel L au groupe de formule (2) ou (3) et ce qui suit s'appliquant pour les autres symboles :
CyC identique ou différent en chaque occurrence, étant un groupe aryle ou hétéroaryle substitué ou non substitué comportant 5 à 14 atomes de cycle aromatiques, qui coordine à M par l'intermédiaire d'un atome de carbone et qui est relié à CyD par l'intermédiaire d'une liaison covalente ;
CyD identique ou différent en chaque occurrence, étant un groupe hétéroaryle substitué ou non substitué comportant 5 à 14 atomes de cycle aromatiques, qui coordine à M par l'intermédiaire d'un atome d'azote ou par l'intermédiaire d'un atome de carbone de carbène et qui est relié à CyC par l'intermédiaire d'une liaison covalente ;
à cet égard, plusieurs des substituants éventuels pouvant former ensemble un système cyclique.

12. Procédé pour la préparation d'un composé selon l'une ou plusieurs des revendications 1 à 11 par la transformation du ligand avec des alcoolates métalliques de formule (57), avec des cétocétonates métalliques de formule (58), avec des halogénures métalliques de formule (59) ou avec des carboxylates métalliques de formule (60), 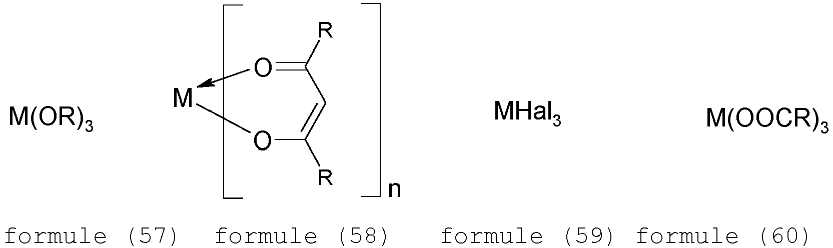 M et R présentant les significations indiquées dans la revendication 1, Hal = F, Cl, Br ou I et les éduits d'iridium ou de rhodium pouvant être également présents sous forme d'hydrates correspondants et/ou des composés d'iridium ou de rhodium, qui portent des radicaux alcoolate et/ou halogénure et/ou hydroxy ainsi que cétocétonate, pouvant également être utilisés.

13. Formulation, contenant au moins un composé selon l'une ou plusieurs des revendications 1 à 11 et au moins un solvant.

14. Utilisation d'un composé selon l'une ou plusieurs des revendications 1 à 11 dans un dispositif électronique ou en tant que sensibilisateur d'oxygène.

15. Dispositif électronique contenant au moins un composé selon l'une ou plusieurs des revendications 1 à 11.

16. Dispositif électronique selon la revendication 15, qui est un dispositif organique d'électroluminescence et le composé selon l'une ou plusieurs des revendications 1 à 11 étant présent en tant que composé émetteur dans une ou plusieurs couches émettrices.
